# EUROPEAN PATENT SPECIFICATION

(11) **EP 3 010 068 B1**
(45) Date of publication and mention of the grant of the patent: **09.12.2020**
(21) Application number: 15190330.9
(22) Date of filing: 19.10.2015
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 17.10.2014 KR 20140141198; 07.10.2015 KR 20150141045
(43) Date of publication of application: 20.04.2016
(73) Proprietor: Samsung Display Co., Ltd., Gyeonggi-do (KR)
(72) Inventor: Kim, Sung-Wook, Yongin-si, Gyeonggi-do (KR); KIM, Myeong-Suk, Yongin-si, Gyeonggi-do (KR); CHO, Hwan-Hee, Yongin-si, Gyeonggi-do (KR); CHU, Chang-Woong, Yongin-si, Gyeonggi-do (KR); KIM, Youn-Sun, Yongin-si, Gyeonggi-do (KR); ITO, Naoyuki, Yongin-si, Gyeonggi-do (KR)
(74) Representative: Gulde & Partner

(56) References cited:
- EP-A1- 3 000 815
- KR-A- 20130 110 934
- US-A1- 2006 228 582
- US-A1- 2014 008 617
- US-A1- 2014 197 386
- CHUL YOUNG KIM ET AL: "Synthesis and characterization of new blue light emitting iridium complexes containing a trimethylsilyl group", JOURNAL OF MATERIALS CHEMISTRY, vol. 22, no. 42, 1 January 2012 (2012-01-01), page 22721, XP055235927, GB ISSN: 0959-9428, DOI: 10.1039/c2jm33084a

## Description

### BACKGROUND

Organic light-emitting devices (OLEDs) are self-emitting devices that have advantages such as wide viewing angles, excellent contrast, quick response, high luminance, and excellent driving voltage characteristics, and can provide multicolored images.

An organic light-emitting device may have a structure in which an anode, a hole transport region, an emission layer, an electron transport region, and a cathode are sequentially disposed upon one another in this order. Holes injected from the anode move to the emission layer via the hole transport region, while electrons injected from the cathode move to the emission layer via the electron transport region. Carriers such as the holes and electrons recombine together in the emission layer to generate exitons. When these exitons drop from an excited state to a ground state, light is emitted.

Chu Young Kim et al. disclose a blue emitting OLED including Ir(F₂-m-trimethylsilyl)₂(fptp) and Ir(F₂-p-trimethylsilyl)₂(fptp) as dopant materials in an emission layer.

US 2014/0008617 A1 discloses silylated metal complexes useful as dopant materials for emission layers of yellow or green emitting OLED devices.

### SUMMARY

One or more exemplary embodiments include an organic light-emitting device having good color coordinates, and improved efficiency and lifetime due to balance between holes and electrons in an emission layer.

Additional aspects will be set forth in part in the description which follows and, in part, will be apparent from the description, or may be learned by practice of the presented embodiments.

According to the present invention, there is provided an organic light-emitting device as defined in claim 1.

### BRIEF DESCRIPTION OF THE DRAWING

These and/or other aspects will become apparent and more readily appreciated from the following description of the exemplary embodiments, taken in conjunction with the accompanying drawings in which:

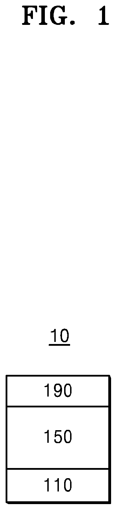

FIG. 1 is a schematic cross-sectional view of an organic light-emitting device according to an exemplary embodiment.

### DETAILED DESCRIPTION

Reference will now be made in detail to exemplary embodiments, examples of which are illustrated in the accompanying drawings, wherein like reference numerals refer to like elements throughout.

FIG. 1 is a schematic cross-sectional view of an organic light-emitting device 10 according to an exemplary embodiment. Referring to FIG. 1, the organic light-emitting device 10 includes a first electrode 110, an organic layer 150, and a second electrode 190.

A substrate (not shown) may be disposed under the first electrode 110 or on the second electrode 190 in FIG. 1. The substrate may be a glass or transparent plastic substrate with good mechanical strength, thermal stability, transparency, surface smoothness, ease of handling, and water resistance.

For example, the first electrode 110 may be formed by depositing or sputtering a first electrode-forming material on the substrate 11. When the first electrode 110 is an anode, a material having a high work function may be used as the first electrode-forming material to facilitate hole injection. The first electrode 110 may be a reflective electrode, a semi-transmissive electrode, or a transmissive electrode. Transparent and conductive materials such as ITO, IZO, SnO₂, and ZnO may be used to form the first electrode. The first electrode 110 as a semi-transmissive electrode or a reflective electrode may be formed of at least one material selected from magnesium (Mg), aluminum (Al), aluminum-lithium (Al-Li), calcium (Ca), magnesium-indium (Mg-In), and magnesium-silver (Mg-Ag). The first electrode 110 may have a single-layer structure or a multilayer structure including a plurality of layers. For example, the first electrode 110 may have a three-layered structure of ITO/Ag/ITO, but is not limited thereto.

The organic layer 150 may be disposed on the first electrode 110. The organic layer 150 includes an emission layer (EML). The organic layer 150 further includes a hole transport region between the first electrode and the emission layer, and an electron transport region between the emission layer and the second electrode. The hole transport region comprises an auxiliary emission layer adjacent to the emission layer, a hole transport layer and a hole injection layer. The hole injection layer is on the first electrode. The hole transport layer is on the hole injection layer. The auxiliary emission layer comprises a first compound represented by Formula 2A or Formula 2B below.

In the organic light-emitting device 10 of FIG. 1, the emission layer includes an organometallic compound represented by Formula 1.

<Formula 1> M(L1)ₙ₁(L2)ₙ₂

In Formula 1, M may be selected from iridium (Ir), platinum (Pt), osmium (Os), titanium (Ti), zirconium (Zr), hafnium (Hf), europium (Eu), terbium (Tb), thulium (Tm), and rhodium (Rd). For example, M may be selected from Os, Ir, and Pt, and in some embodiments, may be Ir.

In Formula 1, L1 may be a ligand represented by Formula 1A;
L2 may be a ligand represented by Formula 1B, wherein L1 and L2 differ from each other;
n1, which indicates the number of L1s, may be 1 or 2, wherein the two L1s when n1 is 2 may be the same or differ from each other; and
n2, which indicates the number of L2s, may be 1 or 2, wherein the two L2s when n2 is 2 may be the same or differ from each other,
wherein n1+n2=2 or n1+n2=3. For example, n1+n2=3.

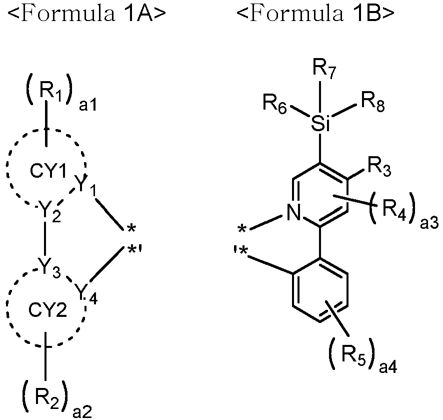

In Formula 1A, CY1 and CY2 may be each independently selected from a C₅-C₆₀ cyclic group and a C₂-C₆₀ heterocyclic group. CY1 and CY2 may be bound to each other via a single bond. Optionally, CY1 and CY2 may be bound to each other via a linking group.

In Formula 1A, Y₁ to Y₄ may be each independently carbon (C) or nitrogen (N). For example, Y₁ may be N, and Y₂ to Y₄ may be C. However, embodiments are not limited thereto. Y₁ and Y₂ may be bound to each other via a single bond or double bond, and Y₃ and Y₄ may be bound to each other via a single bond or double bond.

For example, CY1 and CY2 may be each independently selected from a benzene, a naphthalene, a fluorene, a spiro-fluorene, an indole, an indene, a furan, a thiophene, a carbazole, a benzofuran, a benzothiophene, a dibenzofuran, a dibenzothiophene, a pyrrole, an imidazole, a pyrazole, a thiazole, an isothiazole, an oxazole, an isoxazole, a triazole, a pyridine, a pyrimidine, a pyrazine, a pyridazine, a quinoline, a triazine, an isoquinoline, a benzoquinoline, a quinoxaline, a quinazoline, a naphthyridine, a benzimidazole, a benzoxazole, an isobenzoxazole, and an oxadiazole, but are not limited thereto.

For example, CY1 may be selected from a pyrrole, an imidazole, a triazole, an oxadiazole, a pyridine, a pyrimidine, a pyrazine, a quinoline, an isoquinoline, and a triazine.

For example, CY2 may be selected from a benzene, a naphthalene, a furan, a thiophene, a pyridine, a pyrimidine, a pyrazine, a triazine, a fluorene, a carbazole, an indole, an oxadiazole, a benzofuran, a benzothiophene, a dibenzofuran, and a dibenzothiophene.

In some embodiments, CY1 may be selected from a pyridine, an isoquinoline, an imidazole, and a triazole, and CY2 may be selected from a benzene, a furan, a thiophene, a pyridine, a pyrimidine, a pyrazine, a carbazole, an indole, an oxadiazole, a benzofuran, a benzothiophene, a dibenzofuran, and a dibenzothiophene. However, embodiments are not limited thereto.

In some embodiments, CY1 may be selected from a pyridine, a pyrimidine, a triazine, a quinoline, an isoquinoline, an oxadiazole, a triazole, and an imidazole, and CY2 may be selected from a benzene, a pyridine, a pyrimidine, a dibenzofuran, a dibenzothiophene, a thiophene, a benzothiophene, a furan, a benzofuran, an indole, and a carbazole.

In Formula 1A and Formula 1B,
R₁ to R₅ may be each independently selected from a hydrogen atom, a deuterium atom, -F, -CI, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), and -B(Q₆)(Q₇), provided that R₃ is hydrogen.

For example, R₁ to R₅ in Formula 1A and Formula 1B may be each independently selected from a hydrogen atom, provided that R₃ is hydrogen, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, and a phenoxy group,
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, and a pentoxy group, each substituted with at least one of a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, and a phenoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group.

In Formula 1B, R₆ to R₈ may be each independently selected from a C₁-C₁₀ alkyl group, and
a C₁-C₁₀ alkyl group substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof and a phosphoric acid group or a salt thereof.

For example, in Formula 1B R₆ to R₈ may be each independently selected from a methyl group, an ethyl group, an n-propyl group, an iso-propyl group, an n-butyl group, an iso-butyl group, a sec-butyl group, and a tert-butyl group. For example, R₆ to R₈ may be the same.

At least one substituent of the substituted C₁-C₆₀ alkyl group, substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₆-C₆₀ arylene group, the substituted C₁-C₆₀ heteroarylene group, the substituted monovalent non-aromatic condensed polycyclic group, and the substituted monovalent non-aromatic condensed heteropolycyclic group may be selected from a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), and -B(Q₁₆)(Q₁₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇), and -N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇, and Q₃₁ to Q₃₇ may be each independently selected from a hydrogen, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group. In Formulae 1A and 1B, a₁ and a₂ may be each independently an integer selected from 0 to 5;
a₃ may be an integer selected from 0 to 2; and
a₄ may be an integer selected from 0 to 4.

In Formulae 1A and 1B, a₁, a₂, a₃, and a₄ indicate the number of R₁s, R₂s, R₄s and R₅s, respectively.

Optionally, a plurality of R₅s when a₄ is 2 or greater may be condensed to a benzene ring to which the R₅s are bound, thereby to form a condensed ring. For example, a plurality of R₅s may be condensed to a benzene ring to which the R₅s are bound, thereby to form a naphthalene ring).

For example, when at least one of a₁ to a₄ is 2 or greater, the two or more R₁s, R₂s, R₄s, and/or R₅s may be the same or differ from each other. For example, when a₁ is 2, the two R₁s may be the same or differ from each other. For example, when a₃ is 2, the two R₄s may be the same or differ from each other.

In Formula 1A and) Formula 1B, * and *' may be binding sites to M in Formula 1.

For example, the organometallic compound represented by Formula 1 may be selected from compound PD-1 to compound PD-193, except compound PD-80, but is not limited thereto:

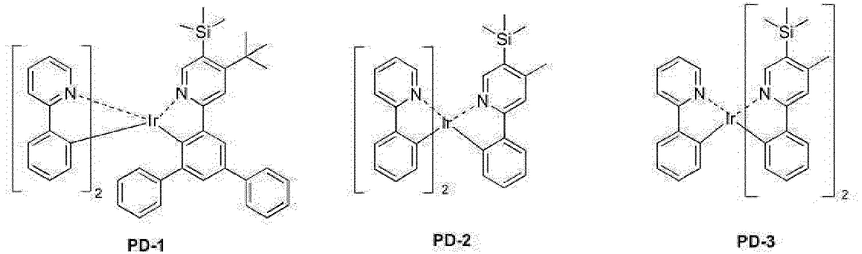

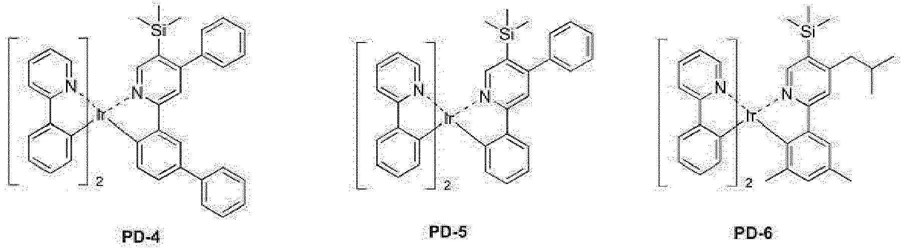

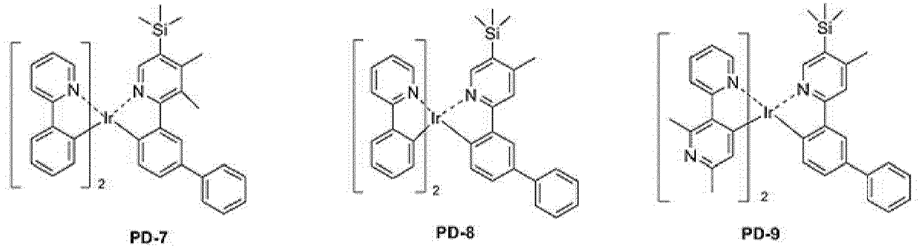

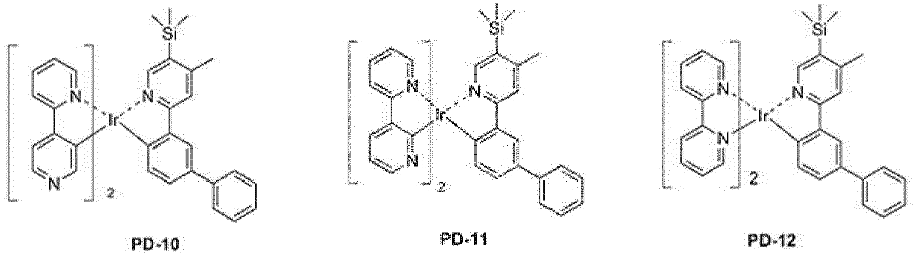

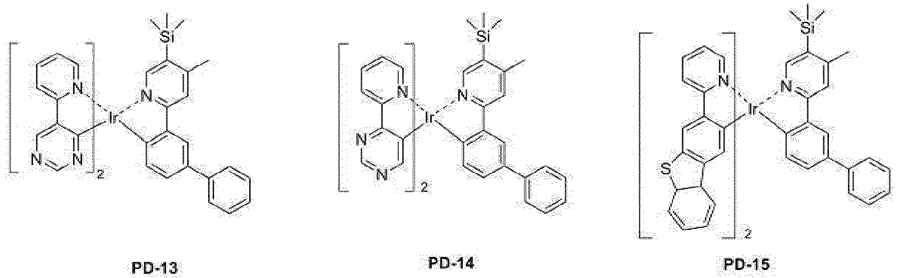

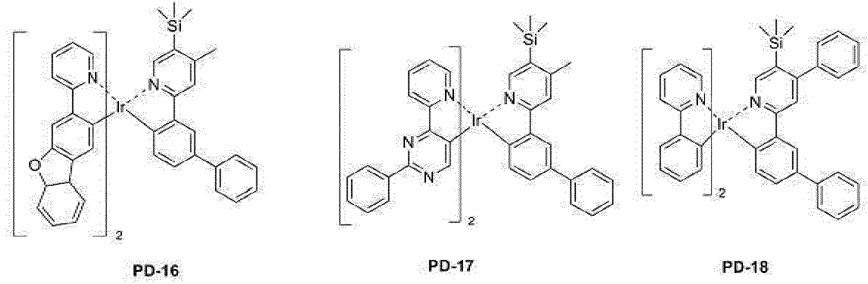

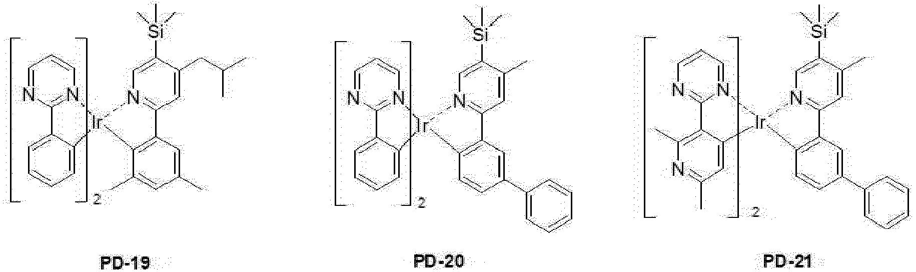

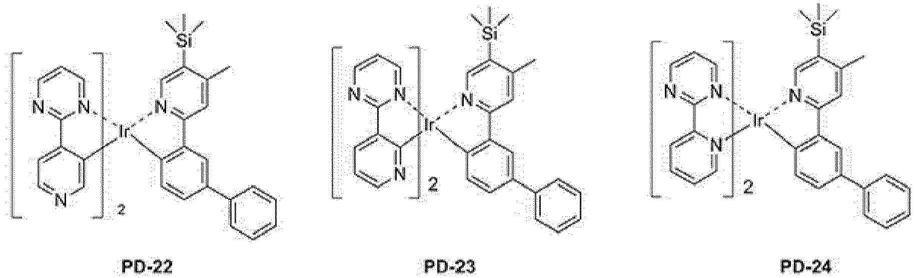

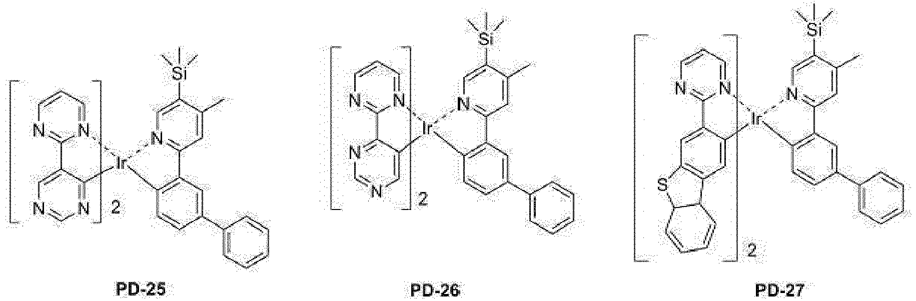

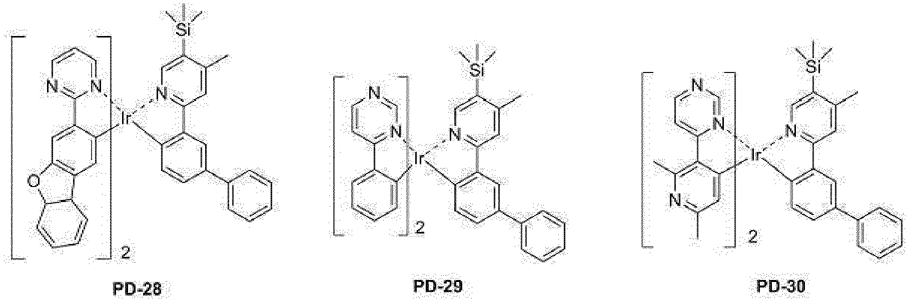

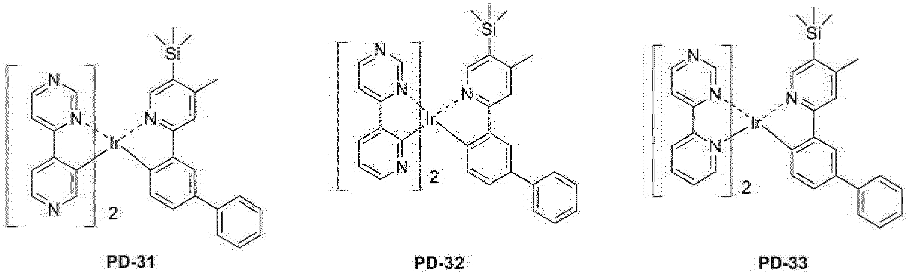

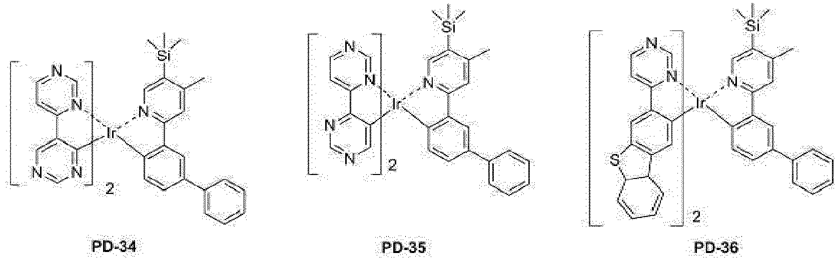

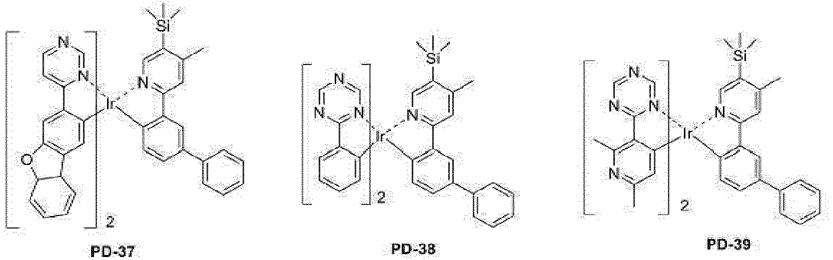

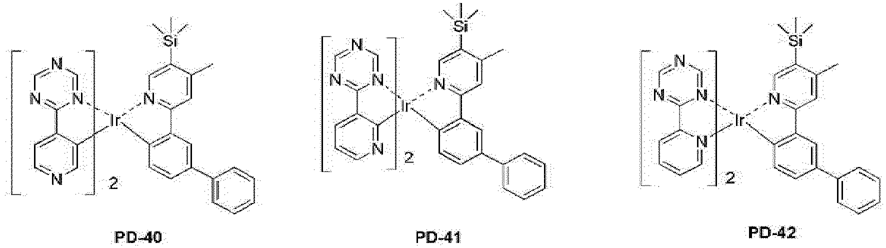

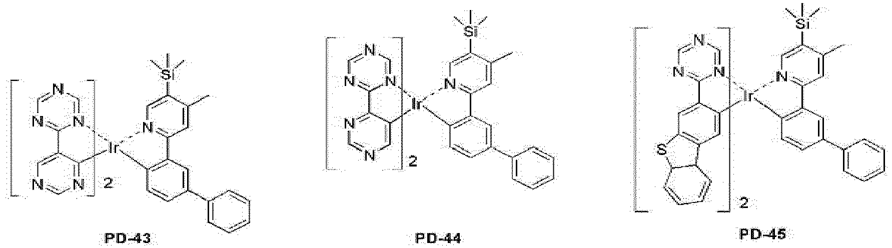

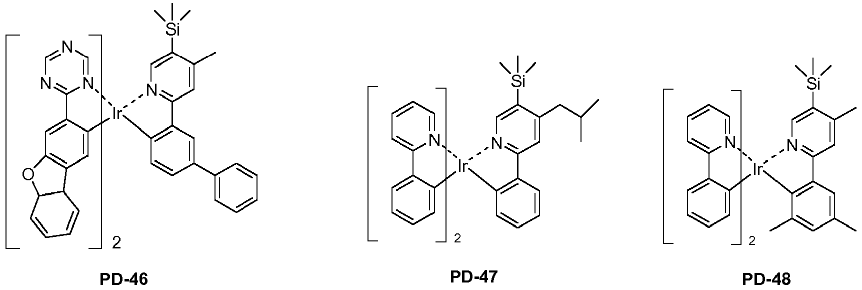

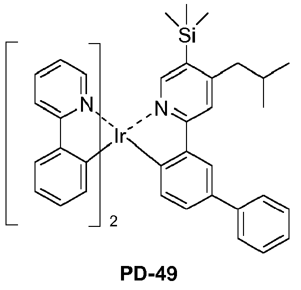

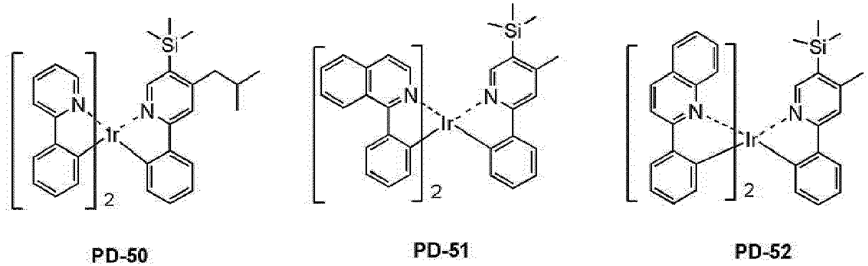

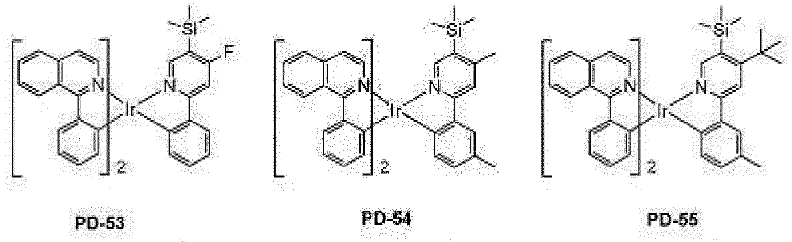

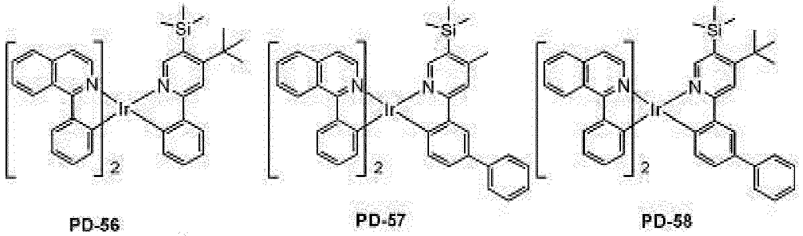

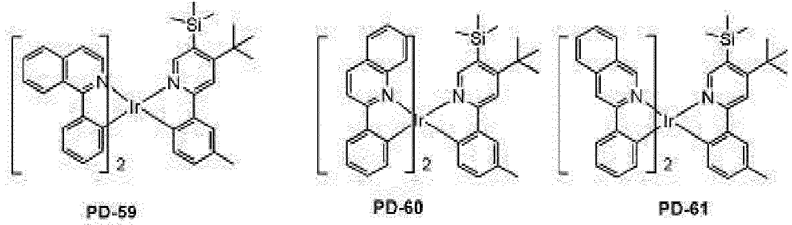

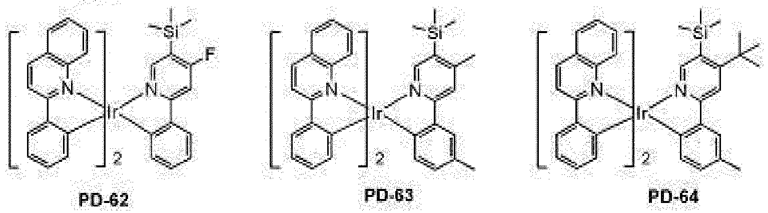

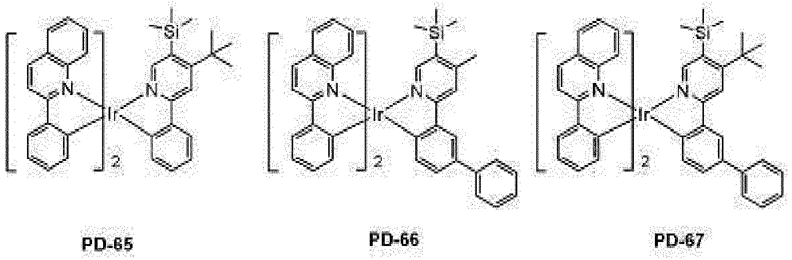

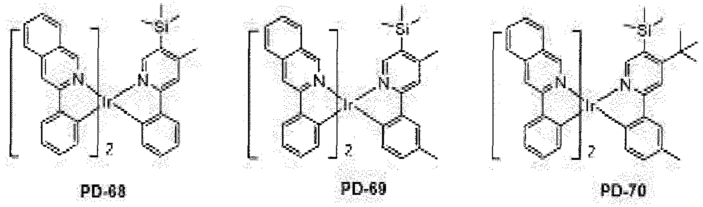

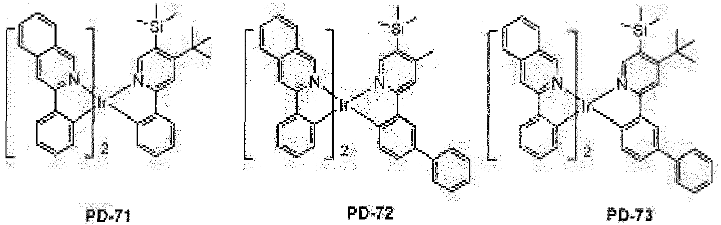

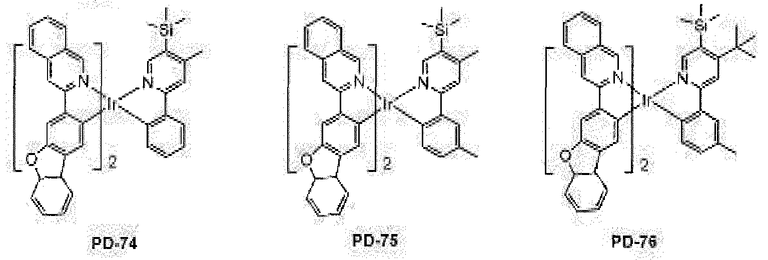

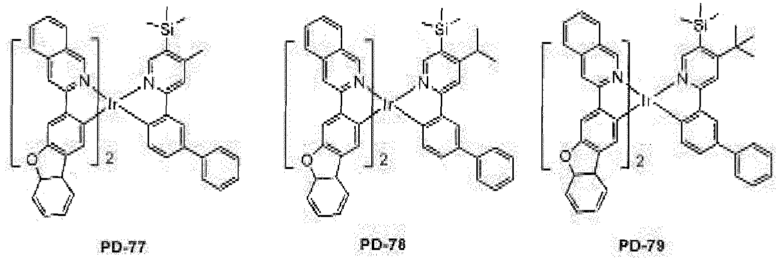

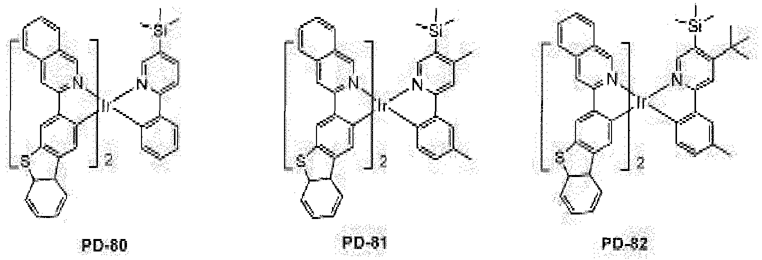

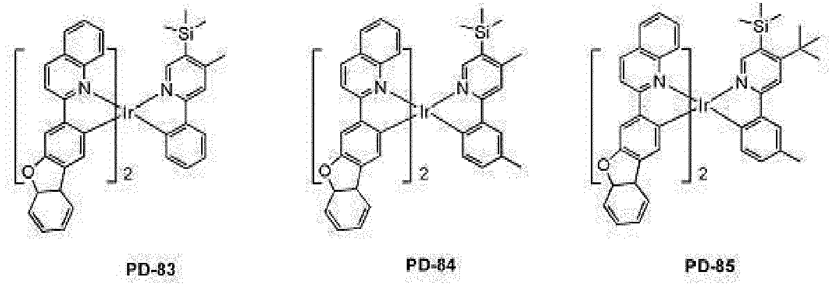

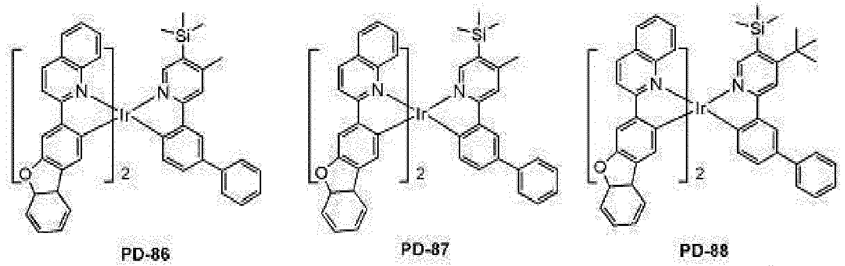

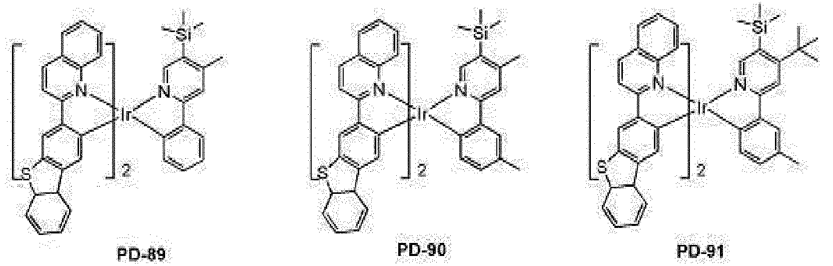

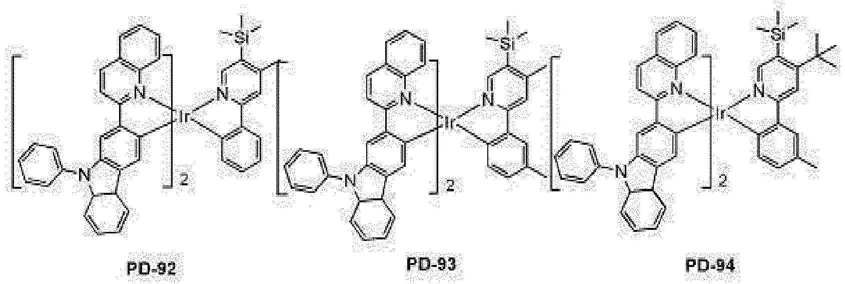

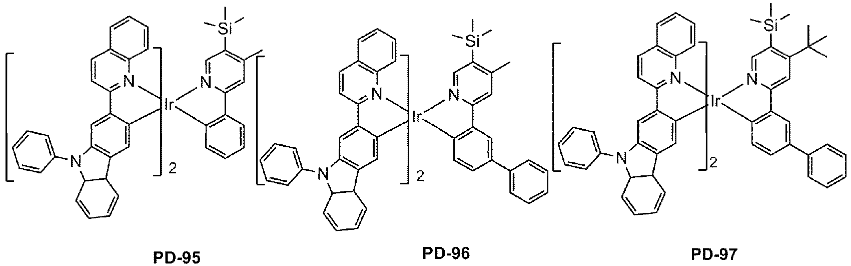

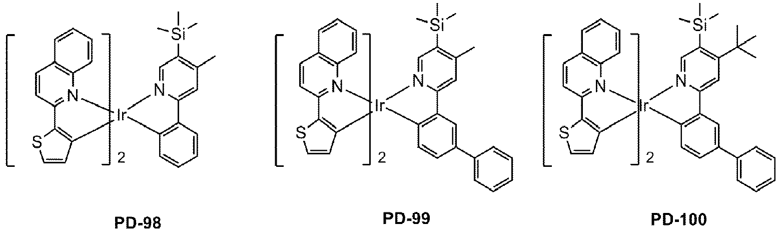

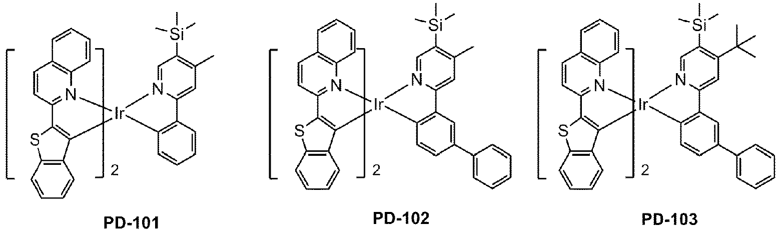

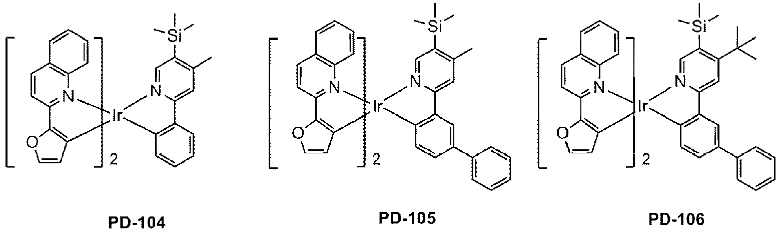

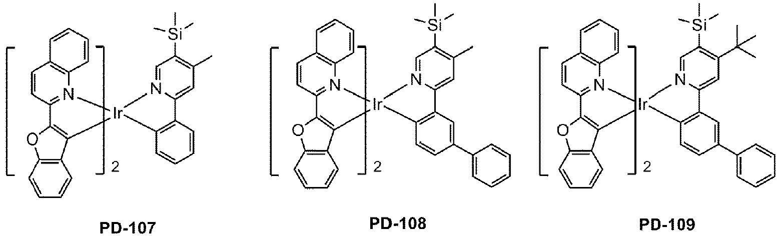

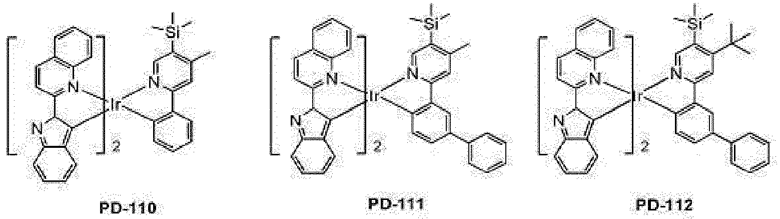

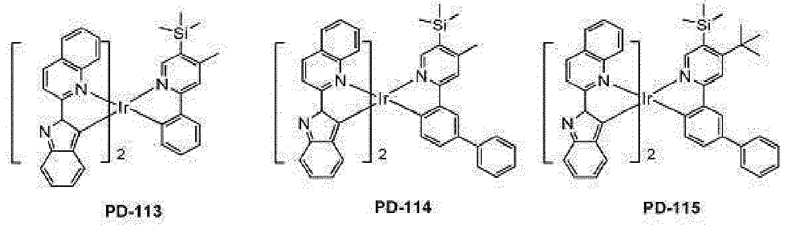

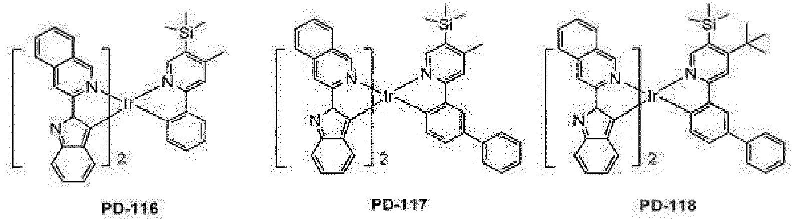

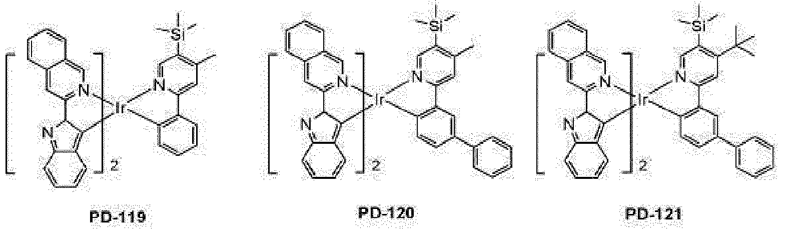

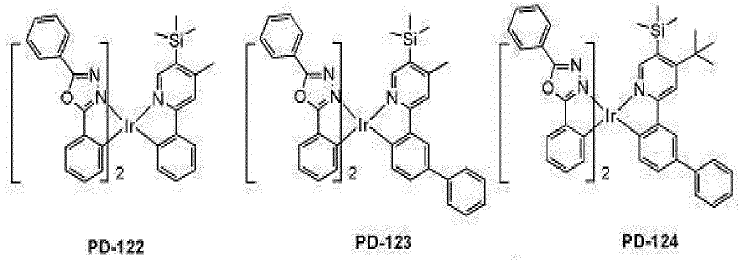

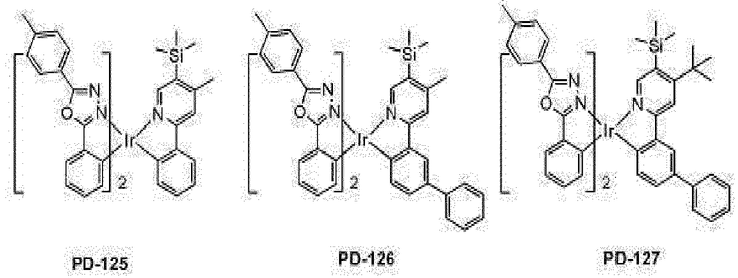

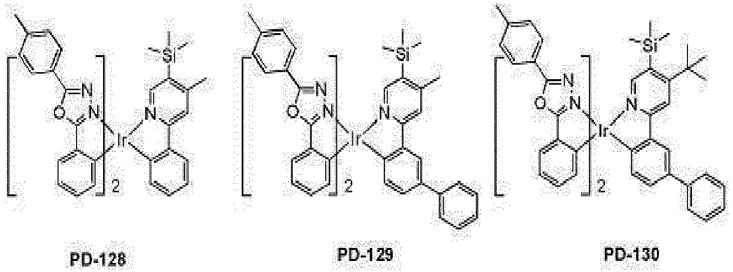

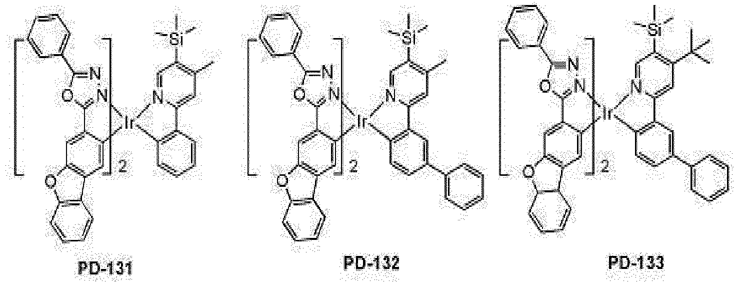

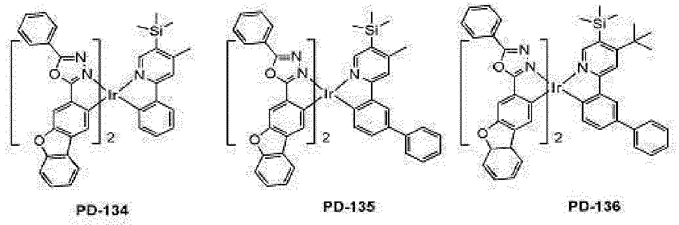

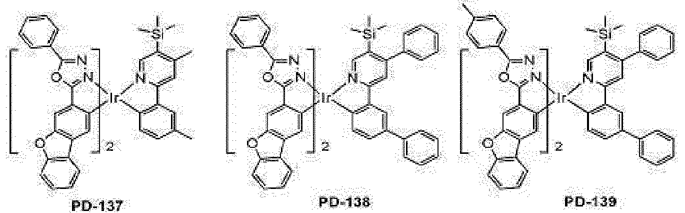

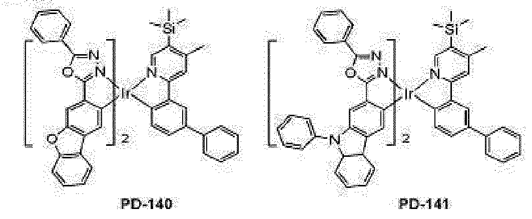

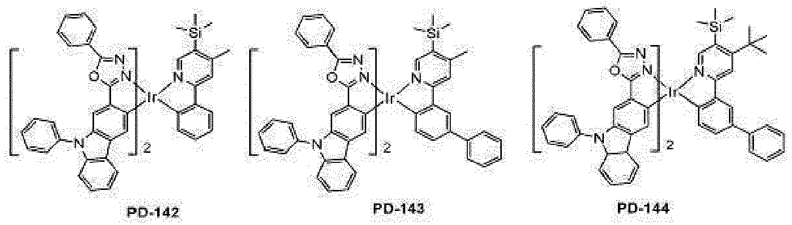

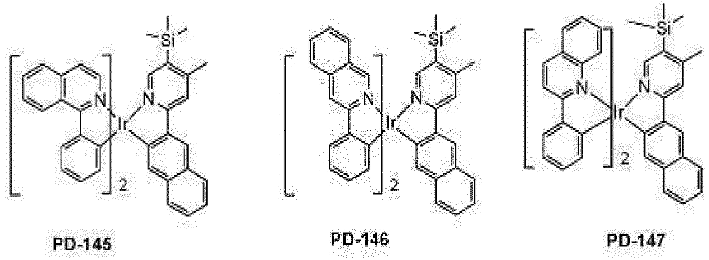

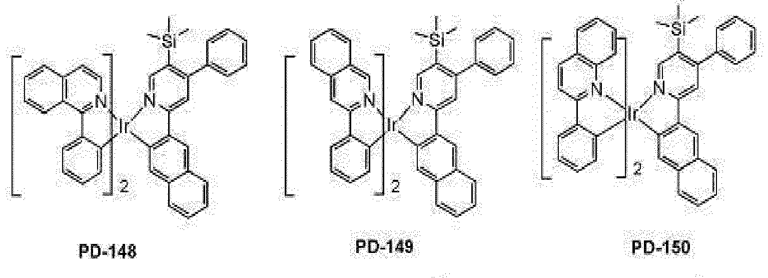

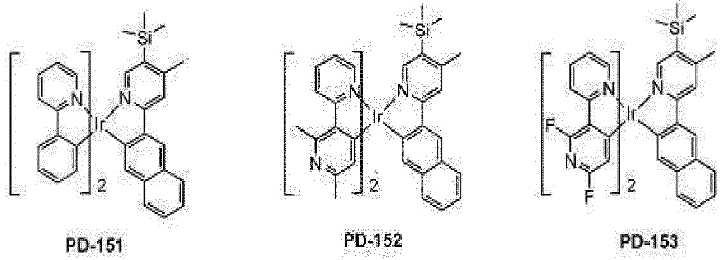

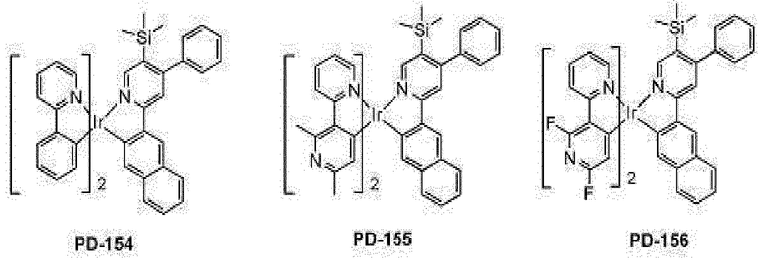

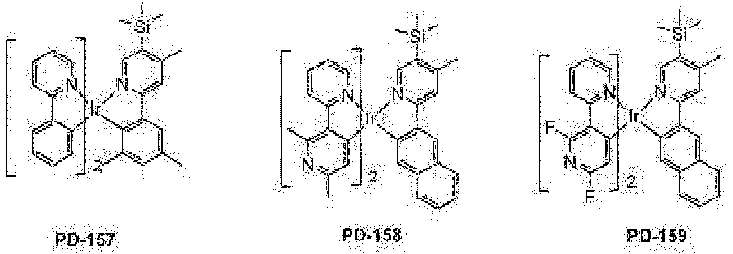

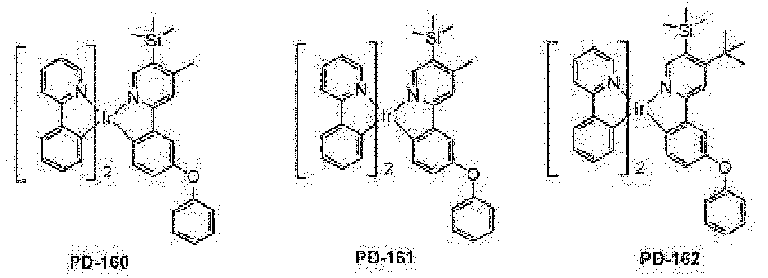

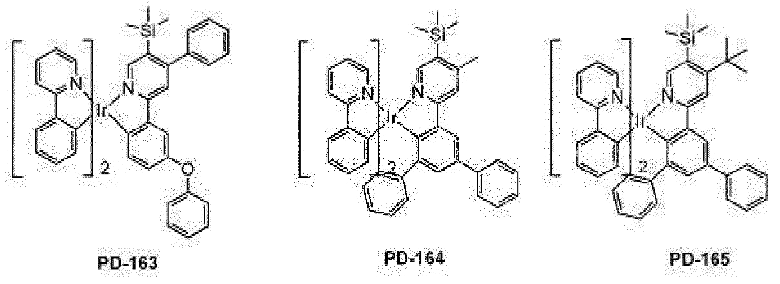

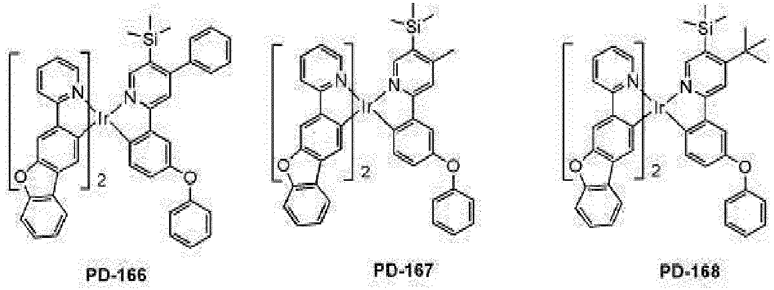

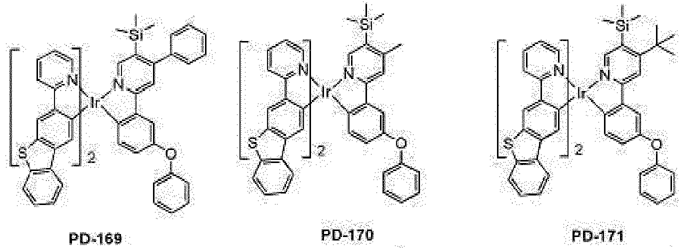

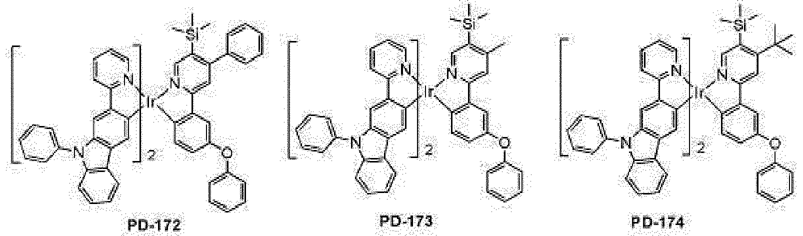

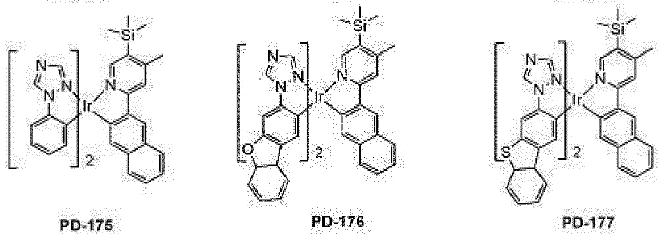

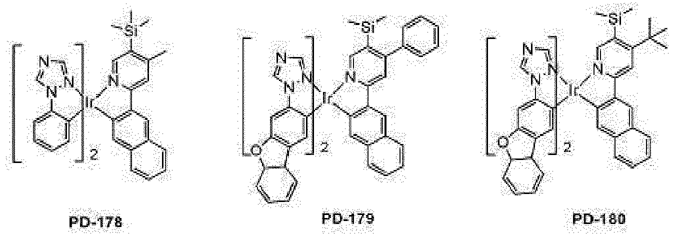

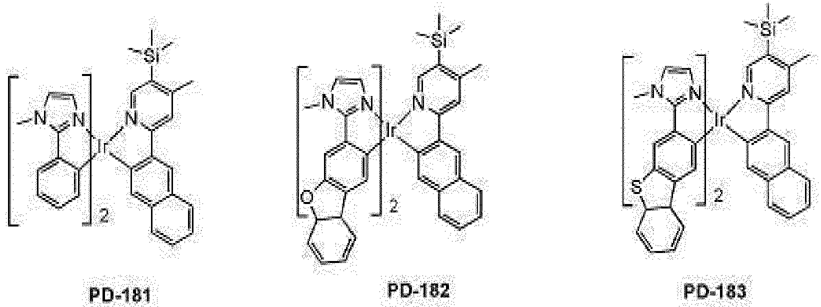

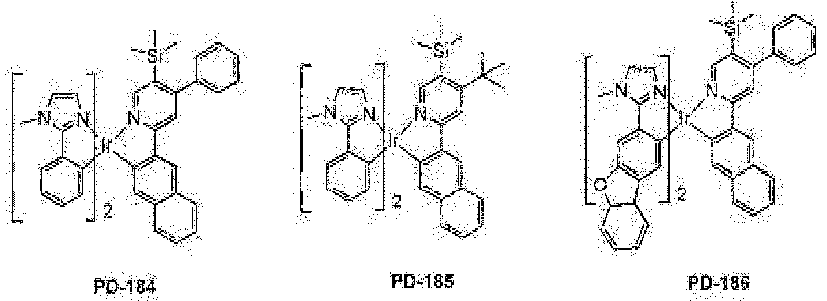

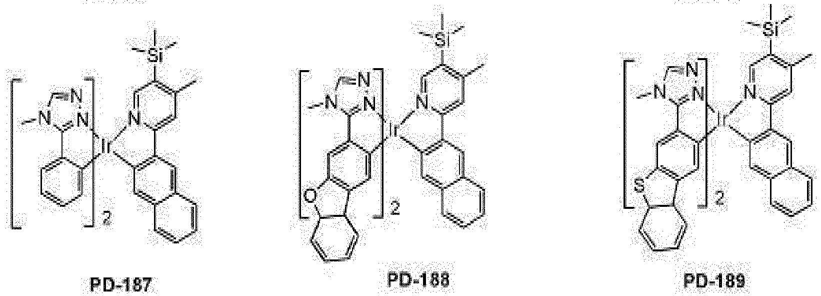

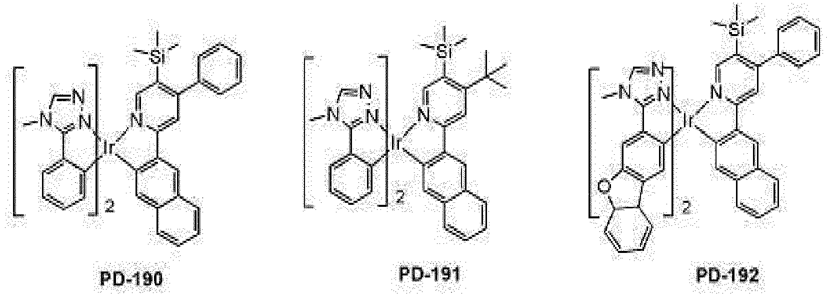

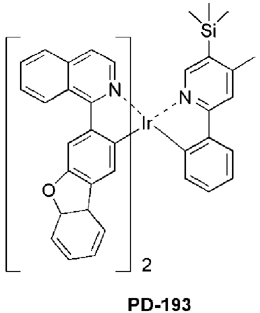

The emission layer may include a dopant and a host. For example, the emission layer may include an organometallic compound of Formula 1 as a dopant. The organometallic compound of Formula 1 may emit green or red light. The emission layer may be a green emission layer or a red emission layer.

Non-limiting examples of the host are CBP (4,4'-N,N'-dicarbazole-biphenyl), CDBP (4,4'-bis(9-carbazolyl)-2,2'-dimethylbiphenyl), mCP (*N,N*'-dicarbazolyl-3,5-benzene), TCP (1,3,5-tris(carbazol-9-yl)benzene), TCTA (tris(4-carbazolyl-9-ylphenyl)amine, tris(4-carbazoyl-9-ylphenyl)amine), and PVK (poly(n-vinyl carbazole)).

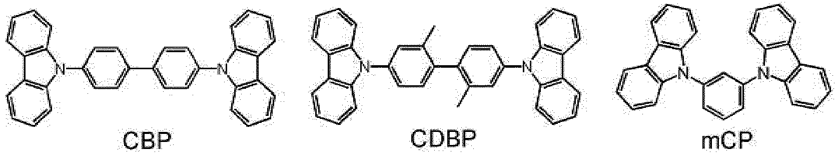

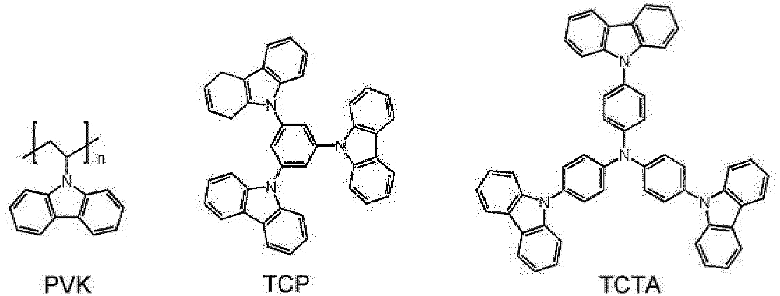

In some embodiments, the host may include a compound represented by one of Formula 301 to Formula 303.

<Formula 301> (R₃₀₃)ₘₐ₃-Ar₃₀₁-[-(L₃₀₁)_{Ia1}-(R₃₀₁)ₘₐ₁]ₙₐ₁

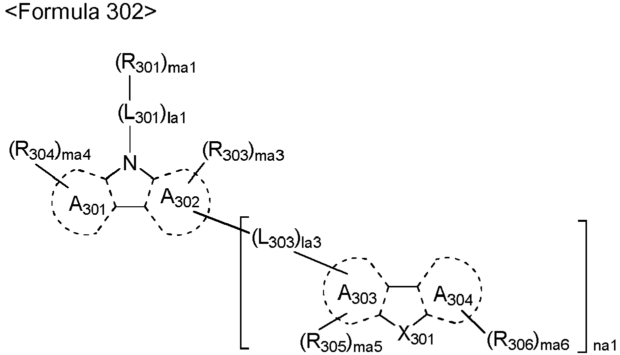

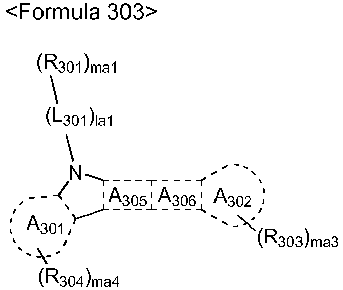

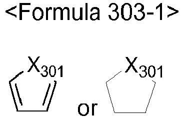

In Formulae 301 to 303, and Formula 303-1,
Ar₃₀₁ may be selected from
a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentaphene and an indenoanthracene,
a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentaphene and an indenoanthracene, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, and -Si(Q₃₀₁)(Q₃₀₂)(Q₃₀₃), wherein Q₃₀₁ to Q₃₀₃ may be each independently selected from a hydrogen atom, a C₁-C₆₀ alkyl group, a C₂-C₆₀ alkenyl group, a C₆-C₆₀ aryl group, and a C₁-C₆₀ heteroaryl group;
A₃₀₁ to A₃₀₄ may be each independently a benzene, a naphthalene, a pyridine, a pyrimidine, a pyrazine, a quinoline, an isoquinoline, a 2,6-naphthyridine, a 1,8-naphthyridine, a 1,5-naphthyridine, a 1,6-naphthyridine, a 1,7-naphthyridine, a 2,7-naphthyridine, a quinoxaline, a phthalazine, and a quinazoline;
A₃₀₅ may be selected from a benzene and a naphthalene;
A₃₀₆ may be represented by Formula 303-1;
X₃₀₁ may be selected from N-[(L₃₀₂)_{Ia2}-(R₃₀₂)ₘₐ₂], an oxygen atom (O), a sulfur atom (S), C(R₃₀₇)(R₃₀₈), Si(R₃₀₇)(R₃₀₈), B(R₃₀₇), P(R₃₀₇), and P(=O)(R₃₀₇);
L₃₀₁ to L₃₀₃ may be each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group.;
R₃₀₁ and R₃₀₂ may be each independently selected from
a C₁-C₂₀ alkyl group and a C₁-C₂₀ alkoxy group,
a C₁-C₂₀ alkyl group and a C₁-C₂₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group,
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazole group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group;
R₃₀₃ to R₃₀₈ may be each independently defined as Q₂₀₁ defined herein;
Ia1 to Ia3 may be each independently 0, 1, 2, and 3;
ma1 to ma6 may be each independently selected from 1, 2, 3, 4, 5, and 6; and
na1 may be selected from 1, 2, 3, and 4.

In some embodiments, in Formula 301,
L₃₀₁ to L₃₀₃ may be each independently selected from
a phenylene group, a naphthylene group, a fluorenylene group, a spiro-fluorenylene group, a benzofluorenylene group, a dibenzofluorenylene group, a phenanthrenylene group, an anthrylene group, a pyrenylene group, and a chrysenylene group, and
a phenylene group, a naphthylene group, a fluorenylene group, a spiro-fluorenylene group, a benzofluorenylene group, a dibenzofluorenylene group, a phenanthrenylene group, anthrylene group, a pyrenylene group, and a chrysenylene group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, and a chrysenyl group;
R₃₀₁ and R₃₀₂ may be each independently selected from
a C₁-C₂₀ alkyl group and a C₁-C₂₀ alkoxy group,
a C₁-C₂₀ alkyl group and a C₁-C₂₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a spiro-fluorenyl group, a benzofluorenyl group, a dibenzofluorenyl group, a phenanthrenyl group, an anthryl group, a pyrenyl group, and a chrysenyl group,
a phenyl group, a naphthyl group, a fluorenyl group, a spiro-fluorenyl group, a benzofluorenyl group, a dibenzofluorenyl group, a phenanthrenyl group, an anthryl group, a pyrenyl group, and a chrysenyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, and a chrysenyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, and a chrysenyl group. However, embodiments are not limited thereto.

For example, the host may include a compound represented by one of Formulae 301B, 301C, 302A, 303A, 303B, 303C, 303D, 303E, 303F, 303G, 303H, 3031, and 303J:

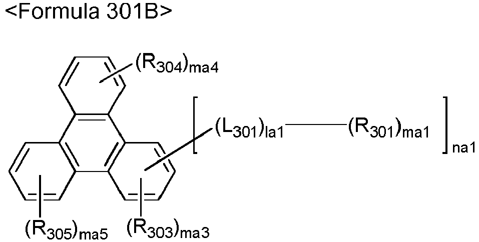

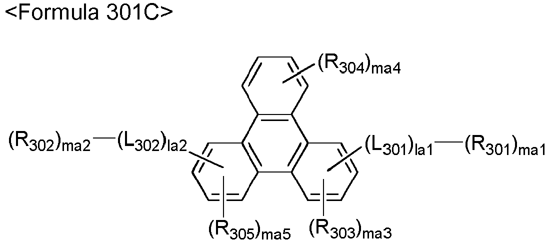

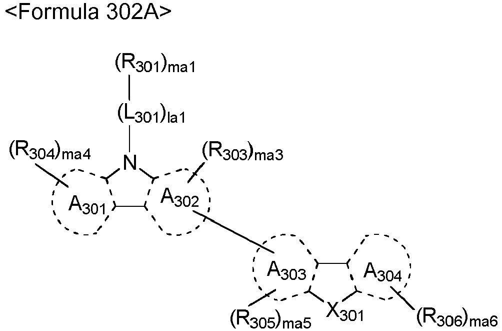

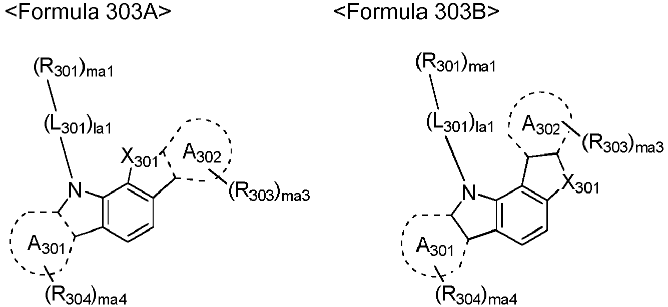

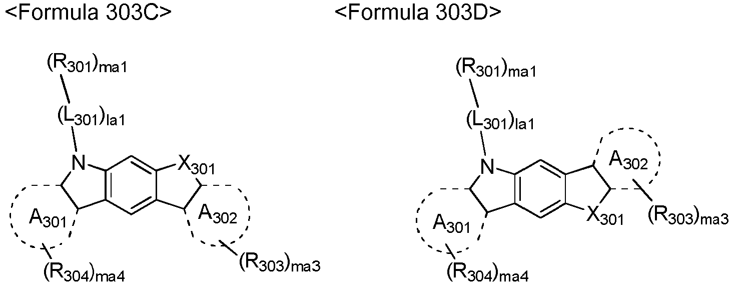

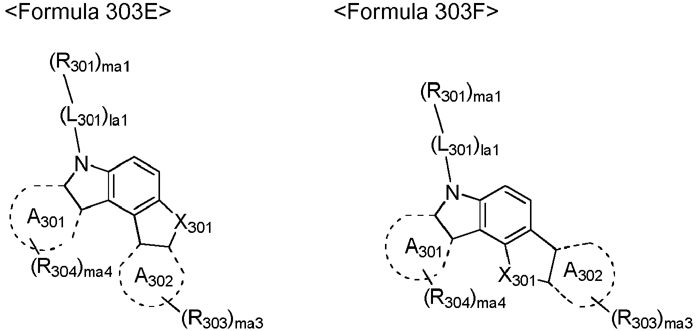

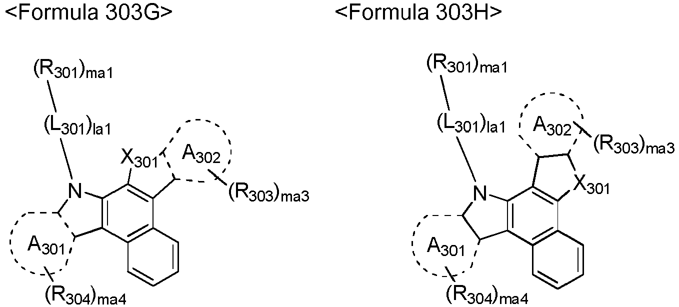

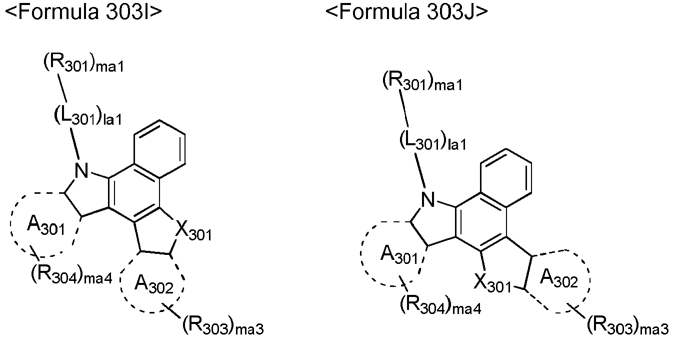

Substituents in Formulae 301B, 301C, 302A, 303A, 303B, 303C, 303D, 303E, 303F, 303G, 303H, 303I, and 303J may be defined as those defined herein.

The compound represented by one of Formulae 301 to 303 may be selected from Compounds H43 to H129, but is not limited thereto:

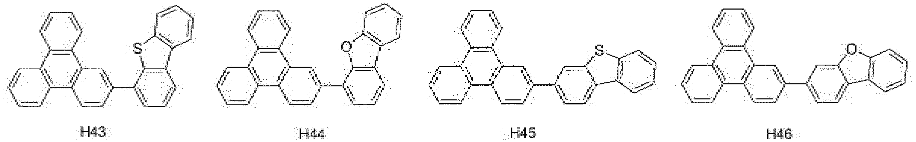

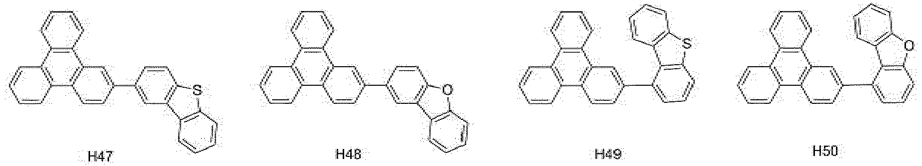

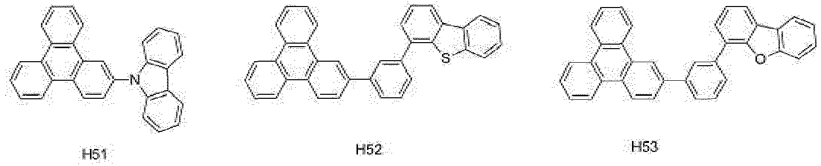

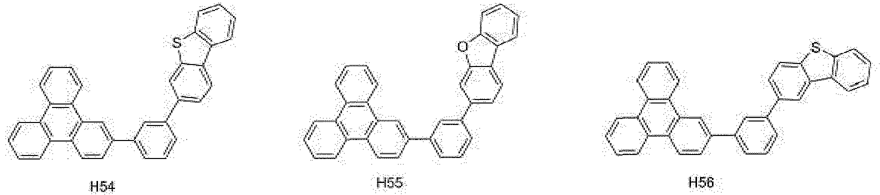

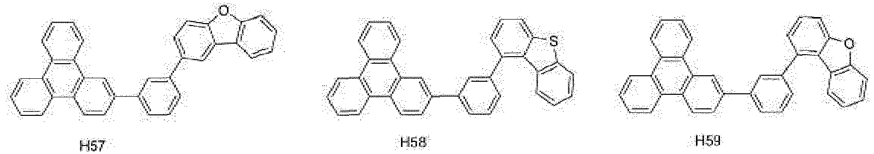

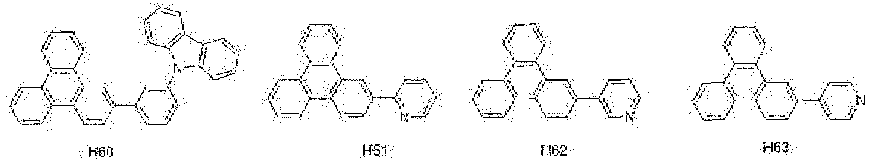

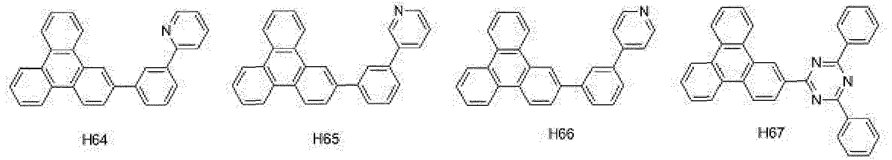

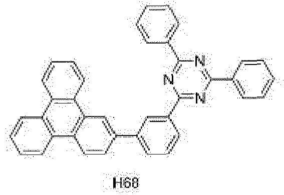

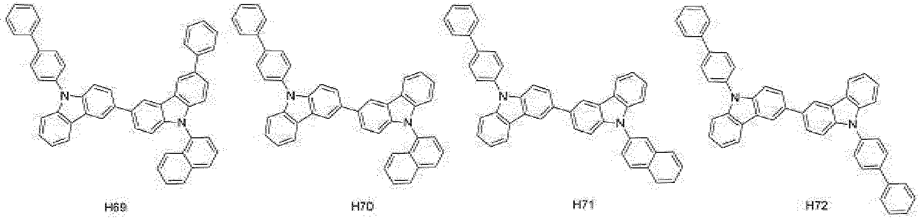

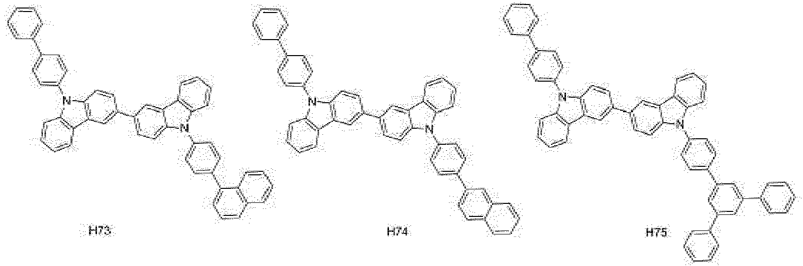

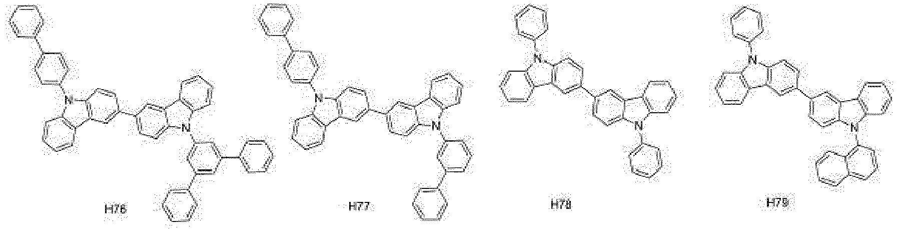

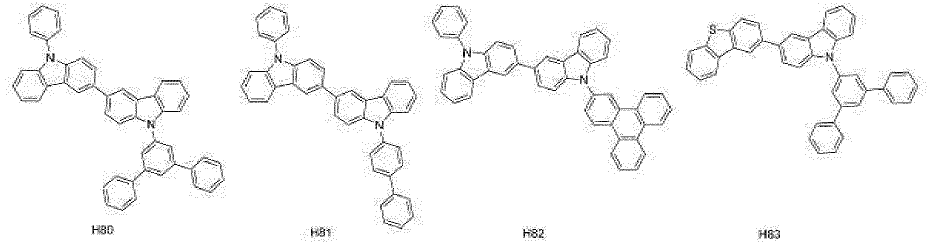

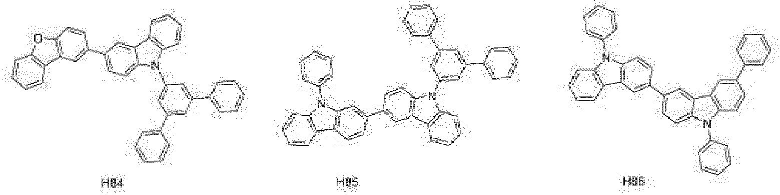

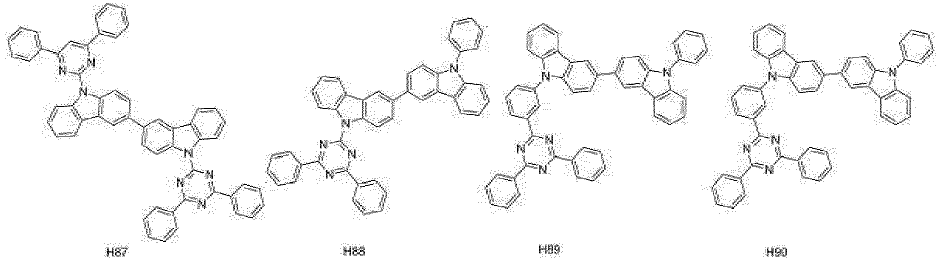

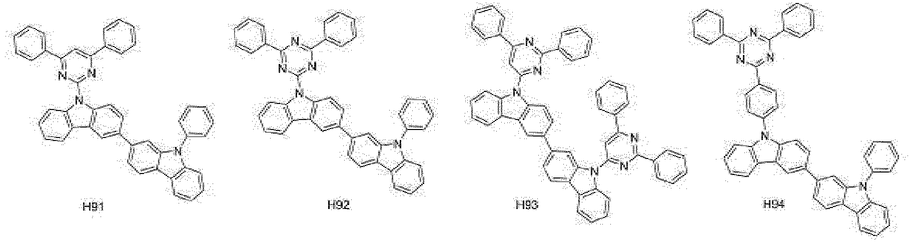

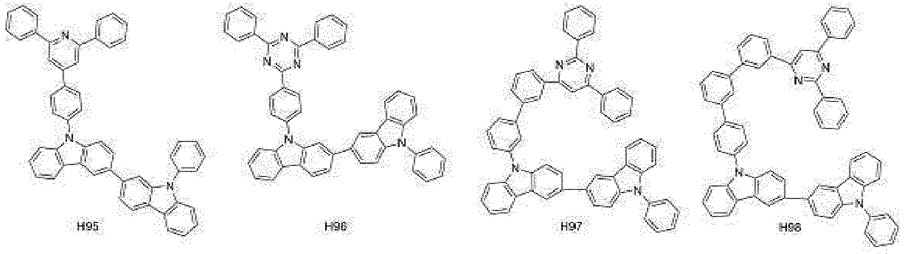

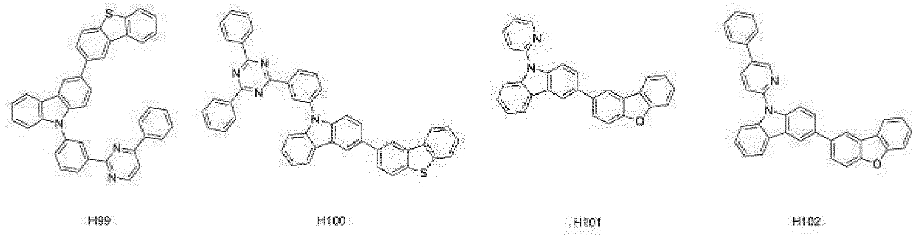

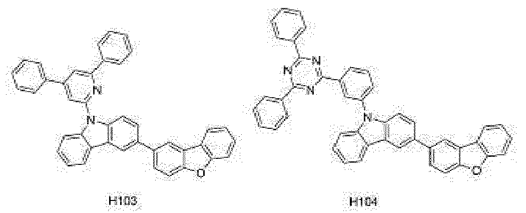

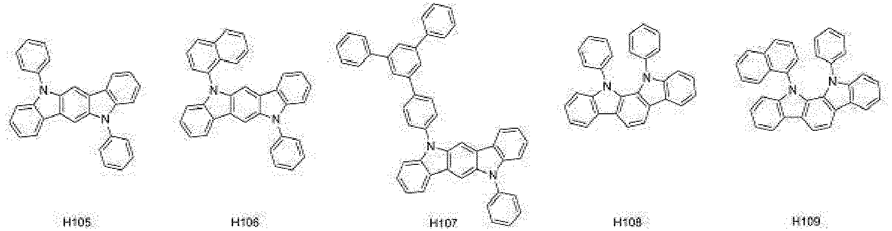

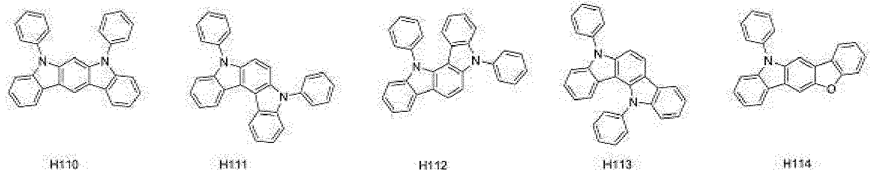

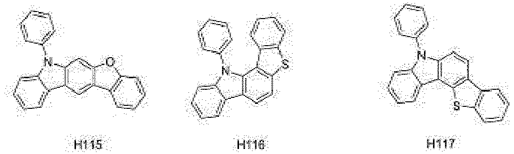

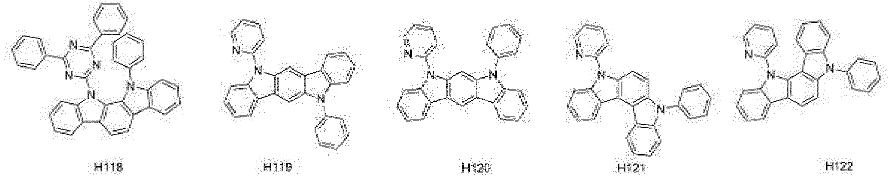

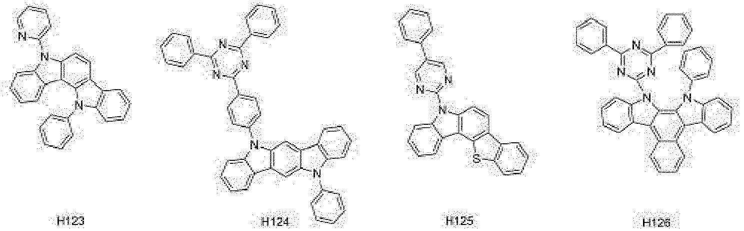

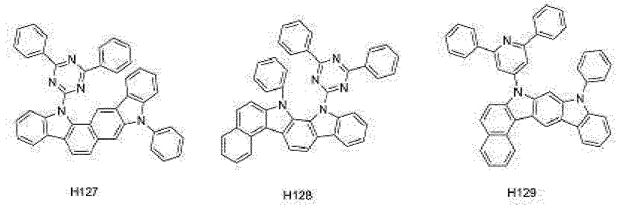

The amount of the dopant in the emission layer may be from about 0.01 parts to about 15 parts by weight based on 100 parts by weight of the host, but is not limited to this range.

The thickness of the emission layer may be from about 100 Å to about 1000 Å, and in some embodiments, may be from about 200 Å to about 600 Å. When the thickness of the emission layer is within these ranges, the organic light-emitting device 10 may have good light emission characteristics without a substantial increase in driving voltage.

When the organic light-emitting device 10 is a full color organic light-emitting device, the EML 150 may be patterned into a red emission layer, a green emission layer, and a blue emission layer. In some embodiments, the emission layer may have a structure in which a red emission layer, a green emission layer and/or a blue emission layer are stacked upon one another, thus to emit white light. However, embodiments are not limited thereto.

In the organic light-emitting device 10 of FIG. 1, the hole transport region includes a first compound represented by Formula 2A or Formula 2B.

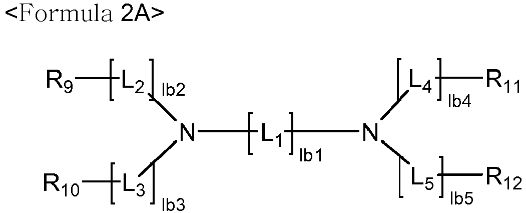

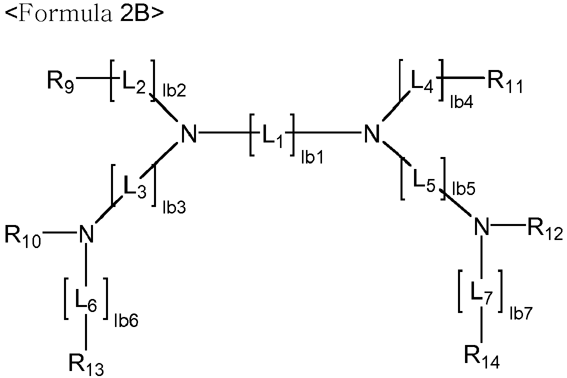

In Formula 2A and Formula 2B,
L₁ to L₇ may be each independently selected from a substituted or unsubstituted C₁-C₂₀ alkylene group, -O-, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group; and
R₉ to R₁₄ may be each independently selected from a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), and -B(Q₆)(Q₇),
wherein at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₁-C₂₀ alkylene group, the substituted C₆-C₆₀ arylene group, the substituted C₁-C₆₀ heteroarylene group, the substituted monovalent and divalent non-aromatic condensed polycyclic group, and the substituted monovalent and divalent non-aromatic condensed heteropolycyclic group, and Q₁ to Q₇, Q₁₁ to Q₁₇, Q₂₁ to Q₂₇, and Q₃₁ to Q₃₇ may be defined as those defined above in conjunction with R₁ to R₅ n Formulae 1A and 1B).

In Formulae 2A and 2B, lb₁ to lb₇ indicate the number of L₁s to L₇s, respectively.
lb₁ may be an integer selected from 1 to 5;
lb₂ to lb₇ may be each independently an integer selected from 0 to 4, wherein when at least one of lb₁ to lb₇ is 2 or greater, the two or more L₁s, L₂s, L₃s, L₄s, L₅s, L₆s, and/or L₇s may be the same or differ. For example, when lb₁ is 3, the three L₁s bound to each other may be the same or differ.

In some embodiments, in Formula 2A and Formula 2B,
L₁ to L₇ may be each independently selected from
-O-, a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, a perylenylene group, a pyrrolylene group, a thienylene group, a furylene group, an imidazolylene group, a pyrazolylene group, a thiazolylene group, an isothiazolylene group, an oxazolylene group, an isoxazolylene group, a pyridylene group, a pyrazinylene group, a pyrimidinylene group, a pyridazinylene group, an isoindolylene group, an indolylene group, an indazolylene group, a purinylene group, a quinolylene group, an isoquinolylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, a benzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, a dibenzocarbazolylene group, a thiadiazolylene group, an imidazopyridylene group, and an imidazopyrimidinylene group, and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, a perylenylene group, a pyrrolylene group, a thienylene group, a furylene group, an imidazolylene group, a pyrazolylene group, a thiazolylene group, an isothiazolylene group, an oxazolylene group, an isoxazolylene group, a pyridylene group, a pyrazinylene group, a pyrimidinylene group, a pyridazinylene group, an isoindolylene group, an indolylene group, an indazolylene group, a purinylene group, a quinolylene group, an isoquinolylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, a benzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, a dibenzocarbazolylene group, a thiadiazolylene group, an imidazopyridylene group, and an imidazopyrimidinylene group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group.

For example, L₁ to L₇ may be each independently selected from -O-, a methylene group, and groups represented by Formula 3A to Formula 3E.

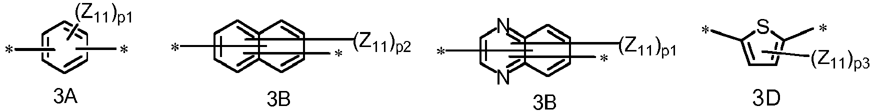

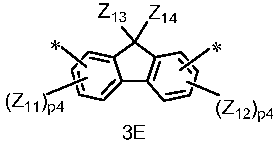

In Formulae 3A to 3E,
Z₁₁ to Z₁₄ may be each independently selected from
a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₃₁)(Q₃₂), and -Si(Q₃₃)(Q₃₄)(Q₃₅), and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenoxy group, a phenylmethyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₂₁)(Q₂₂) and -Si(Q₂₃)(Q₂₄)(Q₂₅),
wherein Q₃₁ to Q₃₅, and Q₂₁ to Q₂₅ may be each independently selected from
a hydrogen atom, a C₁-C₂₀alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, and
a phenyl group, a biphenyl group, a naphthyl group, an anthryl group, a pyrenyl group, a phenanthrenyl group, a triphenylenyl group, and a fluorenyl group, each substituted with at least one of a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group;
optionally, at least two of Q₂₃ to Q₂₅ may be bound to together to form a ring;
optionally, Z₁₃ and Z₁₄ in Formula 3E may be bound to each other to form a ring;
p1 may be an integer of 0 to 4;
p2 may be an integer of 0 to 6;
p3 may be an integer of 0 to 2;
p4 may be an integer of 0 to 3; and
* may be a binding site.

For example, L₁ to L₇ in Formulae 2A and 2B may be each independently selected from -O-, a methylene group, and groups represented by Formulae 4A to Formula 4J.

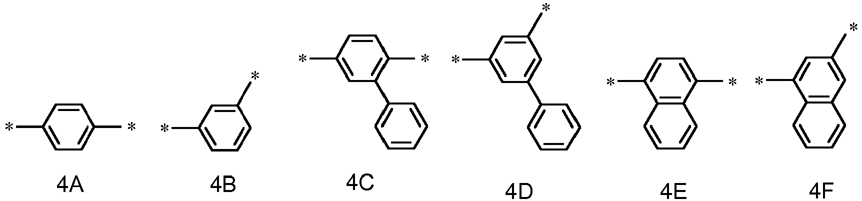

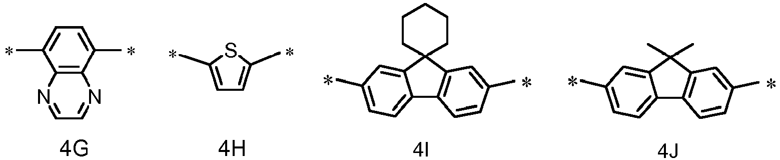

In Formulae 4A to 4J, * is a binding site.

For example, [L₁]_{lb1} in Formulae 2A and 2B may be a group represented by one of Formulae 5A to 5L.

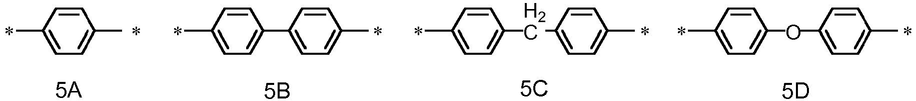

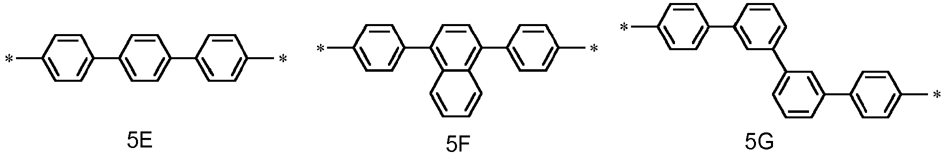

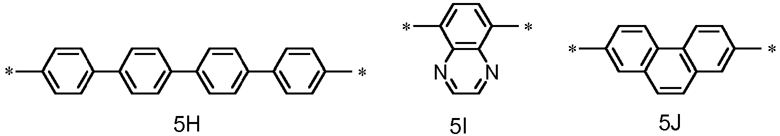

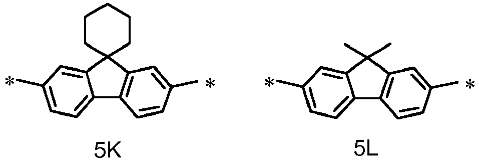

In Formulae 5A to 5L, * is a binding site.

In some embodiments, in Formulae 2A and Formula 2B, R₉ to R₁₄ may be each independently selected from
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, a phenylmethyl group, a triphenylmethyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a cyclohexyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₂₁)(Q₂₂), and -Si(Q₂₃)(Q₂₄)(Q₂₅),
wherein Q₂₁ to Q₂₅ are each independently selected from
a hydrogen atom, a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, and
a phenyl group, a biphenyl group, a naphthyl group, an anthryl group, a pyrenyl group, a phenanthrenyl group, a triphenylenyl group, and a fluorenyl group, each substituted with at least one of a C₁-C₂₀ alkyl group, a C₁-C₂₀ alkoxy group, a biphenyl group, a phenyl group, a naphthyl group, an anthryl group, a pyrenyl group, a phenanthrenyl group, a triphenylenyl group, and a fluorenyl group.

In some other embodiments, R₉ to R₁₄ may be each independently a group represented by one of Formula 6A to Formula 6G.

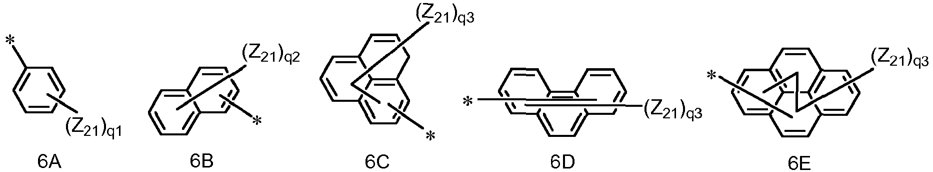

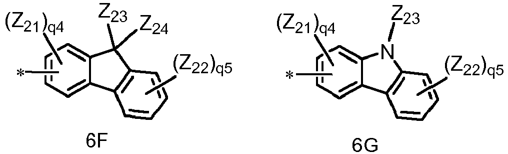

In Formulae 6A to 6G,
Z₂₁ to Z₂₄ may be defined as Z₁₁ to Z₁₄ defined herein;
q1 may be an integer of 0 to 5;
q2 may be an integer of 0 to 7;
q3 may be an integer of 0 to 9;
q4 may be an integer of 0 to 3;
q5 may be an integer of 0 to 4, and.
* is a binding site.

Optionally, at least two of Q₂₃ to Q₂₅ may be bound to each other to form a ring.

Optionally, Z₂₃ and Z₂₄ in Formula 6F may be bound to each other to form a ring.

For example, R₉ to R₁₄ may be each independently a group represented by one of Formula 7A to Formula 7AB.

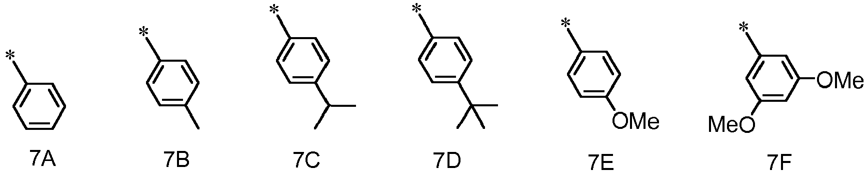

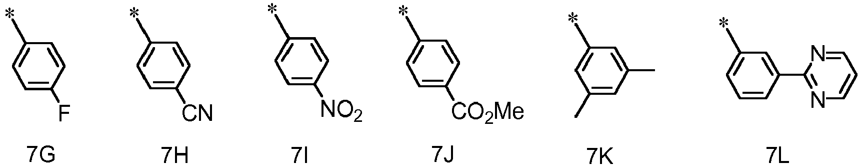

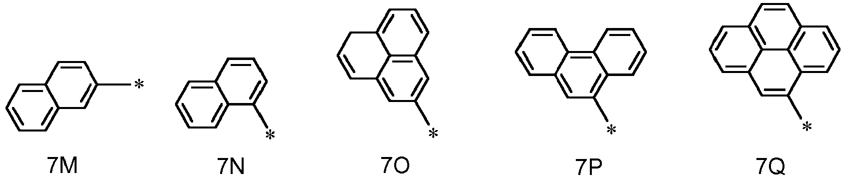

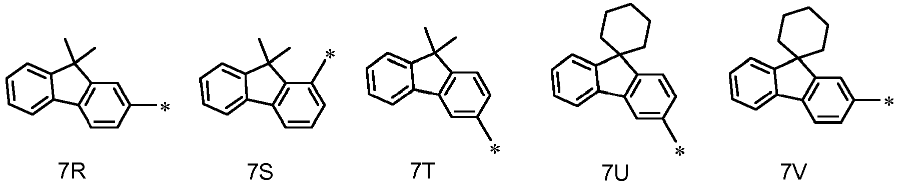

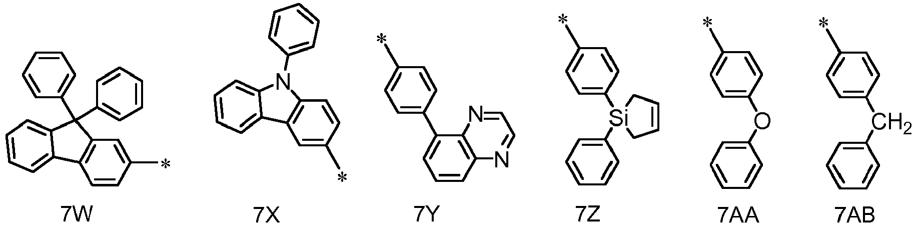

In Formulae 7A to 7AB, * is a binding site.

For example, -[L₂]_{lb2}-R₉, -[L₃]_{lb3}-R₁₀, -[L₄]_{lb4}-R₁₁, -[L₅]_{lb5}-R₁₂, -[L₆]_{lb6}-R₁₃, and -[L₇]_{lb7}-R₁₄ in Formulae 2A and 2B may be each independently a group represented by one of Formulae 8A to 8Al.

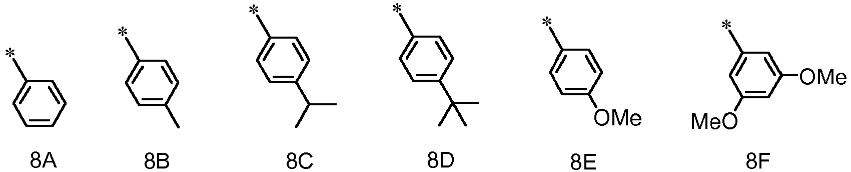

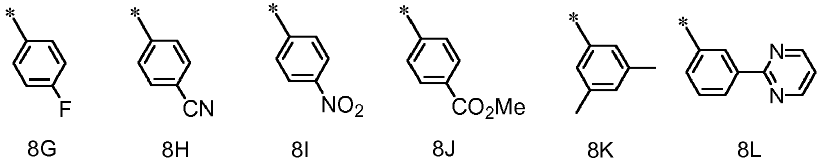

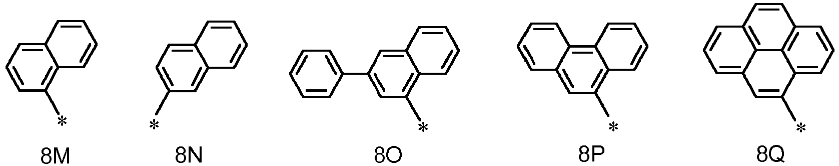

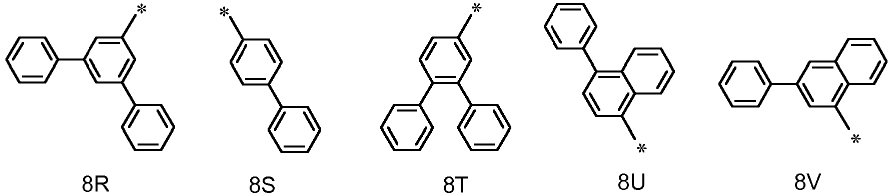

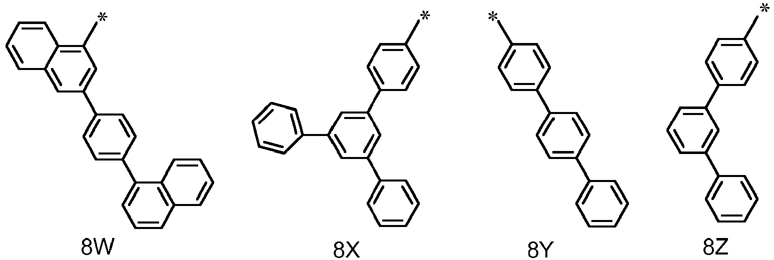

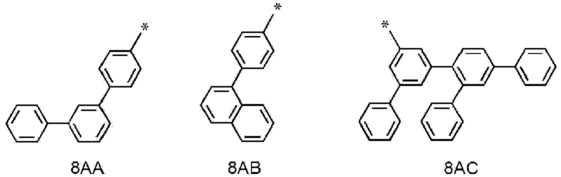

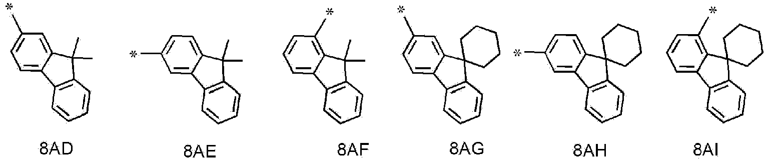

In Formulae 8A to 8AI, * is a binding site.

For example, the first compound represented by Formula 2A or 2B may be selected from compounds HTa-1 to HTa-121 and HTa-129 to HTa-284, but is not limited thereto.

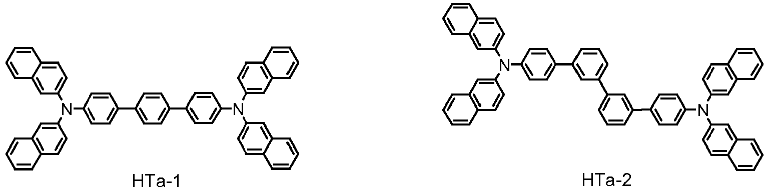

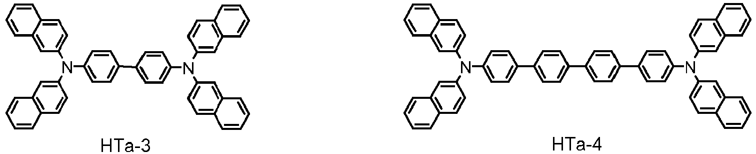

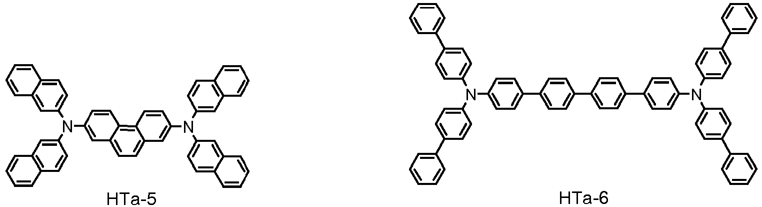

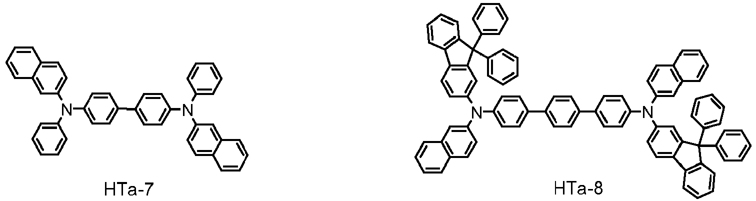

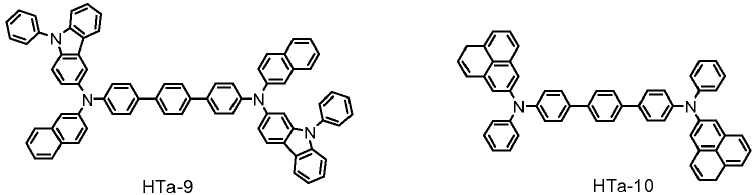

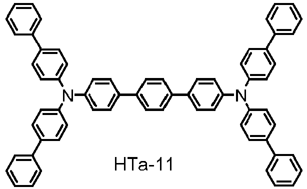

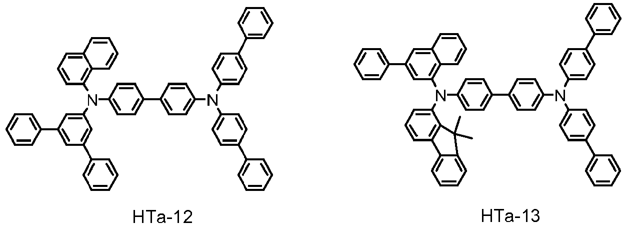

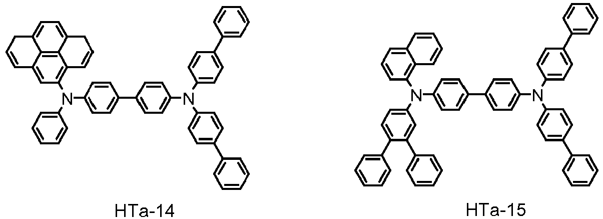

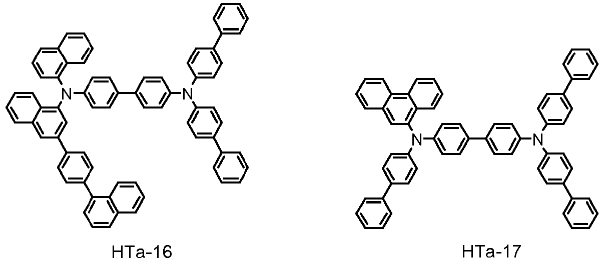

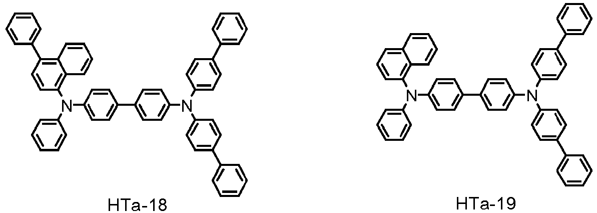

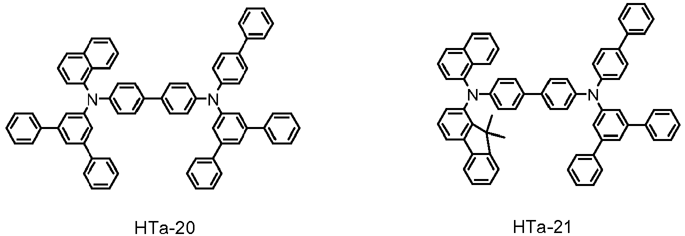

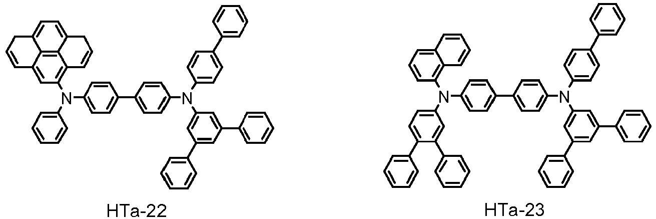

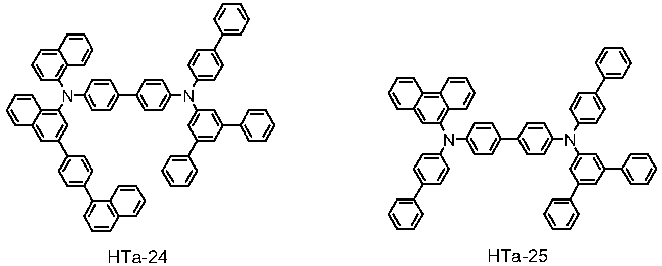

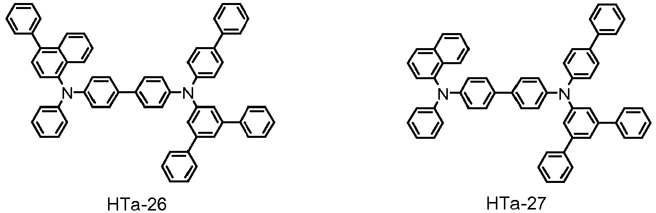

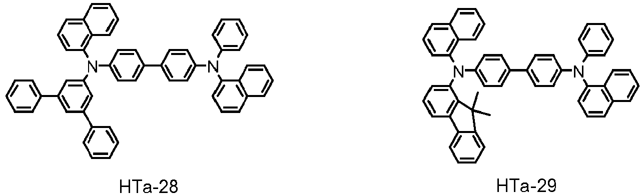

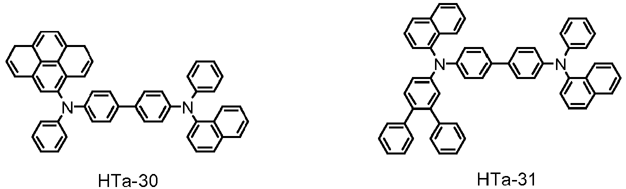

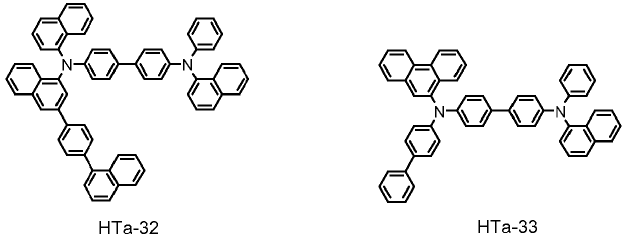

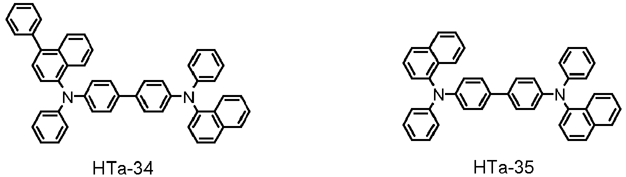

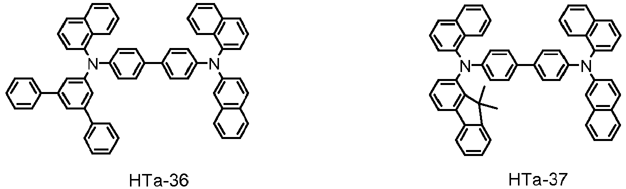

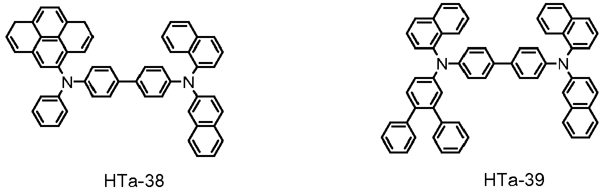

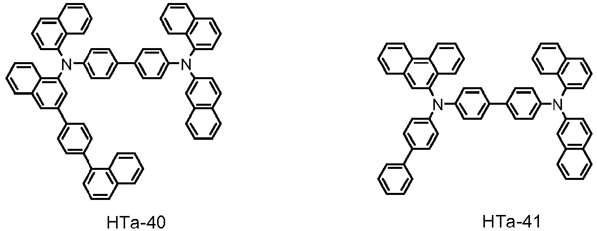

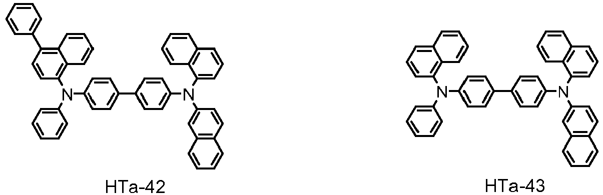

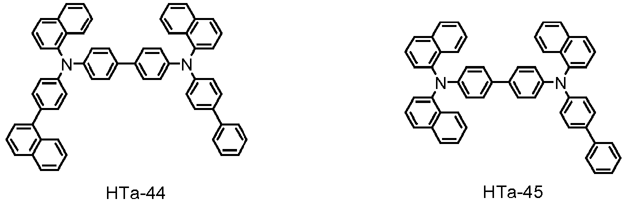

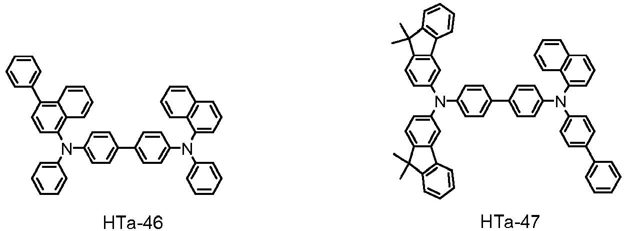

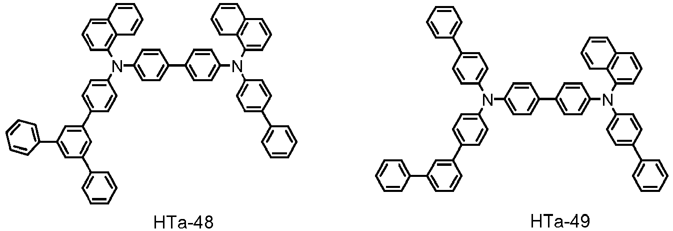

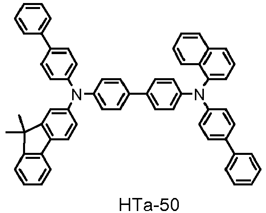

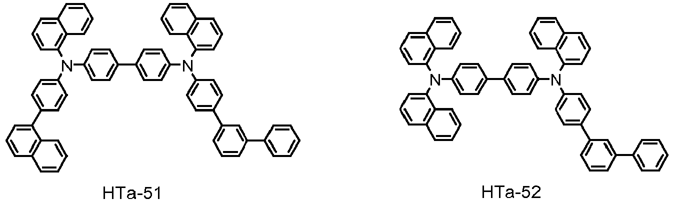

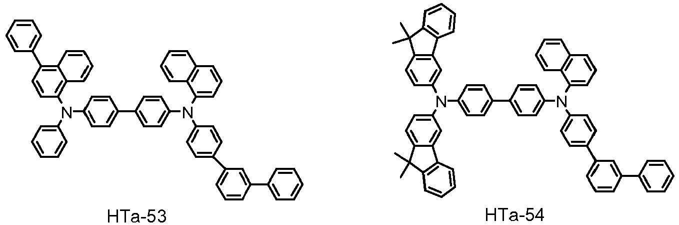

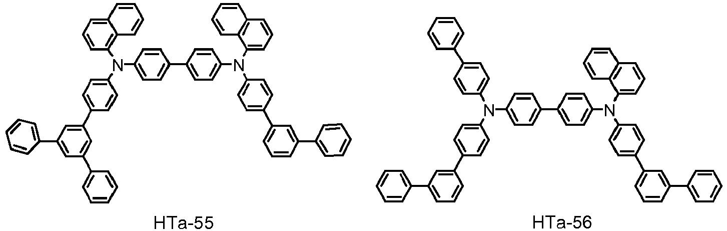

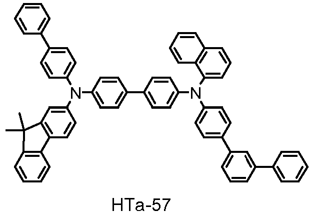

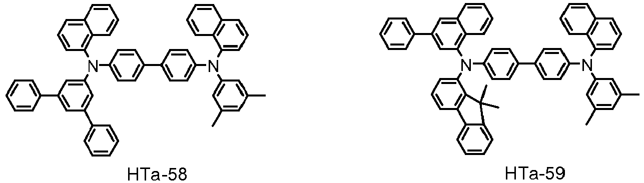

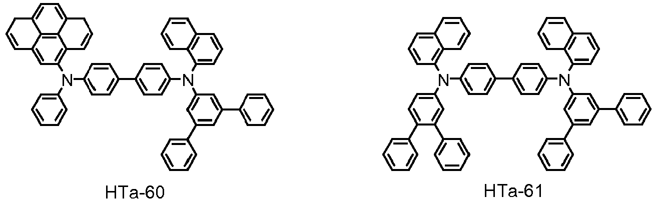

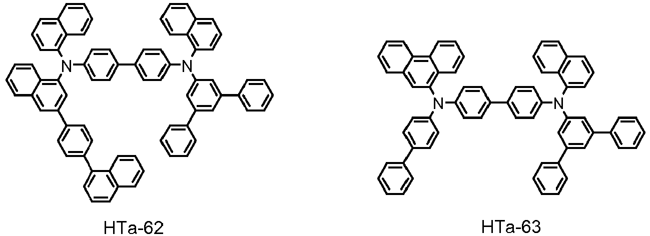

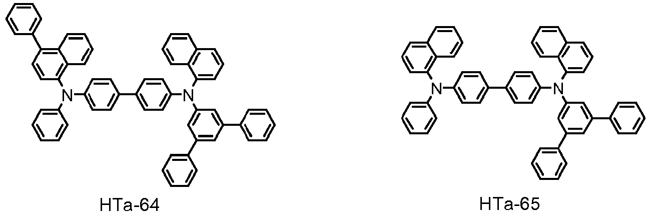

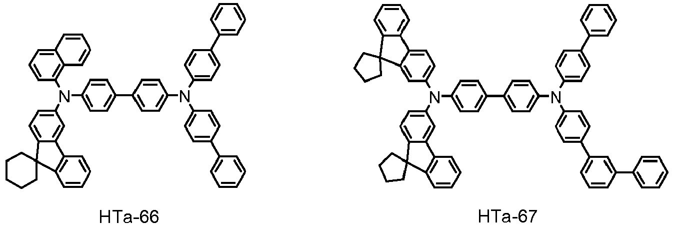

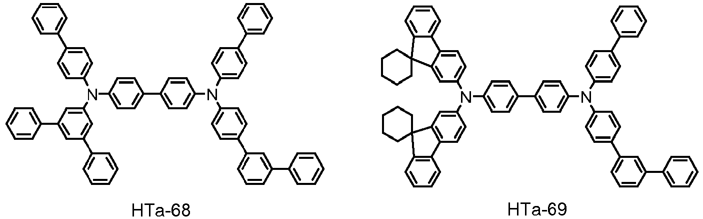

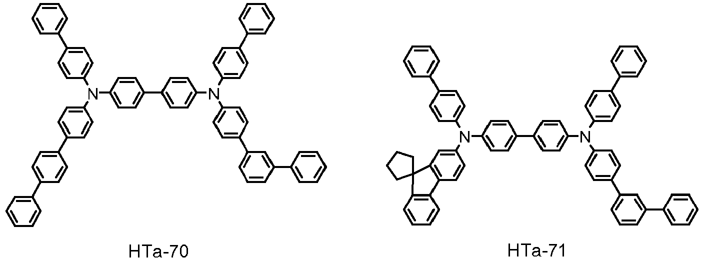

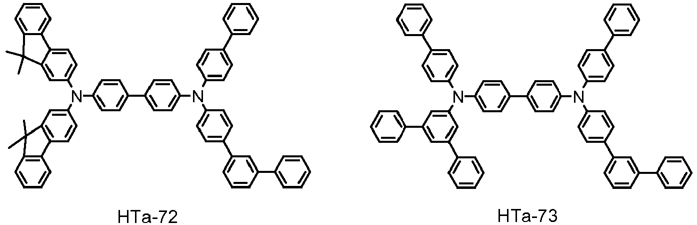

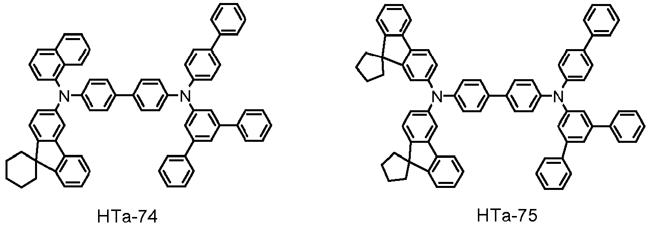

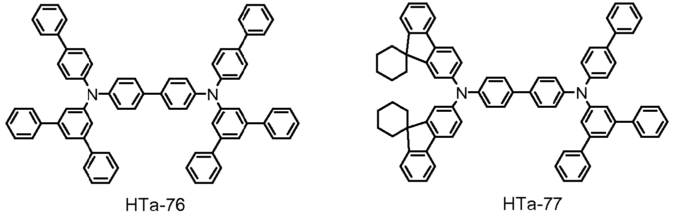

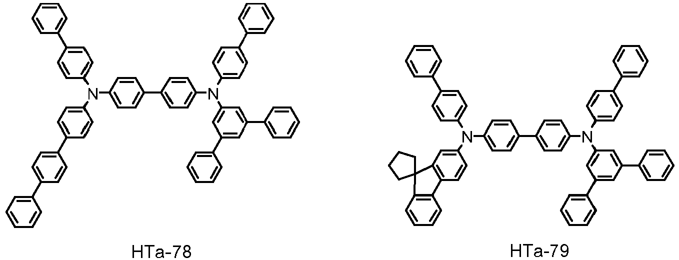

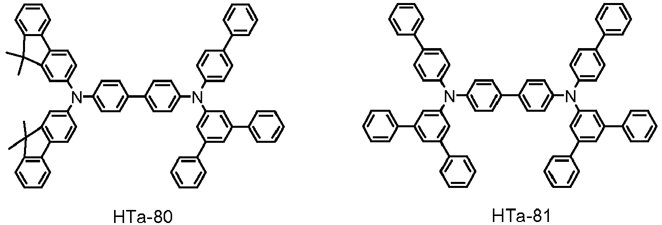

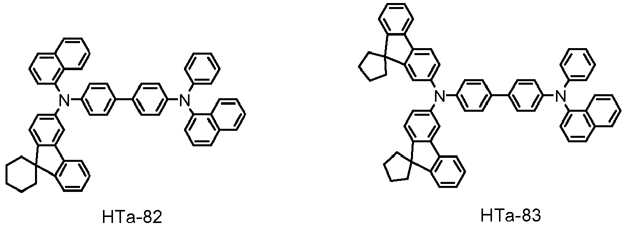

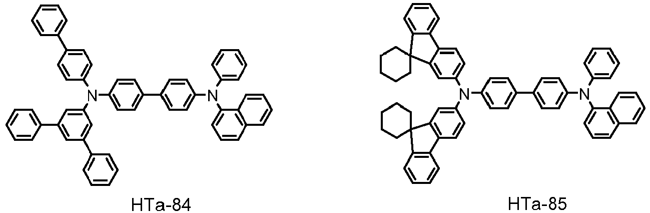

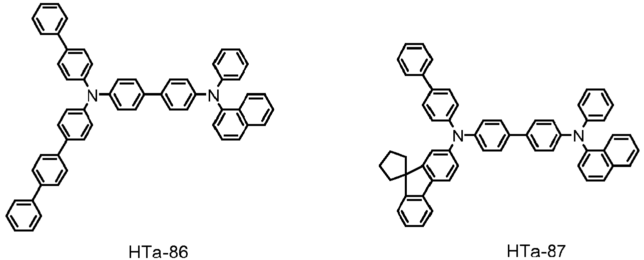

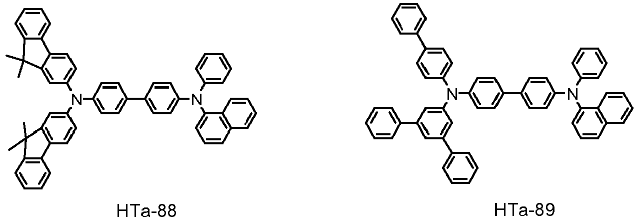

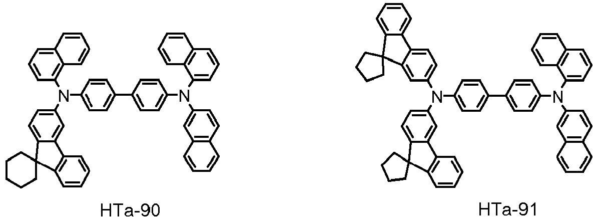

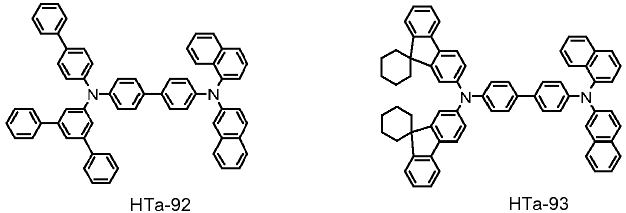

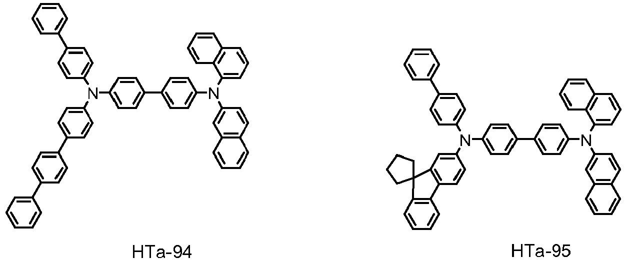

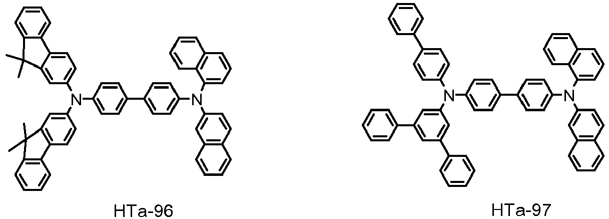

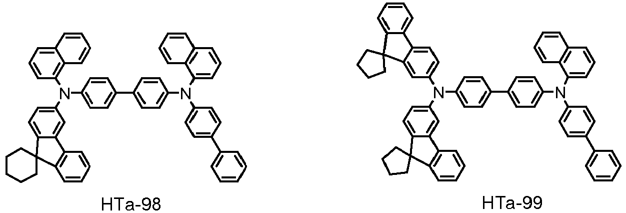

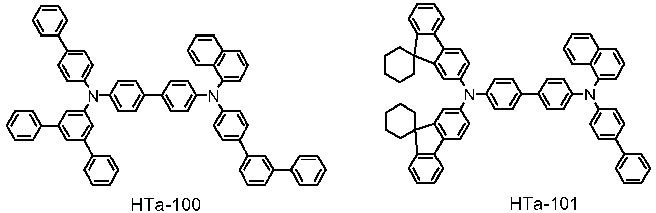

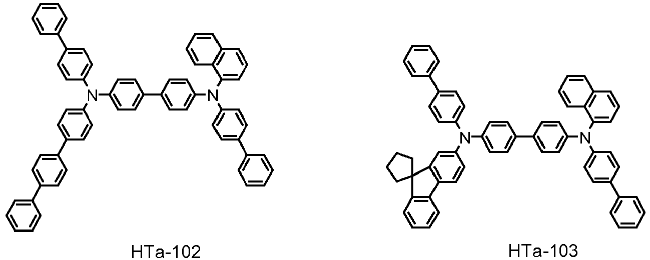

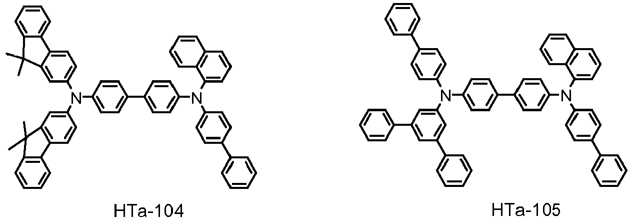

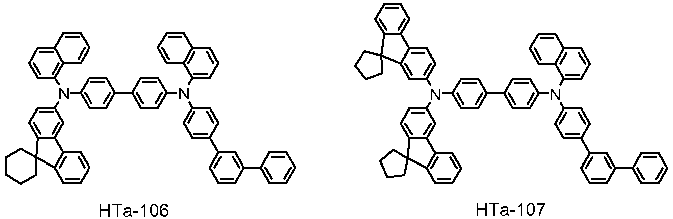

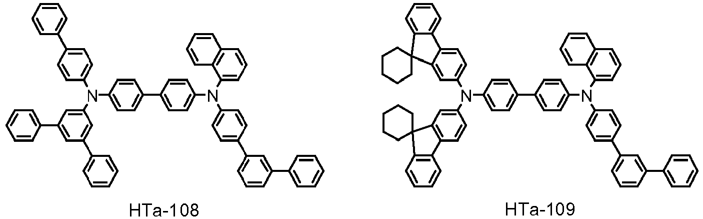

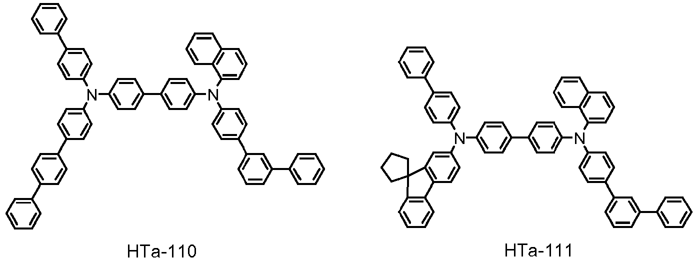

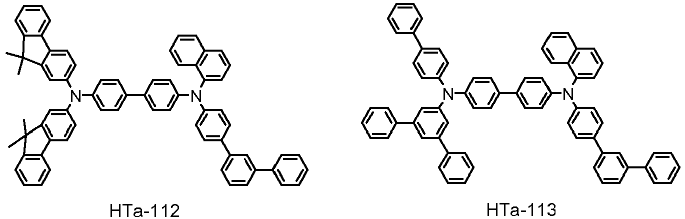

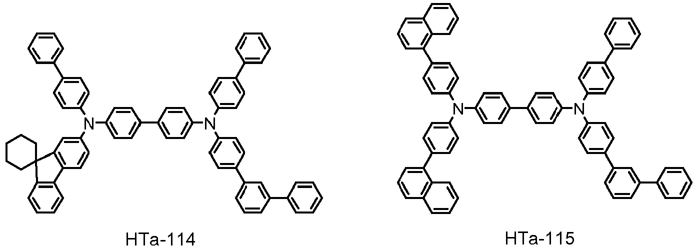

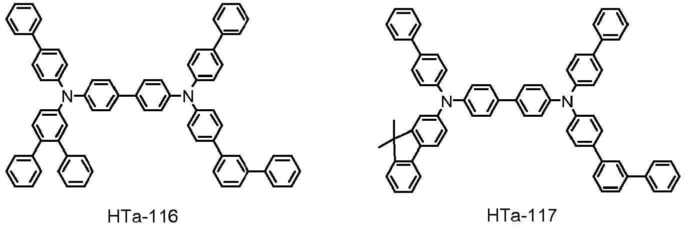

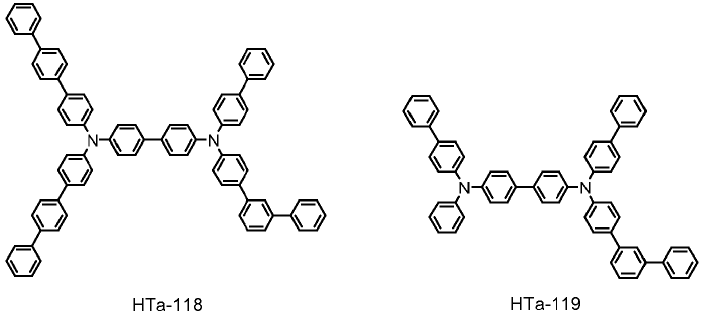

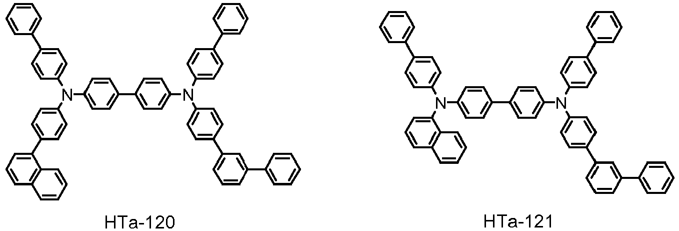

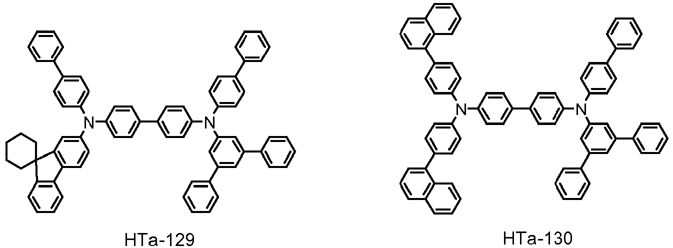

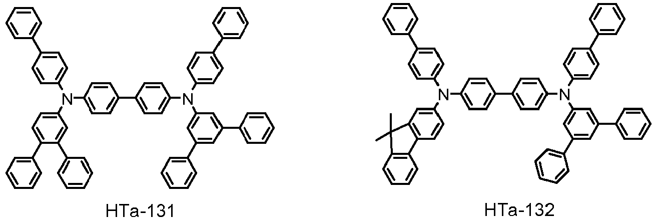

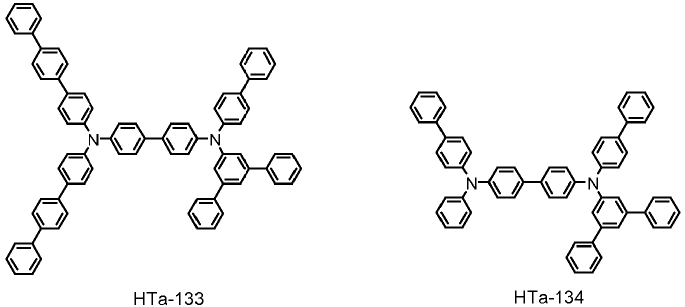

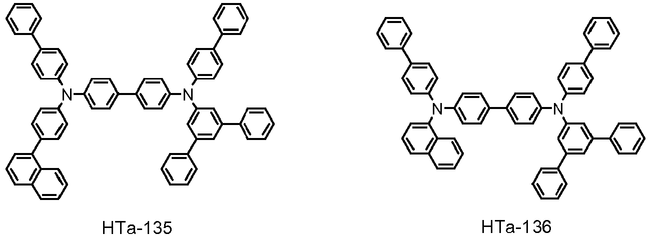

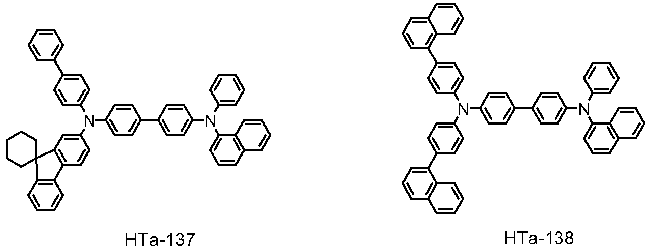

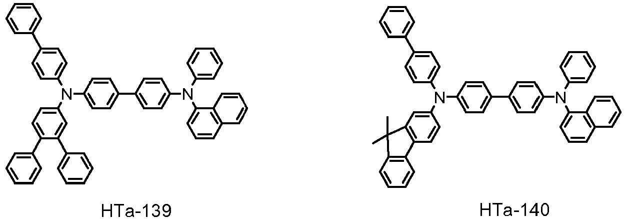

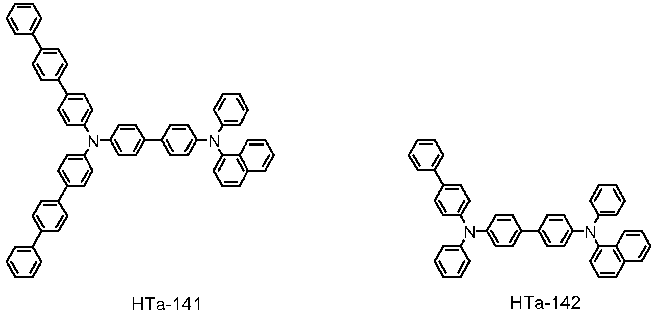

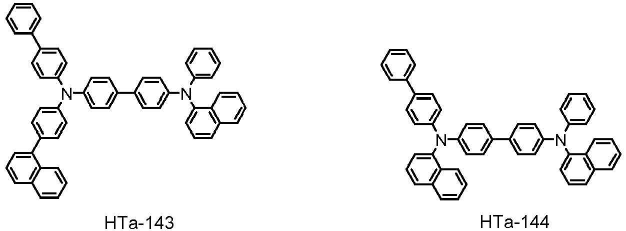

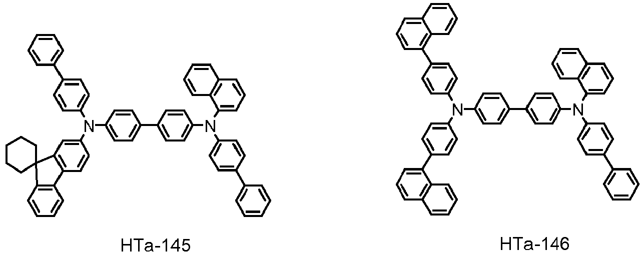

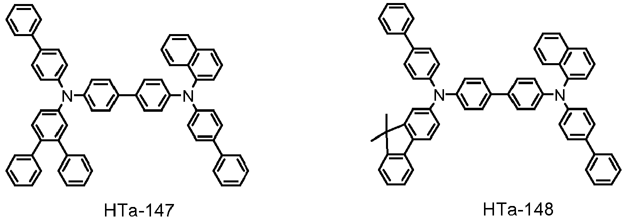

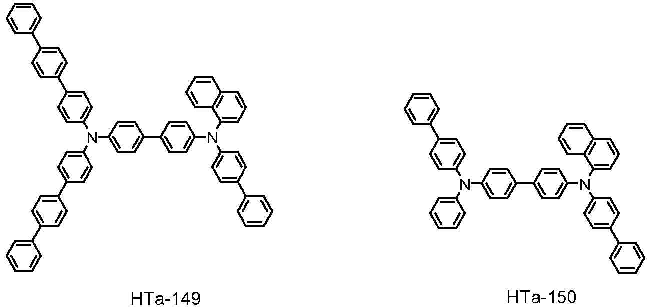

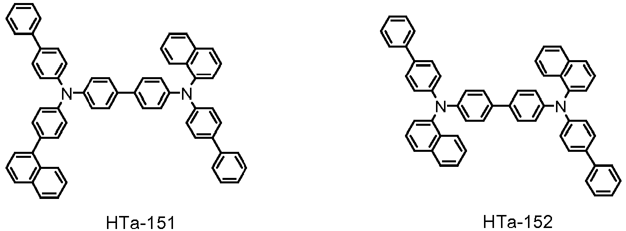

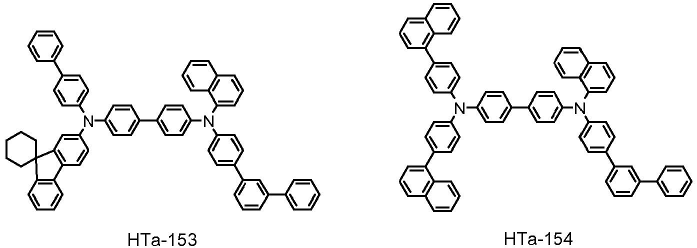

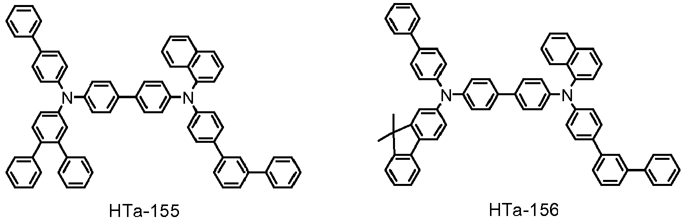

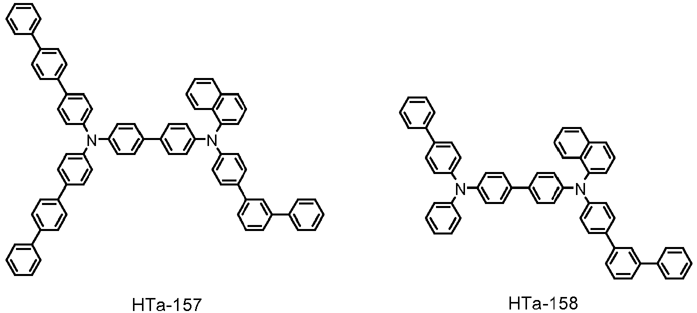

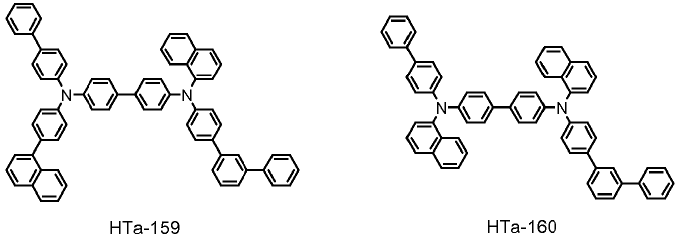

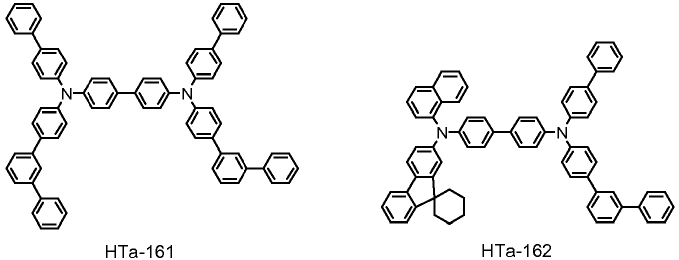

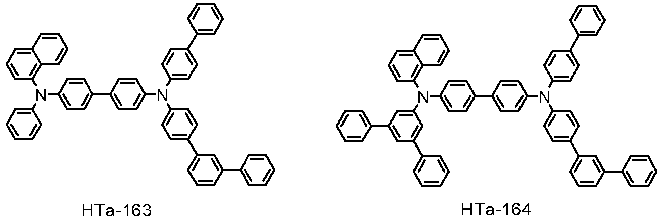

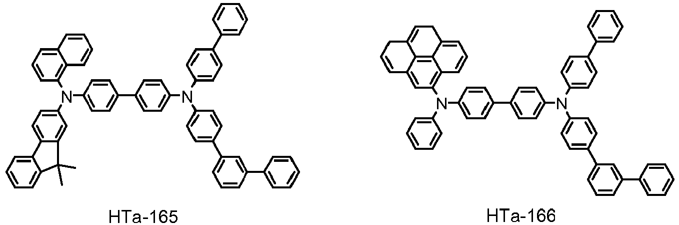

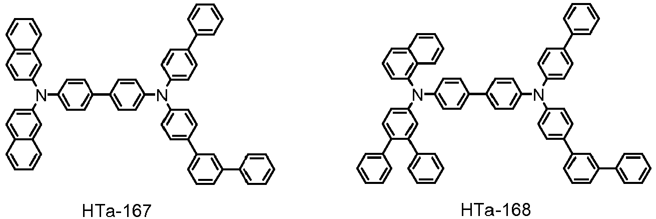

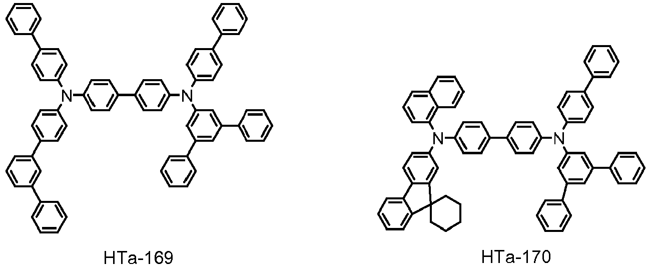

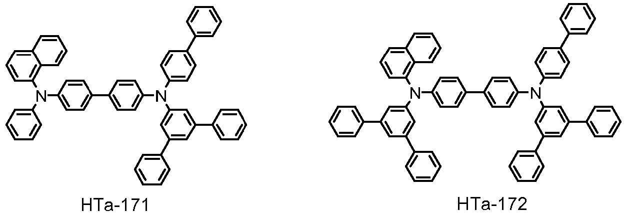

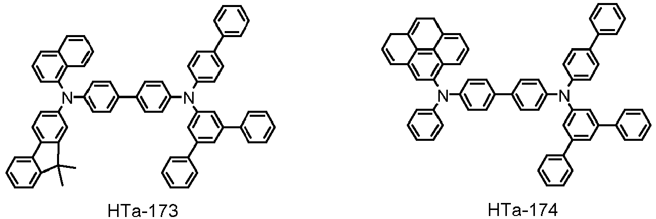

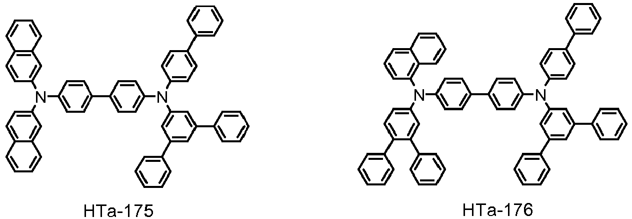

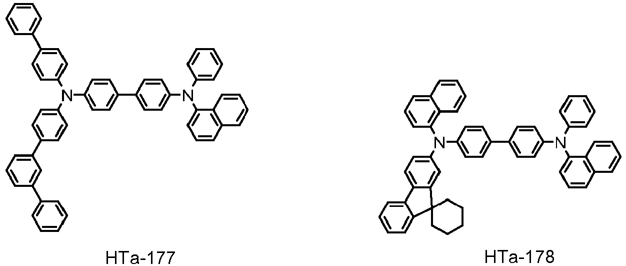

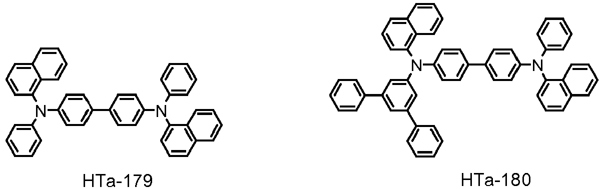

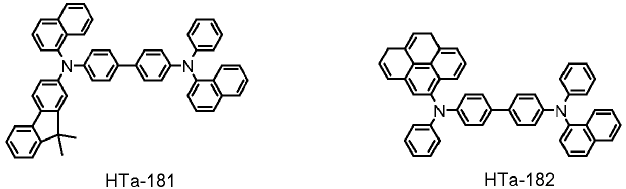

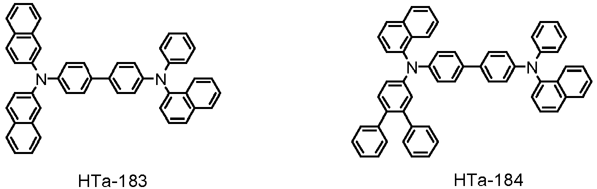

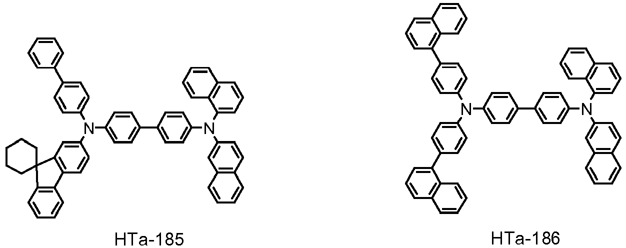

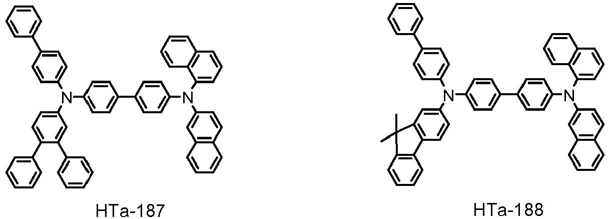

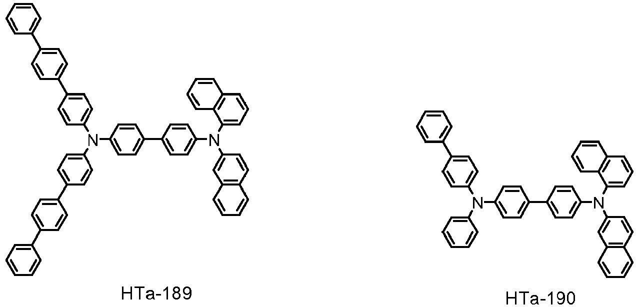

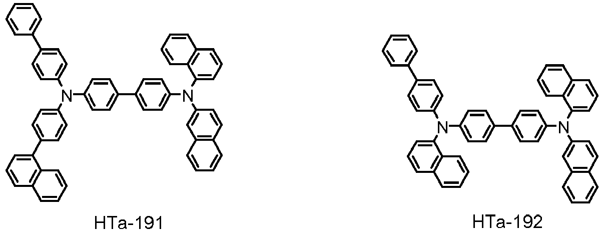

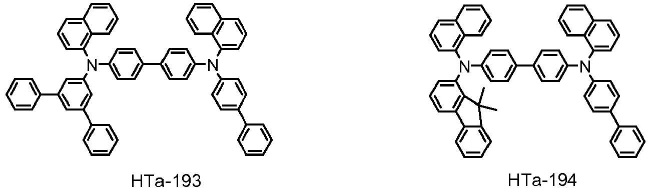

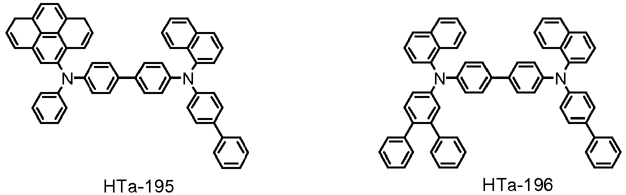

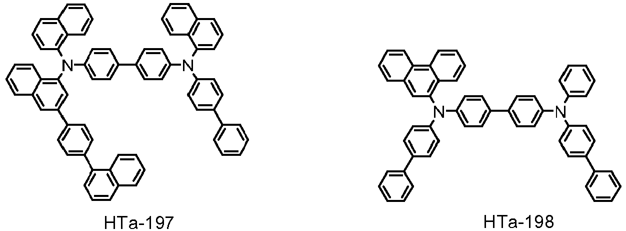

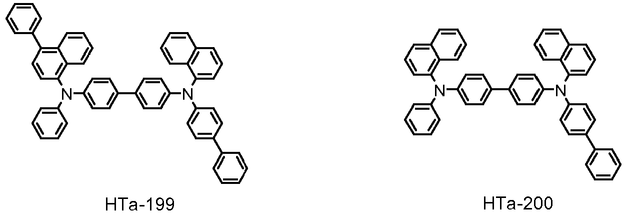

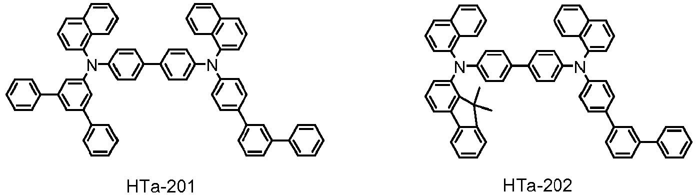

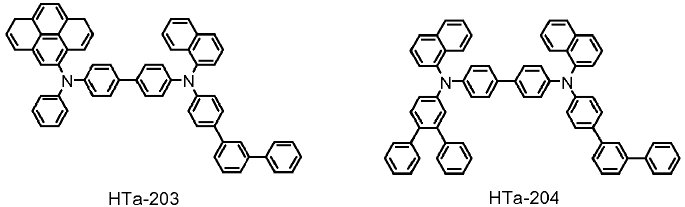

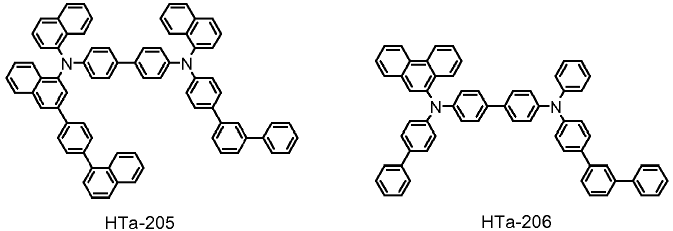

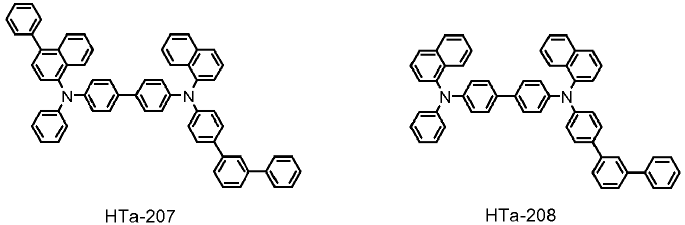

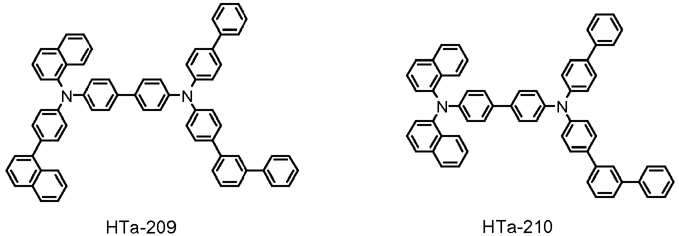

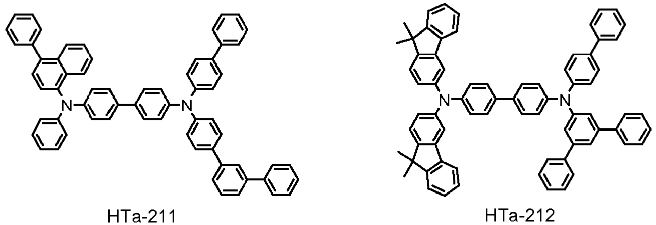

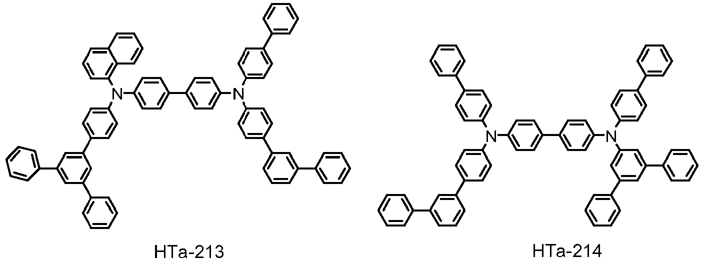

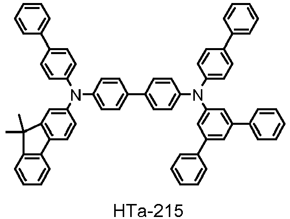

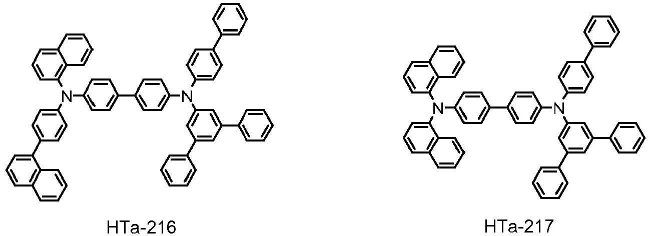

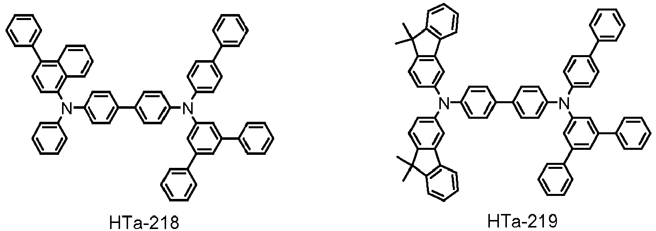

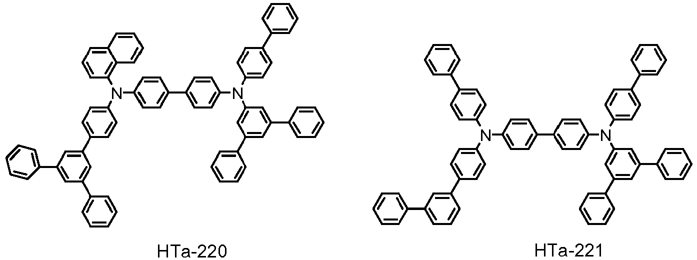

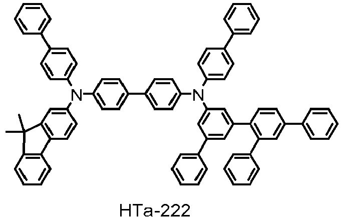

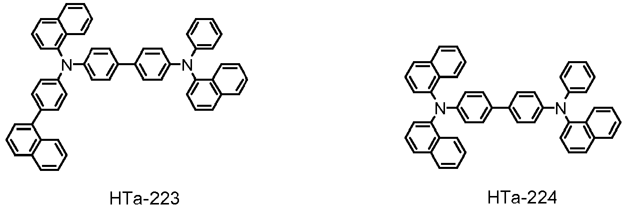

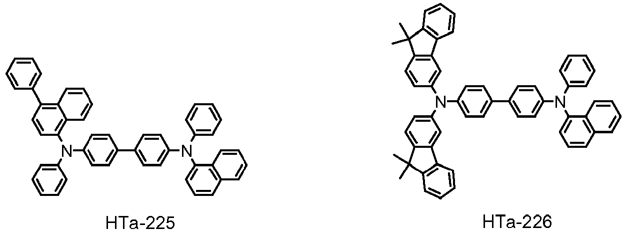

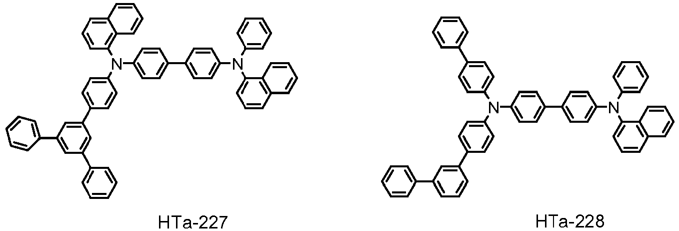

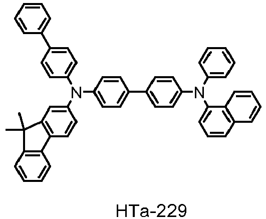

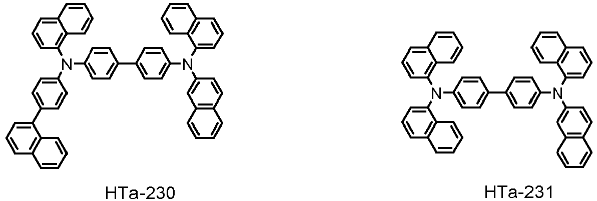

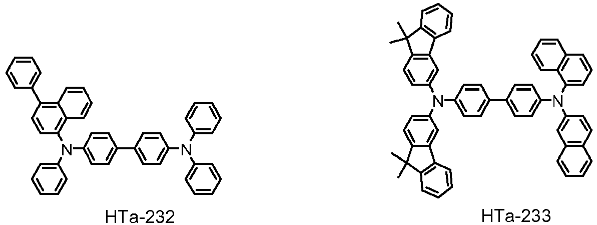

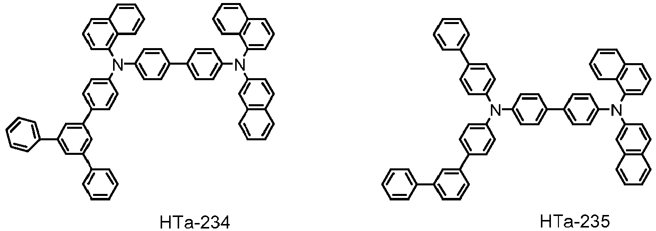

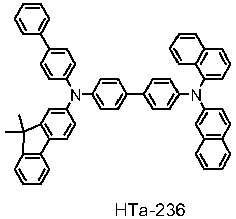

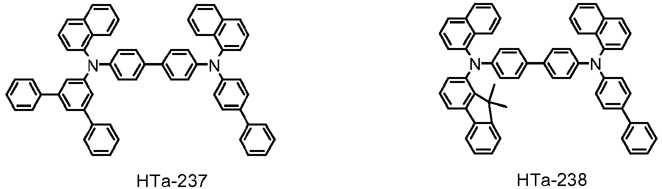

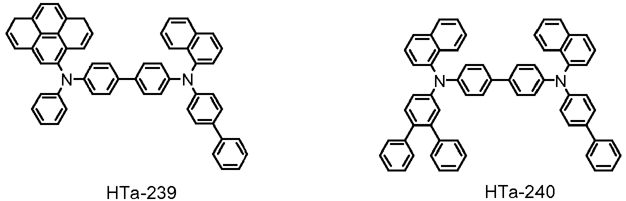

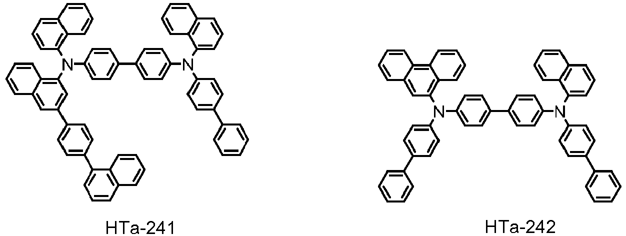

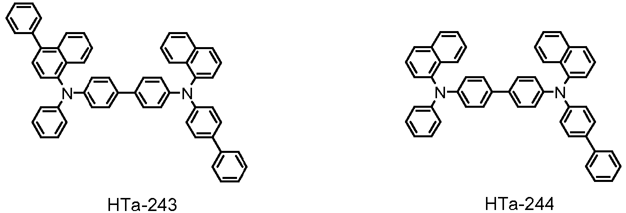

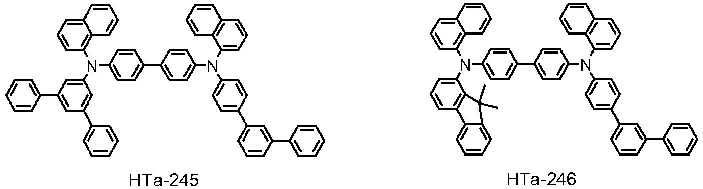

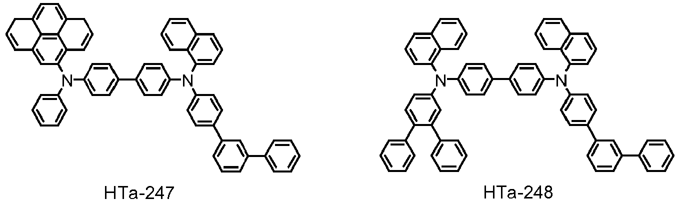

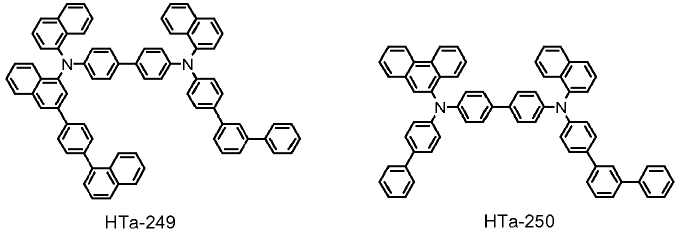

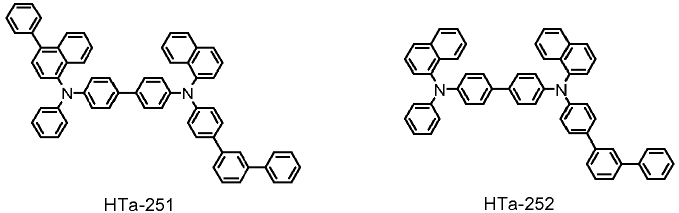

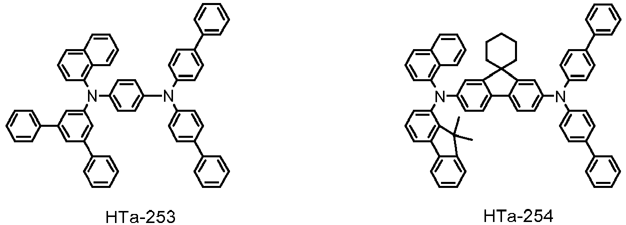

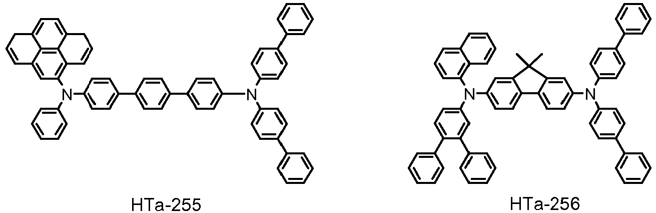

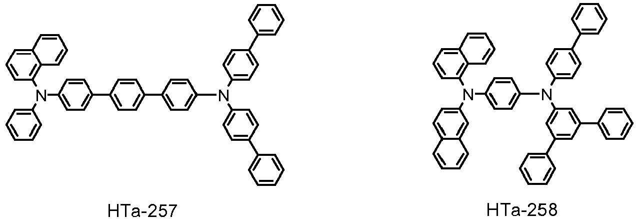

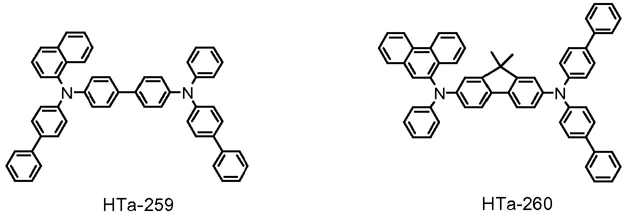

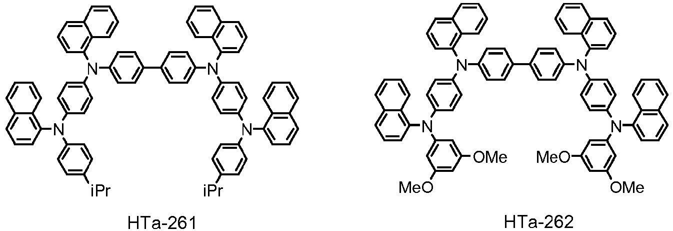

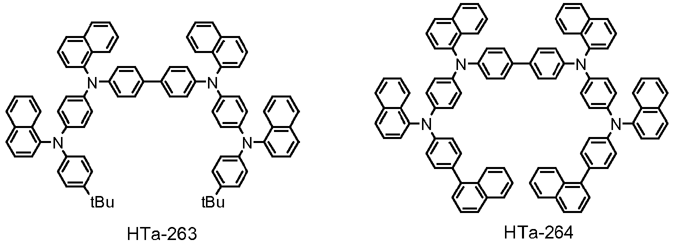

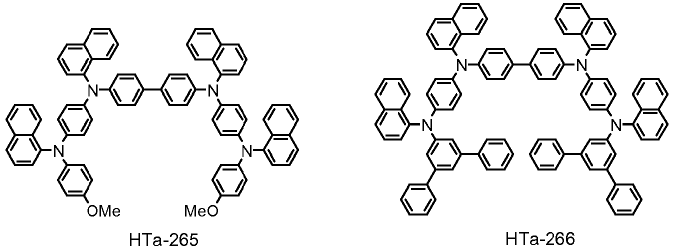

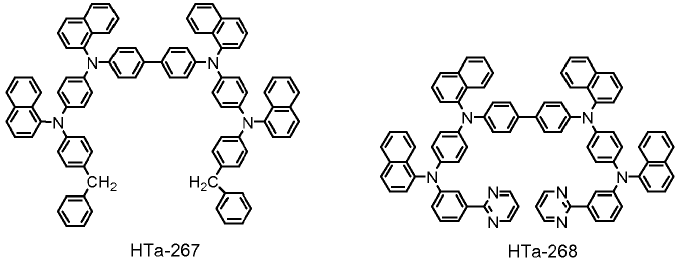

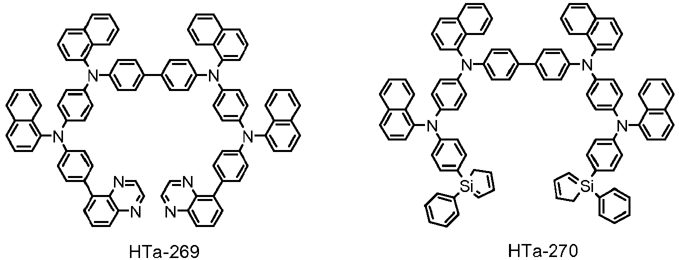

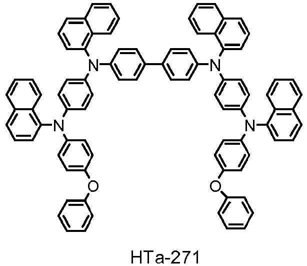

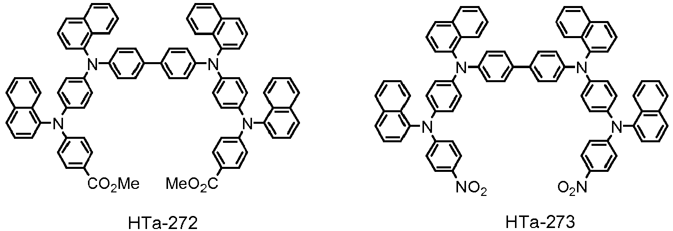

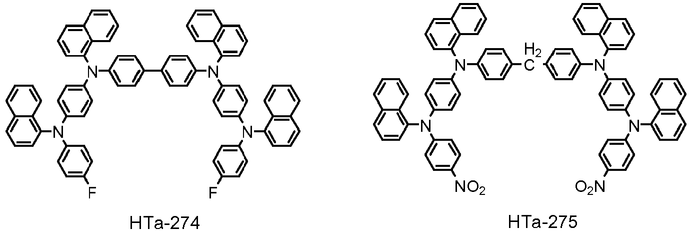

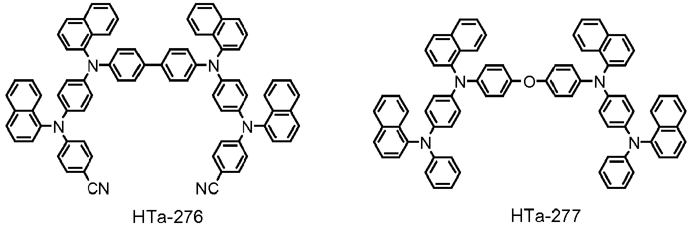

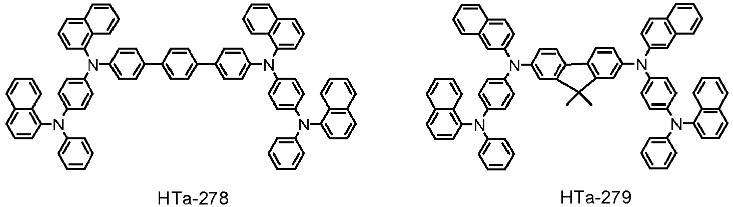

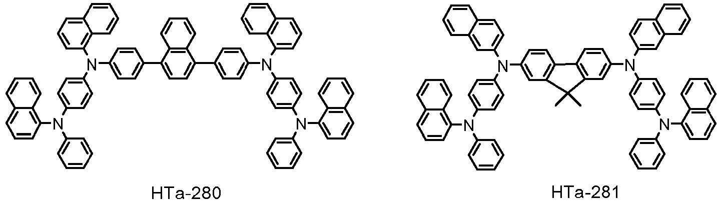

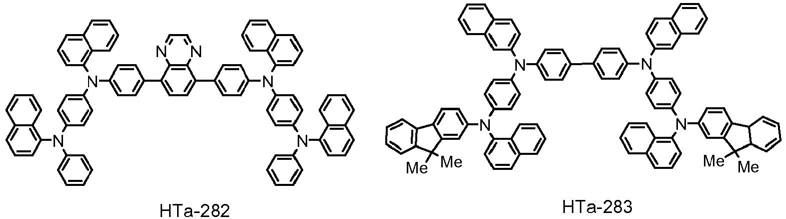

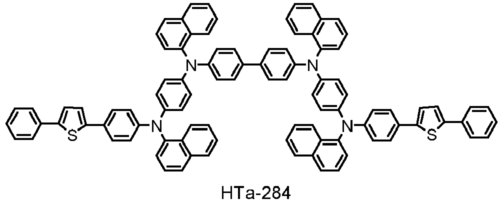

In the organic light-emitting device 10 of FIG. 1, the hole transport region further includes an auxiliary emission layer, and the auxiliary emission layer includes the first compound of Formula 2A or 2B. The emission layer is adjacent to the auxiliary emission layer.

The thickness of the auxiliary emission layer may be from about 10 Å to about 1,000 Å. For example, when the emission layer on the auxiliary emission is a green emission layer, the auxiliary emission layer may have a thickness of about 200 Å to about 450 Å. In some embodiments, when the emission layer on the auxiliary emission layer is a red emission layer, the auxiliary emission layer may have a thickness of about 500 Å to about 1,000 Å.

When the thickness of the auxiliary emission layer is within these ranges, satisfactory hole transport characteristics may be obtained without a substantial increase in driving voltage. When the thickness of the auxiliary emission layer satisfies the above ranges, the organic light-emitting device may have improved efficiency. When the thickness of the auxiliary emission layer satisfies the above ranges, a roll-off phenomenon may be improved.

In some embodiments, in the organic light-emitting device 10 of FIG. 1, the hole transport region may further include at least one of a hole injection layer (HIL), a hole transport layer (HTL), and an electron blocking layer (EBL), in addition to the auxiliary emission layer.

The HIL is on the first electrode 110.

The HTL is on the HIL.

For example, a hole transport material used in the hole transport region, such as a HIL or HTL may include at least one of phthalocyanine compounds, such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris (3-methylphenylphenylamino) triphenylamine), TDATA, 2-TNATA, PANI/DBSA (polyaniline/dodecyl benzene sulfonic acid), PEDOT/PSS (poly(3,4-ethylenedioxythiophene)/poly(4-styrene sulfonate)), PANI/CSA (polyaniline/camphor sulfonic acid) and PANI/PSS (polyaniline)/poly(4-styrene sulfonate)); carbazole derivatives such as N-phenyl carbazole, polyvinyl carbazole, and the like; and TPD (N,N'-bis(3-methylphenyl)-N,N'-diphenyl-[1,1-biphenyl]-4,4'-diamine), HMTPD (N, N,N',N'-tetra-(3-methylphenyl)-3,3'-dimethylbenzidine), Spiro-TPD, TCTA (4,4',4"-tris(N-carbazolyl)triphenylamine)), NPB (N,N'-di(1-naphthyl)-N,N'-diphenylbenzidine)), β-NPB, α-NPD, TAPC (di-[4-(N,N-ditolyl-amino)-phenyl]cyclohexane), a compound represented by Formula 201, and a compound represented by Formula 202.

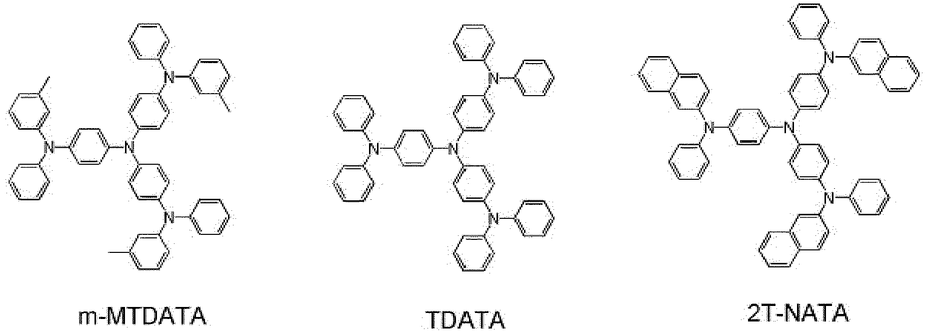

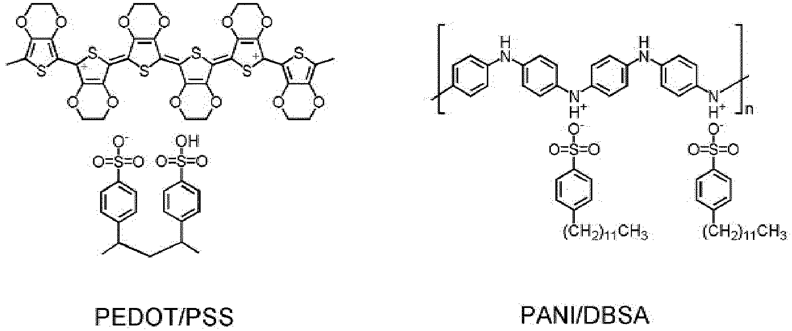

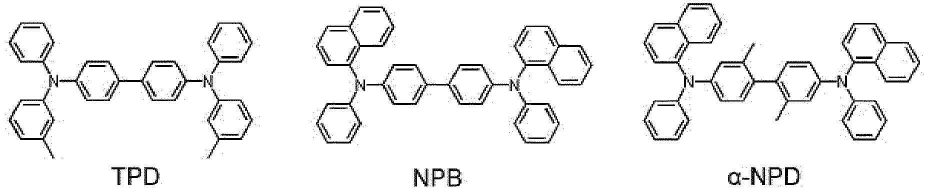

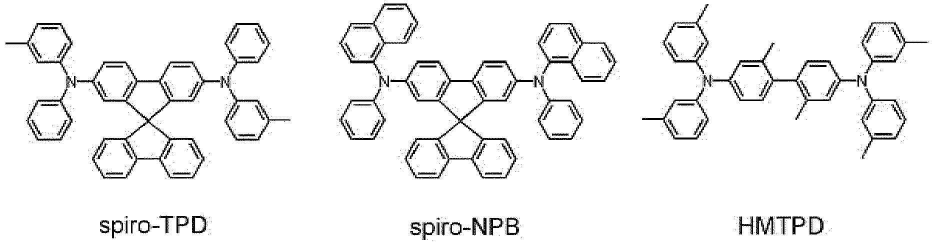

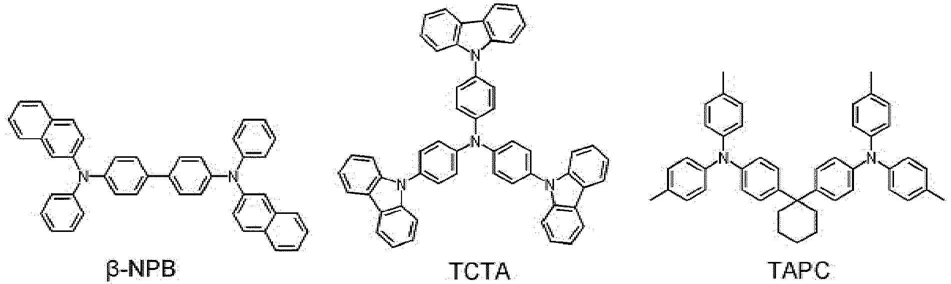

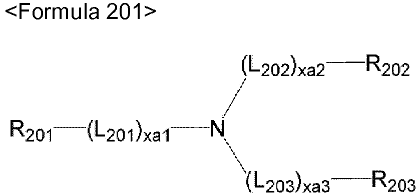

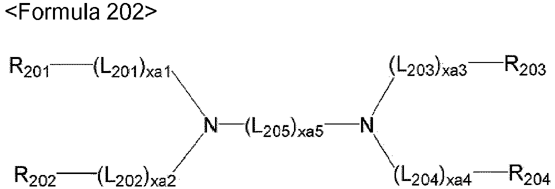

In Formulae 201 and 202,
L₂₀₁ to L₂₀₅ may be each independently selected from
a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group ,
wherein at least one substituent of the substituted C₃-C₁₀ cycloalkylene group, the substituted C₁-C₁₀heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic condensed heteropolycyclic group may be selected from
a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₀₁)(Q₂₀₂), -Si(Q₂₀₃)(Q₂₀₄)(Q₂₀₅), and -B(Q₂₀₆)(Q₂₀₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁₁)(Q₂₁₂), -Si(Q₂₁₃)(Q₂₁₄)(Q₂₁₅) and - B(Q₂₁₆)(Q₂₁₇), and
   -N(Q₂₂₁)(Q₂₂₂), -Si(Q₂₂₃)(Q₂₂₄)(Q₂₂₅), and -B(Q₂₂₆)(Q₂₂₇);
xa1 to xa4 may be each independently selected from 0, 1, 2, and 3;
xa5 may be selected from 1, 2, 3, 4, and 5; and
R₂₀₁ to R₂₀₅ may be each independently selected from a
a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₃₁)(Q₂₃₂), -Si(Q₂₃₃)(Q₂₃₄)(Q₂₃₅), and -B(Q₂₃₆)(Q₂₃₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, and
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₄₁)(Q₂₄₂), -Si(Q₂₄₃)(Q₂₄₄)(Q₂₄₅), and - B(Q₂₄₆₎(Q₂₄₇₎,
wherein Q₂₀₁ to Q₂₀₇, Q₂₁₁ to Q₂₁₇, Q₂₂₁ to Q₂₂₇, Q₂₃₁ to Q₂₃₇, and Q₂₄₁ to Q₂₄₇ may be each independently selected from
a hydrogen atom, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, and
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, in Formulae 201 and 202,
L₂₀₁ to L₂₀₅ may be each independently selected from
a phenylene group, a naphthylenylene group, a fluorenylene group, a spiro-fluorenylene group, a benzofluorenylene group, a dibenzofluorenylene group, a phenanthrenylene group, anthrylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, and
a phenylene group, a naphthylenylene group, a fluorenylene group, a spiro-fluorenylene group, a benzofluorenylene group, a dibenzofluorenylene group, a phenanthrenylene group, anthrylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, an isoindolyl group, a quinolyl group, an isoquinolyl group, a quinoxalinyl group, a quinazolinyl group, a carbazolyl group, and a triazinyl group;
xa1 to xa4 may be each independently 0, 1, or 2;
xa5 may be 1, 2 or 3;
R₂₀₁ to R₂₀₅ may be each independently selected from
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an azulenyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group. However, embodiments are not limited thereto.

The compound of Formula 201 may be represented by Formula 201A.

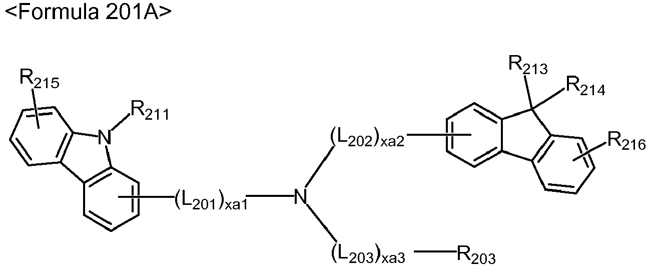

For example, the compound of Formula 201 may be represented by, but not limited to, Formula 201A-1.

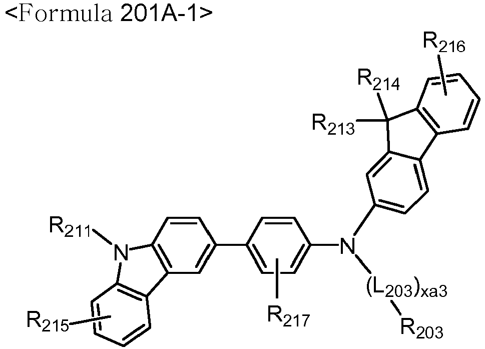

The compound of Formula 202 may be represented by, but not limited to, Formula 202A.

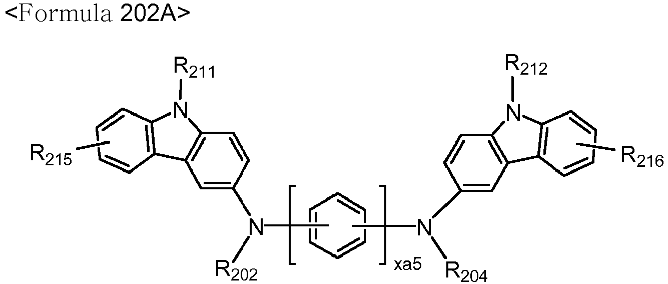

In Formulae 201A, 201A-1, and 202A,
L₂₀₁ to L₂₀₃, xa1 to xa3, xa5 and R₂₀₂ to R₂₀₄ may be defined as those defined herein;
R₂₁₁ and R₂₁₂ may be defined as R₂₀₃ defined herein; and
R₂₁₃ to R₂₁₇ may be each independently selected from a hydrogen atom, a deuterium atom, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, in Formulae 201A, 201A-1 and 202A,
L₂₀₁ to L₂₀₃ may be each independently selected from
a phenylene group, a naphthylenylene group, a fluorenylene group, a spiro-fluorenylene group, a benzofluorenylene group, a dibenzofluorenylene group, a phenanthrenylene group, anthrylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, and
a phenylene group, a naphthylenylene group, a fluorenylene group, a spiro-fluorenylene group, a benzofluorenylene group, a dibenzofluorenylene group, a phenanthrenylene group, anthrylene group, a pyrenylene group, a chrysenylene group, a pyridinylene group, a pyrazinylene group, a pyrimidinylene group, a pyridazinylene group, a quinolinylene group, an isoquinolinylene group, a quinoxalinylene group, a quinazolinylene group, a carbazolylene group, and a triazinylene group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group;
xa1 to xa3 may be each independently 0 or 1;
R₂₀₃, R₂₁₁, and R₂₁₂ may be each independently selected from
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group;
R₂₁₃ and R₂₁₄ may be each independently selected from
a C₁-C₂₀ alkyl group and a C₁-C₂₀ alkoxy group,
a C₁-C₂₀ alkyl group and a C₁-C₂₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group,
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group;
R₂₁₅ and R₂₁₇ may be each independently selected from
a hydrogen atom, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof,
a C₁-C₂₀ alkyl group, and a C₁-C₂₀ alkoxy group,
a C₁-C₂₀ alkyl group and a C₁-C₂₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group,
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, and a triazinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group; and
xa5 may be 1 or 2.

In Formulae 201A and 201A-1, R₂₁₃ and R₂₁₄ may be bound to each other thus to form a saturated or unsaturated ring.

In some embodiments, the hole transport region may further include a second compound represented by one of Formulae 201A-1 and 202A.

In Formula3 201A-1 and 202A, R₂₀₂ to R₂₀₄, and R₂₁₁ to R₂₁₂ may be each independently selected from
a substituted or unsubstituted C₆-C₆₀ aryl group, a substituted or unsubstituted C₁-C₆₀ heteroaryl group, the substituted monovalent non-aromatic condensed polycyclic group, and the substituted monovalent non-aromatic condensed heteropolycyclic group;
L₂₀₃ may be a substituted or unsubstituted C₆-C₆₀ arylene group;
xa3 and xa5 may be each independently an integer selected from 0 to 3;
R₂₁₃ and R₂₁₄ may be each independently selected from
a C₁-C₁₀ alkyl group, a C₁-C₁₀ alkoxy group, and a C₁-C₂₀ aryl group;
a C₁-C₁₀ alkyl group and a C₁-C₁₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof; and
a C₁-C₂₀ aryl group substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, and a C₁-C₂₀ aryl group;
optionally, R₂₁₃ and R₂₁₄ may be bound to each other to form a condensed polycyclic ring,
R₂₁₅ to R₂₁₇ may be each independently selected from
a hydrogen atom, a deuterium atom, -F, -CI, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), and -B(Q₆)(Q₇);
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₆-C₆₀ arylene group, the substituted monovalent non-aromatic condensed polycyclic group, and the substituted monovalent non-aromatic condensed heteropolycyclic group may be selected from
a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C60 aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇), and
   -N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇ and Q₃₁ to Q₃₇ may be each independently selected from a hydrogen atom, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

In some embodiments, in Formulae 201A-1 and 202A, R₂₀₂ to R₂₀₄, and R₂₁₁ to R₂₁₂ may be each independently selected from
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group;
L₂₀₃ may be selected from
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, and a perylenylene group, and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, and a perylenylene group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group;
R₂₁₃ and R₂₁₄ may be each independently selected from
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group,
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, and a pentoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group;
R₂₁₅ to R₂₁₇ may be each independently selected from
a hydrogen atom, a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group.

In some embodiments, in Formulae 201A-1 and 202A, R₂₀₂ to R₂₀₄, and R₂₁₁ to R₂₁₂ may be each independently a phenyl group, a biphenyl group, a naphthyl group, a fluorenyl group, and a pyridyl group; and a phenyl group, and a fluorenyl group, each substituted with at least one of - F, -CI, -Br, -I, a methyl group, or a cyano group;
L₂₀₃ may be a phenylene group;
R₂₁₃ and R₂₁₄ may be each independently a methyl group or a phenyl group, and optionally R₂₁₃ and R₂₁₄ may be bound to each other to form a fluorene ring; and
R₂₁₅ to R₂₁₇ may be a hydrogen atom.

The second compound may be selected from Compounds HTb-1 to HTb-20, but are not limited thereto.

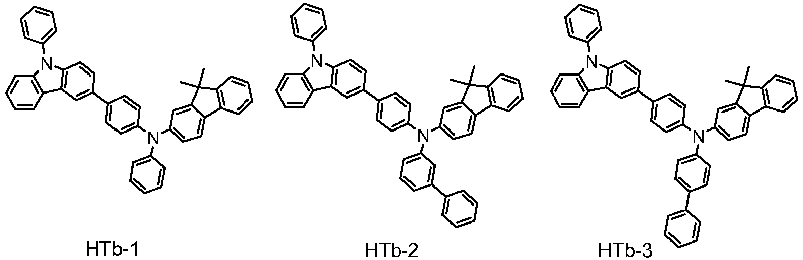

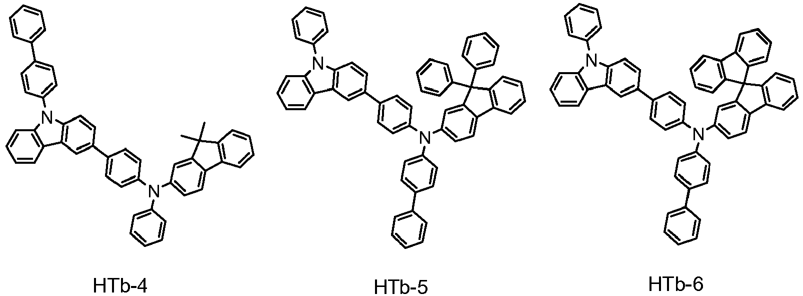

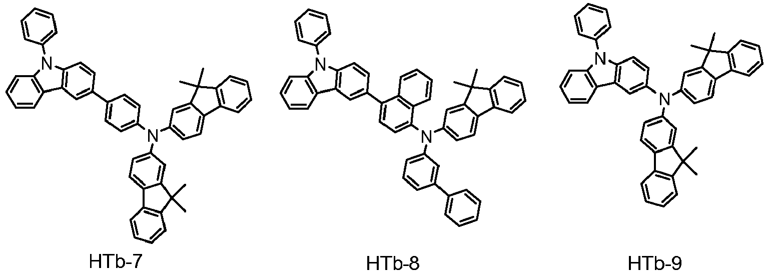

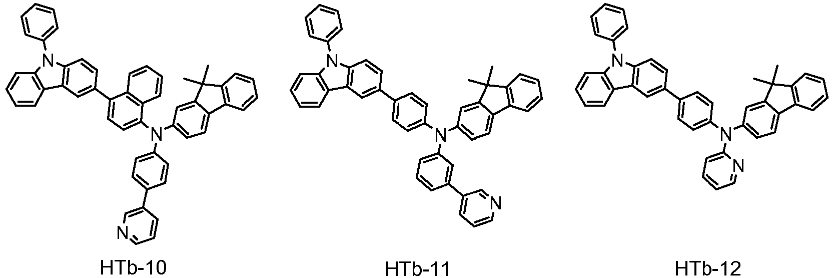

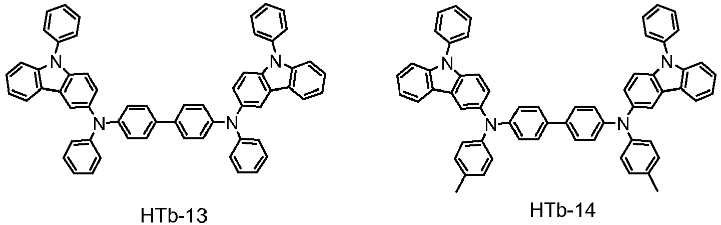

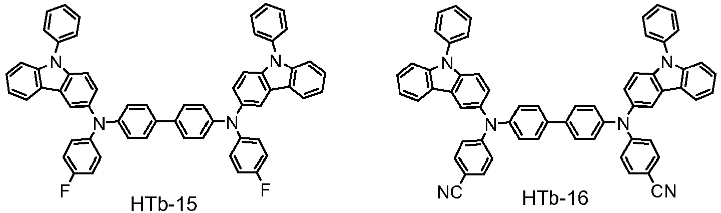

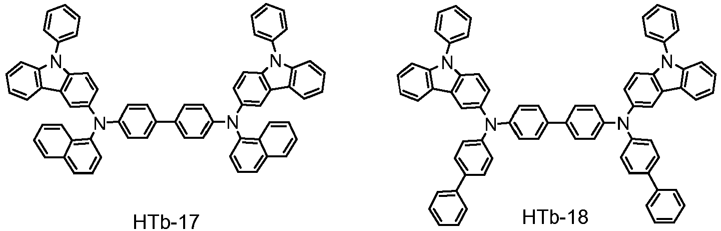

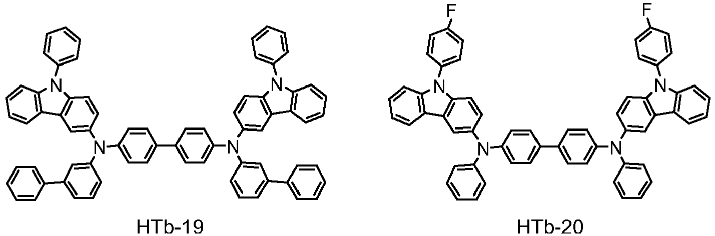

In some embodiments, the auxiliary emission layer may include both a first compound represented by one of Formulae 2A and 2B, and a second compound represented by one of Formulae 201A-1 and 202A.

When the auxiliary emission layer include both the first compound and the second compound, a weight ratio of the first compound and the second compound may be in a range of 1:3 to 1:8. For example, a weight ratio of the first compound and the second compound may be 1:6, but not limited thereto.

The thickness of the hole transport region may be in a range of from about 100 Å to about 10,000 Å, and in some embodiments, from about 100 Å to about 2,000 Å. When the hole transport region includes both a HIL and a HTL, a thickness of the HIL may be in a range from about 100 Å to about 10,000 Å, and in some embodiments, from about 100 Å to about 1,000 Å, and a thickness of the HTL may be in a range of from about 50 Å to about 2,000 Å, and in some embodiments, from about 100 Å to about 1,500 Å. When the thicknesses of the hole transport region, the HIL, and the HTL are within these ranges, satisfactory hole transport characteristics may be obtained without a substantial increase in driving voltage.

The hole transport region may further include a charge-generating material to improve conductivity, in addition to the materials as described above. The charge-generating material may be homogeneously or inhomogeneously dispersed in the hole transport region.

The charge-generating material may be, for example, a p-dopant. Non-limiting examples of the p-dopant are quinone derivatives such as tetracyanoquinonedimethane (TCNQ),2,3,5,6-tetrafluoro-tetracyano-1,4-benzoquinonedimethane (F4-TCNQ), and the like; metal oxides such as tungsten oxide, molybdenum oxide, and the like; and Compound HATCN (1,4,5,8,9,11-hexaazatriphenylene-hexacarbonitrile).

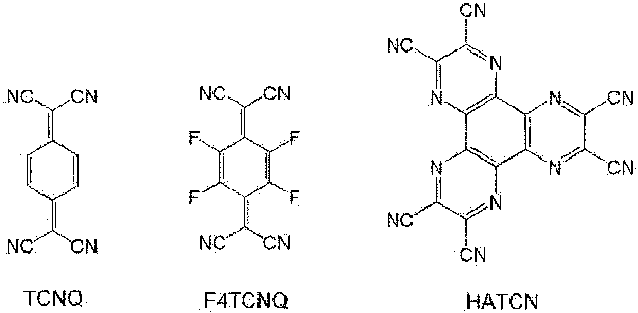

In some embodiments, the hole transport region may further include at least one of a buffer layer (not shown) and an electron blocking layer (EBL, not shown), in addition to the HIL, HTL, and the auxiliary emission layer. The buffer layer may compensate for an optical resonance distance of light according to a wavelength of the light emitted from the EML, and thus may improve light-emission efficiency. A material in the buffer layer may be any material used in the hole transport region. The EBL may block injection of electrons from the hole transport region. For example, mCP may be used a material for the EBL. However, embodiments are not limited thereto.

In the organic light-emitting device 10 of FIG. 1, the electron transport region may include at least one of a hole blocking layer (HBL), an electron transport layer (ETL), and an electron blocking layer (EBL). However, embodiments are not limited thereto.

For example, the electron transport region may have a structure of layers sequentially stacked on the emission layer, the layers including an ETL/EIL or a HBL/ETL/EIL. However, embodiments are not limited thereto.

For example, the HBL may include at least one of BCP, Bphen, and TmPyPB, but is not limited thereto.

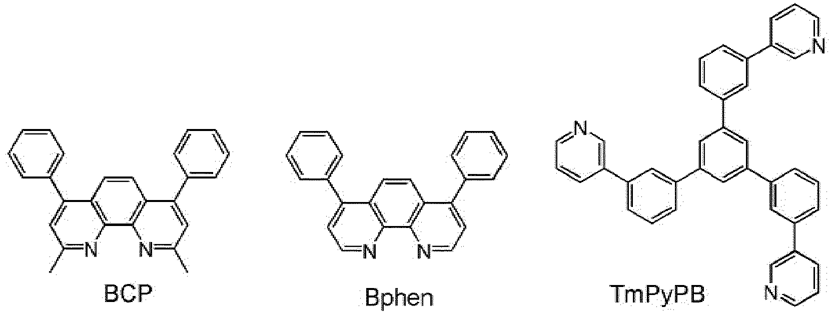

The thickness of the HBL may be from about 20 Å to about 1,000 Å, and in some embodiments, may be from about 30 Å to about 300 Å. When the thickness of the HBL is within these ranges, the organic light-emitting device may have satisfactory hole blocking ability without a substantial increase in driving voltage.

The ETL may include at least one of BCP, Bphen, Alq₃, BAlq, TAZ, and NTAZ, but is not limited thereto.

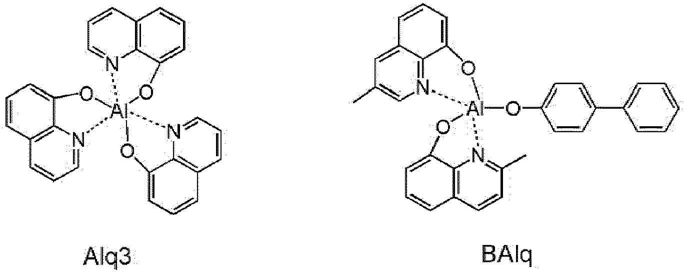

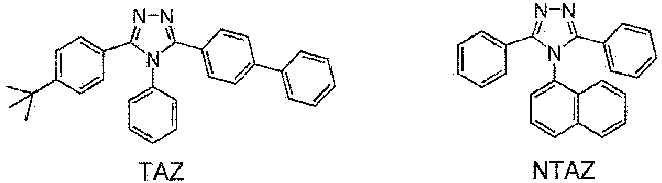

In some embodiments, the ETL may include at least one of the compounds represented by Formula 601.

<Formula 601> Ar₆₀₁-[(L₆₀₁)ₓₑ₁-E₆₀₁]ₓₑ₂

In Formula 601,
Ar₆₀₁ may be selected from
a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, naphthacene, a picene, a perylene, a pentaphene, and an indenoanthracene,
a naphthalene, a heptalene, a fluorene, a spiro-fluorene, a benzofluorene, a dibenzofluorene, a phenalene, a phenanthrene, an anthracene, a fluoranthene, a triphenylene, a pyrene, a chrysene, naphthacene, a picene, a perylene, a pentaphene, and an indenoanthracene, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ heterocycloalkyl group, a C₃-C₁₀ cycloalkenyl group, a C₃-C₁₀ heterocycloalkenyl group, a C₆-C₆₀ aryl group, a C₆-C₆₀ aryloxy group, a C₆-C₆₀ arylthio group, a C₂-C₆₀ heteroaryl group, a monovalent C₂-C₆₀ non-aromatic condensed polycyclic group, and -Si(Q₃₀₁)(Q₃₀₂)(Q₃₀₃), wherein Q₃₀₁ to Q₃₀₃ may be each independently selected from a hydrogen atom, a C₁-C₆₀ alkyl group, a C₂-C₆₀ alkenyl group, a C₆-C₆₀ aryl group, and a C₂-C₆₀ heteroaryl group;
L₆₀₁ may be defined as L₂₀₁ defined herein;
E₆₀₁ may be selected from
a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, and
a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, a ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group;
xe1 may be selected from 0, 1, 2, and 3; and
xe2 may be selected from 1, 2, 3, and 4.

In some embodiments, the ETL may include at least one of the compounds represented by Formula 602.

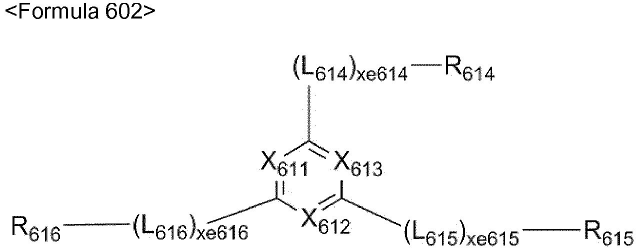

In Formula 602,
X₆₁₁ may be N or C-(L₆₁₁)xe₆₁₁-R₆₁₁;
X₆₁₂ may be N or C-(L₆₁₂)xe₆₁₂-R₆₁₂;
X₆₁₃ may be N or C-(L₆₁₃)xe₆₁₃-R₆₁₃;
at least one of X₆₁₁ to X₆₁₃ may be N;
L₆₁₁ to L₆₁₆ may be defined as L₂₀₁ herein;
R₆₁₁ to R₆₁₆ may be each independently selected from
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, and
a phenyl group, a naphthyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and a triazinyl group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an azulenyl group, a fluorenyl group, a spiro-fluorenyl group, a benzofluorenyl group, a dibenzofluorenyl group, a phenanthrenyl group, an anthryl group, a pyrenyl group, a chrysenyl group, a pyridyl group, a pyrazinyl group, a pyrimidinyl group, a pyridazinyl group, a quinolyl group, an isoquinolyl group, a quinoxalinyl group, a quinazolinyl group, a carbazolyl group, and triazinyl group; and
xe₆₁₁ to xe₆₁₆ may be each independently selected from 0, 1, 2, and 3.

The compound of Formula 601 and the compound of Formula 602 may include at least one of compounds ET1 to ET15.

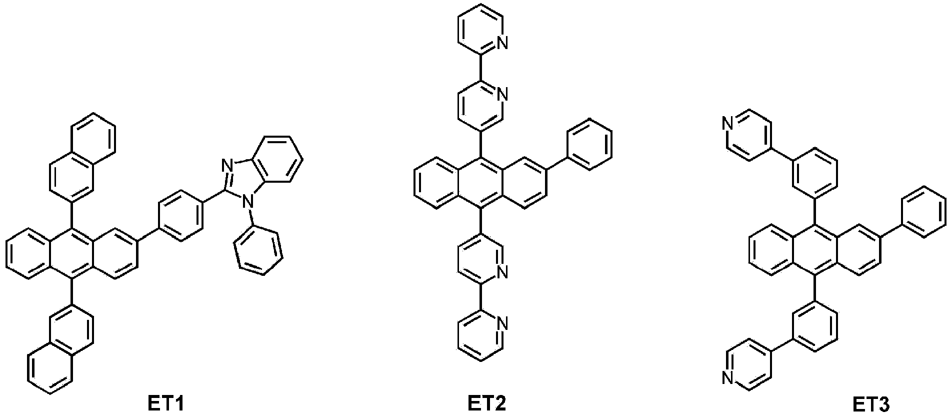

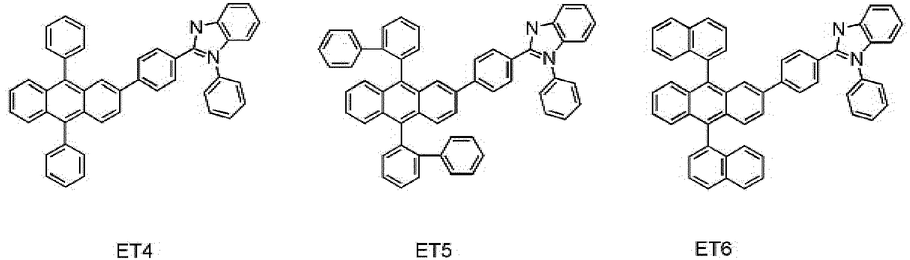

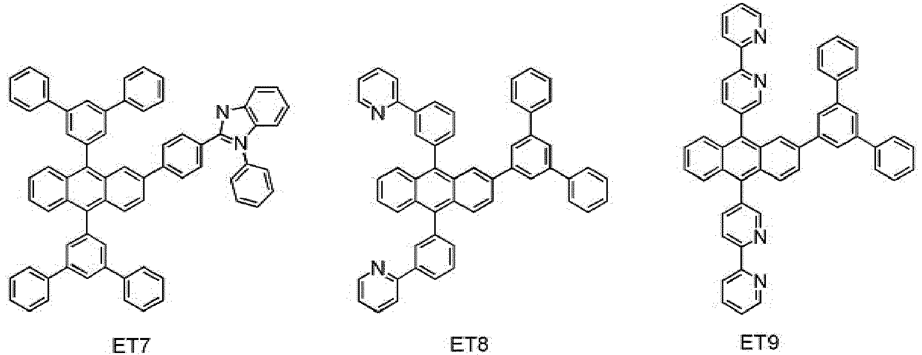

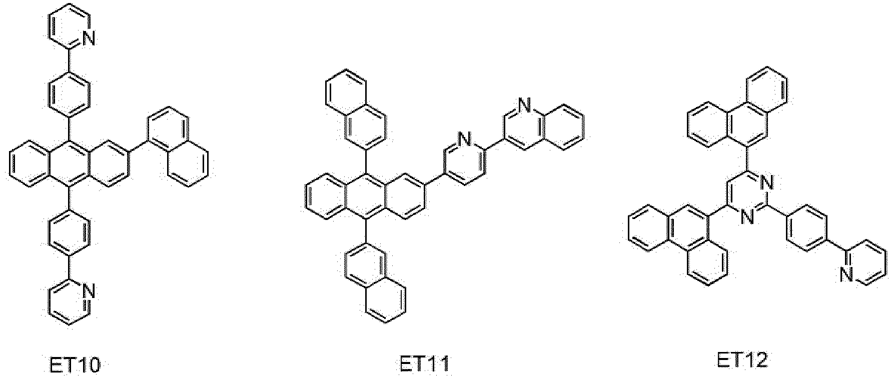

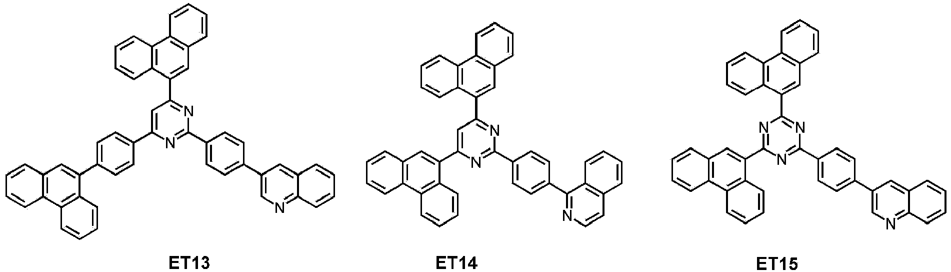

The thickness of the ETL may be from about 100 Å to about 1,000 Å, and in some embodiments, may be from about 150 Å to about 500 Å. When the thickness of the ETL is within these ranges, the ETL may have satisfactory electron transporting ability without a substantial increase in driving voltage.

In some embodiments, the ETL may further include a metal-containing material, in addition to the above-described compounds.

The metal-containing material may include a Li complex. Non-limiting examples of the Li complex are LiQ (lithium quinolate) or LiBTz (lithium [2-(2-hydroxyphenyl)benzothiazole]).

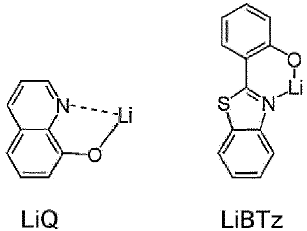

In some embodiments, the electron transport region may include an electron injection layer (EIL) that may facilitate injection of electrons from the second electrode 190.

For example, the electron injection layer may include at least one selected from LiF, NaCl, CsF, Li₂O, and BaO. However, embodiments are not limited thereto.

The thickness of the EIL may be from about 1 Å to about 100 Å, and in some embodiments, may be from about 3 Å to about 90 Å. When the thickness of the EIL is within these ranges, the organic light-emitting device may have satisfactory electron injection ability without a substantial increase in driving voltage.

The layers or regions of the organic layer 150 may be formed by any of a variety of methods, for example, vacuum deposition, spin coating, casting, Langmuir-Blodgett (LB) deposition, inkjet printing, laser printing, laser induced thermal imaging (LITI), and the like.

The second electrode 190 may be disposed on the organic layer 150. The second electrode 190 may be a cathode. A material for the second electrode 150 may be, for example, a metal, an alloy, or an electrically conductive compound that have a low work function, or a combination thereof. Non-limiting examples of the material for the second electrode are lithium (Li), magnesium (Mg), aluminum (Al), aluminum-lithium (Al-Li), calcium (Ca), magnesium-indium (Mg-In), and magnesium-silver (Mg-Ag). In some embodiments, to manufacture a top-emission light-emitting device, the second electrode190 may be formed as a transmissive electrode by using, for example, indium tin oxide (ITO) or indium zinc oxide (IZO). However, embodiments of the present disclosure are not limited thereto.

Although the organic light-emitting device has been described above in connection with FIG. 1, embodiments are not limited thereto.

As used herein, a C₁-C₆₀ alkyl group refers to a linear or branched aliphatic hydrocarbon monovalent group having 1 to 60 carbon atoms. Non-limiting examples of the C₁-C₆₀ alkyl group include a methyl group, an ethyl group, an n-propyl group an iso-propyl group, an n-butyl group, an iso-butyl group, a sec-butyl group, a tert-butyl group, a pentyl group, an iso-amyl group, and a hexyl group. A C₁-C₆₀ alkylene group refers to a divalent group having the same structure as the C₁-C₆₀ alkyl.

As used herein, a C₁-C₆₀ alkoxy group refers to a monovalent group represented by - OA₁₀₁ (where A₁₀₁ is a C₁-C₆₀ alkyl group, as described above. Non-limiting examples of the C₁-C₆₀ alkoxy group are a methoxy group, an ethoxy group, and an isopropyloxy group.

As used herein, a C₂-C₆₀ alkenyl group refers to a hydrocarbon group including at least one carbon double bond in the middle or terminal of the C₂-C₆₀ alkyl group. Non-limiting examples of the C₂-C₆₀ alkenyl group are an ethenyl group, a propenyl group, and a butenyl group. A C₂-C₆₀ alkylene group refers to a divalent group having the same structure as the C₂-C₆₀ alkenyl group.

As used herein, a C₂-C₆₀ alkynyl group refers to a hydrocarbon group including at least one carbon triple bond in the middle or terminal of the C₂-C₆₀ alkyl group. Non-limiting examples of the C₂-C₆₀ alkynyl group are an ethynyl group, and a propynyl group. A C₂-C₆₀ alkynylene group used herein refers to a divalent group having the same structure as the C₂-C₆₀ alkynyl group.

As used herein, a C₃-C₁₀ cycloalkyl group refers to a monovalent, monocyclic hydrocarbon group having 3 to 10 carbon atoms. Non-limiting examples of the C₃-C₁₀ cycloalkyl group are a cyclopropyl group, a cyclobutyl group, a cyclopentyl group, a cyclohexyl group, and a cycloheptyl group. A C₃-C₁₀ cycloalkylene group refers to a divalent group having the same structure as the C₃-C₁₀ cycloalkyl group.

As used herein, a C₁-C₁₀ heterocycloalkyl group refers to a monovalent monocyclic group having 1 to 10 carbon atoms in which at least one hetero atom selected from N, O, P, and S is included as a ring-forming atom. Non-limiting examples of the C₂-C₁₀ heterocycloalkyl group are a tetrahydrofuranyl group, and a tetrahydrothiophenyl group. A C₁-C₁₀ heterocycloalkylene group refers to a divalent group having the same structure as the C₁-C₁₀ heterocycloalkyl group.

As used herein, a C₃-C₁₀ cycloalkenyl group refers to a monovalent monocyclic group having 3 to 10 carbon atoms that includes at least one double bond in the ring but does not have aromaticity. Non-limiting examples of the C₃-C₁₀ cycloalkenyl group are a cyclopentenyl group, a cyclohexenyl group, and a cycloheptenyl group. A C₃-C₁₀ cycloalkenylene group refers to a divalent group having the same structure as the C₃-C₁₀ cycloalkenyl group.

As used herein, a C₁-C₁₀ heterocycloalkenyl group used herein refers to a monovalent monocyclic group having 1 to 10 carbon atoms that includes at least one double bond in the ring and in which at least one hetero atom selected from N, O, P, and S is included as a ring-forming atom. Non-limiting examples of the C₁-C₁₀ heterocycloalkenyl group are a 2,3-hydrofuranyl group, and a 2,3-hydrothiophenyl group. A C₁-C₁₀ heterocycloalkenylene group used herein refers to a divalent group having the same structure as the C₁-C₁₀ heterocycloalkenyl group.

As used herein, a C₆-C₆₀ aryl group refers to a monovalent, aromatic carbocyclic aromatic group having 6 to 60 carbon atoms, and a C₆-C₆₀ arylene group refers to a divalent, aromatic carbocyclic group having 6 to 60 carbon atoms. Non-limiting examples of the C₆-C₆₀ aryl group are a phenyl group, a naphthyl group, an anthracenyl group, a phenanthrenyl group, a pyrenyl group, and a chrysenyl group. When the C₆-C₆₀ aryl group, and the C₆-C₆₀arylene group include at least two rings, the rings may be fused to each other.

As used herein, a C₁-C₆₀ heteroaryl group refers to a monovalent, aromatic carbocyclic aromatic group having 1 to 60 carbon atoms and at least one hetero atom selected from N, O, P, and S as a ring-forming atom. A C₁-C₆₀ heteroarylene group refers to a divalent, aromatic carbocyclic group having 1 to 60 carbon atoms, and at least one hetero atom selected from N, O, P, and S as a ring-forming atom. Non-limiting examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group, and the C₁-C₆₀ heteroarylene group include at least two rings, the rings may be fused to each other.

As used herein, a C₆-C₆₀ aryloxy group indicates -OA₁₀₂ (where A₁₀₂ is a C₆-C₆₀ aryl group, as described above), and a C₆-C₆₀ arylthio group indicates -SA₁₀₃ (where A₁₀₃ is a C₆-C₆₀ aryl group, as described above).

As used herein, a monovalent non-aromatic condensed polycyclic group refers to a monovalent group that includes at least two rings condensed to each other and includes only carbon atoms as ring-forming atoms and that represents non-aromaticity as a whole. An example of the monovalent non-aromatic condensed polycyclic group is a fluorenyl group. As used herein, a divalent non-aromatic condensed polycyclic group refers to a divalent group with the same structure as the monovalent non-aromatic condensed polycyclic group.

As used herein, a monovalent non-aromatic condensed heteropolycyclic group refers to a monovalent group that includes at least two rings condensed to each other and include carbon and hetero atoms selected from N, O, P and S as ring-forming atoms and that represents non-aromaticity as a whole. An example of the monovalent non-aromatic condensed heteropolycyclic group is a carbazolyl group. As used herein, a divalent non-aromatic condensed heteropolycyclic group refers to a divalent group with the same structure as the monovalent non-aromatic condensed polycyclic group.

One or more embodiments of the present disclosure will now be described in detail with reference to the following examples including synthesis examples. However, these examples are only for illustrative purposes and are not intended to limit the scope of the one or more embodiments of the present disclosure.

### Example 1

An ITO/ Ag/ITO glass substrate was cleaned by ultrasonication with isopropyl alcohol and pure water, each for about 5 minutes, and then by irradiation of ultraviolet rays for about 30 minutes and exposure to ozone to form an ITO/Ag/ITO anode. Then, m-MTDATA was vacuum-deposited on the ITO/Ag/ITO anode to form a hole injection layer (HIL) having a thickness of about 350 Å, and Compound A was then vacuum-deposited on the HIL to form a hole transport layer (HTL) having a thickness of about 500 Å. Next, compound HTa-1 was vacuum-deposited on the HTL to form an auxiliary emission layer having a thickness of about 100 Å.

mCP as a host and compound PD-2 as a dopant were co-deposited on the auxiliary emission layer in a weight ratio of about 95:5 to form an emission layer (EML) having a thickness of about 300 Å. Next, Alq₃ and LiF were co-deposited on the EML in a weight ratio of about 1:1 to form an electron transport layer (ETL) having a thickness of about 300 Å. LiF was vacuum-deposited on the ETL to form an electron injection layer (EIL) having a thickness of about 10 Å, and then MgAg was vacuum-deposited to form a cathode having a thickness of about 100 Å, thereby manufacturing an organic light-emitting device.

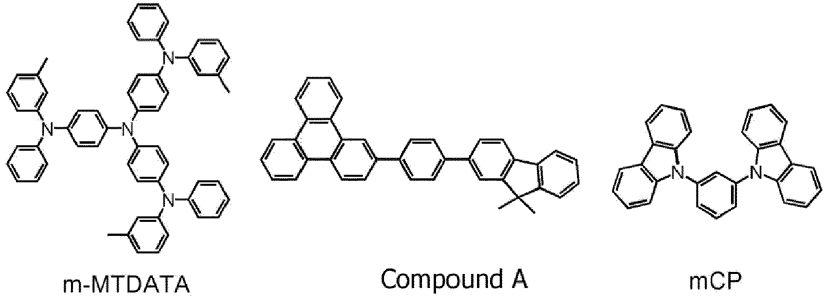

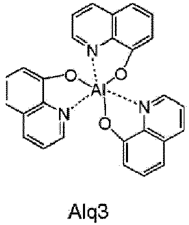

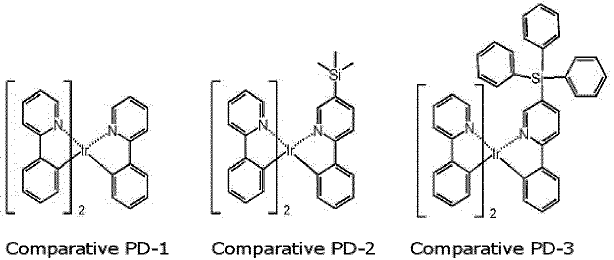

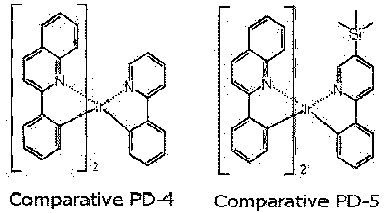

### Examples 2 to 30

Organic light-emitting devices were manufactured in the same manner as in Example 1, except that compounds shown in Table 1 were used as compounds for the auxiliary emission layer and the dopant.

### Examples 31 to 40

Organic light-emitting devices were manufactured in the same manner as in Example 1, except that two compounds shown in Table 1 used as compounds for the auxiliary emission layer were co-deposited in a weight ratio of about 1 : 6 and the compounds shown in Table 1 were used as the dopant.

### Comparative Examples 1 to 14

Organic light-emitting devices were manufactured in the same manner as in Example 1, except that compounds shown in Table 1 were used as compounds for the auxiliary emission layer and as dopants.

Current efficiencies, lifetimes, and chromaticities of the organic light-emitting devices of Examples 1 to 40 and Comparative Examples 1 to 14 were evaluated using current-voltage-luminance (IVL) measurement units (PhotoResearch PR650 and Keithley 238). The results are shown in Table 1. In Table 1, the current efficiencies and lifetimes are relative levels to those of the organic light-emitting device of Comparative Example 3. The chromaticities are represented as CIE 1931 standard chromaticity coordinates. The organic light-emitting devices of Examples 1 to 40 and Comparative Examples 1 to 14 were found to emit green light.

**[Table 1]**

| Example | Auxiliary emission layer | Dopant | Efficiency | Lifetime | Chromaticity |
|---|---|---|---|---|---|
| Example1 | HTa-1 | PD-2 | 1.3 | 1.3 | 0.22 / 0.71 |
| Example2 | HTa-1 | PD-3 | 1.4 | 1.2 | 0.22 / 0.70 |
| Example3 | HTa-1 | PD-50 | 1.4 | 1.3 | 0.23 / 0.69 |
| Example4 | HTa-1 | PD-5 | 1.3 | 1.2 | 0.23 / 0.69 |
| Example5 | HTa-1 | PD-8 | 1.4 | 1.2 | 0.23 / 0.70 |
| Example6 | HTa-3 | PD-2 | 1.3 | 1.2 | 0.22 / 0.70 |
| Example7 | HTa-3 | PD-3 | 1.4 | 1 | 0.23 / 0.69 |
| Example8 | HTa-3 | PD-50 | 1.3 | 1.2 | 0.22 / 0.70 |
| Example9 | HTa-3 | PD-5 | 1.3 | 1.2 | 0.23 / 0.69 |
| Example10 | HTa-3 | PD-8 | 1.4 | 1 | 0.22 / 0.70 |
| Example11 | HTa-4 | PD-2 | 1.3 | 1.3 | 0.23 / 0.70 |
| Example12 | HTa-4 | PD-3 | 1.4 | 1.2 | 0.22 / 0.71 |
| Example13 | HTa-4 | PD-50 | 1.3 | 1.1 | 0.23 / 0.70 |
| Example14 | HTa-4 | PD-5 | 1.4 | 1.2 | 0.22 / 0.70 |
| Example15 | HTa-4 | PD-8 | 1.4 | 1 | 0.23 / 0.69 |
| Example16 | HTa-5 | PD-2 | 1.3 | 1.2 | 0.23 / 0.70 |
| Example17 | HTa-5 | PD-3 | 1.4 | 1.1 | 0.22 / 0.71 |
| Example18 | HTa-5 | PD-50 | 1.3 | 1 | 0.23 / 0.69 |
| Example19 | HTa-5 | PD-5 | 1.3 | 1.2 | 0.23 / 0.70 |
| Example20 | HTa-5 | PD-8 | 1.3 | 1.3 | 0.22 / 0.71 |
| Example21 | HTa-47 | PD-2 | 1.3 | 1.3 | 0.23 / 0.69 |
| Example22 | HTa-47 | PD-3 | 1.4 | 1.1 | 0.22 / 0.70 |
| Example23 | HTa-47 | PD-50 | 1.4 | 1.2 | 0.23 / 0.70 |
| Example24 | HTa-47 | PD-5 | 1.3 | 1 | 0.22 / 0.71 |
| Example25 | HTa-47 | PD-8 | 1.3 | 1 | 0.23 / 0.70 |
| Example26 | HTa-278 | PD-2 | 1.4 | 1.2 | 0.23 / 0.70 |
| Example27 | HTa-278 | PD-3 | 1.3 | 1 | 0.22 / 0.71 |
| Example28 | HTa-278 | PD-50 | 1.4 | 1.2 | 0.23 / 0.69 |
| Example29 | HTa-278 | PD-5 | 1.3 | 1.1 | 0.22 / 0.70 |
| Example30 | HTa-278 | PD-8 | 1.4 | 1 | 0.23 / 0.70 |
| Example31 | HTa-1/HTb-13 | PD-2 | 1.4 | 1.2 | 0.23 / 0.70 |
| Example32 | HTa-1/HTb-13 | PD-3 | 1.3 | 1 | 0.22 / 0.71 |
| Example33 | HTa-1/HTb-13 | PD-22 | 1.4 | 1.2 | 0.23 / 0.69 |
| Example34 | HTa-1/HTb-13 | PD-37 | 1.3 | 1.1 | 0.22 / 0.70 |
| Example35 | HTa-1/HTb-13 | PD-16 | 1.4 | 1 | 0.23 / 0.70 |
| Example36 | HTa-1/HTb-1 | PD-2 | 1.4 | 1.3 | 0.23 / 0.69 |
| Example37 | HTa-1/HTb-1 | PD-3 | 1.3 | 1.1 | 0.23 / 0.70 |
| Example38 | HTa-1/HTb-1 | PD-22 | 1.3 | 1 | 0.22 / 0.71 |
| Example39 | HTa-1/HTb-1 | PD-37 | 1.4 | 1 | 0.23 / 0.69 |
| Example40 | HTa-1/HTb-1 | PD-16 | 1.3 | 1.2 | 0.22 / 0.70 |
| Comparative Example1 | Compound A | PD-2 | 1 | 1.1 | 0.22 / 0.69 |
| Comparative Example2 | Compound A | PD-3 | 1 | 1 | 0.22 / 0.70 |
| Comparative Example3 | Compound A | PD-50 | 1 | 1 | 0.23 / 0.70 |
| Comparative Example4 | HTa-1 | Comparative PD-1 | 1 | 1 | 0.27 / 0.67 |
| Comparative Example5 | HTa-1 | Comparative PD-2 | 1 | 1.1 | 0.30 / 0.66 |
| Comparative Example6 | HTa-1 | Comparative PD-1 | 1.1 | 1 | 0.28 / 0.66 |
| Comparative Example7 | HTa-1 | Comparative PD-2 | 1.2 | 1.1 | 0.29 / 0.67 |
| Comparative Example8 | HTa-3 | Comparative PD-1 | 1.2 | 1 | 0.27 / 0.67 |
| Comparative Example9 | HTa-1 | Comparative PD-3 | 1.1 | 1 | 0.30 / 0.65 |
| Comparative Example10 | HTa-3 | Comparative PD-2 | 1.2 | 1.1 | 0.31 / 0.66 |
| Comparative Example11 | HTa-4 | Comparative PD-2 | 1.1 | 1 | 0.30 / 0.66 |
| Comparative Example12 | HTa-5 | Comparative PD-2 | 1.1 | 1 | 0.30 / 0.66 |
| Comparative Example13 | HTa-47 | Comparative PD-2 | 1.1 | 1 | 0.31 / 0.66 |
| Comparative Example14 | HTa-278 | Comparative PD-2 | 1.1 | 1 | 0.30 / 0.66 |

### Example 41

An ITO / Ag / ITO glass substrate was cleaned by ultrasonication with isopropyl alcohol and pure water, each for about 5 minutes, and then by irradiation of ultraviolet rays for about 30 minutes and exposure to ozone to form an ITO/Ag/ITO anode. Then, m-MTDATA was vacuum-deposited on the ITO/Ag/ITO anode to form a HIL having a thickness of about 750 Å, and Compound A was then vacuum-deposited on the HIL to form a HTL having a thickness of about 500 Å. Next, Compound HTa-1 was vacuum-deposited on the HTL to form an auxiliary emission layer having a thickness of about 100 Å.

mCP as a host and Compound PD-51 as a green dopant were co-deposited on the auxiliary emission layer in a weight ratio of about 97:3 to form an EML having a thickness of about 300 Å. Next, Alq₃ and LiF were co-deposited on the EML in a weight ratio of about 1:1 to form an ETL having a thickness of about 300 Å. LiF was vacuum-deposited on the ETL to form an EIL having a thickness of about 10 Å, and then MgAg was vacuum-deposited to form a cathode having a thickness of about 100 Å, thereby manufacturing an organic light-emitting device.

### Examples 42 to 50

Organic light-emitting devices were manufactured in the same manner as in Example 41, except that compounds shown in Table 2 were used as compounds for the auxiliary emission layer and as dopants.

### Examples 51 to 59

Organic light-emitting devices were manufactured in the same manner as in Example 41, except that two compounds shown in Table 2 used as compounds for the auxiliary emission layer were co-deposited in a weight ratio of about 1 : 6 and the compounds shown in Table 2 were used as the dopant.

### Comparative Examples 15 to 24

Organic light-emitting devices were manufactured in the same manner as in Example 41, except that compounds shown in Table 2 were used as compounds for the auxiliary emission layer and as dopants.

Current efficiencies, lifetimes, and chromaticities of the organic light-emitting devices of Examples 41 to 59 and Comparative Examples 15 to 24 were evaluated using current-voltage-luminance (IVL) measurement units (PhotoResearch PR650 and Keithley 238). The results are shown in Table 2. In Table 2, the current efficiencies and lifetimes are relative levels to those of the organic light-emitting device of Comparative Example 16. The chromaticities are represented as CIE 1931 standard chromaticity coordinates. The organic light-emitting devices of Examples 41 to 59 and Comparative Examples 15 to 24 were found to emit red light.

**[Table 2]**

| Example | Auxiliary emission layer | Dopant | Efficiency | Lifetime | Chromaticity |
|---|---|---|---|---|---|
| Example41 | HTa-1 | PD-51 | 1.2 | 1.1 | 0.66 / 0.34 |
| Example42 | HTa-1 | PD-52 | 1.3 | 1 | 0.66 / 0.33 |
| Example43 | HTa-3 | PD-51 | 1.2 | 1.1 | 0.66 / 0.34 |
| Example44 | HTa-3 | PD-52 | 1.3 | 1 | 0.65 / 0.34 |
| Example45 | HTa-4 | PD-51 | 1.2 | 1.2 | 0.65 / 0.34 |
| Example46 | HTa-4 | PD-52 | 1.3 | 1.1 | 0.66 / 0.33 |
| Example47 | HTa-5 | PD-51 | 1.2 | 1.1 | 0.66 / 0.34 |
| Example48 | HTa-5 | PD-52 | 1.3 | 1.2 | 0.66 / 0.33 |
| Example49 | HTa-47 | PD-51 | 1.2 | 1.1 | 0.66 / 0.34 |
| Example50 | HTa-47 | PD-52 | 1.3 | 1.2 | 0.66 / 0.33 |
| Example 51 | HTa-1 | PD-193 | 1.1 | 1.1 | 0.64 / 0.34 |
| Example 52 | HTa-1 | PD-83 | 1.15 | 1.1 | 0.64 / 0.34 |
| Example 53 | HTa-4/HTb-1 | PD-52 | 1.3 | 1.1 | 0.66 / 0.33 |
| Example 54 | HTa-5/HTb-1 | PD-51 | 1.2 | 1.1 | 0.66 / 0.34 |
| Example 55 | HTa-5/HTb-1 | PD-52 | 1.3 | 1.2 | 0.66 / 0.33 |
| Example 56 | HTa-47/HTb-1 | PD-51 | 1.2 | 1.1 | 0.66 / 0.34 |
| Example 57 | HTa-47/HTb-1 | PD-52 | 1.3 | 1.2 | 0.66 / 0.33 |
| Example 58 | HTa-4/HTb-1 | PD-193 | 1.1 | 1.1 | 0.65 / 0.33 |
| Example 59 | HTa-5/HTb-1 | PD-83 | 1.1 | 1.1 | 0.65 / 0.34 |
| Comparative Example15 | Compound A | PD-51 | 1.1 | 1.1 | 0.66 / 0.34 |
| Comparative Example16 | Compound A | PD-52 | 1 | 1 | 0.66 / 0.33 |
| Comparative Example17 | HTa-1 | Comparative PD-4 | 1.1 | 1 | 0.66 / 0.34 |
| Comparative Example18 | HTa-1 | Comparative PD-5 | 1 | 1 | 0.63 / 0.34 |
| Comparative Example19 | HTa-3 | Comparative PD-4 | 1 | 1.1 | 0.62 / 0.35 |
| Comparative Example20 | HTa-3 | Comparative PD-5 | 1.1 | 1 | 0.63 / 0.34 |
| Comparative Example21 | HTa-4 | Comparative PD-5 | 1 | 1 | 0.62 / 0.35 |
| Comparative Example22 | HTa-5 | Comparative PD-5 | 1.2 | 1 | 0.63 / 0.34 |
| Comparative Example23 | HTa-47 | Comparative PD-5 | 1 | 1.1 | 0.62 / 0.35 |
| Comparative Example24 | HTa-278 | Comparative PD-5 | 1.1 | 1.1 | 0.35 |

Based on the data in Tables 1 and 2, the organic light-emitting device of Examples1 to 59 were found to have improved current efficiencies and lifetimes, compared to those of the organic light-emitting devices of Comparative Examples 1 to 24.

As described above, according to the one or more embodiments, an organic light-emitting device may include an organometallic compound represented by Formula 1 as a dopant of an emission layer and include a first compound represented by Formula 2a or 2B in a hole transport region, and thus may have good color coordinates and improved efficiency and lifetime characteristics.

## Claims

1. An organic light-emitting device comprising:
a first electrode;
a second electrode disposed opposite to the first electrode;
an emission layer between the first electrode and the second electrode; and
a hole transport region between the first electrode and the emission layer, wherein the hole transport region comprises an auxiliary emission layer adjacent to the emission layer, a hole transport layer and a hole injection layer,
wherein the hole injection layer is on the first electrode,
wherein the hole transport layer is on the hole injection layer, and
wherein the emission layer comprises an organometallic compound represented by Formula 1, and the auxiliary emission layer comprises a first compound represented by Formula 2A or Formula 2B:
<Formula 1> M(L1)ₙ₁(L2)ₙ₂
wherein, in Formula 1,
M is selected from iridium (Ir), platinum (Pt), osmium (Os), titanium (Ti), zirconium (Zr), hafnium (Hf), europium (Eu), terbium (Tb), thulium (Tm), and rhodium (Rd);
L1 is a ligand represented by Formula 1A;
L2 is a ligand represented by Formula 1B, wherein L1 and L2 differ from each other;
n1 and n2 are each independently 1 or 2, wherein n1+n2=2 or n1+n2=3, the two L1s when n1 is 2 are the same or differ from each other, and the two L2s when n2 is 2 are the same or differ from each other; 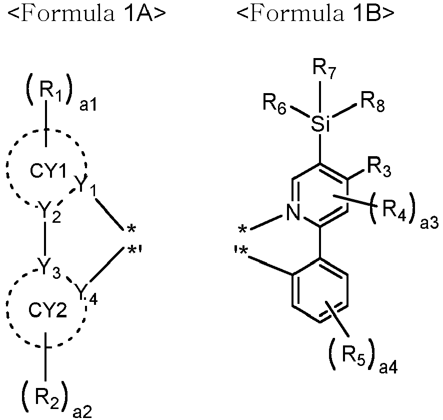 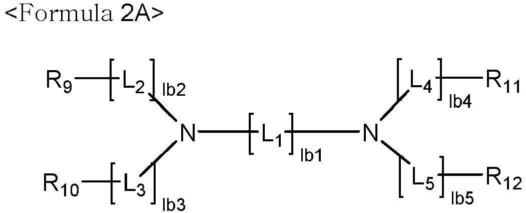 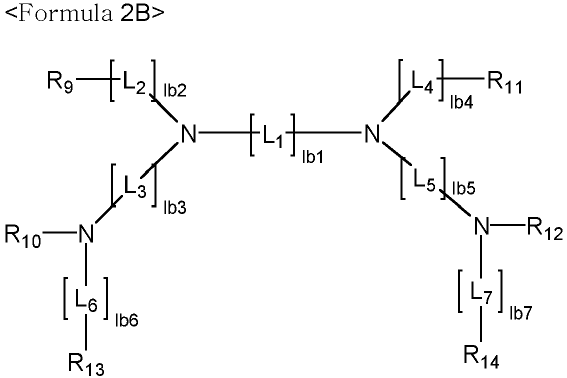
wherein, in Formulae 1A, 1B, 2A, and 2B,
CY1 and CY2 are each independently selected from a C₅-C₆₀ cyclic group and a C₂-C₆₀ heterocyclic group, and CY1 and CY2 are bound to each other via a single bond;
Y₁ to Y₄ are each independently carbon (C) or nitrogen (N), Y₁ and Y₂ are bound to each other via a single bond or double bond, and Y₃ and Y₄ are bound to each other via a single bond or double bond;
L₁ to L₇ are each independently selected from a substituted or unsubstituted C₁-C₂₀ alkylene group, -O-, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
R₁ to R₅, and Rg to R₁₄ are each independently selected from a hydrogen atom, a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), and -B(Q₆)(Q₇), provided that R₃ is not hydrogen;
R₆ to R₈ are each independently selected from
a C₁-C₁₀ alkyl group, and
a C₁-C₁₀ alkyl group substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof and a phosphoric acid group or a salt thereof;
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₆-C₆₀ arylene group, the substituted C₁-C₆₀ heteroarylene group, the substituted monovalent non-aromatic condensed polycyclic group, and the substituted monovalent non-aromatic condensed heteropolycyclic group is selected from
a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), and -B(Q₁₆)(Q₁₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇), and -N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇, and Q₃₁ to Q₃₇ are each independently selected from a hydrogen, a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a₁ and a₂ are each independently an integer selected from 0 to 5;
a₃ is an integer selected from 0 to 2;
a₄ is an integer selected from 0 to 4, wherein optionally, a plurality of R₅s when a₄ is 2 or greater are condensed to a benzene ring to which the R₅s are bound, thereby to form a condensed ring;
Ib₁ is an integer selected from 1 to 5;
Ib₂ to Ib₇ are each independently an integer selected from 0 to 4; and
* and *' are binding sites to M in Formula 1.

2. The organic light-emitting device of claim 1, wherein M in Formula 1 is osmium (Os), iridium (Ir), or platinum (Pt).

3. The organic light-emitting device of claim 1, wherein M in Formula 1 is iridium (Ir).

4. The organic light-emitting device of claim 1, wherein n1 and n2 in Formula 1 are each independently 1 or 2, and n1+n2=3.

5. The organic light-emitting device of claim 1, wherein Y₁ in Formula 1A is a nitrogen (N), and Y₂ to Y₄ are a carbon (C).

6. The organic light-emitting device of claim 1, wherein CY1 and CY2 in Formula 1A are each independently selected from a benzene, a naphthalene, a fluorene, a spiro-fluorene, an indole, an indene, a furan, a thiophene, a carbazole, a benzofuran, a benzothiophene, a dibenzofuran, a dibenzothiophene, a pyrrole, an imidazole, a pyrazole, a thiazole, an isothiazole, an oxazole, an isoxazole, a triazole, a pyridine, a pyrimidine, a pyrazine, a pyridazine, a quinoline, a triazine, an isoquinoline, a benzoquinoline, a quinoxaline, a quinazoline, a naphthyridine, a benzimidazole, a benzoxazole, an isobenzoxazole, and an oxadiazole.

7. The organic light-emitting device of claim 1, wherein CY1 in Formula 1A is selected from a pyrrole, an imidazole, a triazole, an oxadiazole, a pyridine, a pyrimidine, a pyrazine, a quinoline, an isoquinoline, and a triazine.

8. The organic light-emitting device of claim 1, wherein CY2 in Formula 1A is selected from a benzene, a naphthalene, a furan, a thiophene, a pyridine, a pyrimidine, a pyrazine, a triazine, a fluorene, a carbazole, a phenyl-carbazole, an indole, an oxadiazole, a benzofuran, a benzothiophene, a dibenzofuran, and a dibenzothiophene.

9. The organic light-emitting device of claim 1, wherein in Formula 1A, CY1 is selected from a pyridine, a pyrimidine, a triazine, a quinoline, an isoquinoline, an oxadiazole, a triazole, and an imidazole; and
CY2 is selected from a benzene, a pyridine, a pyrimidine, a dibenzofuran, a dibenzothiophene, a thiophene, a benzothiophene, a furan, a benzofuran, an indole, a carbazole, and a phenyl-carbazole.

10. The organic light-emitting device of claim 1, wherein R₁ to R₅ in Formula 1A and Formula 1B are each independently selected from
a hydrogen atom, provided that R₃ is not hydrogen, a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, and a phenoxy group,
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, and a pentoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, and a phenoxy group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group; and
R₆ to R₈ are selected from a methyl group, an ethyl group, an n-propyl group, an iso-propyl group, an n-butyl group, an iso-butyl group, a sec-butyl group, and a tert-butyl group, and R₆ to R₈ are same each other.

11. The organic light-emitting device of claim 1, wherein the organometallic compound represented by Formula 1 is selected from compounds PD-1 to PD-79 and PD-81 to PD-193:

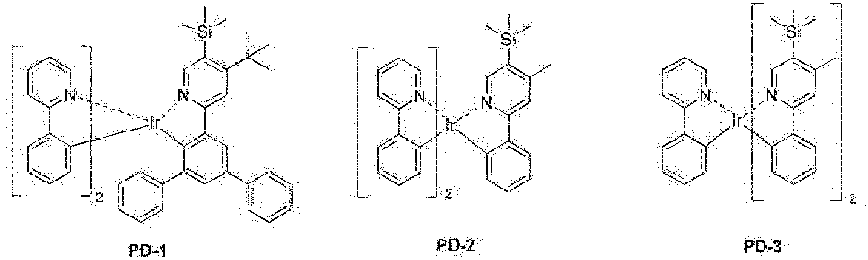

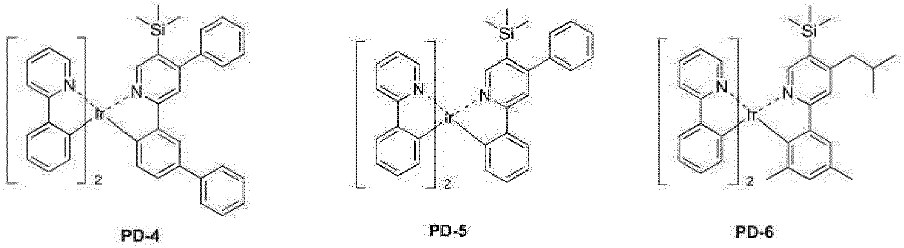

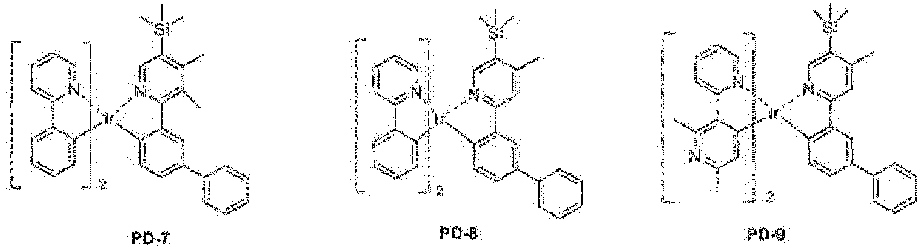

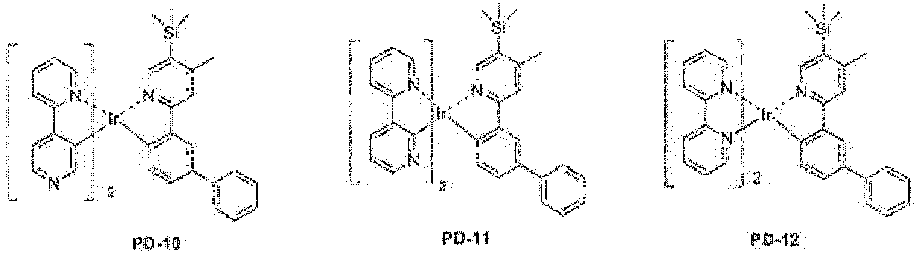

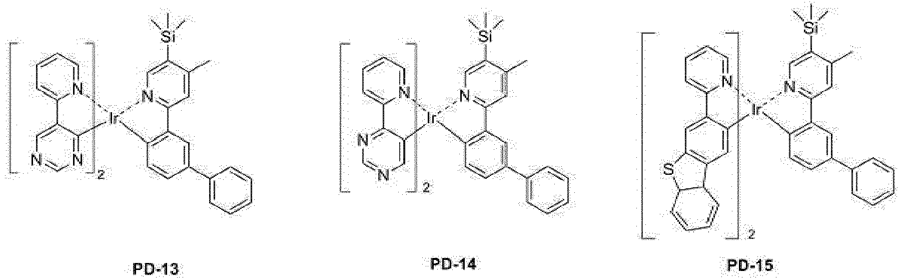

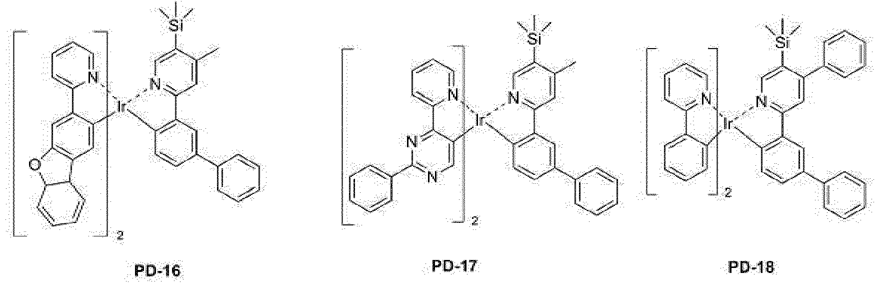

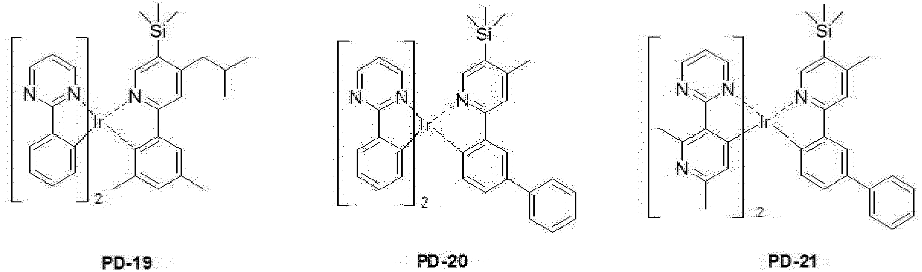

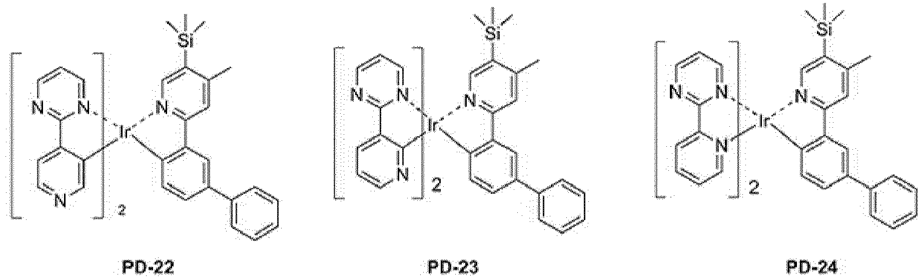

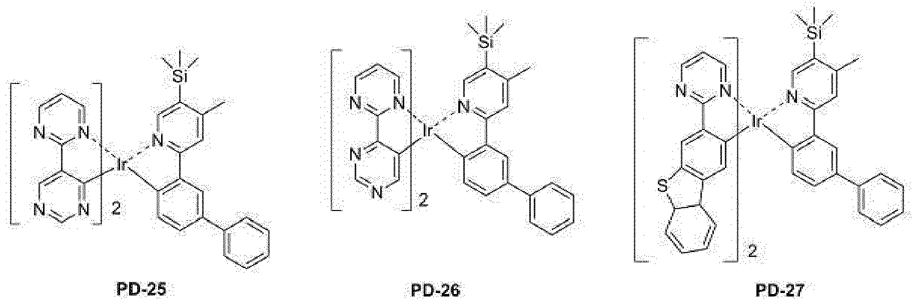

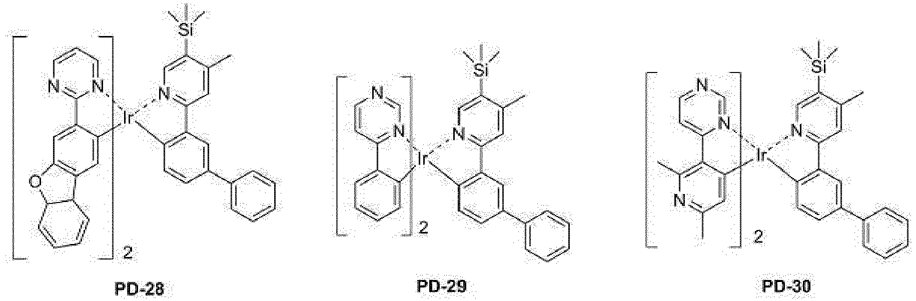

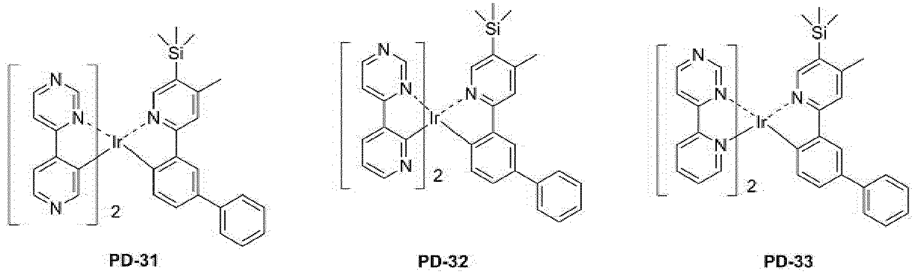

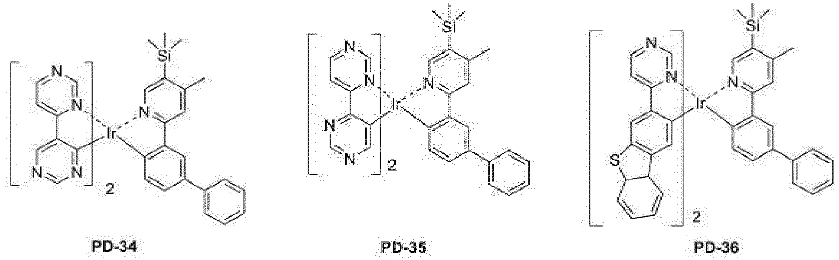

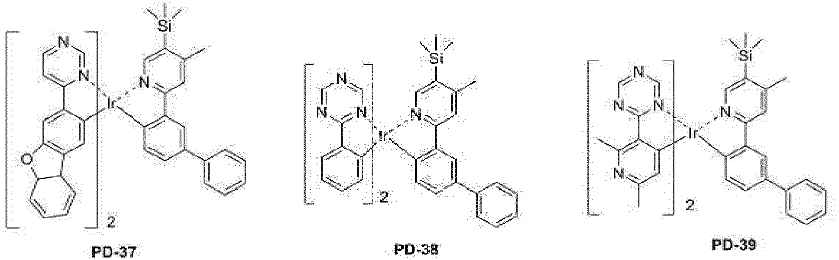

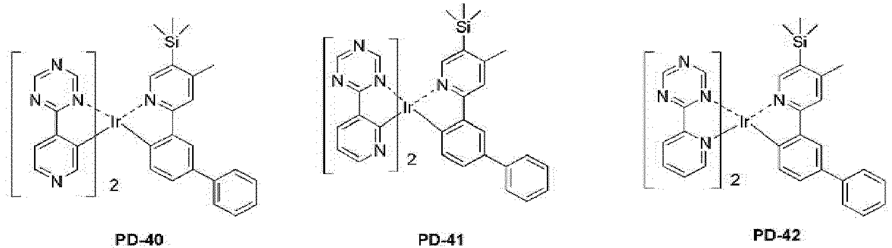

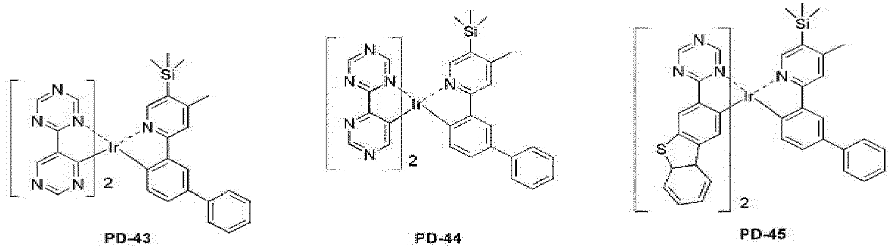

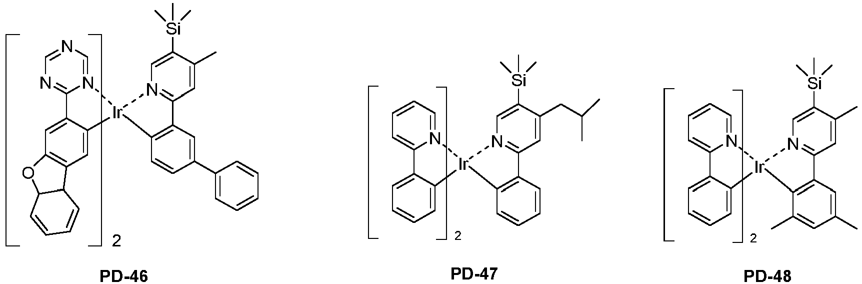

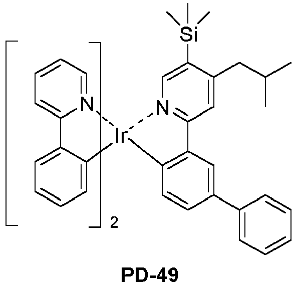

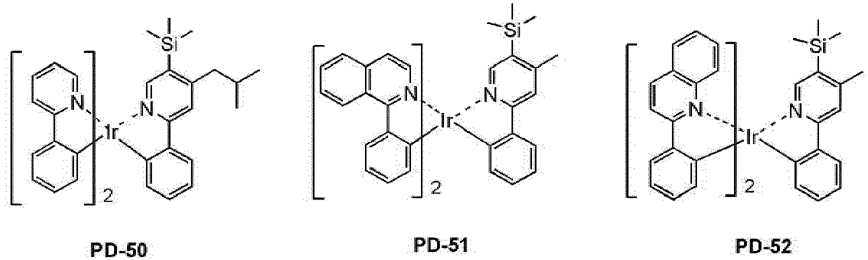

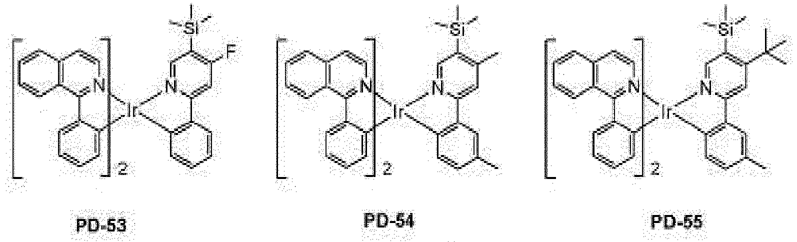

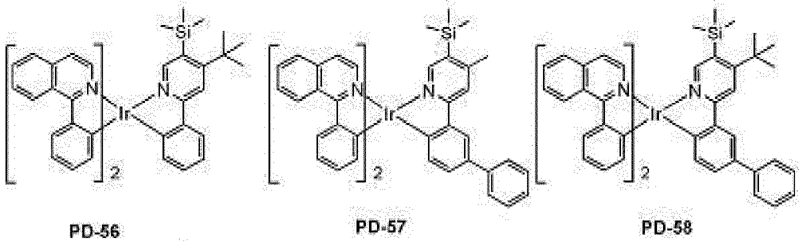

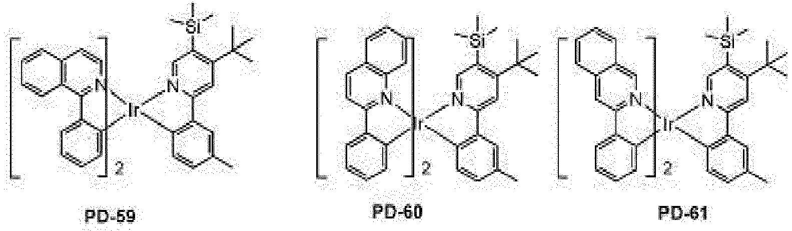

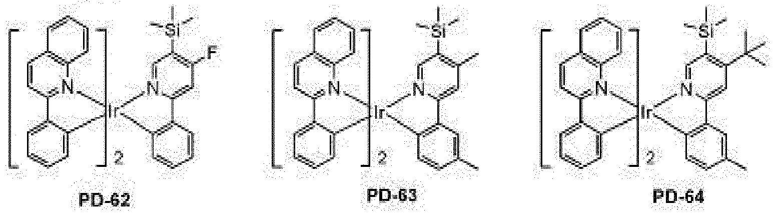

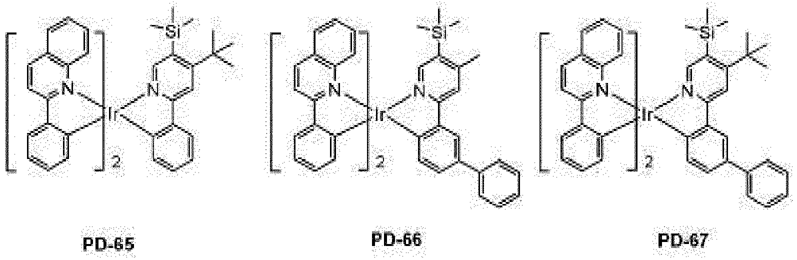

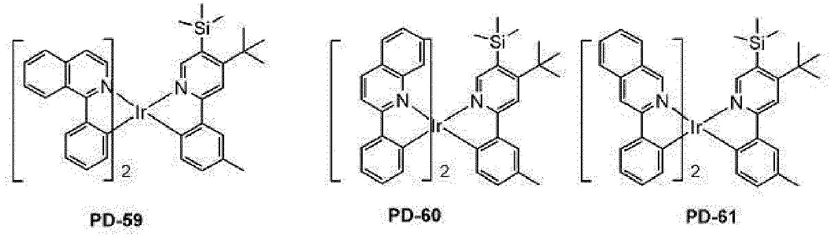

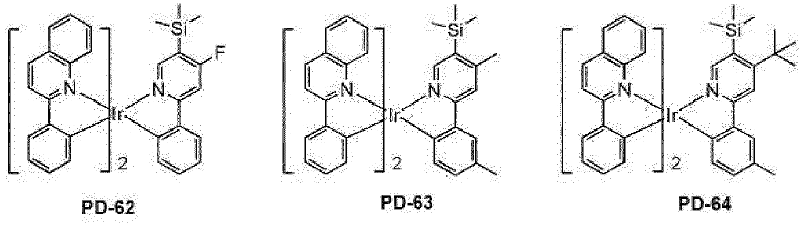

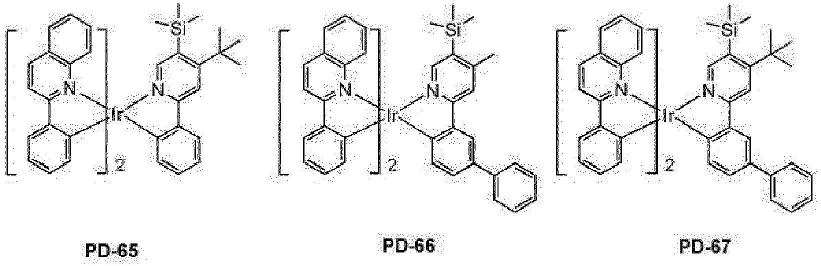

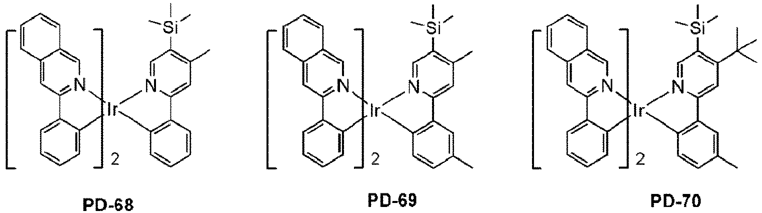

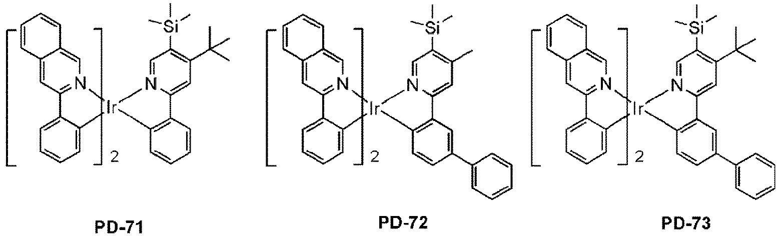

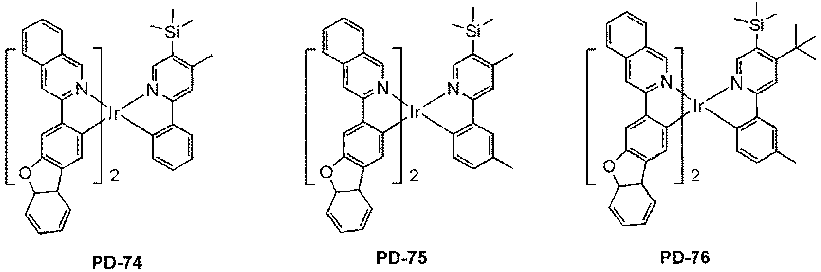

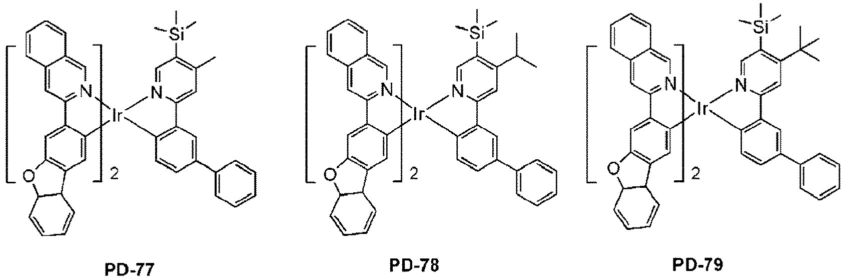

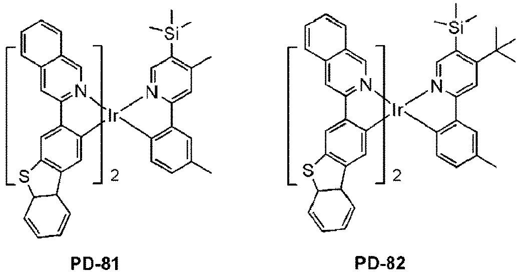

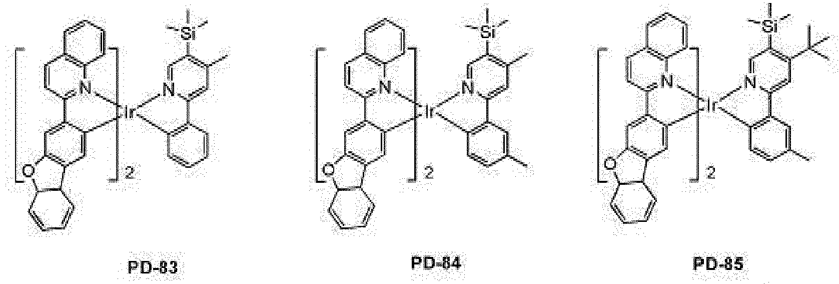

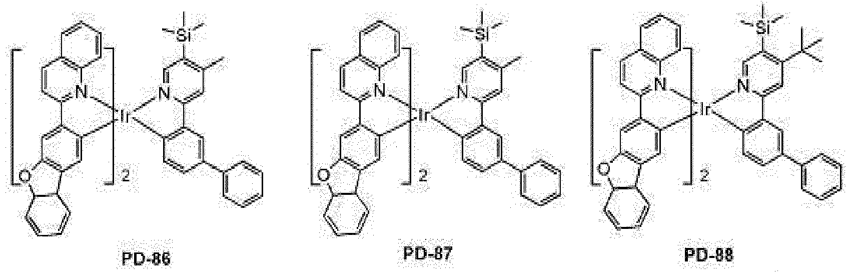

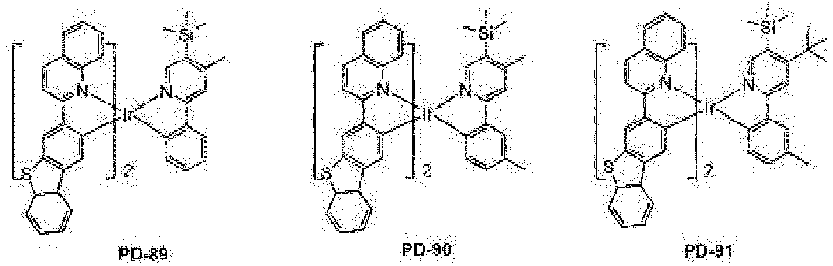

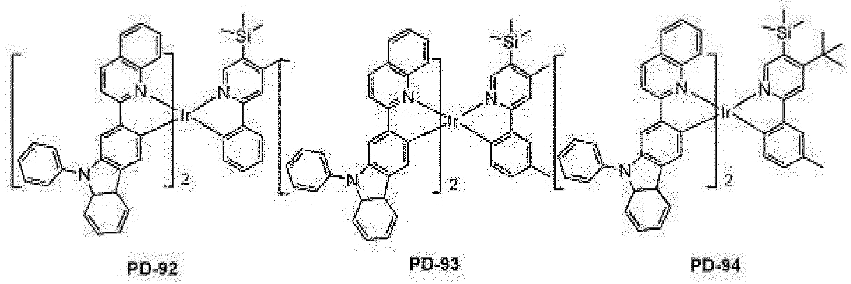

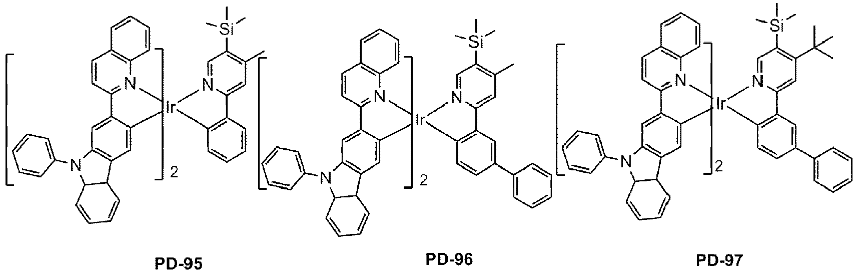

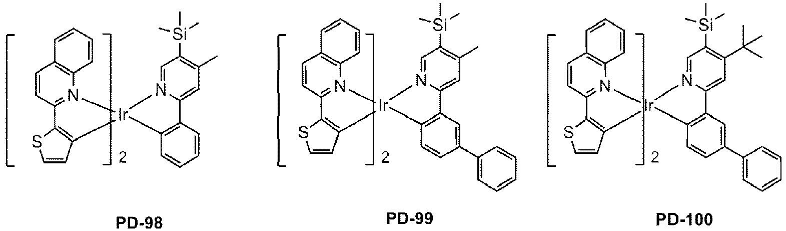

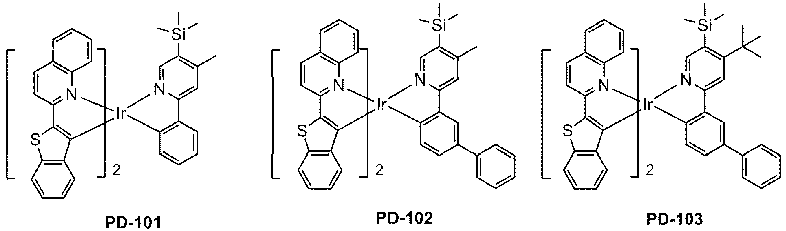

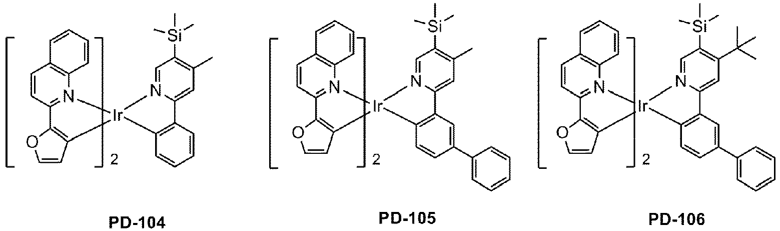

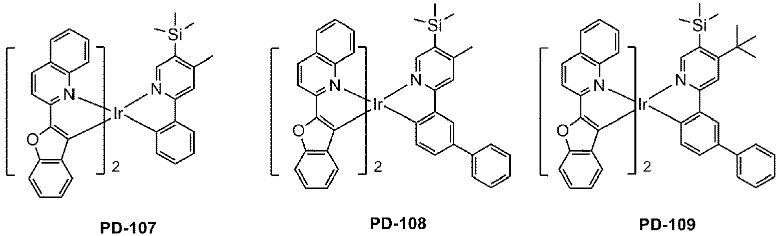

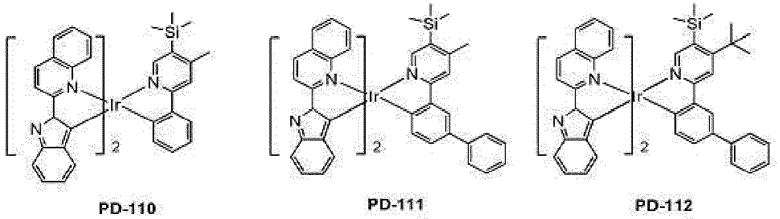

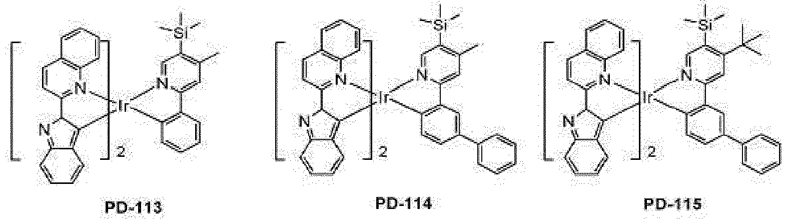

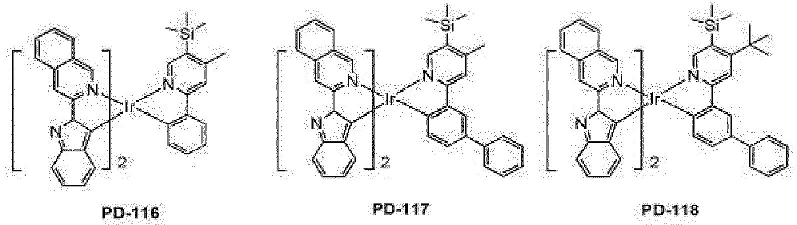

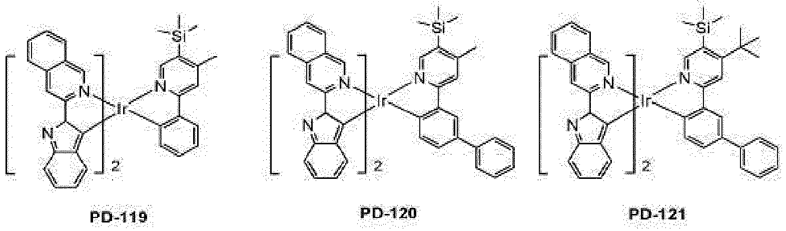

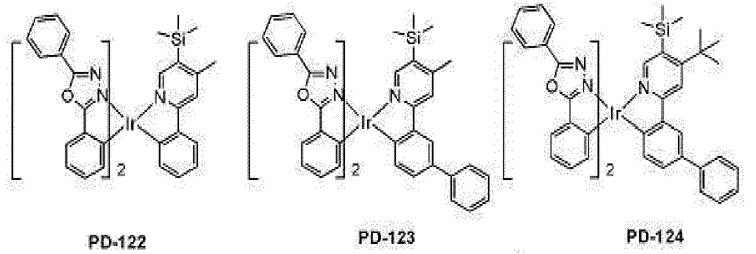

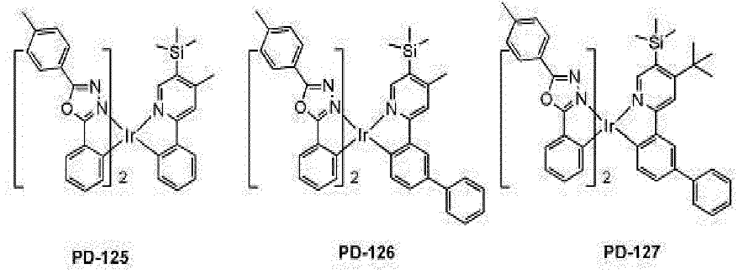

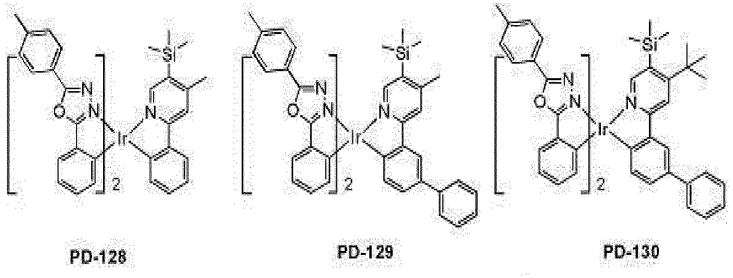

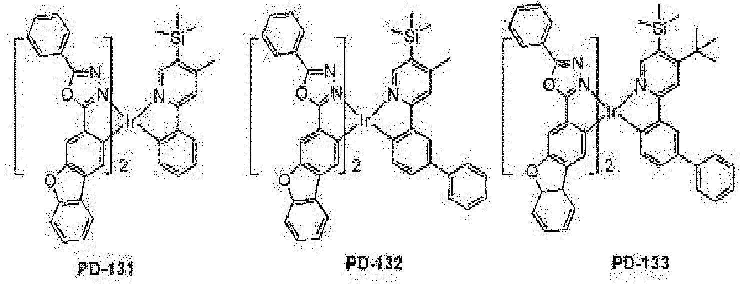

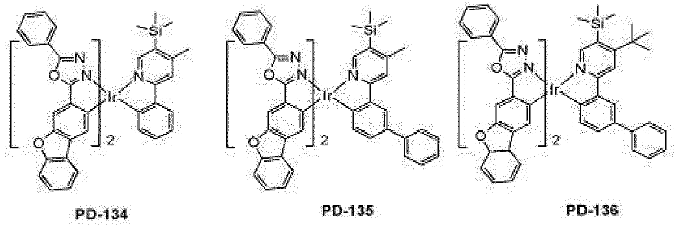

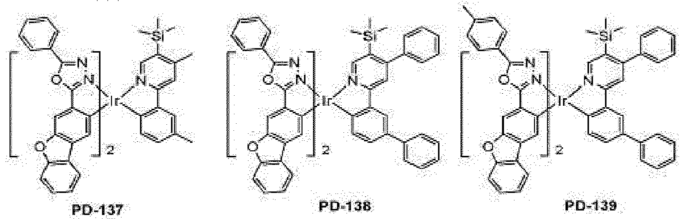

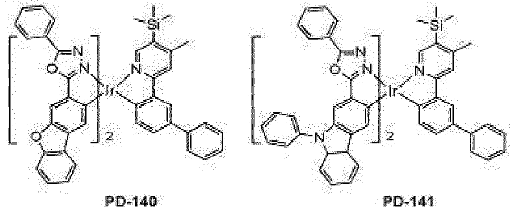

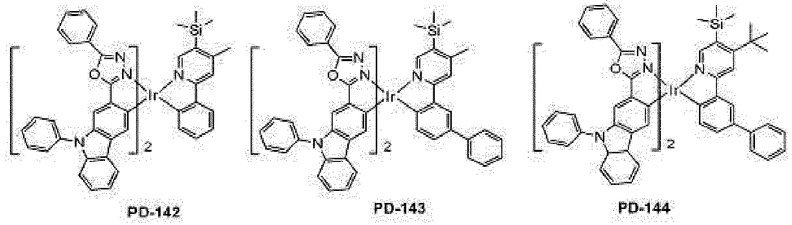

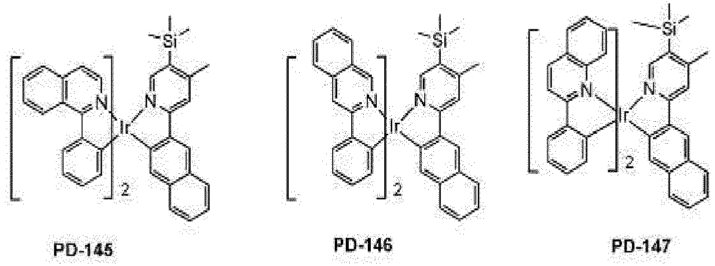

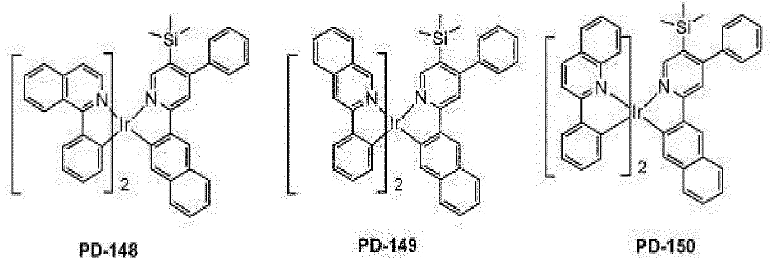

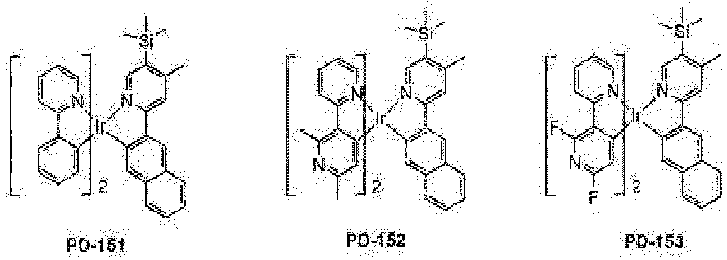

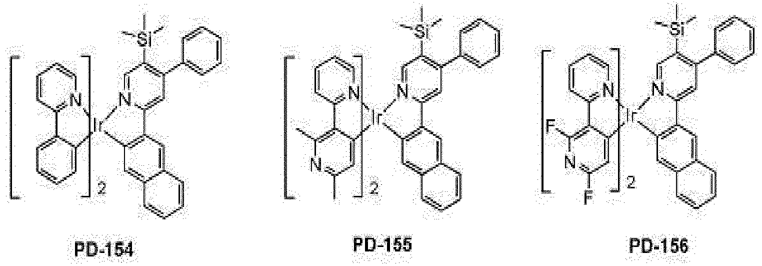

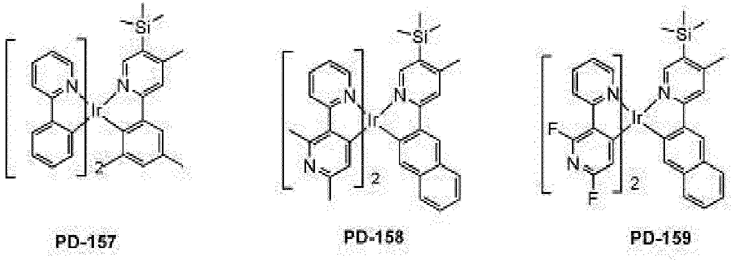

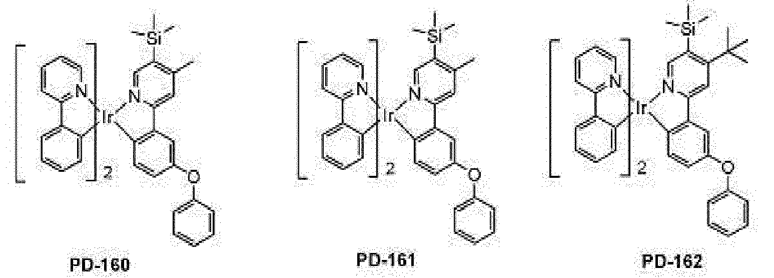

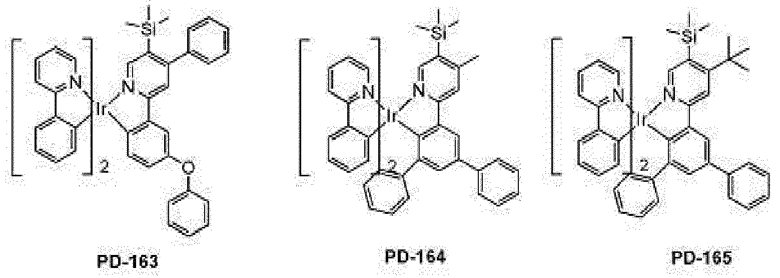

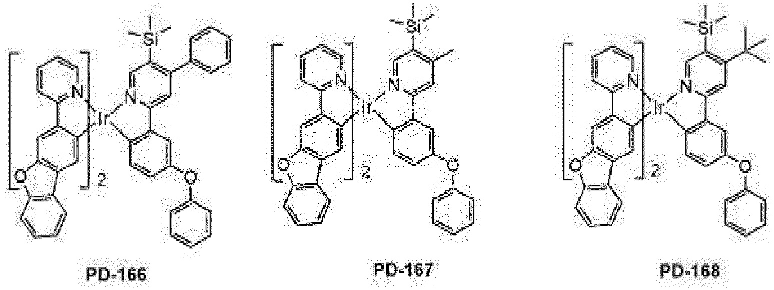

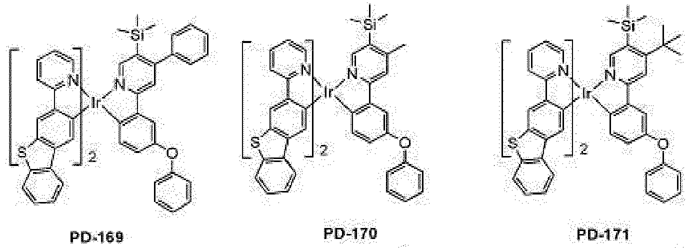

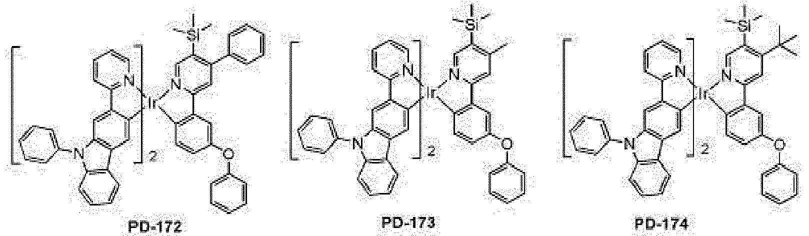

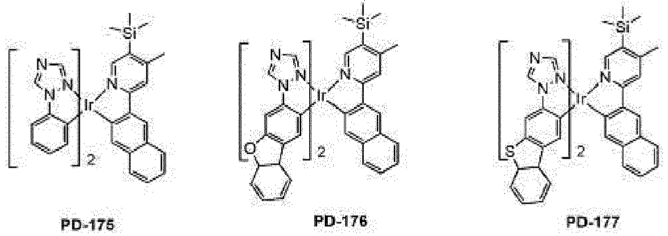

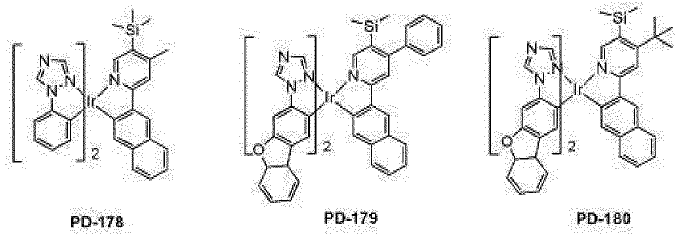

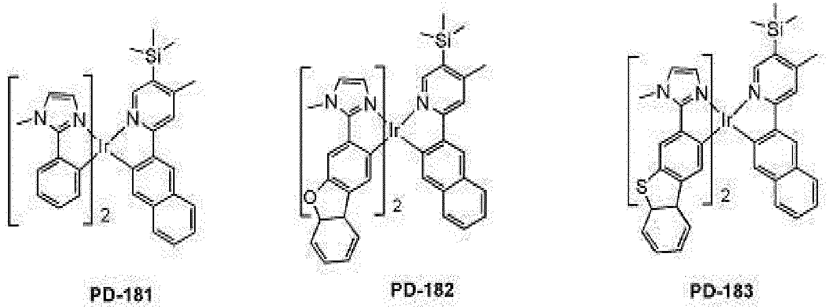

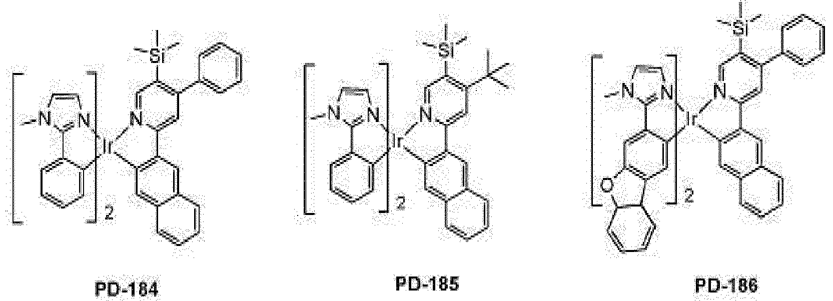

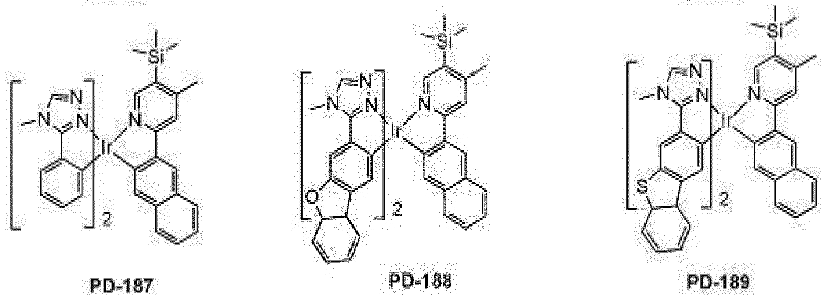

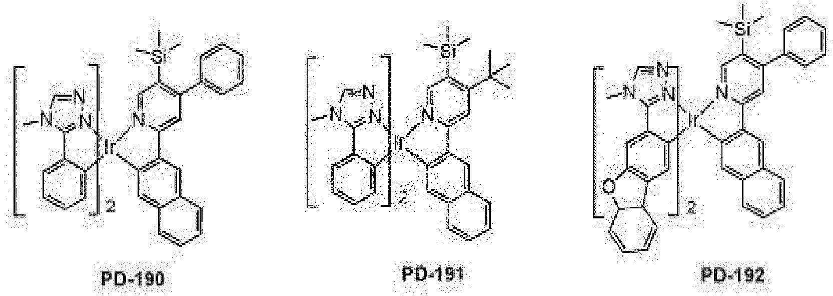

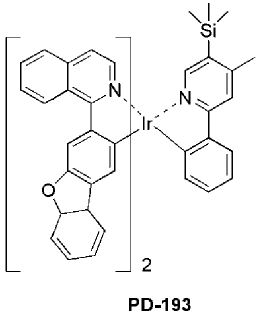

12. The organic light-emitting device of claim 1, wherein L₁ to L₇ in Formulae 2A and 2B are each independently selected from
-O-, a methylene group, a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, a perylenylene group, a pyrrolylene group, a thienylene group, a furylene group, an imidazolylene group, a pyrazolylene group, a thiazolylene group, an isothiazolylene group, an oxazolylene group, an isoxazolylene group, a pyridylene group, a pyrazinylene group, a pyrimidinylene group, a pyridazinylene group, an isoindolylene group, an indolylene group, an indazolylene group, a purinylene group, a quinolylene group, an isoquinolylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, a benzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, a dibenzocarbazolylene group, a thiadiazolylene group, an imidazopyridylene group, an imidazopyrimidinylene group, and a cyclohexyl group, and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, a perylenylene group, a pyrrolylene group, a thienylene group, a furylene group, an imidazolylene group, a pyrazolylene group, a thiazolylene group, an isothiazolylene group, an oxazolylene group, an isoxazolylene group, a pyridylene group, a pyrazinylene group, a pyrimidinylene group, a pyridazinylene group, an isoindolylene group, an indolylene group, an indazolylene group, a purinylene group, a quinolylene group, an isoquinolylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, a benzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, a dibenzocarbazolylene group, a thiadiazolylene group, an imidazopyridylene group, an imidazopyrimidinylene group, and a cyclohexyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group.

13. The organic light-emitting device of claim 1, wherein L₁ to L₇ in Formulae 2A and 2B are each independently selected from -O-, a methylene group, and a group represented by one of Formula 3A to Formula 3E: 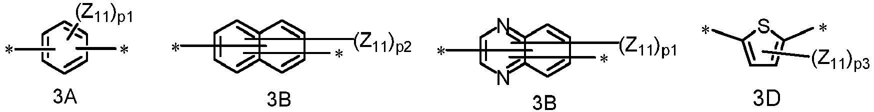 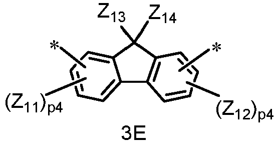 wherein, in Formulae 3A to 3E,
Z₁₁ to Z₁₄ are each independently selected from
a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₃₁)(Q₃₂), and -Si(Q₃₃)(Q₃₄)(Q₃₅), and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₂₁)(Q₂₂) and -Si(Q₂₃)(Q₂₄)(Q₂₅),
wherein Q₃₁ to Q₃₅, and Q₂₁ to Q₂₅ are each independently selected from
a hydrogen atom, a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, and
a phenyl group, a biphenyl group, a naphthyl group, an anthryl group, a pyrenyl group, a phenanthrenyl group, a triphenylenyl group, and a fluorenyl group, each substituted with at least one of a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group;
optionally, at least two of Q₂₃ to Q₂₅ are bound to together to form a ring;
optionally, Z₁₃ and Z₁₄ in Formula 3E are bound to each other to form a ring;
p1 is an integer of 0 to 4;
p2 is an integer of 0 to 6;
p3 is an integer of 0 to 2;
p4 is an integer of 0 to 3; and
* is a binding site.

14. The organic light-emitting device of claim 1, wherein L₁ to L₇ in Formulae 2A and 2B are each independently selected from -O-, a methylene group, and groups represented by Formulae 4A to Formula 4J: 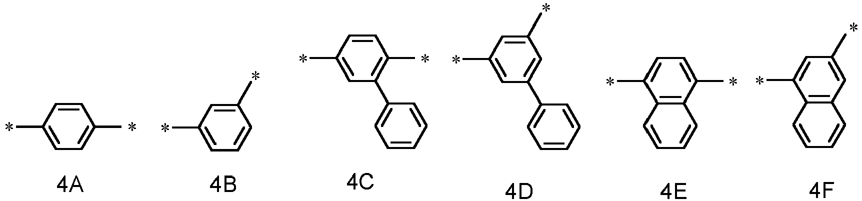 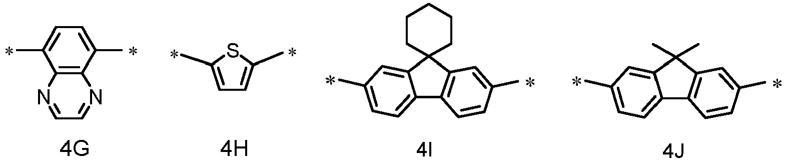 wherein, in Formulae 4A to 4J, * is a binding site.

15. The organic light-emitting device of claim 1, wherein [L₁]_{lb1} in Formulae 2A and 2B is a group represented by one of Formulae 5A to 5L: 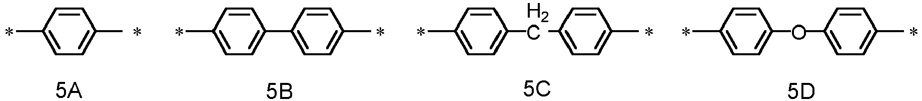 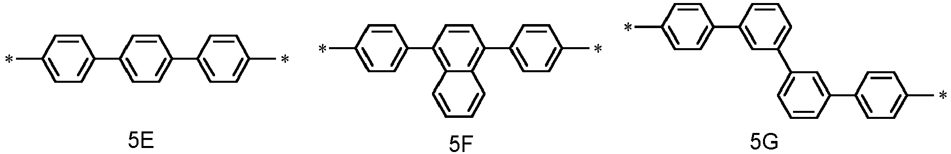 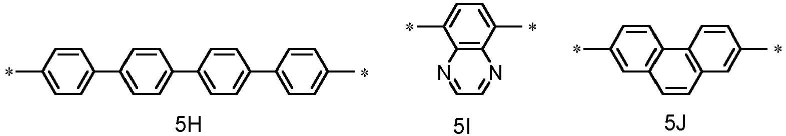 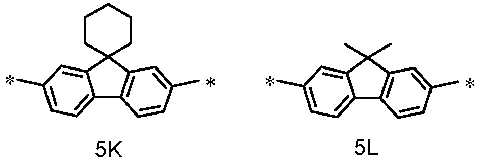 wherein, in Formulae 5A to 5L, * is a binding site.

16. The organic light-emitting device of claim 1, wherein Rg to R₁₄ in Formulae 2A and 2B are each independently selected from
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, a phenylmethyl group, a triphenylmethyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a cyclohexyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₂₁)(Q₂₂), and -Si(Q₂₃)(Q₂₄)(Q₂₅),
wherein Q₂₁ to Q₂₅ are each independently selected from
a hydrogen atom, a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, and
a phenyl group, a biphenyl group, a naphthyl group, an anthryl group, a pyrenyl group, a phenanthrenyl group, a triphenylenyl group, and a fluorenyl group, each substituted with at least one of a C₁-C₂₀ alkyl group, a C₁-C₂₀ alkoxy group, a biphenyl group, a phenyl group, a naphthyl group, an anthryl group, a pyrenyl group, a phenanthrenyl group, a triphenylenyl group, and a fluorenyl group.

17. The organic light-emitting device of claim 1, wherein R₉ to R₁₄ in Formulae 2A and 2B are each independently a group represented by one of Formula 6A to Formula 6G: 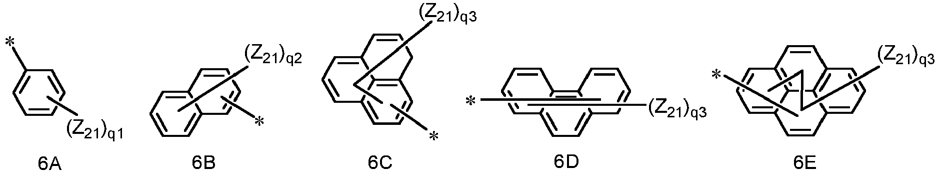 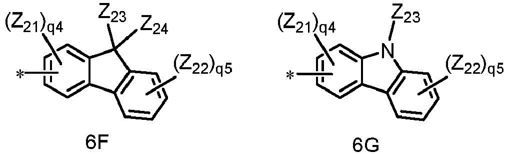 wherein, in Formulae 6A to 6G,
Z₂₁ to Z₂₄ are each independently selected from
a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₃₁)(Q₃₂), and -Si(Q₃₃)(Q₃₄)(Q₃₅), and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenoxy group, a phenylmethyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, an imidazopyrimidinyl group, -N(Q₂₁)(Q₂₂), and -Si(Q₂₃)(Q₂₄)(Q₂₅),
wherein Q₃₁ to Q₃₅, and Q₂₁ to Q₂₅ are each independently selected from
a hydrogen atom, a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, and
a phenyl group, a biphenyl group, a naphthyl group, an anthryl group, a pyrenyl group, a phenanthrenyl group, a triphenylenyl group, and a fluorenyl group, each substituted with at least one of a C₁-C₂₀ alkyl group, a C₁-C₂₀ alkoxy group, a phenyl group, a biphenyl group, a naphthyl group, an anthryl group, a pyrenyl group, a phenanthrenyl group, a triphenylenyl group, and a fluorenyl group, wherein optionally, at least two of Q₂₃ to Q₂₅ are bound to each other to form a ring;
optionally, Z₂₃ and Z₂₄ in Formula 6F are bound to each other to form a ring;
q1 is an integer of 0 to 5;
q2 is an integer of 0 to 7;
q3 is an integer of 0 to 9;
q4 is an integer of 0 to 3;
q5 is an integer of 0 to 4; and
* is a binding site.

18. The organic light-emitting device of claim 1, wherein R₉ to R₁₄ in Formulae 2A and 2B are each independently a group represented by one of Formula 7A to Formula 7AB: 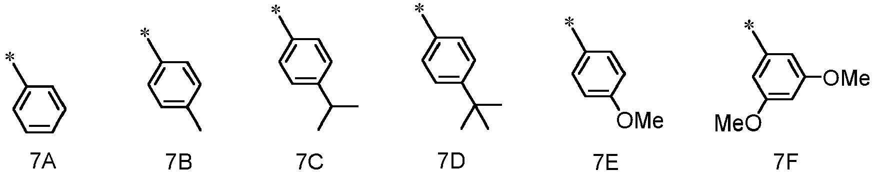 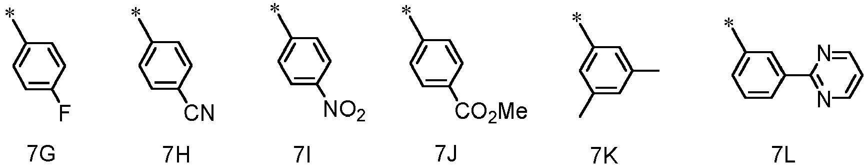 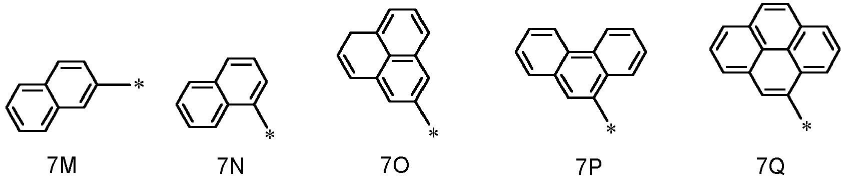 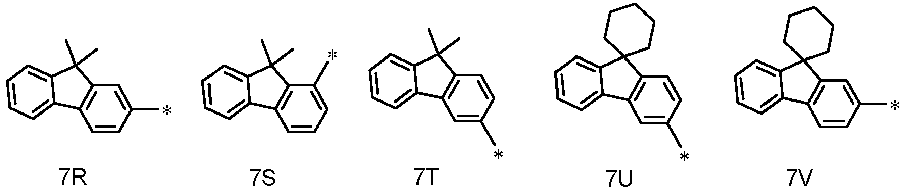 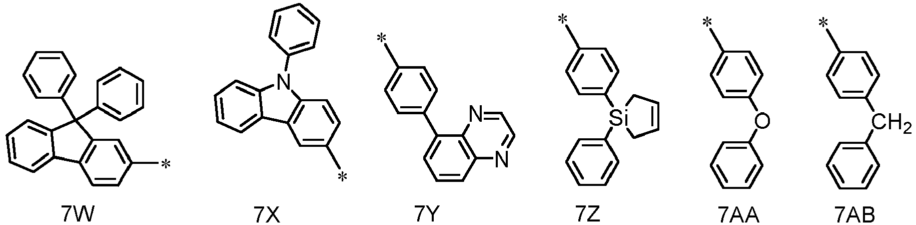 wherein, in Formulae 7A to 7AB, * is a binding site.

19. The organic light-emitting device of claim 1, wherein -[L₂]_{lb2}-R₉, -[L₃]_{lb3}-R₁₀, -[L₄]_{lb4}-R₁₁, - [L₅]_{lb5}-R₁₂, -[L₆]_{lb6}-R₁₃, and -[L₇]_{lb7}-R₁₄ in Formulae 2A and 2B are each independently a group represented by one of Formulae 8A to 8AI: 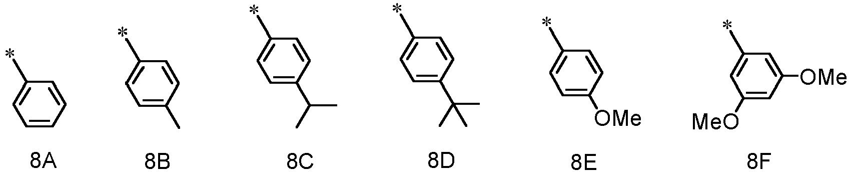 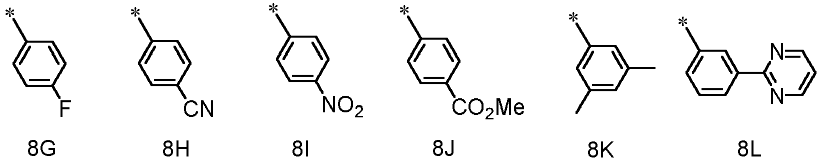 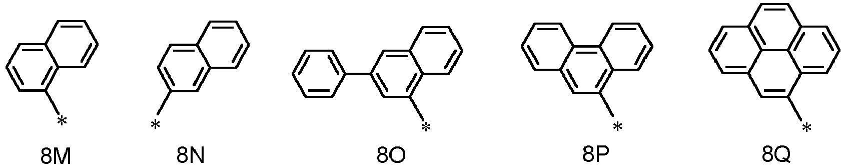 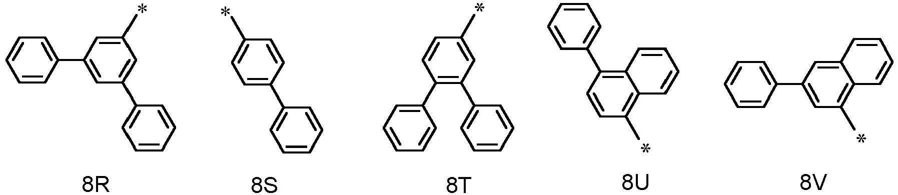 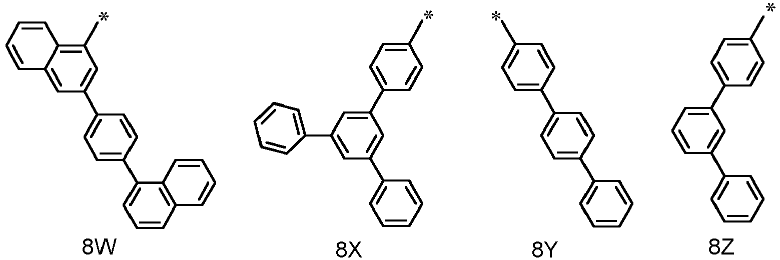 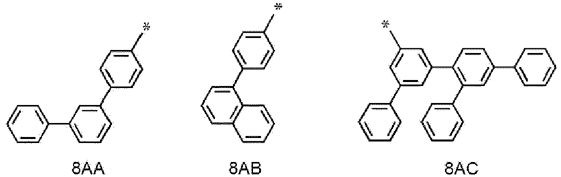 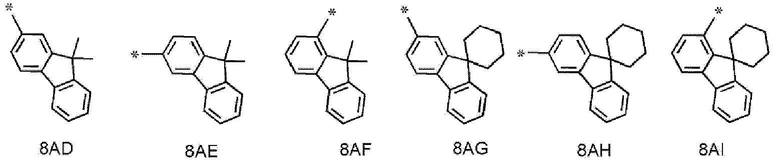 wherein, in Formulae 8A to 8AI, * is a binding site.

20. The organic light-emitting device of claim 1, wherein the first compound represented by Formula 2A or 2B is selected from compounds HTa-1 to HTa-121 to HTa-129 to HTa-284:

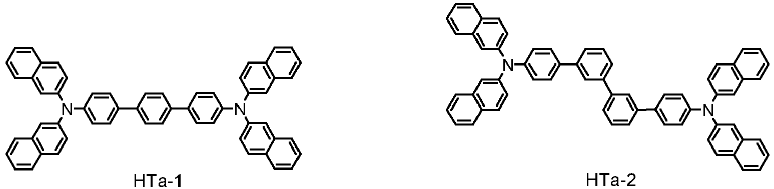

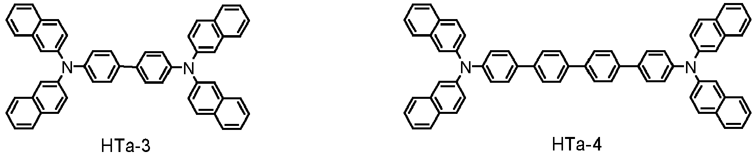

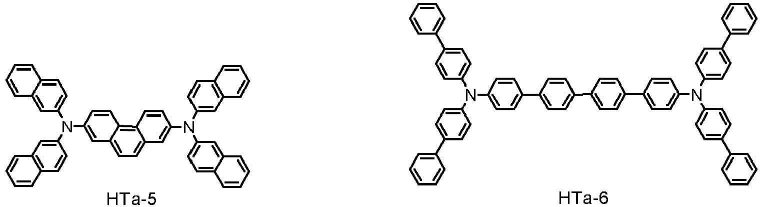

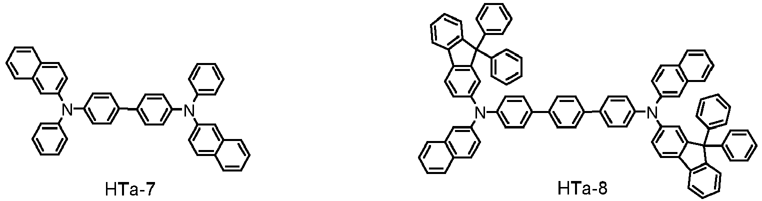

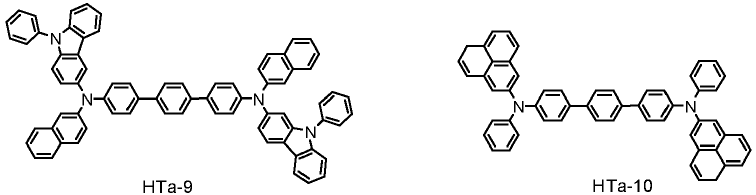

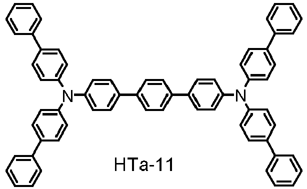

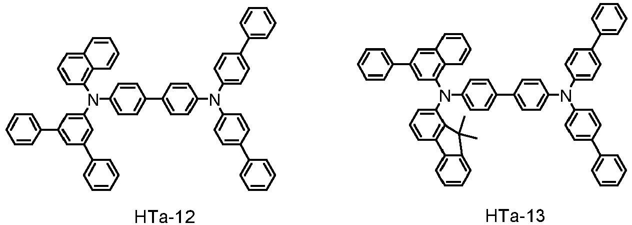

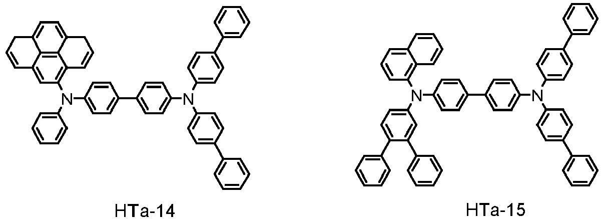

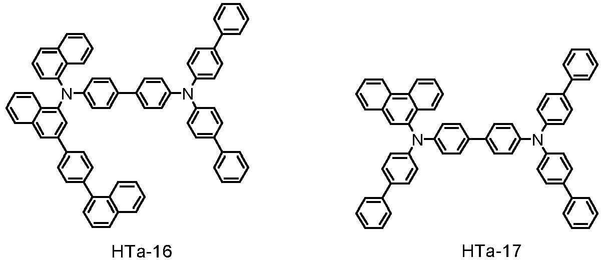

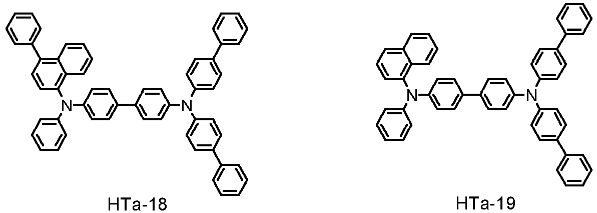

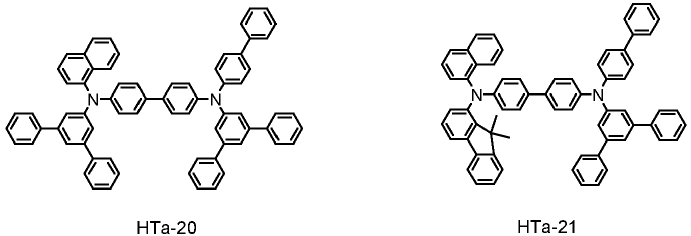

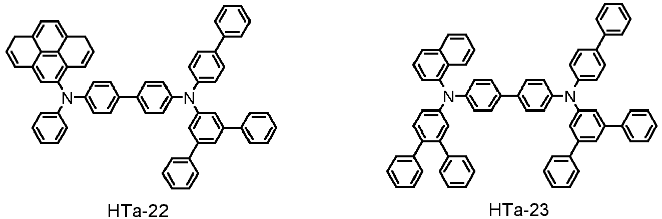

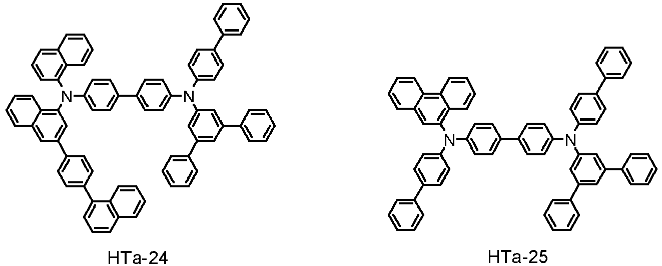

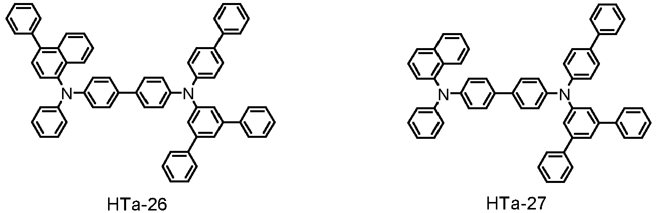

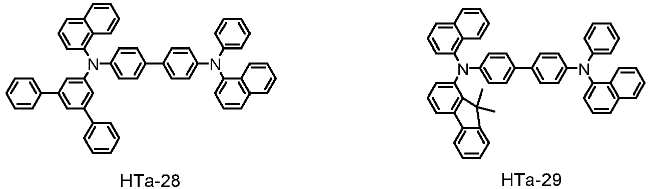

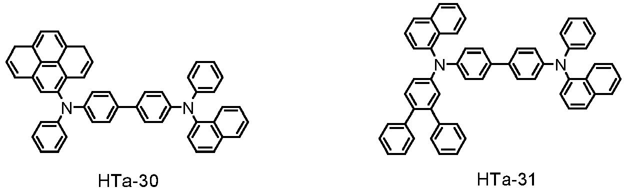

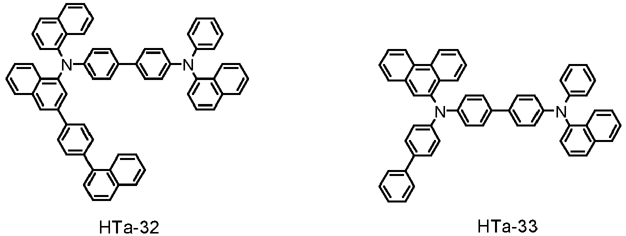

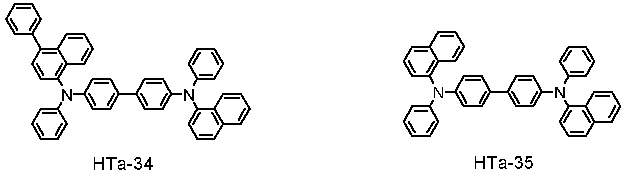

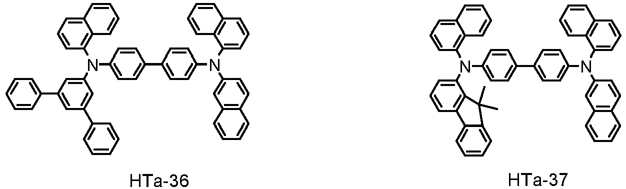

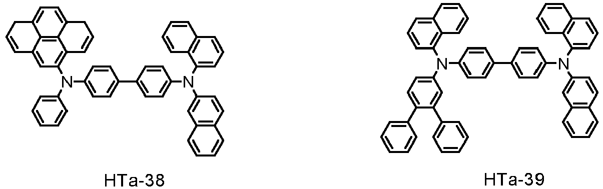

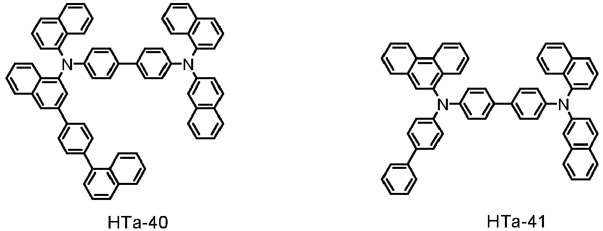

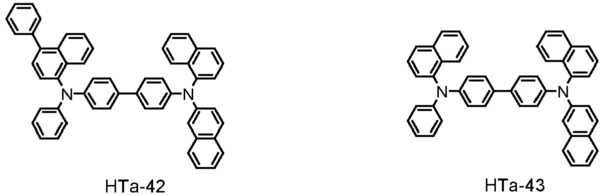

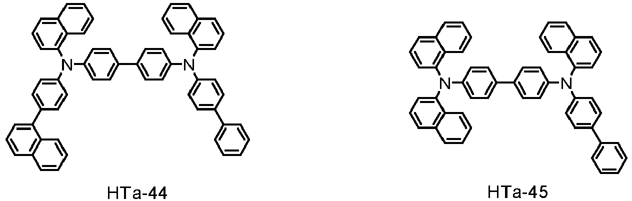

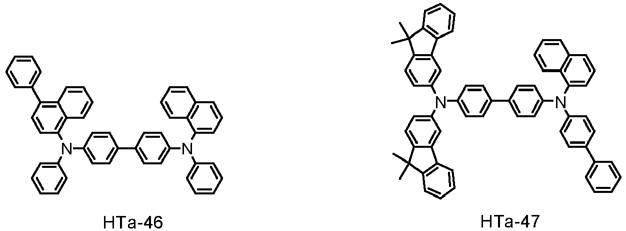

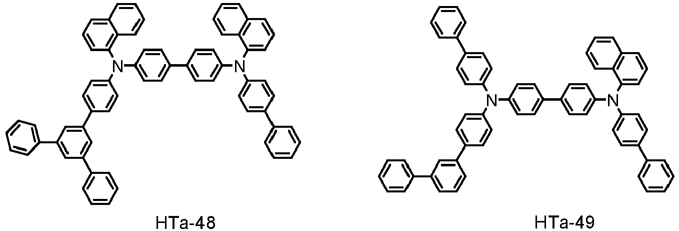

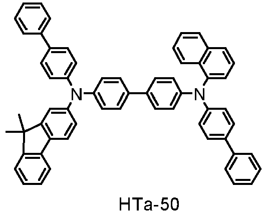

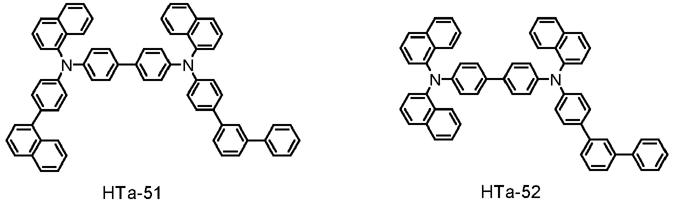

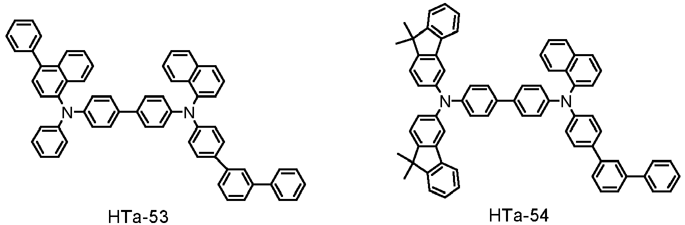

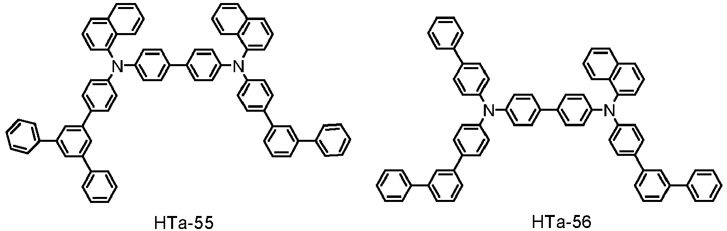

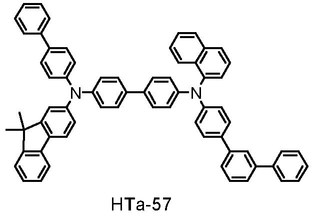

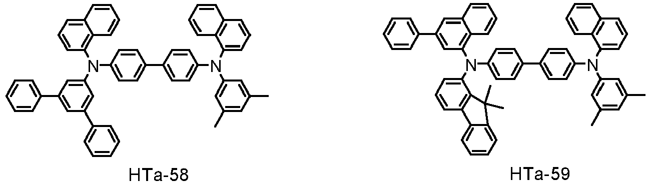

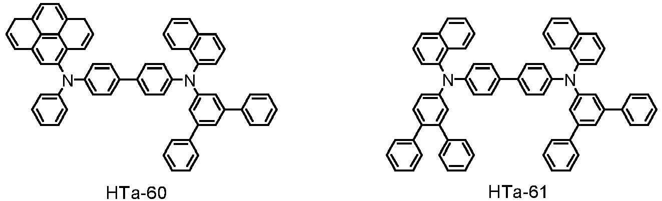

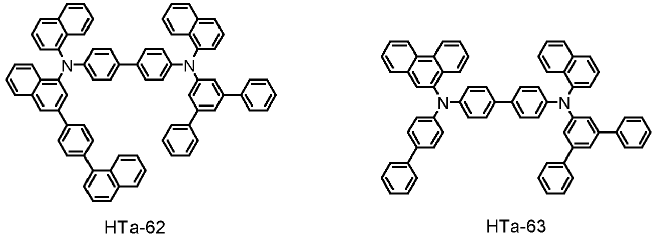

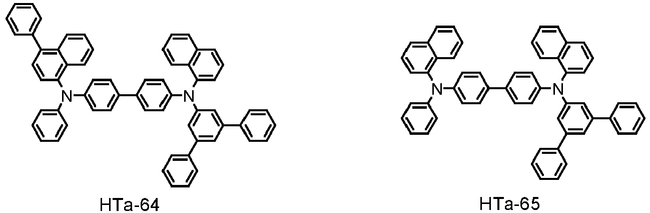

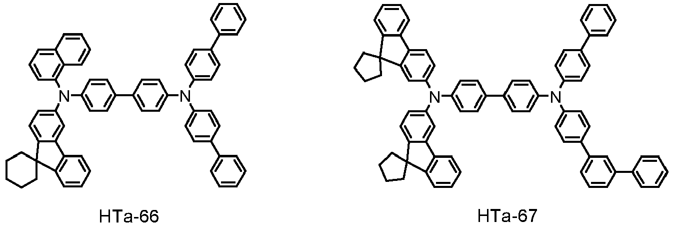

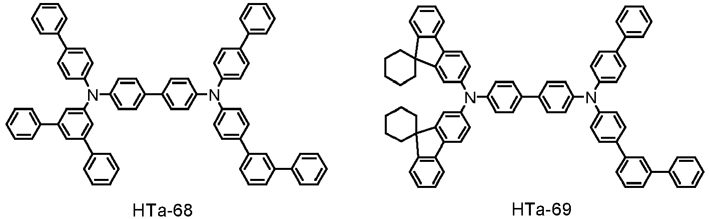

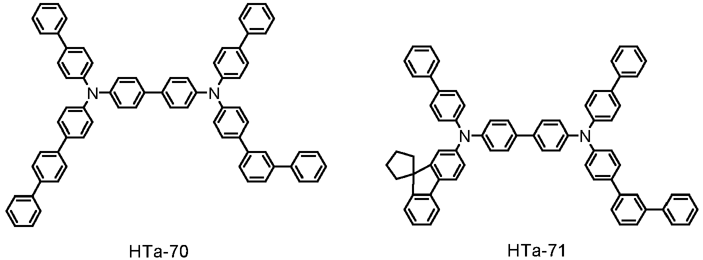

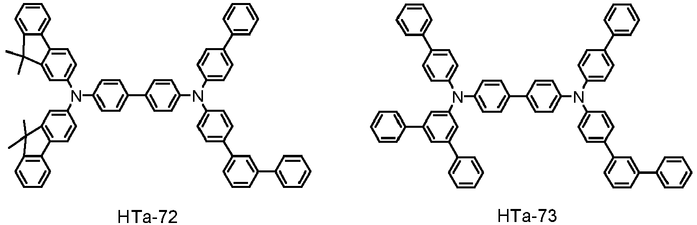

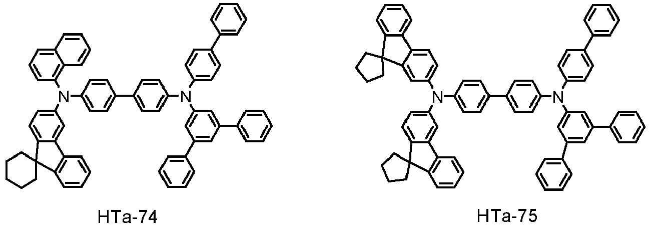

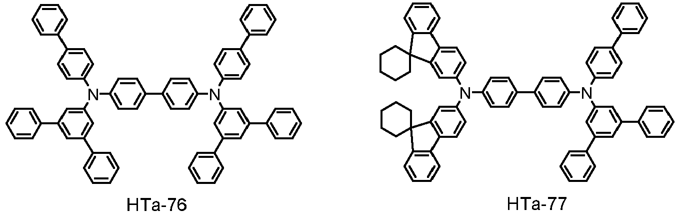

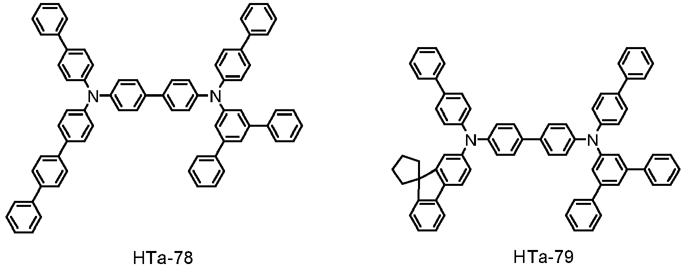

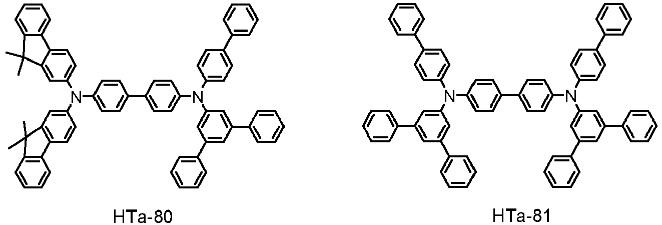

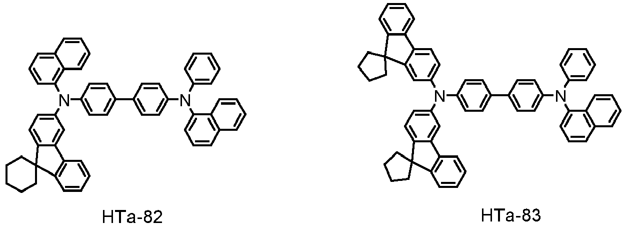

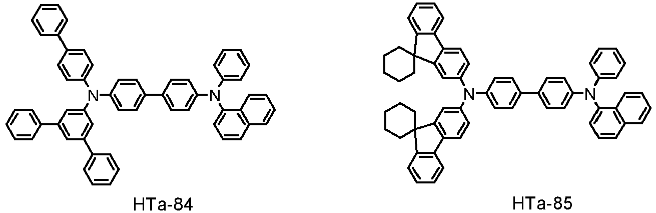

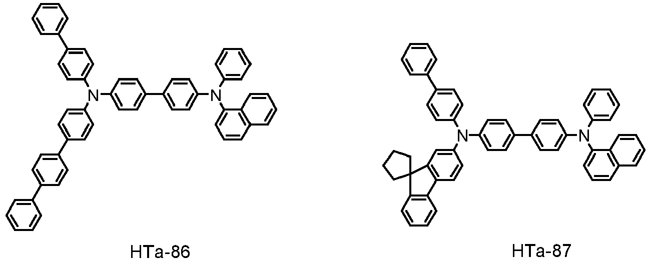

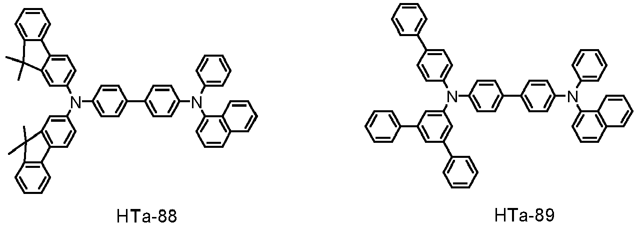

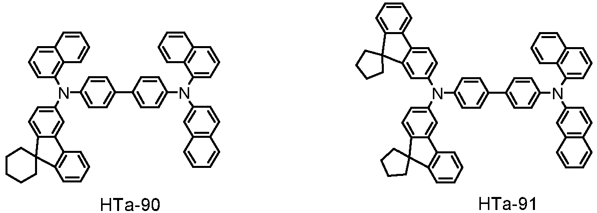

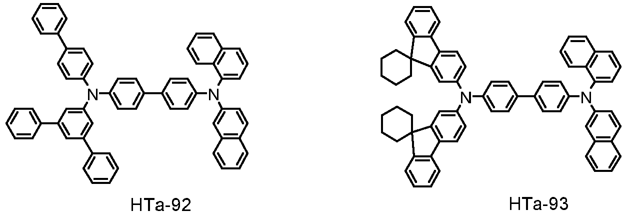

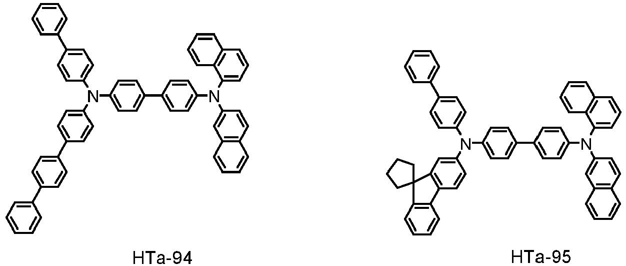

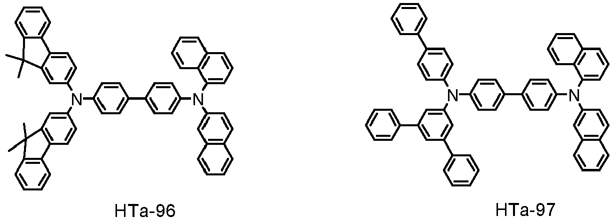

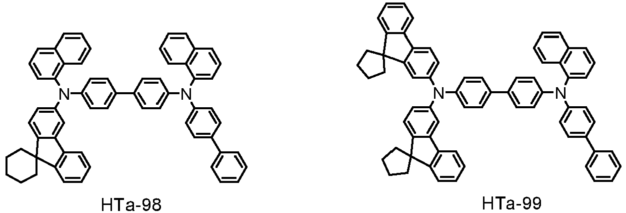

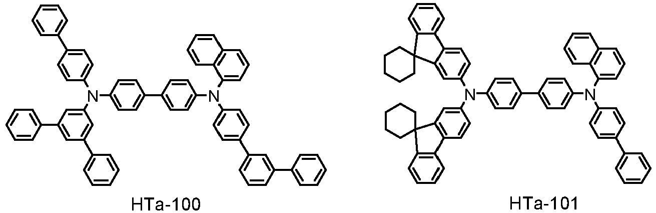

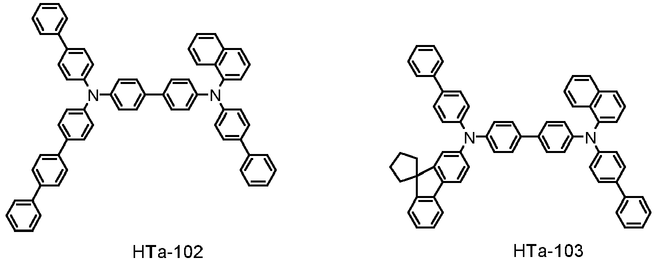

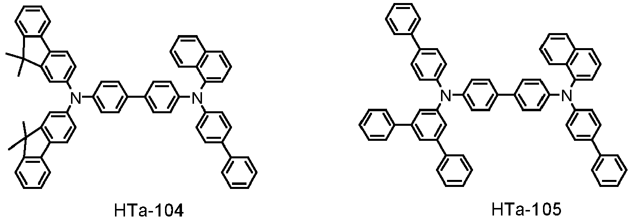

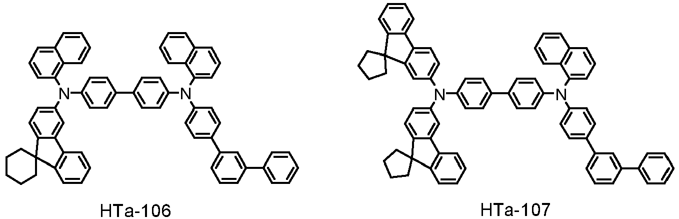

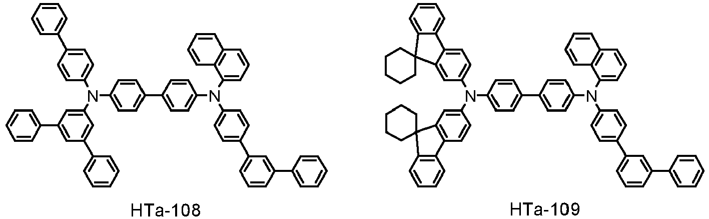

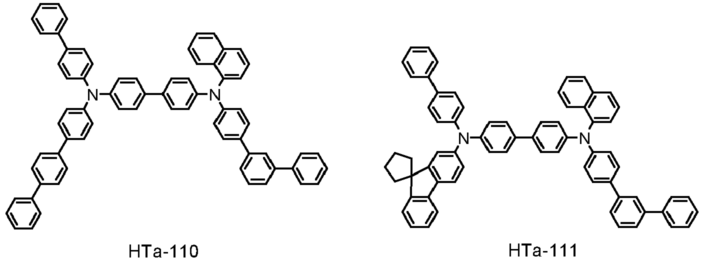

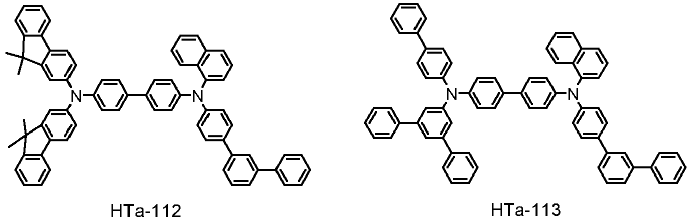

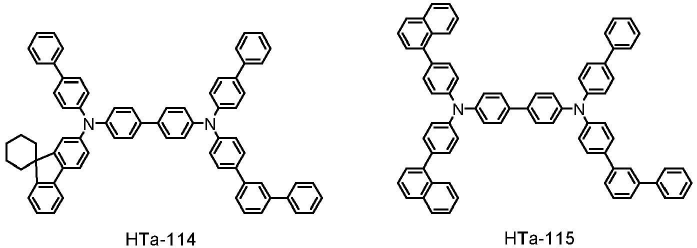

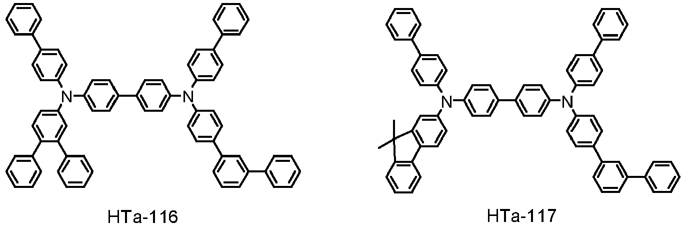

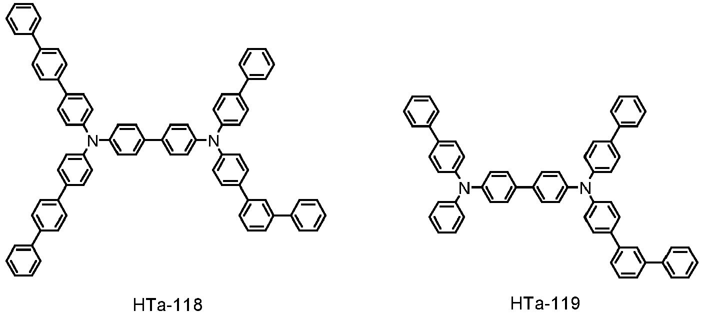

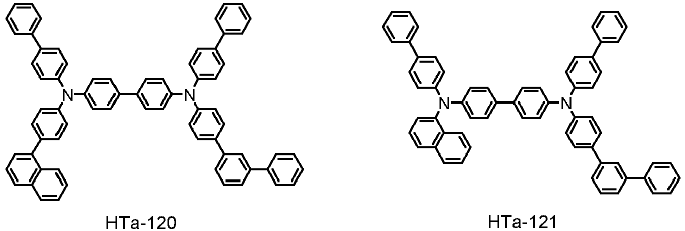

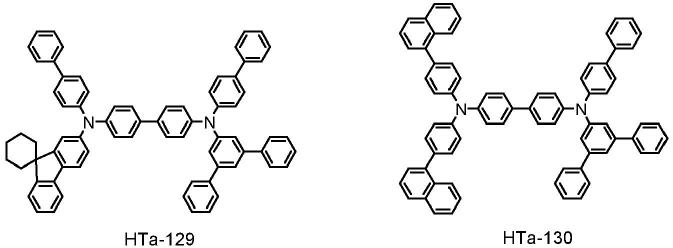

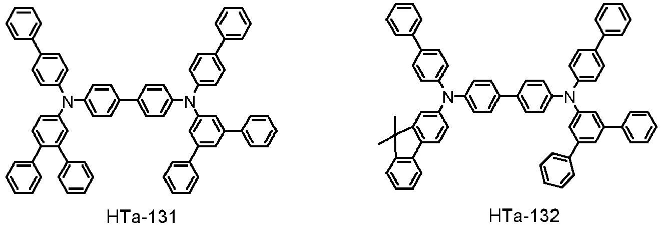

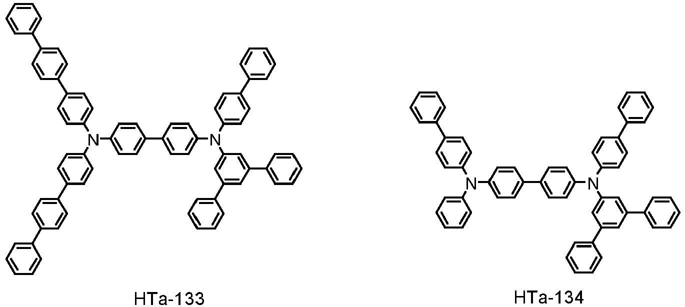

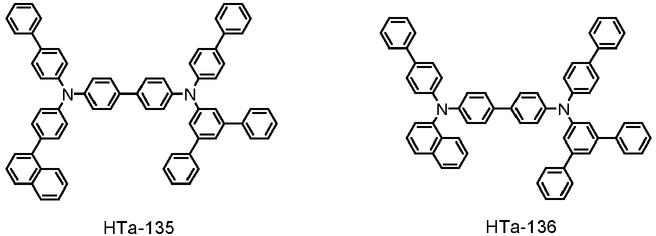

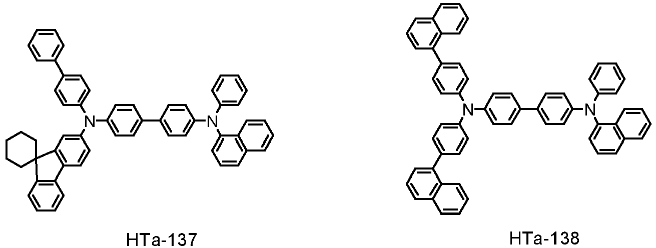

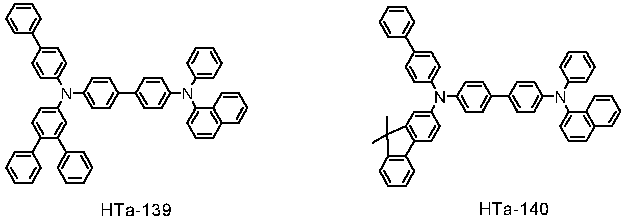

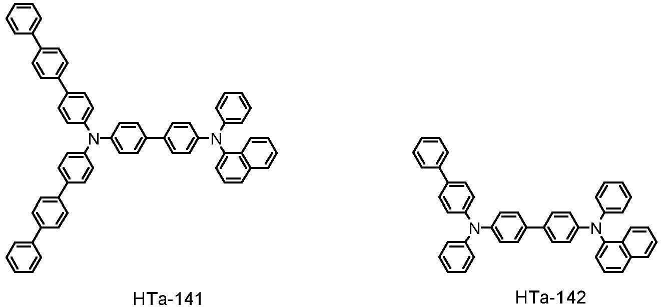

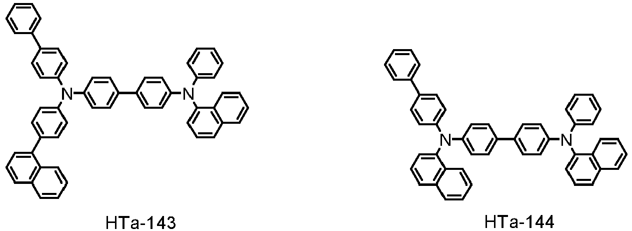

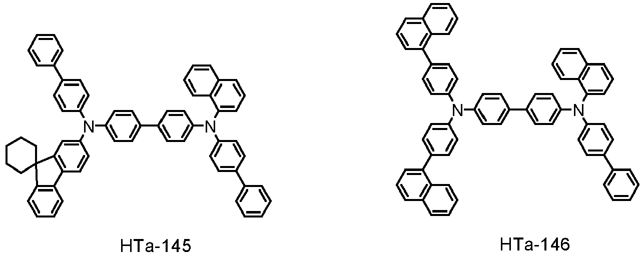

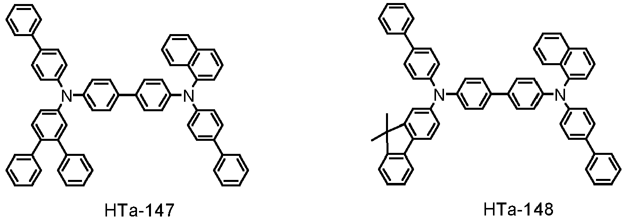

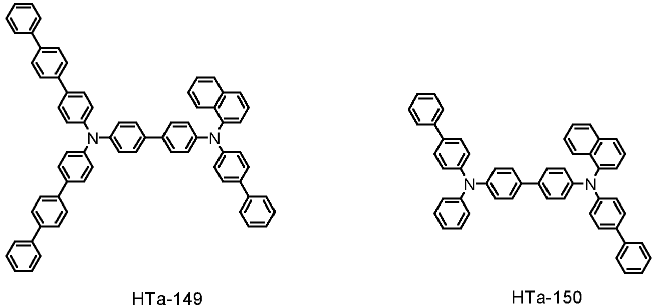

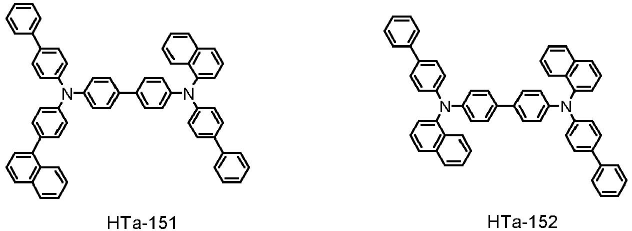

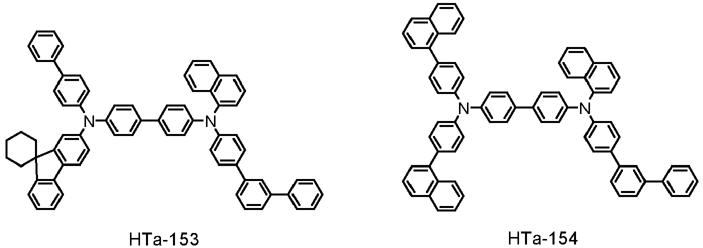

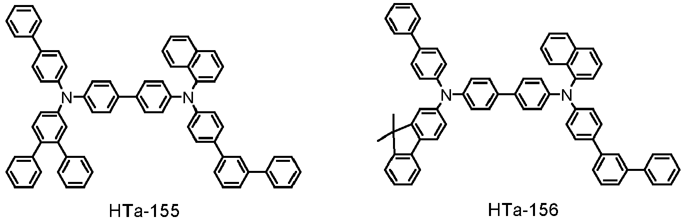

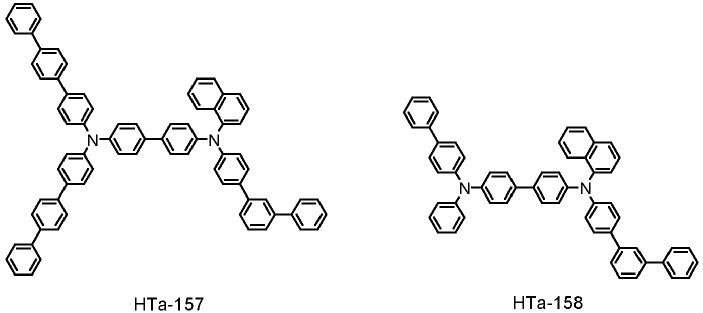

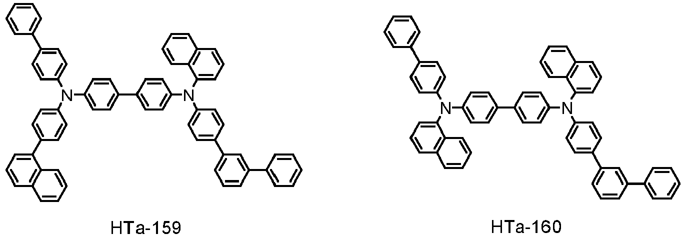

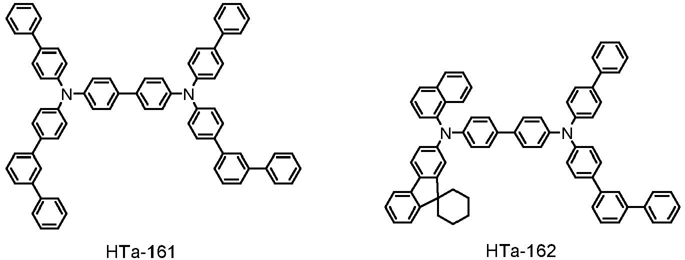

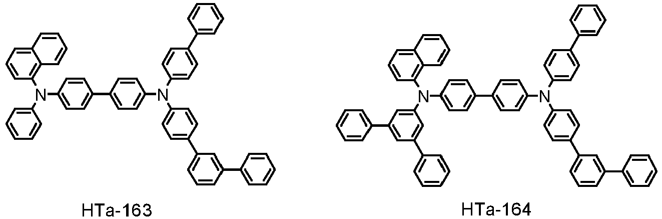

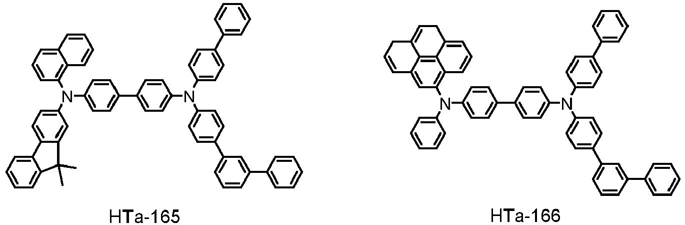

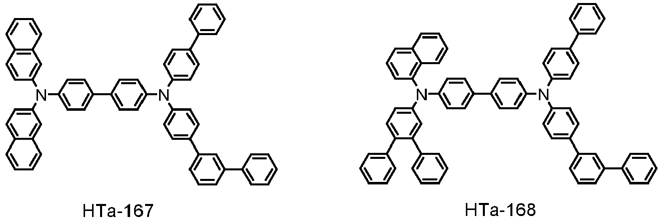

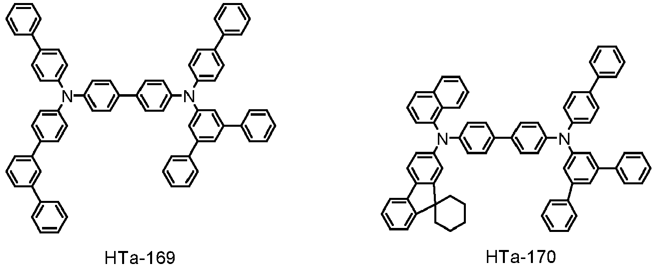

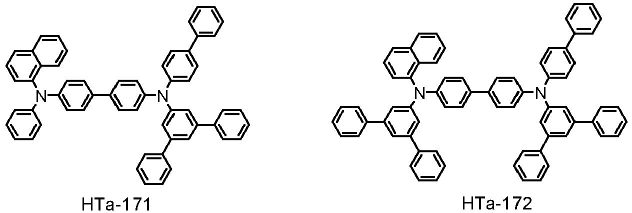

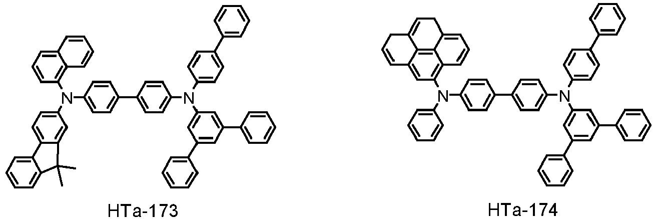

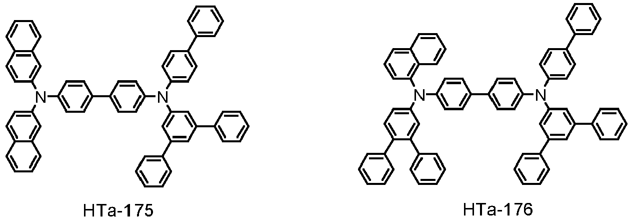

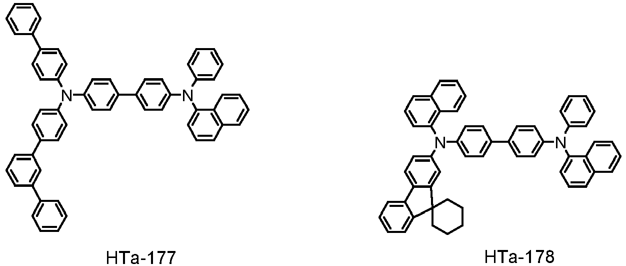

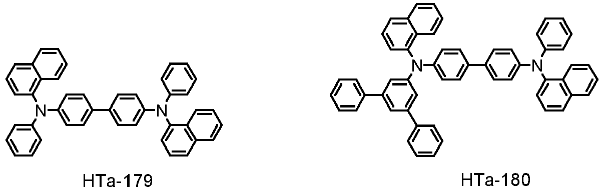

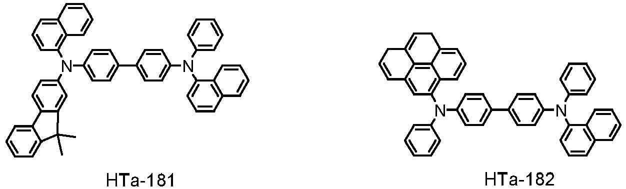

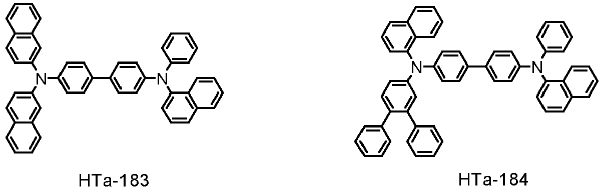

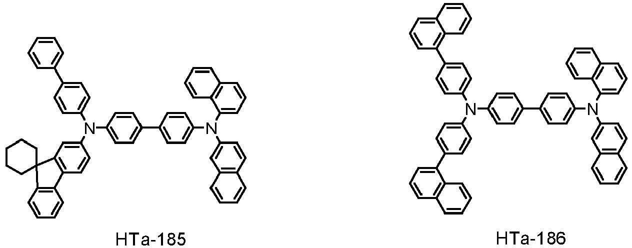

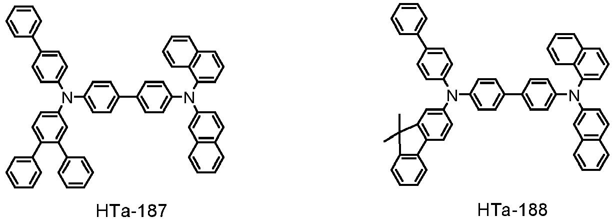

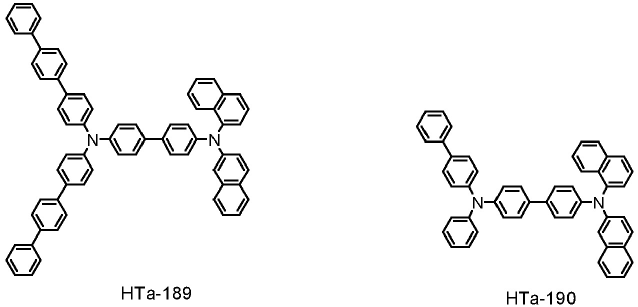

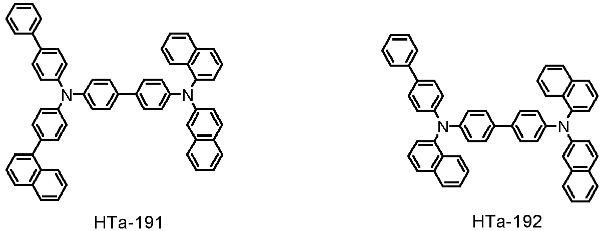

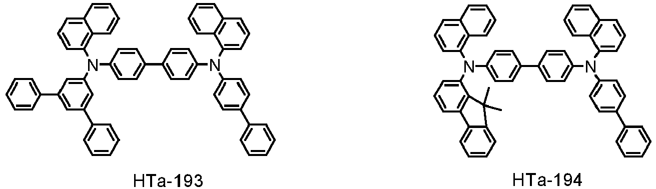

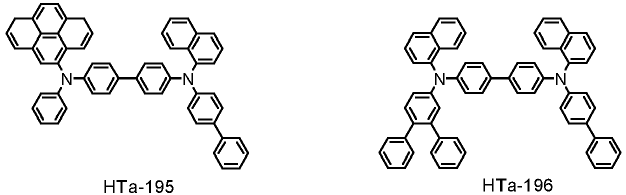

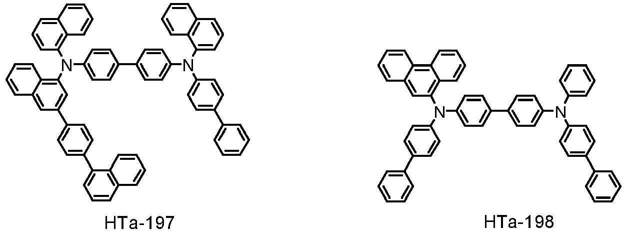

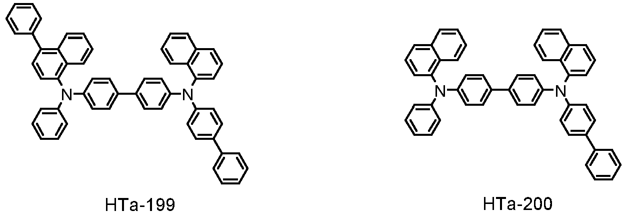

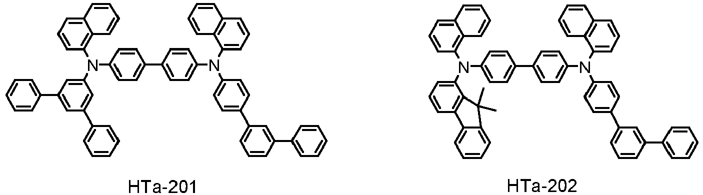

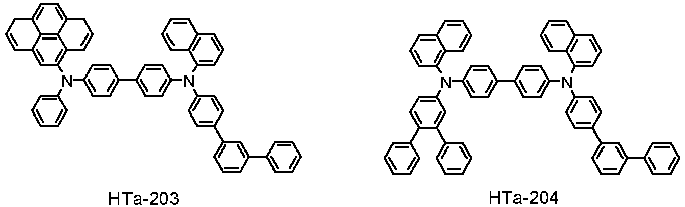

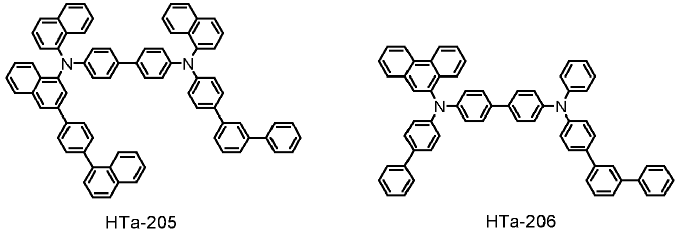

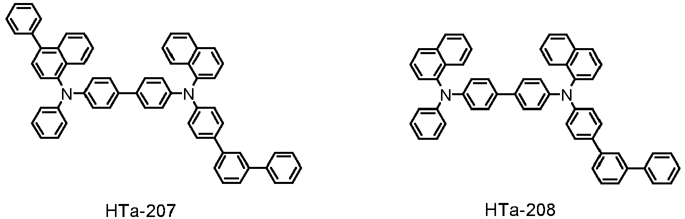

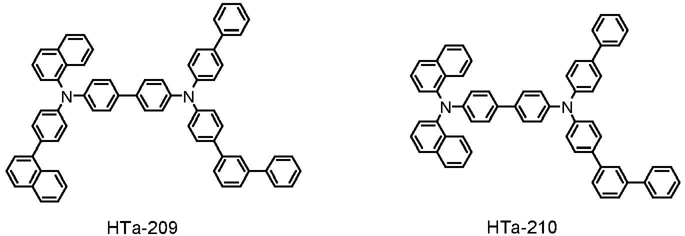

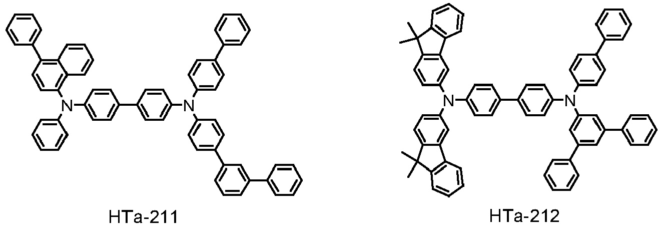

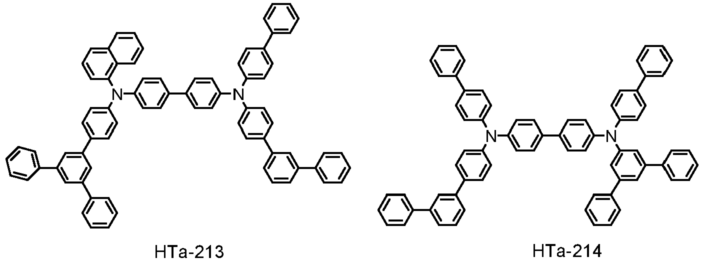

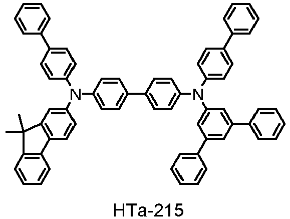

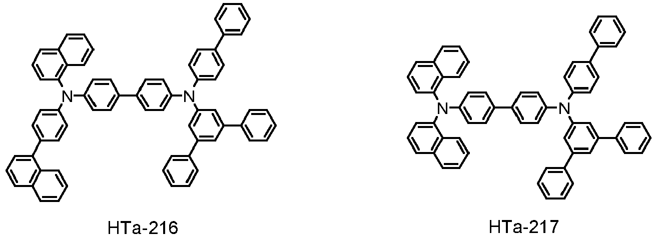

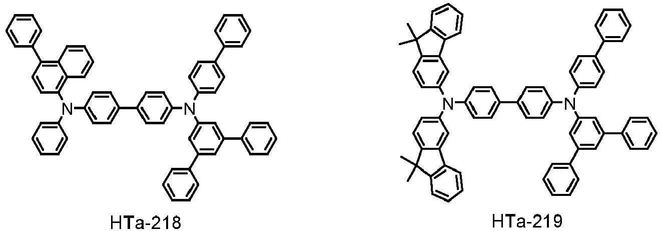

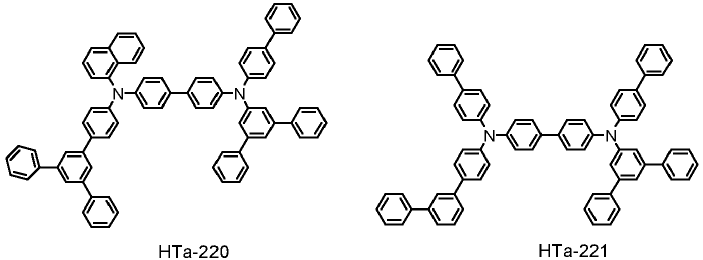

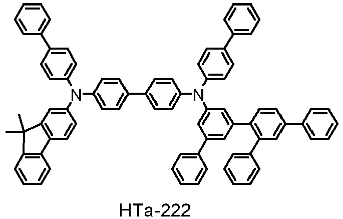

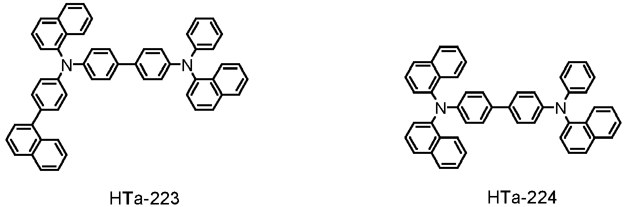

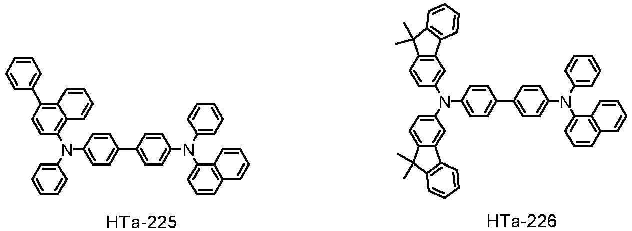

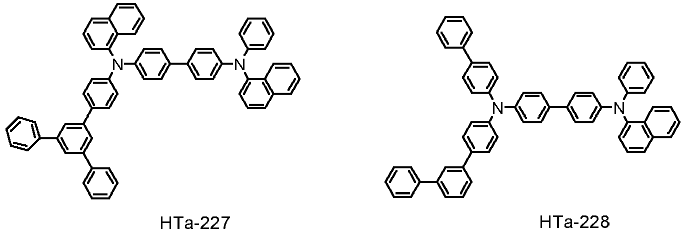

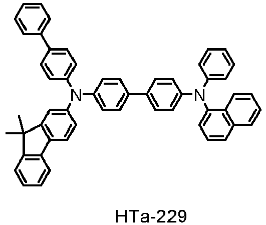

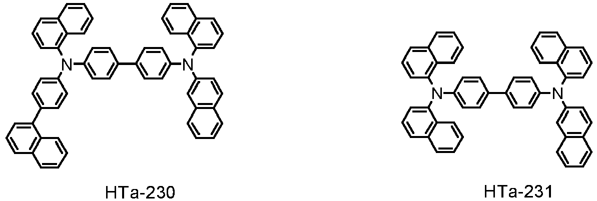

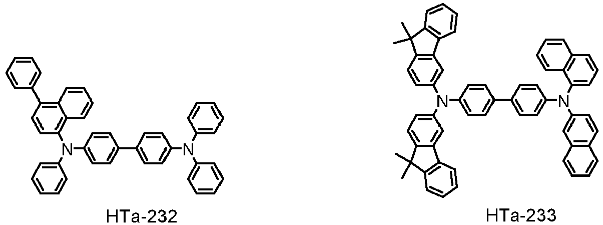

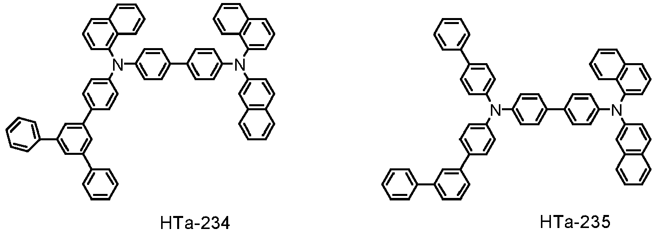

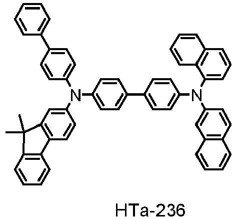

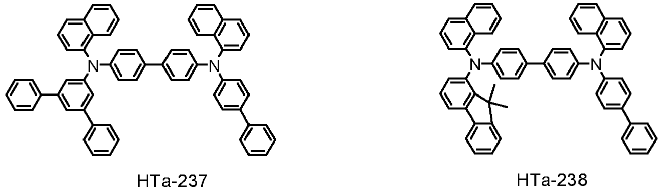

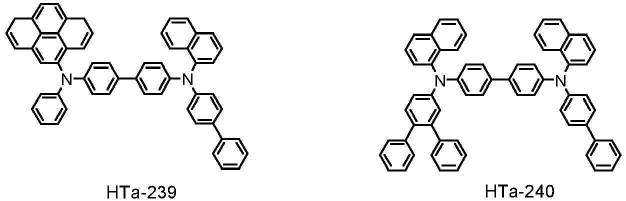

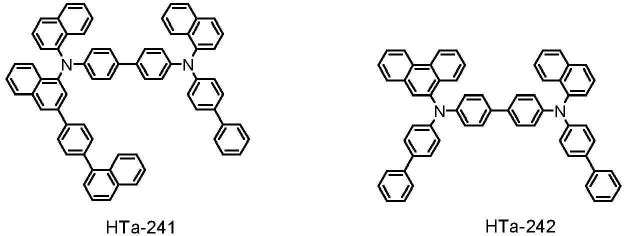

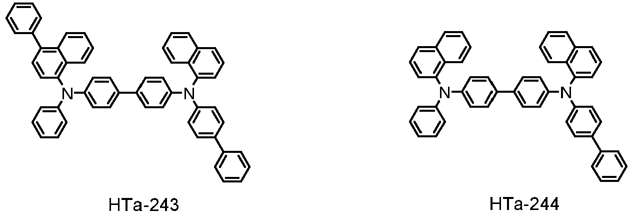

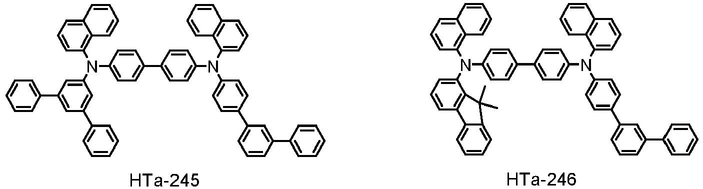

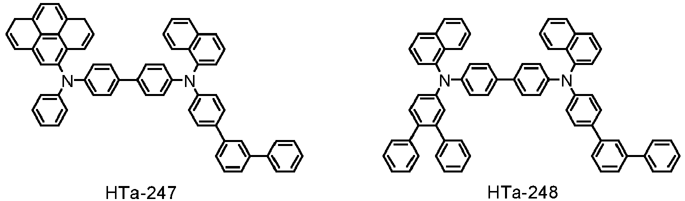

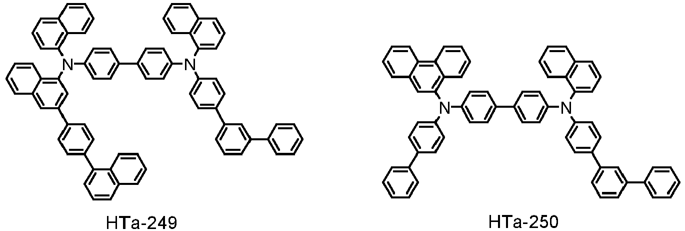

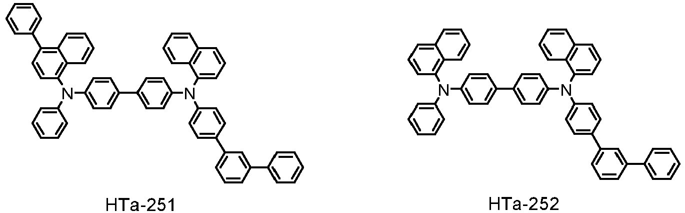

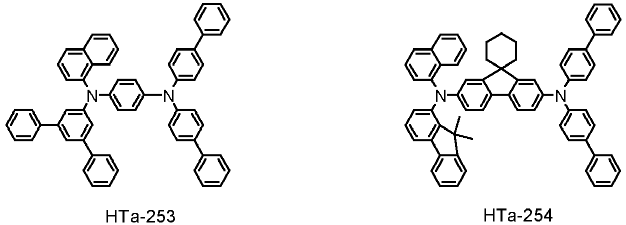

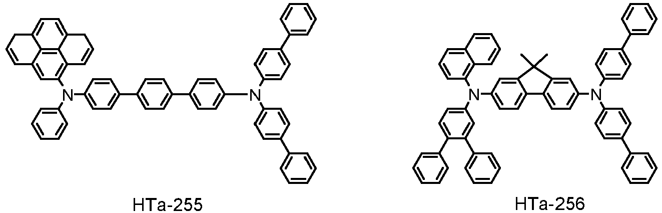

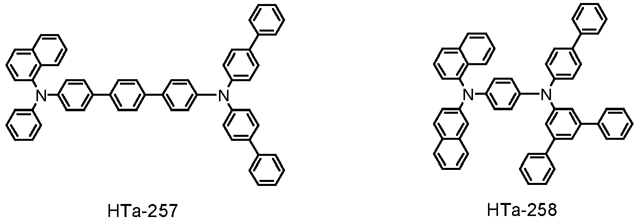

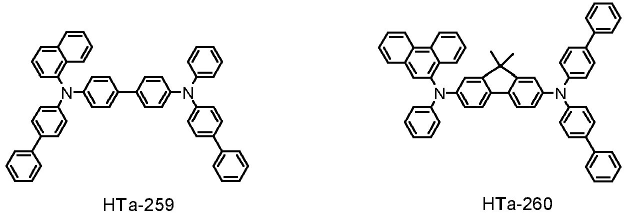

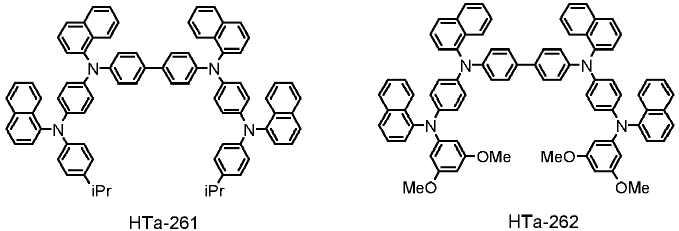

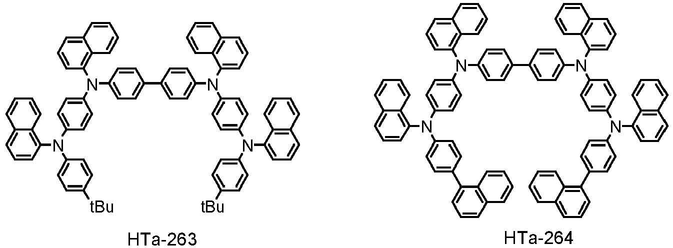

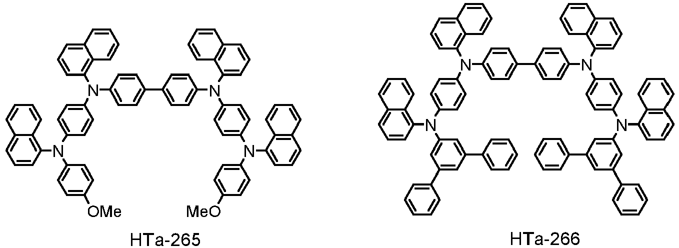

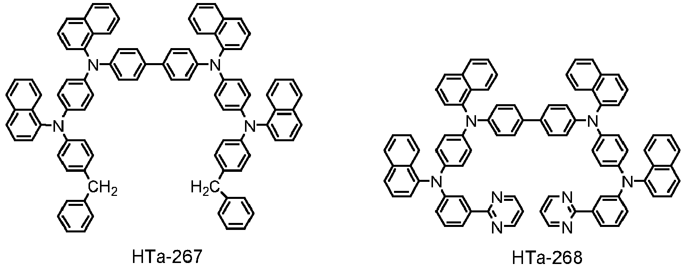

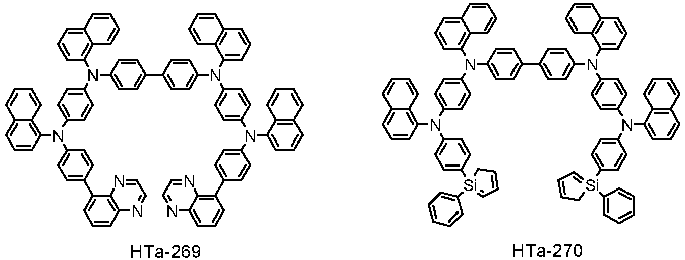

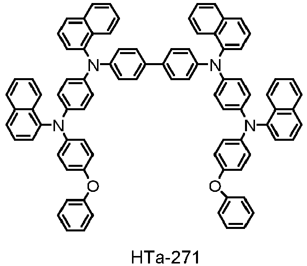

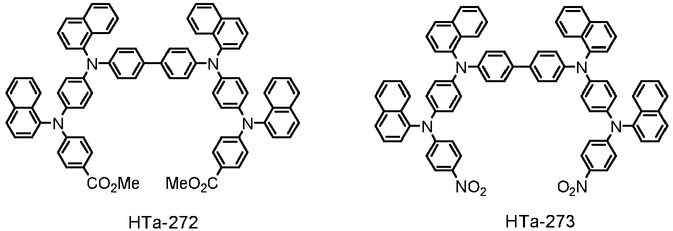

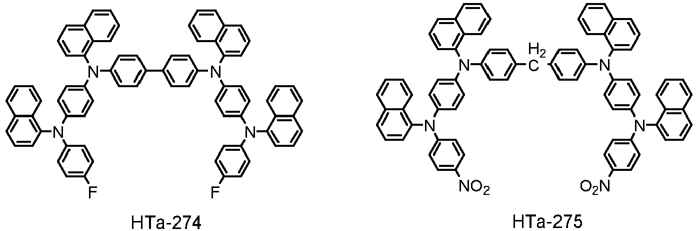

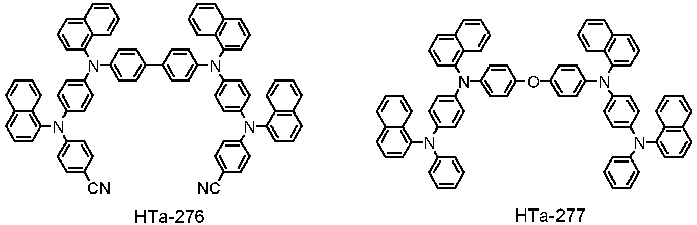

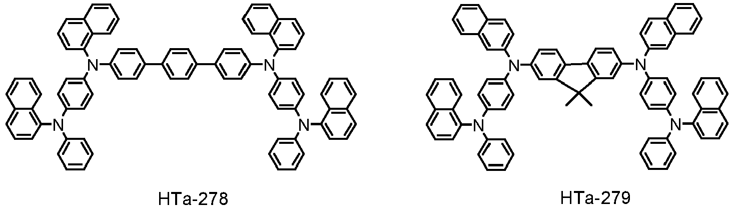

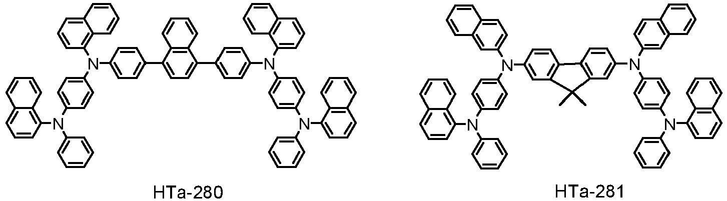

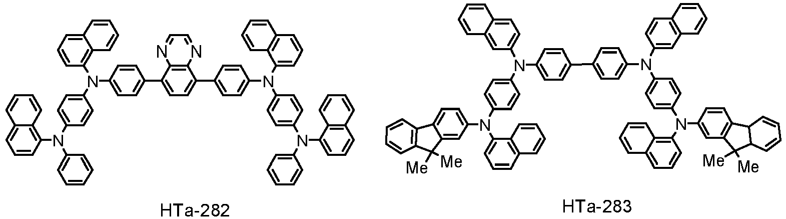

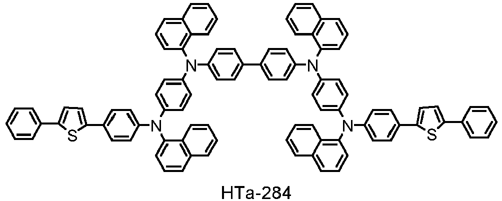

21. The organic light-emitting device of claim 1, wherein the hole transport region further comprises a second compound represented by one of Formula 201A-1 and Formula 202A: 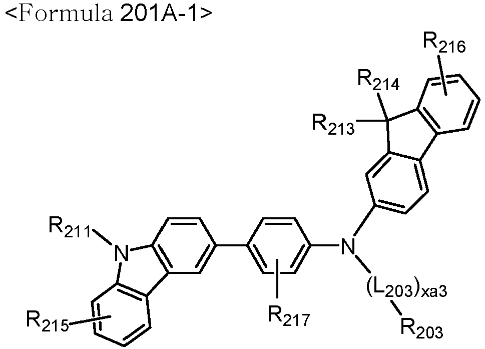 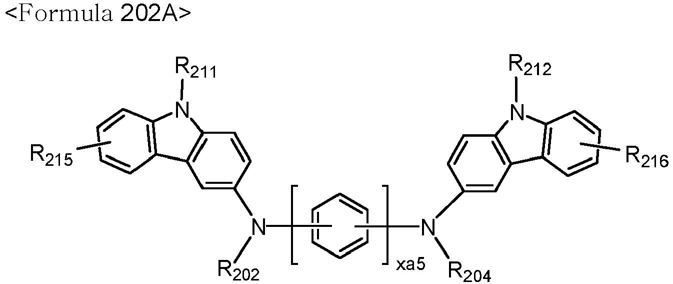 wherein, in Formulae 201A-1 and 202A,
R₂₀₂ to R₂₀₄, and R₂₁₁ to R₂₁₂ are each independently selected from
a substituted or unsubstituted C₆-C₆₀ aryl group, a substituted or unsubstituted C₁-C₆₀ heteroaryl group, the substituted monovalent non-aromatic condensed polycyclic group, and the substituted monovalent non-aromatic condensed heteropolycyclic group;
L₂₀₃ is a substituted or unsubstituted C₆-C₆₀ arylene group;
xa3 and xa5 are each independently an integer selected from 0 to 3;
R₂₁₃ and R₂₁₄ are each independently selected from
a C₁-C₁₀ alkyl group, a C₁-C₁₀ alkoxy group, and a C₁-C₂₀ aryl group;
a C₁-C₁₀ alkyl group and a C₁-C₁₀ alkoxy group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof; and
a C₁-C₂₀ aryl group substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, and a C₁-C₂₀ aryl group;
optionally, R₂₁₃ and R₂₁₄ are bound to each other to form a condensed polycyclic ring,
R₂₁₅ to R₂₁₇ are each independently selected from
a hydrogen atom, a deuterium atom, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), and -B(Q₆)(Q₇);
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₆-C₆₀ arylene group, the substituted monovalent non-aromatic condensed polycyclic group, and the substituted monovalent non-aromatic condensed heteropolycyclic group is selected from
a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group,
a C₁-C₆₀ alkyl group, a C₂-C₆₀ alkenyl group, a C₂-C₆₀ alkynyl group, and a C₁-C₆₀ alkoxy group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), and -B(Q₁₆)(Q₁₇),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇), and -N(Q₃₁)(Q₃₂), -Si(Q₃₃)(Q₃₄)(Q₃₅), and -B(Q₃₆)(Q₃₇),
wherein Q₁ to Q₇, Q₁₁ to Q₁₇, Q₂₁ to Q₂₇ and Q₃₁ to Q₃₇ are each independently selected from a hydrogen atom, a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

22. The organic light-emitting device of claim 21, wherein, in Formulae 201A-1 and 202A, R₂₀₂ to R₂₀₄, and R₂₁₁ to R₂₁₂ are each independently selected from
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group;
L₂₀₃ is selected from
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, and a perylenylene group, and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, anthrylene group, a fluoranthenylene group, a triphenylenylene group, a pyrenylene group, a chrysenylene group, a naphthacenylene group, a picenylene group, and a perylenylene group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group;
R₂₁₃ and R₂₁₄ are each independently selected from
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group,
a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, and a pentoxy group, each substituted with at least one of a deuterium atom, -F, -CI, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, each substituted with at least one of a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group;
R₂₁₅ to R₂₁₇ are each independently selected from
a hydrogen atom, a deuterium atom, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, and a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group, each substituted with at least one of a deuterium atom, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a methoxy group, an ethoxy group, a propoxy group, a butoxy group, a pentoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthryl group, a fluoranthenyl group, a triphenylenyl group, a pyrenyl group, a chrysenyl group, a naphthacenyl group, a picenyl group, a perylenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridyl group, a pyrazinyl group, a pyrimidinyl group, a pyridazinyl group, an isoindolyl group, an indolyl group, an indazolyl group, a purinyl group, a quinolyl group, an isoquinolyl group, a benzoquinolyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzofluorenyl group, a benzimidazolyl group, a benzofuranyl group, a benzothiophenyl group, a benzothiazolyl group, a benzoxazolyl group, an isobenzoxazolyl group, a triazolyl group, a tetrazolyl group, an oxadiazolyl group, a triazinyl group, a dibenzofluorenyl group, a dibenzofuranyl group, a dibenzothiophenyl group, a benzocarbazolyl group, a dibenzocarbazolyl group, a thiadiazolyl group, an imidazopyridyl group, and an imidazopyrimidinyl group.

23. The organic light-emitting device of claim 21, wherein, in Formulae 201A-1 and 202A, R₂₀₂ to R₂₀₄, and R₂₁₁ to R₂₁₂ are each independently a phenyl group, a biphenyl group, a naphthyl group, a fluorenyl group, and a pyridyl group; and a phenyl group, and a fluorenyl group, each substituted with at least one of -F, -Cl, -Br, -I, a methyl group, and a cyano group;
L₂₀₃ is a phenylene group;
R₂₁₃ and R₂₁₄ are each independently a methyl group or a phenyl group, and optionally R₂₁₃ and R₂₁₄ are bound to each other to form a fluorene ring; and
R₂₁₅ to R₂₁₇ are a hydrogen atom.

24. The organic light-emitting device of claim 21, wherein the second compound is selected from compounds HTb-1 to HTb-20:

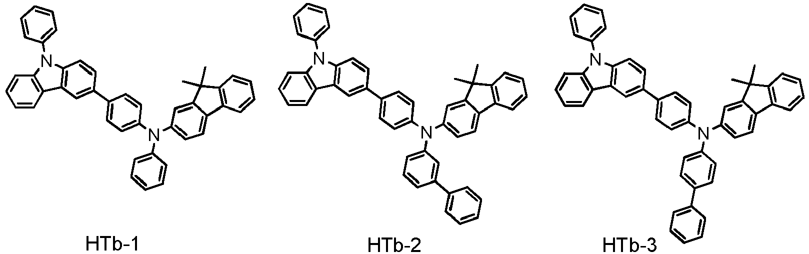

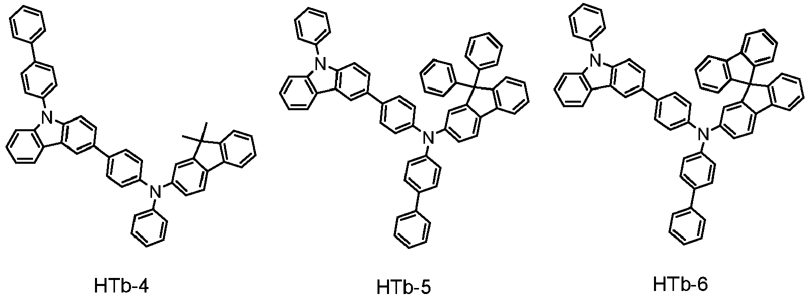

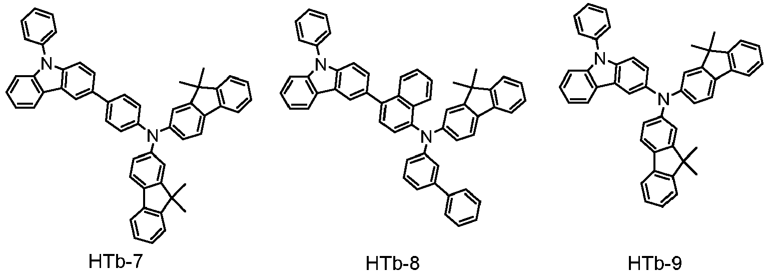

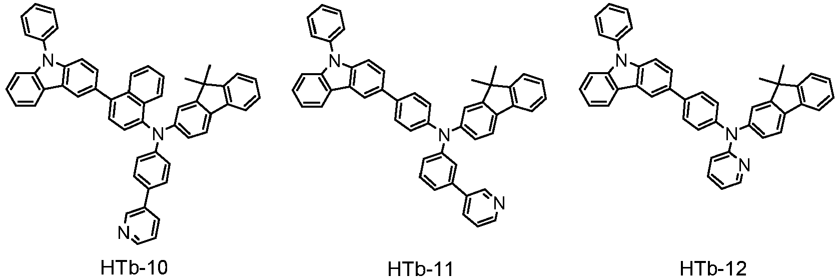

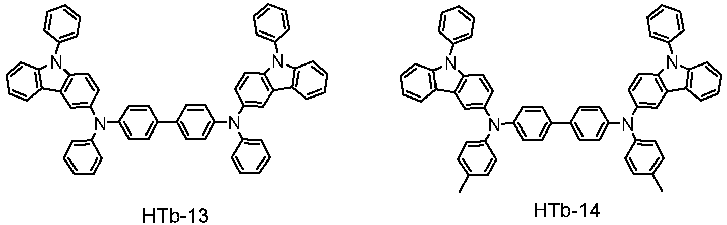

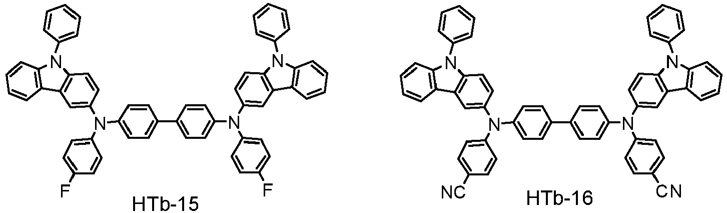

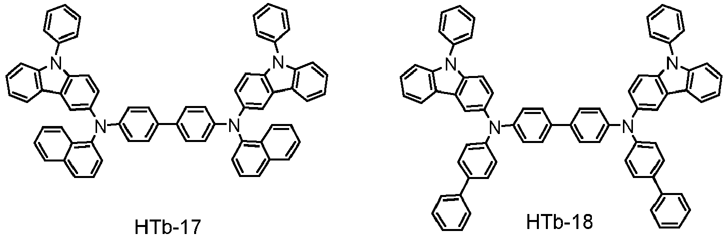

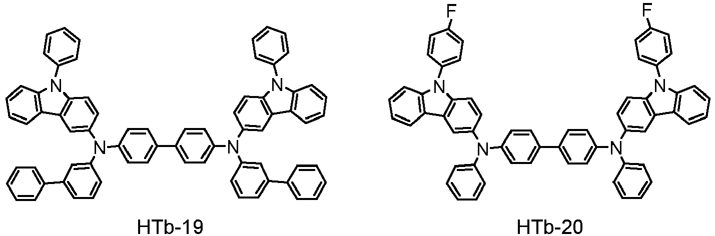

25. The organic light-emitting device of claim 21, wherein the auxiliary emission layer further comprises the second compound.

26. The organic light-emitting device of claim 21, wherein the hole transport layer comprises the second compound.

## Patentansprüche

1. Organische lichtemittierende Vorrichtung, umfassend:
eine erste Elektrode;
eine zweite Elektrode, die gegenüber der ersten Elektrode angeordnet ist;
eine Emissionsschicht zwischen der ersten Elektrode und der zweiten Elektrode; und
einen Lochleitungsbereich zwischen der ersten Elektrode und der Emissionsschicht, wobei der Lochleitungsbereich eine zusätzliche Emissionsschicht, die an die Emissionsschicht angrenzt, eine Lochleitungsschicht und eine Lochinjektionsschicht umfasst,
wobei sich die Lochinjektionsschicht auf der ersten Elektrode befindet,
wobei sich die Lochleitungsschicht auf der Lochinjektionsschicht befindet, und
wobei die Emissionsschicht eine metallorganische Verbindung umfasst, die durch die Formel 1 dargestellt ist, und die zusätzliche Emissionsschicht eine erste Verbindung umfasst, die durch Formel 2A oder Formel 2B dargestellt ist:
<Formel 1> M(L1)ₙ₁(L2)ₙ₂
wobei in Formel 1,
M ausgewählt ist aus Iridium (Ir), Platin (Pt), Osmium (Os), Titan (Ti), Zirkonium (Zr), Hafnium (Hf), Europium (Eu), Terbium (Tb), Thulium (Tm) und Rhodium (Rd) ;
L1 ein Ligand ist, dargestellt durch Formel 1A;
L2 ein Ligand ist, dargestellt durch Formel 1B, wobei L1 und L2 jeweils voneinander verschieden sind;
n1 und n2 jeweils unabhängig voneinander 1 oder 2 sind, wobei n1+n2=2 oder n1+n2=3, die beiden L1, wenn n1 gleich 2 ist, gleich oder voneinander verschieden sind, und die beiden L2, wenn n2 gleich 2 ist, jeweils gleich oder voneinander verschieden sind; 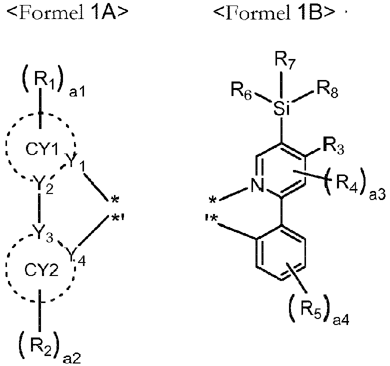 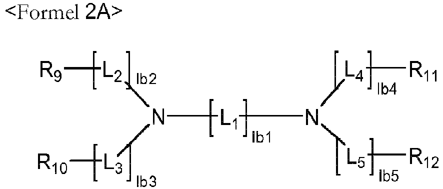 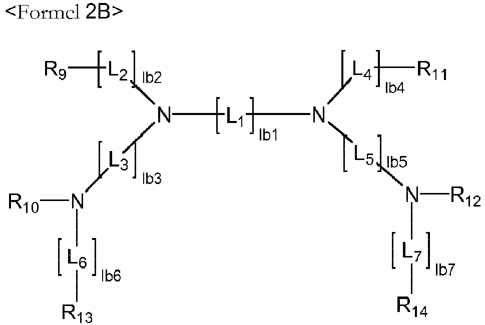
wobei in den Formeln 1A, 1B, 2A und 2B,
CY1 und CY2 jeweils unabhängig voneinander aus einer zyklischen C₅-C₆₀-Gruppe und einer heterozyklischen C₂-C₆₀-Gruppe ausgewählt sind, und CY1 und CY2 jeweils über eine Einfachbindung aneinandergebunden sind;
Y₁ bis Y₄ jeweils unabhängig voneinander Kohlenstoff (C) oder Stickstoff (N) sind, Y₁ und Y₂ jeweils über eine Einfach- oder Doppelbindung aneinandergebunden sind, und Y₃ und Y₄ jeweils über eine Einfach- oder Doppelbindung aneinandergebunden sind;
L₁ bis L₇ jeweils unabhängig voneinander ausgewählt sind aus einer substituierten oder unsubstituierten C₁-C₂₀-Alkylengruppe, -O-, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht-aromatischen kondensierten polyzyklischen Gruppe und einer substituierten oder unsubstituierten zweiwertigen nicht-aromatischen kondensierten heteropolyzyklischen Gruppe;
R₁ bis R₅ und R₉ bis R₁₄ jeweils unabhängig voneinander ausgewählt sind aus einem Wasserstoffatom, einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polyzyklischen Gruppe, einer substituierten oder unsubstituierten einwertigen nicht-aromatischen kondensierten heteropolyzyklischen Gruppe, -N(Q₁) (Q₂) , -Si(Q₃) (Q₄) (Q₅) und -B (Q₆) (Q₇) ; unter der Bedingung, dass R₃ nicht Wasserstoff ist;
R₆ bis R₈ jeweils unabhängig voneinander ausgewählt sind aus
einer C₁-C₁₀-Alkylgruppe, und
einer C₁-C₁₀-Alkylgruppe, substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon und einer Phosphorsäuregruppe oder einem Salz davon;
mindestens ein Substituent der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten C₆-C₆₀-Arylengruppe, der substituierten C₁-C₆₀-Heteroarylengruppe, der substituierten einwertigen nicht-aromatischen kondensierten polyzyklischen Gruppe und der substituierten einwertigen nicht-aromatischen kondensierten heteropolyzyklischen Gruppe ausgewählt ist aus
einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe,
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe, einer einwertigen nicht-aromatischen kondensierten heteropolyzyklischen Gruppe, -N(Q₁₁) (Q₁₂), -Si(Q₁₃) (Q₁₄) (Q₁₅) und -B(Q₁₆) (Q₁₇),
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀ Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe,
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe, jeweils substituiert mit mindestens einem aus einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe, einer einwertigen nicht-aromatischen kondensierten heteropolyzyklischen Gruppe, -N(Q₂₁)(Q₂₂) , -Si (Q₂₃) (Q₂₄) (Q₂₅), und -B (Q₂₆) (Q₂₇), und -N(Q₃₁₎ (Q₃₂), -Si(Q₃₃) (Q₃₄) (Q₃₅) und -B(Q₃₆) (Q₃₇),
wobei Q₁ bis Q₇, Q₁₁ bis Q₁₇, Q₂₁ bis Q₂₇ und Q₃₁ bis Q₃₇ jeweils unabhängig ausgewählt sind aus einem Wasserstoff, einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon,
einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe;
a₁ und a₂ jeweils unabhängig voneinander eine ganze Zahl sind, ausgewählt aus 0 bis 5;
a₃ eine ganze Zahl ist, ausgewählt aus 0 bis 2;
a₄ eine ganze Zahl ist, ausgewählt aus 0 bis 4, wobei optional mehrere R₅, wenn a₄ 2 oder größer ist, an einen Benzolring kondensiert sind, an den die R₅ gebunden sind, wodurch ein kondensierter Ring gebildet wird;
Ib₁ eine ganze Zahl ist, ausgewählt aus 1 bis 5;
Ib₂ bis Ib₇ jeweils unabhängig voneinander eine ganze Zahl sind, ausgewählt aus 0 bis 4; und
* und *' Bindungsstellen an M in Formel 1 sind.

2. Organische lichtemittierende Vorrichtung nach Anspruch 1, wobei M in Formel 1 Osmium (Os), Iridium (Ir) oder Platin (Pt) ist.

3. Organische lichtemittierende Vorrichtung nach Anspruch 1, wobei M in Formel 1 Iridium (Ir) ist.

4. Organische lichtemittierende Vorrichtung nach Anspruch 1, wobei n1 und n2 in Formel 1 jeweils unabhängig voneinander 1 oder 2 sind und n1+n2=3.

5. Organische lichtemittierende Vorrichtung nach Anspruch 1, wobei Y₁ in Formel 1A ein Stickstoff (N) ist und Y₂ bis Y₄ ein Kohlenstoff (C) sind.

6. Organische lichtemittierende Vorrichtung nach Anspruch 1, wobei CY1 und CY2 in Formel 1A jeweils unabhängig voneinander ausgewählt sind aus einem Benzol, einem Naphthalin, einem Fluoren, einem Spirofluoren, einem Indol, einem Inden, einem Furan, einem Thiophen, einem Carbazol, einem Benzofuran, einem Benzothiophen, einem Dibenzofuran, einem Dibenzothiophen, einem Pyrrol, einem Imidazol, einem Pyrazol, einem Thiazol, einem Isothiazol, einem Oxazol, einem Isoxazol, einem Triazol, einem Pyridin, einem Pyrimidin, einem Pyrazin, einem Pyridazin, einem Chinolin, einem Triazin, einem Isochinolin, einem Benzochinolin, einem Chinoxalin, einem Chinazolin, einem Naphthyridin, einem Benzimidazol, einem Benzoxazol, einem Isobenzoxazol und einem Oxadiazol.

7. Organische lichtemittierende Vorrichtung nach Anspruch 1, worin CY1 in Formel 1A ausgewählt ist aus einem Pyrrol, einem Imidazol, einem Triazol, einem Oxadiazol, einem Pyridin, einem Pyrimidin, einem Pyrazin, einem Chinolin, einem Isochinolin und einem Triazin.

8. Organische lichtemittierende Vorrichtung nach Anspruch 1, worin CY2 in Formel 1A ausgewählt ist aus einem Benzol, einem Naphthalin, einem Furan, einem Thiophen, einem Pyridin, einem Pyrimidin, einem Pyrazin, einem Triazin, einem Fluoren, einem Carbazol, einem Phenylcarbazol, einem Indol, einem Oxadiazol, einem Benzofuran, einem Benzothiophen, einem Dibenzofuran und einem Dibenzothiophen.

9. Organische lichtemittierende Vorrichtung nach Anspruch 1, wobei CY1 in Formel 1A ausgewählt ist aus einem Pyridin, einem Pyrimidin, einem Triazin, einem Chinolin, einem Isochinolin, einem Oxadiazol, einem Triazol und einem Imidazol; und
CY2 ausgewählt ist aus einem Benzol, einem Pyridin, einem Pyrimidin, einem Dibenzofuran, einem Dibenzothiophen, einem Thiophen, einem Benzothiophen, einem Furan, einem Benzofuran, einem Indol, einem Carbazol und einem Phenylcarbazol.

10. Organische lichtemittierende Vorrichtung nach Anspruch 1, wobei R₁ bis R₅ in Formel 1A und Formel 1B jeweils unabhängig voneinander ausgewählt sind aus
einem Wasserstoffatom, unter der Bedingung, dass R₃ nicht Wasserstoff ist, einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe und einer Phenoxygruppe,
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe und einer Pentoxygruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe und einer Perylenylgruppe, und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe und einer Phenoxygruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe und einer Perylenylgruppe; und
R₆ bis R₈ ausgewählt sind aus einer Methylgruppe, einer Ethylgruppe, einer n-Propylgruppe, einer Isopropylgruppe, einer n-Butylgruppe, einer Isobutylgruppe, einer sec-Butylgruppe und einer tert-Butylgruppe und R₆ bis R₈ jeweils gleich sind.

11. Organische lichtemittierende Vorrichtung nach Anspruch 1, wobei die metallorganische Verbindung, dargestellt durch Formel 1, ausgewählt ist aus den Verbindungen PD-1 bis PD-79 und PD-81 bis PD-193:

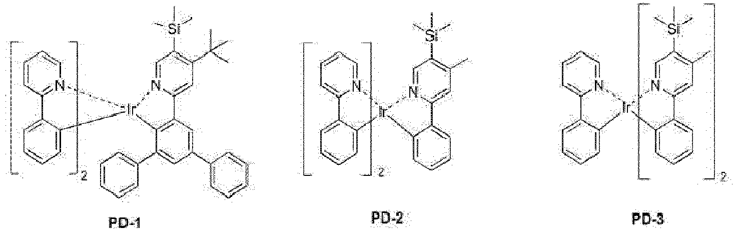

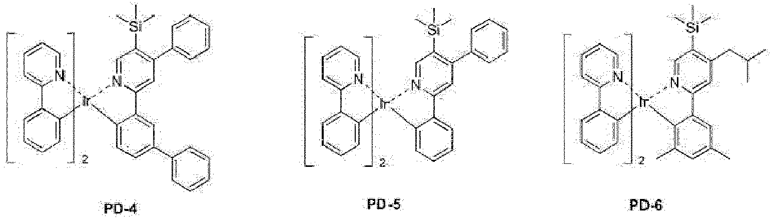

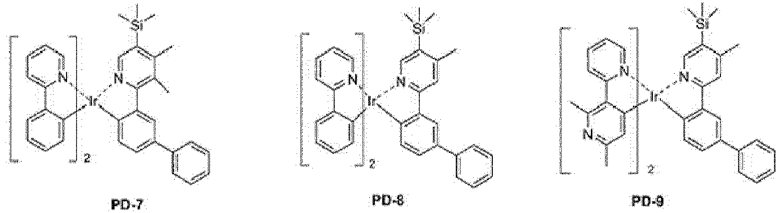

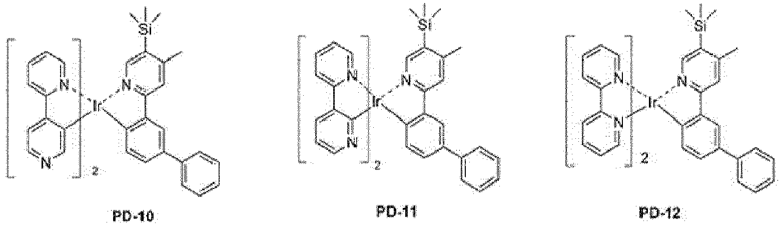

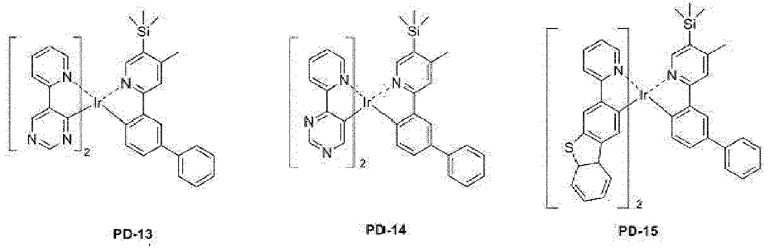

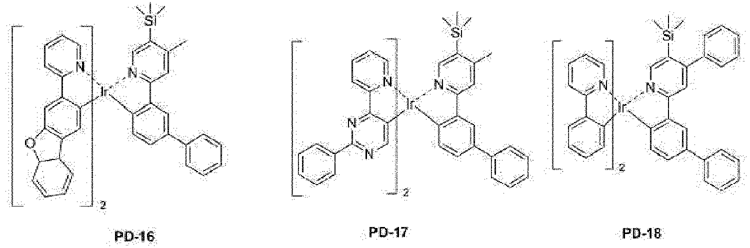

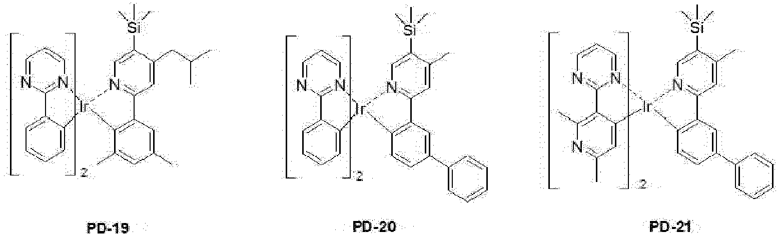

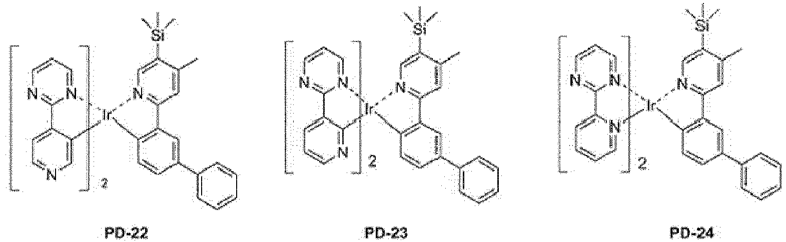

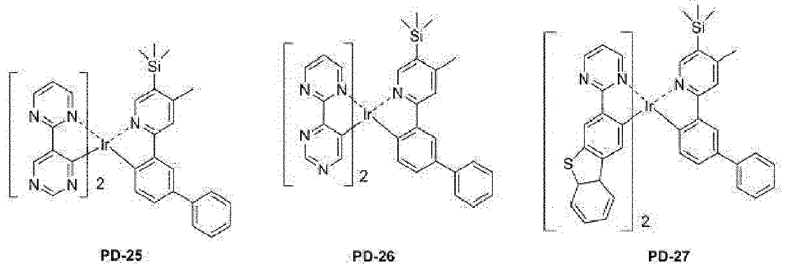

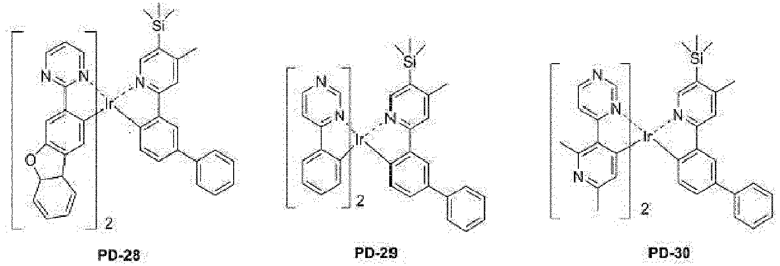

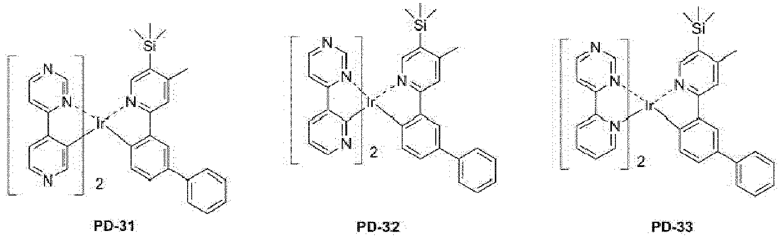

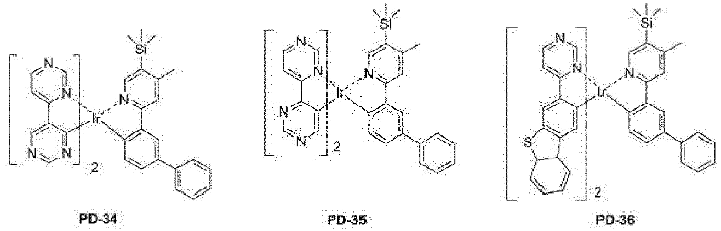

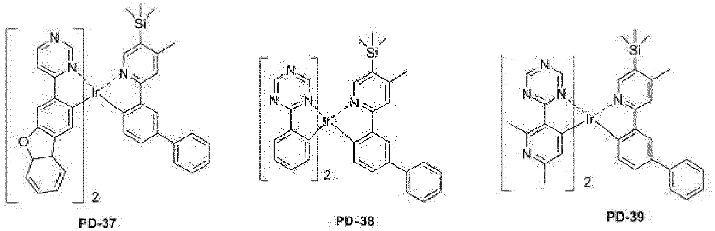

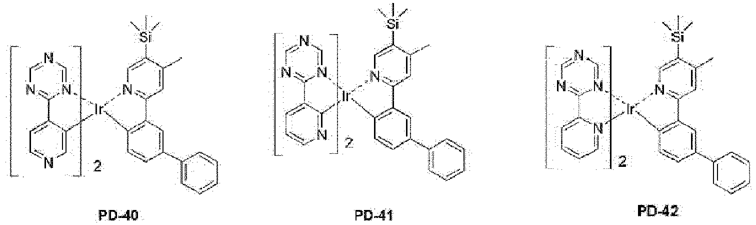

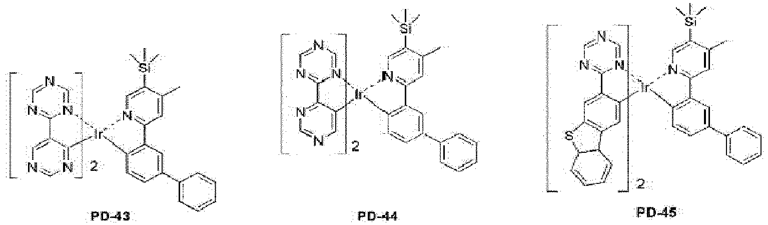

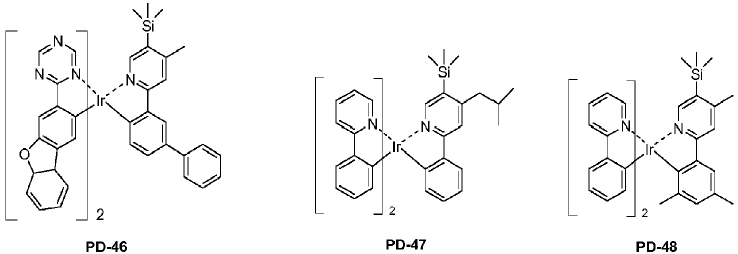

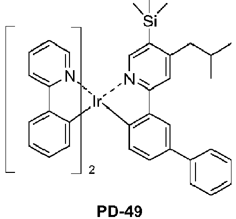

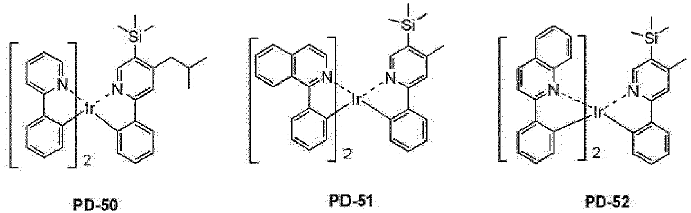

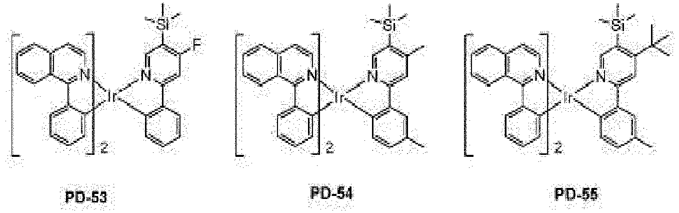

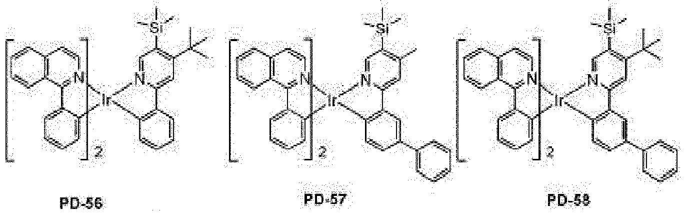

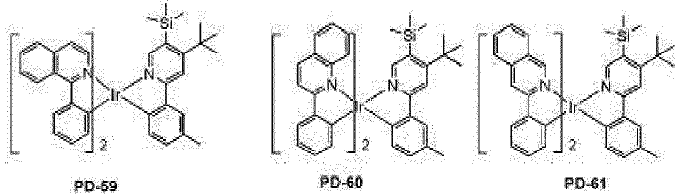

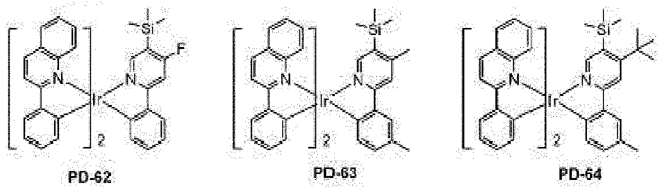

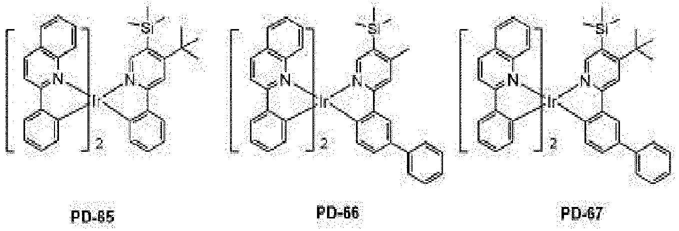

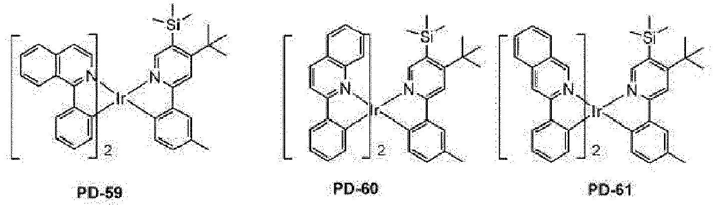

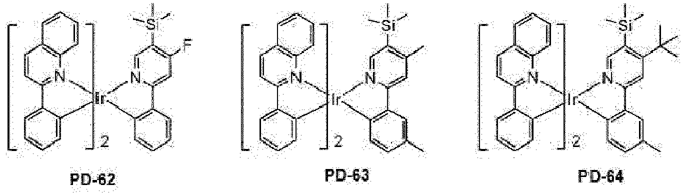

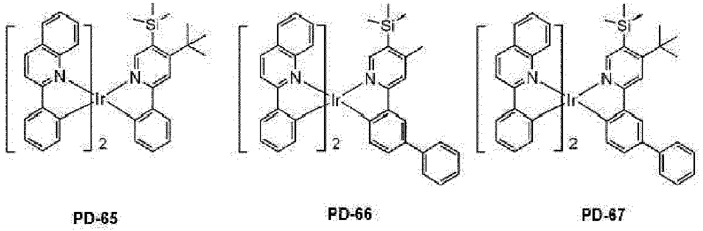

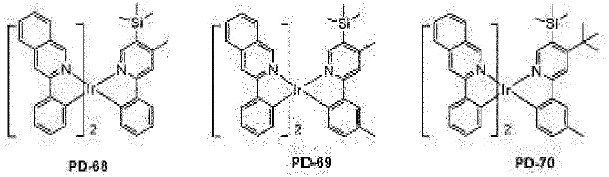

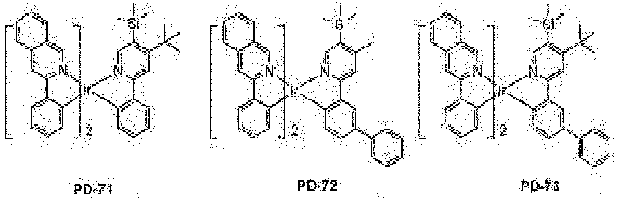

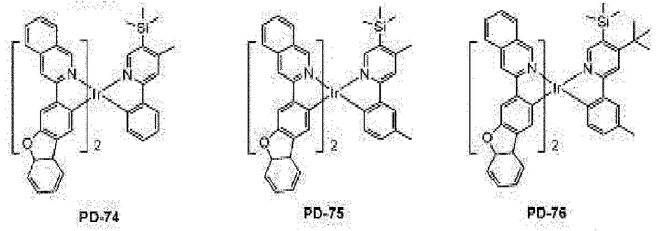

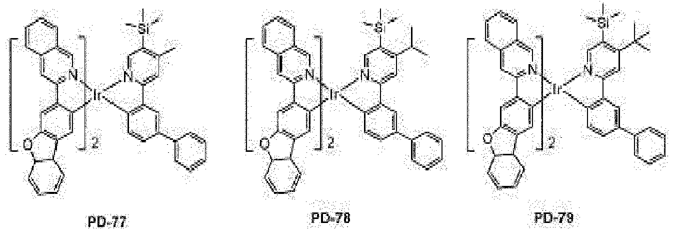

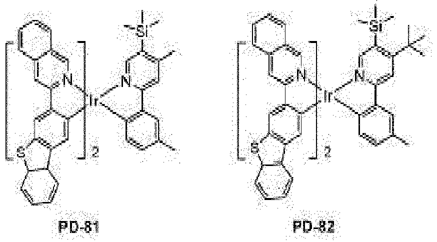

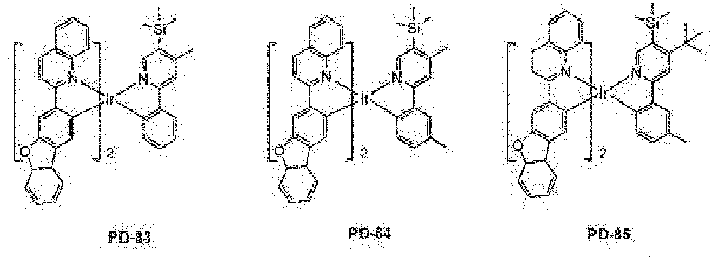

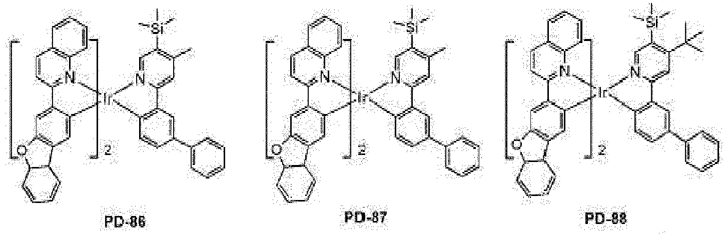

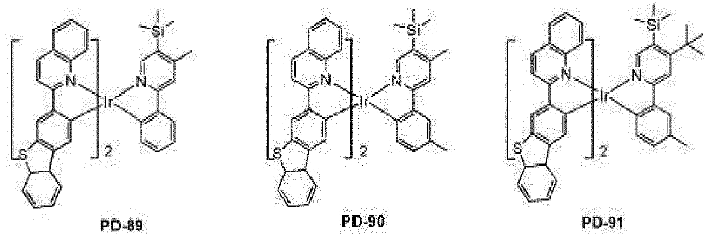

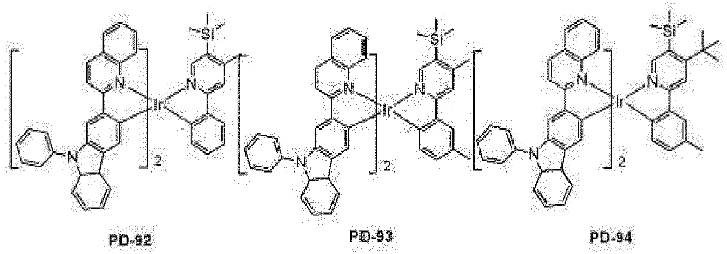

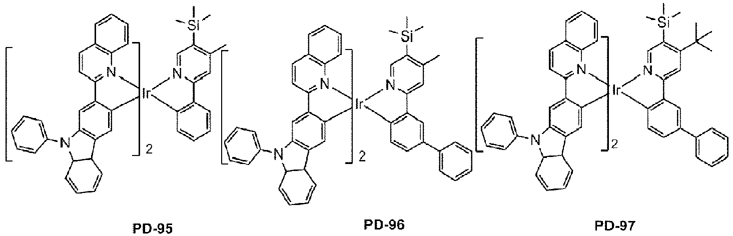

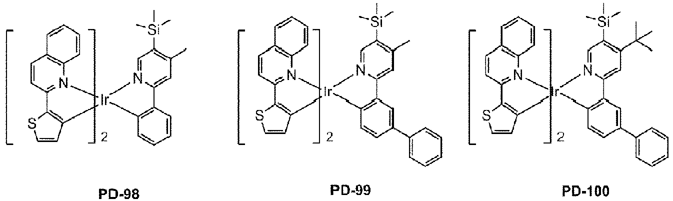

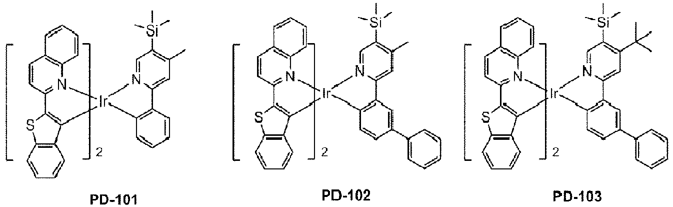

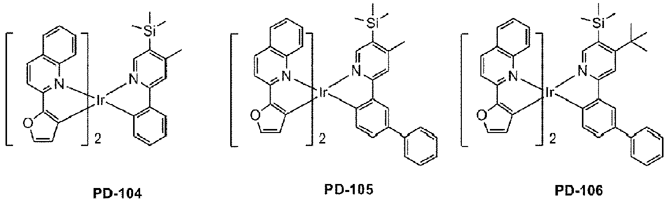

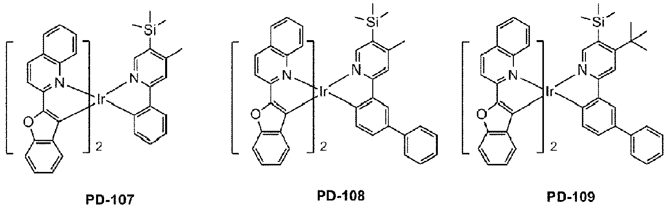

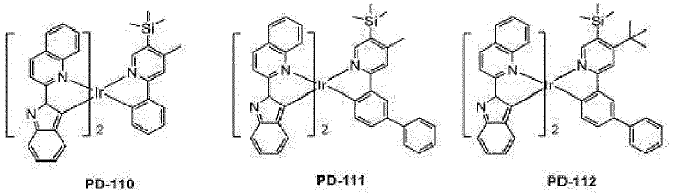

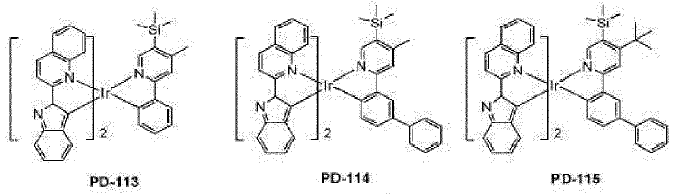

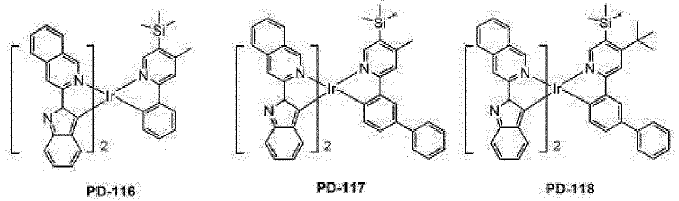

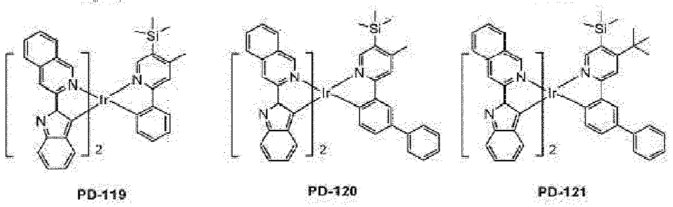

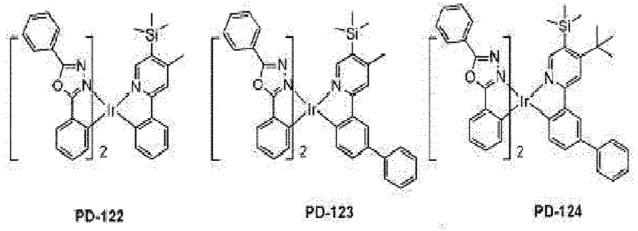

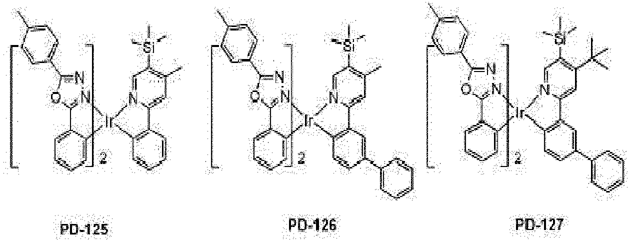

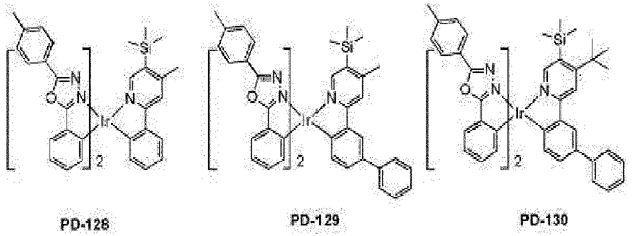

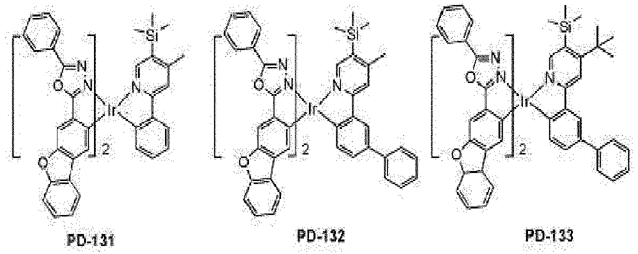

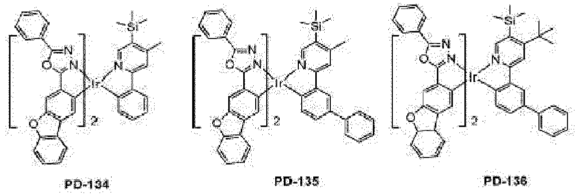

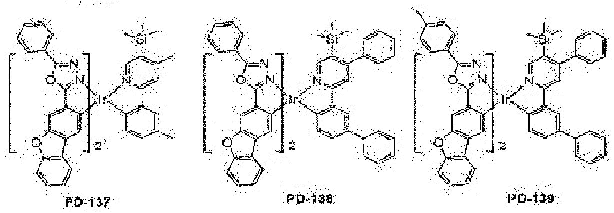

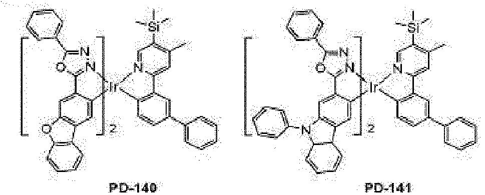

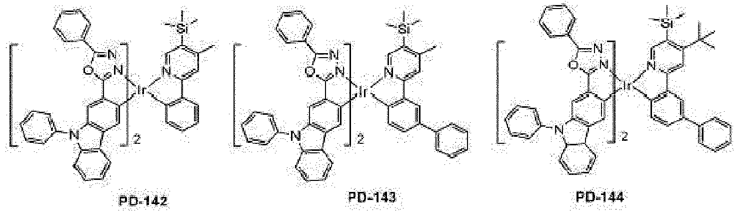

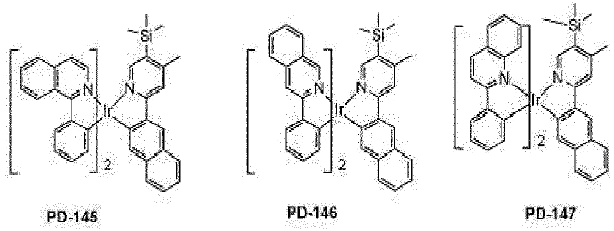

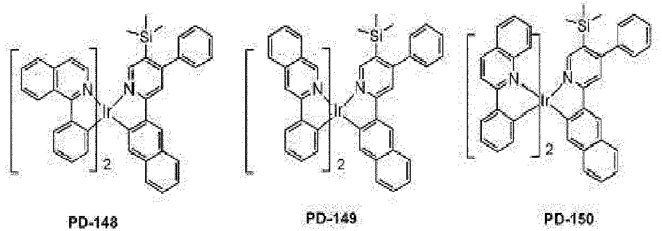

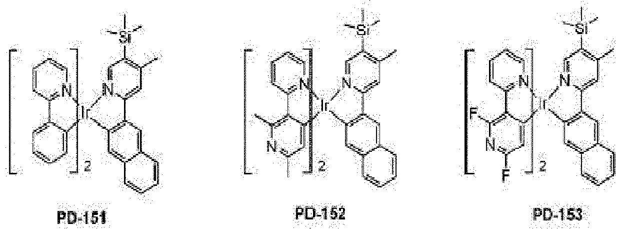

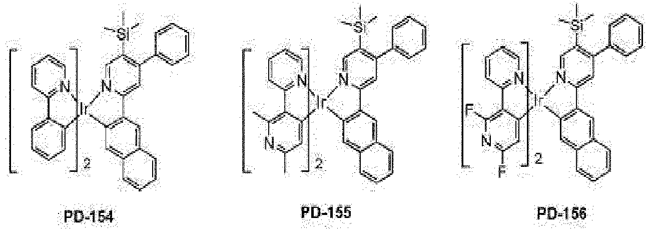

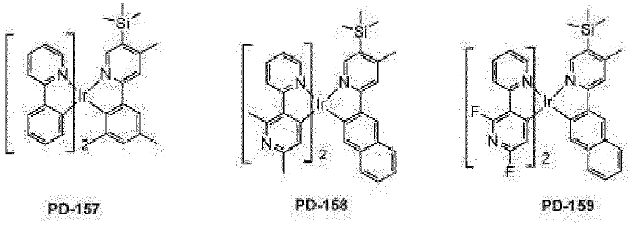

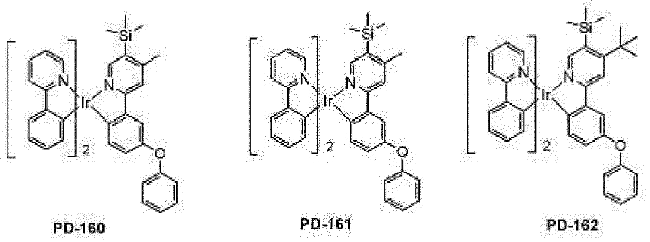

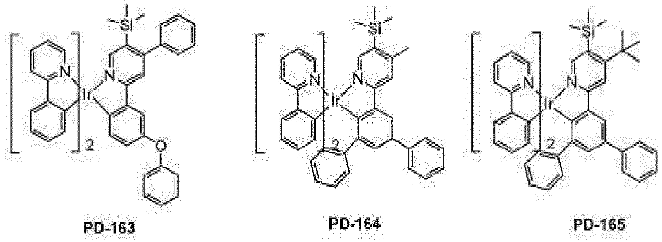

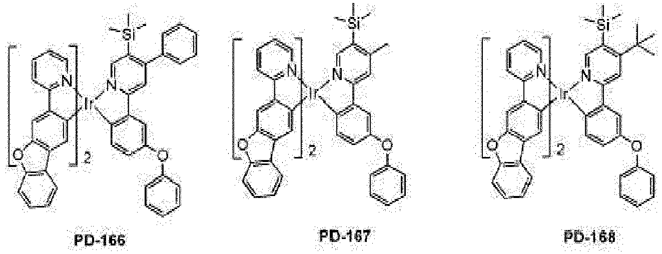

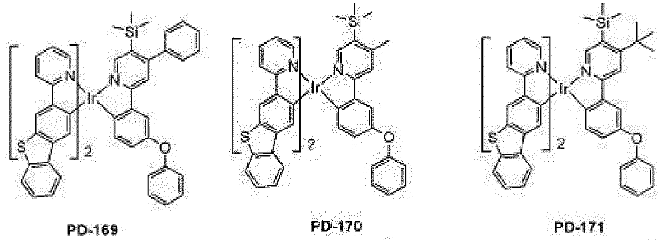

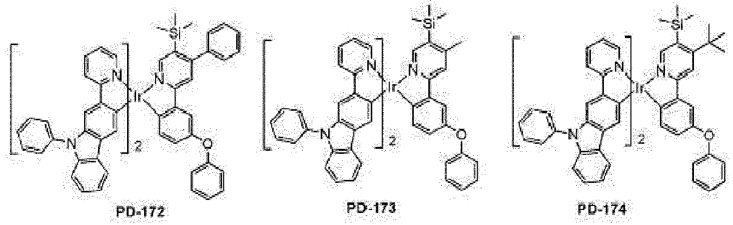

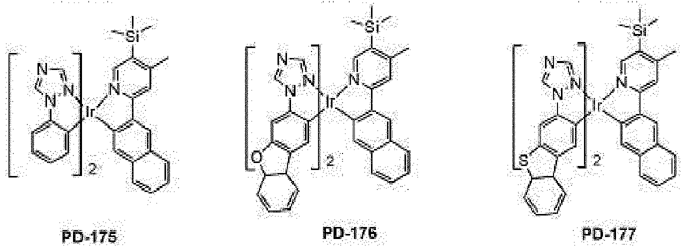

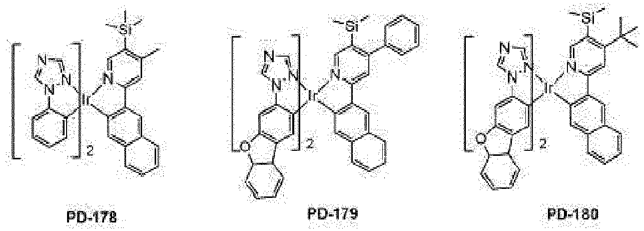

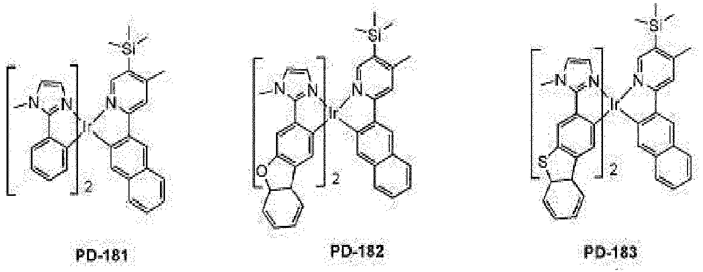

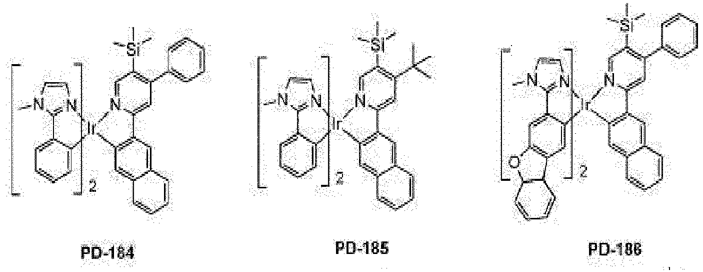

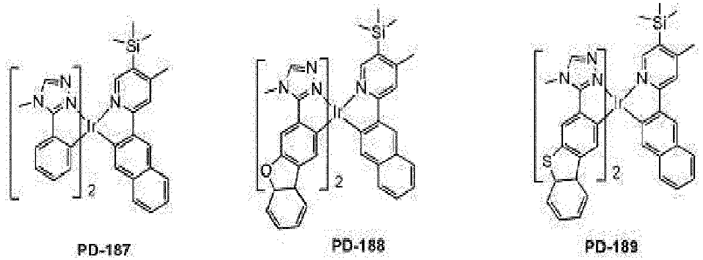

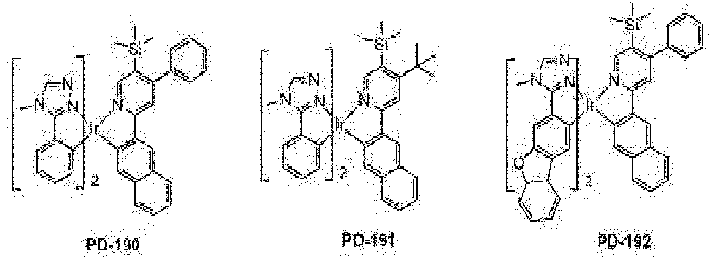

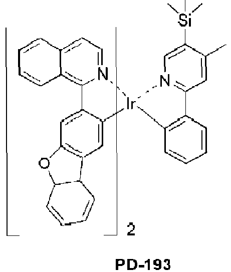

12. Organische lichtemittierende Vorrichtung nach Anspruch 1, wobei L₁ bis L₇ in den Formeln 2A und 2B jeweils unabhängig voneinander ausgewählt sind aus
-O-, einer Methylengruppe, einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, Anthrylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pyrrolylengruppe, einer Thienylengruppe, einer Furylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolylengruppe, einer Isochinolylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe, einer Dibenzocarbazolylengruppe, einer Thiadiazolylengruppe, einer Imidazopyridylengruppe, einer Imidazopyrimidinylengruppe und einer Cyclohexylgruppe, und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, Anthrylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pyrrolylengruppe, einer Thienylengruppe, einer Furylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolylengruppe, einer Isochinolylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe, einer Dibenzocarbazolylengruppe, einer Thiadiazolylengruppe, einer Imidazopyridylengruppe, einer Imidazopyrimidinylengruppe und einer Cyclohexylgruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe.

13. Organische lichtemittierende Vorrichtung nach Anspruch 1, wobei L₁ bis L₇ in den Formeln 2A und 2B jeweils unabhängig voneinander ausgewählt sind aus -O-, einer Methylengruppe und einer Gruppe, die durch eine der Formeln 3A bis Formel 3E dargestellt ist: 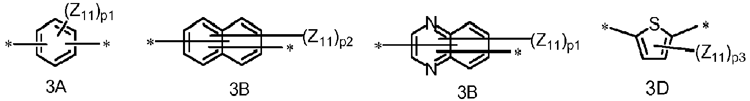 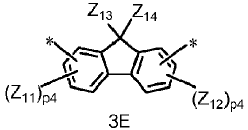 wobei in den Formeln 3A bis 3E,
Z₁₁ bis Z₁₄ jeweils unabhängig voneinander ausgewählt sind aus
einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, einer Imidazopyrimidinylgruppe, -N(Q₃₁) (Q₃₂) und -Si (Q₃₃) (Q₃₄) (Q₃₅), und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, jeweils substituiert mit mindestens einem aus einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, einer Imidazopyrimidinylgruppe, -N(Q₂₁) (Q₂₂) und -Si (Q₂₃) (Q₂₄) (Q₂₅),
wobei Q₃₁ bis Q₃₅ und Q₂₁ bis Q₂₅ jeweils unabhängig voneinander ausgewählt sind aus
einem Wasserstoffatom, einer C₁-C₂₀-Alkylgruppe, einer C₁-C₂₀-Alkoxygruppe, einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, und
einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, jeweils substituiert mit mindestens einer aus einer C₁-C₂₀-Alkylgruppe, einer C₁-C₂₀)-Alkoxygruppe, einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe;
optional mindestens zwei aus Q₂₃ bis Q₂₅ aneinandergebunden sind, um einen Ring zu bilden;
optional Z₁₃ und Z₁₄ in den Formeln 3E jeweils aneinandergebunden sind, um einen Ring zu bilden;
p1 eine ganze Zahl von 0 bis 4 ist;
p2 eine ganze Zahl von 0 bis 6 ist;
p3 eine ganze Zahl von 0 bis 2 ist;
p4 eine ganze Zahl von 0 bis 3 ist; und
* eine Bindungsstelle ist.

14. Organische lichtemittierende Vorrichtung nach Anspruch 1, wobei L₁ bis L₇ in den Formeln 2A und 2B jeweils unabhängig voneinander ausgewählt sind aus -O-, einer Methylengruppe und Gruppen, die durch die Formeln 4A bis Formel 4J dargestellt sind: 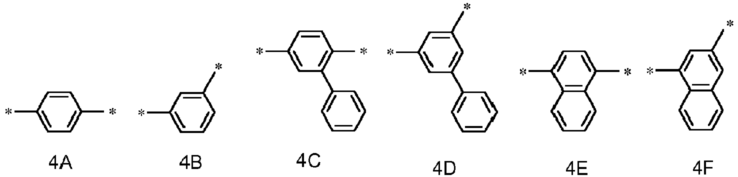 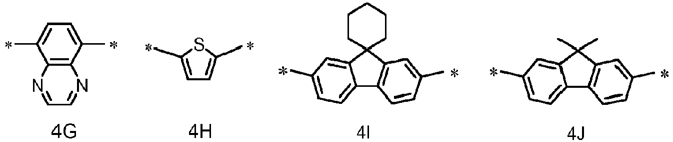 wobei in den Formeln 4A bis 4J, * eine Bindungsstelle ist.

15. Organische lichtemittierende Vorrichtung nach Anspruch 1, wobei [L₁]_{Ib1} in den Formeln 2A und 2B eine Gruppe ist, die durch eine der Formeln 5A bis 5L dargestellt ist: 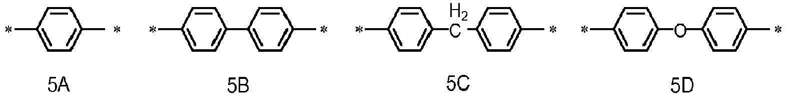 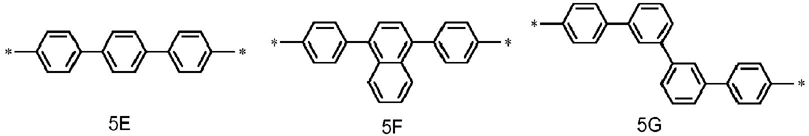 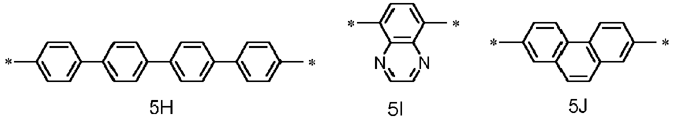 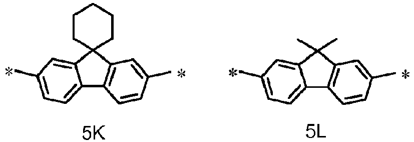 wobei in den Formeln 5A bis 5L, * eine Bindungsstelle ist.

16. Organische lichtemittierende Vorrichtung nach Anspruch 1, wobei R₉ bis R₁₄ in den Formeln 2A und 2B jeweils unabhängig voneinander ausgewählt sind aus
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe und einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, jeweils substituiert mit mindestens einem aus einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Phenylmethylgruppe, einer Triphenylmethylgruppe, einer Ethylgruppe, einer N-Propylgruppe, einer Isopropylgruppe, einer N-Butylgruppe, einer Isobutylgruppe, einer sec-Butylgruppe, einer tert-Butylgruppe, einer N-Pentylgruppe, einer Isopentylgruppe, einer sec-Pentylgruppe, einer tert-Pentylgruppe, einer Cyclohexylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, einer Imidazopyrimidinylgruppe, -N(Q₂₁) (Q₂₂) und -Si (Q₂₃) (Q₂₄) (Q₂₅),
wobei Q₂₁ bis Q₂₅ jeweils unabhängig voneinander ausgewählt sind aus
einem Wasserstoffatom, einer C₁-C₂₀-Alkylgruppe, einer C₁-C₂₀)-Alkoxygruppe, einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, und
einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, jeweils substituiert mit mindestens einer aus einer C₁-C₂₀-Alkylgruppe, einer C₁-C₂₀)-Alkoxygruppe, einer Biphenylgruppe, einer Phenylgruppe, einer Naphthylgruppe, einer Anthrylgruppe, einer Pyrenylgruppe, einer Phenanthrenylgruppe, einer Triphenylenylgruppe und einer Fluorenylgruppe.

17. Organische lichtemittierende Vorrichtung nach Anspruch 1, wobei R₉ bis R₁₄ in den Formeln 2A und 2B jeweils unabhängig voneinander eine Gruppe sind, die durch eine der Formeln 6A bis Formel 6G dargestellt ist: 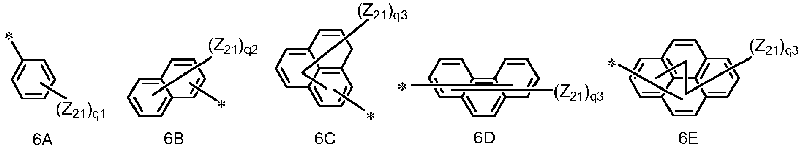 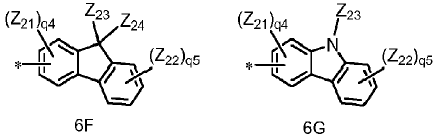 wobei in den Formeln 6A bis 6G,
Z₂₁ bis Z₂₄ jeweils unabhängig voneinander ausgewählt sind aus
einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, einer Imidazopyrimidinylgruppe, -N(Q₃₁) (Q₃₂), und -Si (Q₃₃) (Q₃₄) (Q₃₅), und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenoxygruppe, einer Phenylmethylgruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, einer Imidazopyrimidinylgruppe, -N(Q₂₁) (Q₂₂) , und -Si (Q₂₃) (Q₂₄) (Q₂₅),
wobei Q₃₁ bis Q₃₅ und Q₂₁ bis Q₂₅ jeweils unabhängig voneinander ausgewählt sind aus
einem Wasserstoffatom, einer C₁-C₂₀-Alkylgruppe, einer C₁-C₂₀)-Alkoxygruppe, einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, und
einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, jeweils substituiert mit mindestens einer aus einer C₁-C₂₀-Alkylgruppe, einer C₁-C₂₀)-Alkoxygruppe, einer Phenylgruppe, einer Biphenylgruppe, einer Naphthylgruppe, einer Anthrylgruppe, einer Pyrenylgruppe, einer Phenanthrenylgruppe, einer Triphenylenylgruppe und einer Fluorenylgruppe, wobei optional mindestens zwei aus Q₂₃ bis Q₂₅ jeweils aneinander gebunden sind, um einen Ring zu bilden;
optional Z₂₃ und Z₂₄ in den Formeln 6F jeweils aneinandergebunden sind, um einen Ring zu bilden;
q1 eine ganze Zahl von 0 bis 5 ist;
q2 eine ganze Zahl von 0 bis 7 ist;
q3 eine ganze Zahl von 0 bis 9 ist;
q4 eine ganze Zahl von 0 bis 3 ist;
q5 eine ganze Zahl von 0 bis 4 ist; und
* eine Bindungsstelle ist.

18. Organische lichtemittierende Vorrichtung nach Anspruch 1, wobei R₉ bis R₁₄ in den Formeln 2A und 2B jeweils unabhängig voneinander eine Gruppe sind, die durch eine der Formeln 7A bis Formel 7AB dargestellt ist: 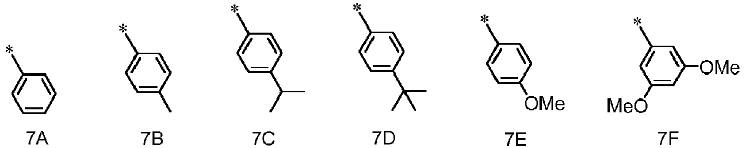 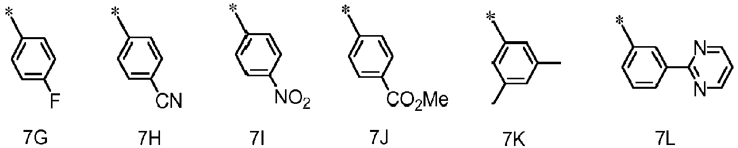 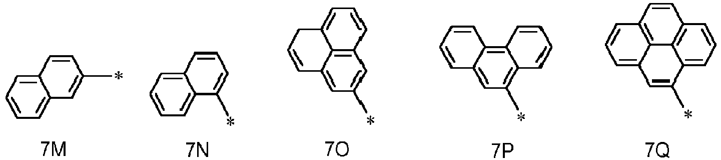 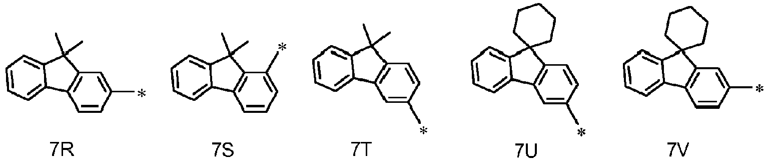 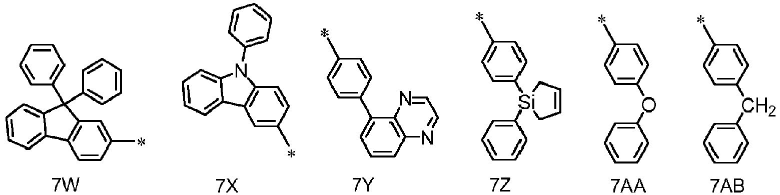 wobei in den Formeln 7A bis 8AB, * eine Bindungsstelle ist.

19. Organische lichtemittierende Vorrichtung nach Anspruch 1, wobei - [L₂]_{lb2}-R₉, - [L₃]_{lb3}-R₁₀, - [L₄]_{lb4}-R₁₁, - [L₅]_{lb5}-R₁₂, -[L₆]_{lb6}-R₁₃ und -[L₇]_{lb7}-R₁₄ in den Formeln 2A und 2B jeweils unabhängig voneinander eine Gruppe sind, die durch eine der Formeln 8A bis 8AI dargestellt ist: 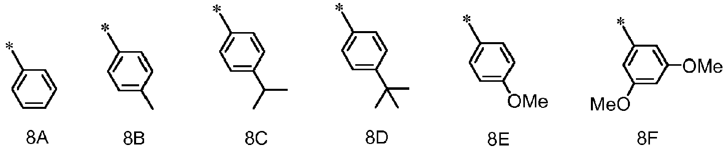 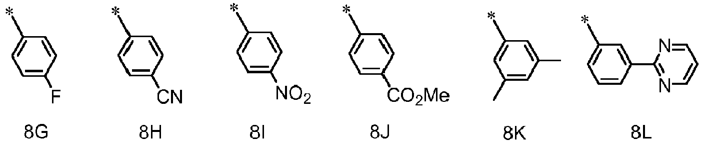 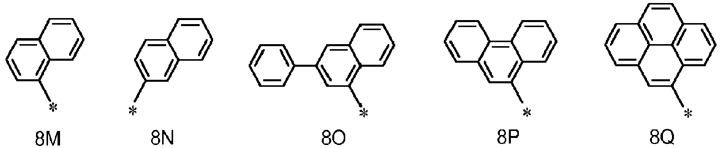 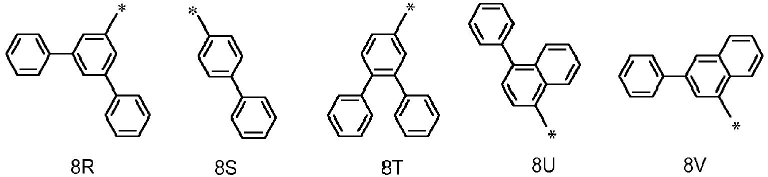 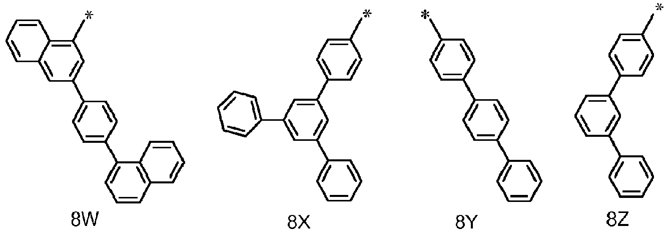 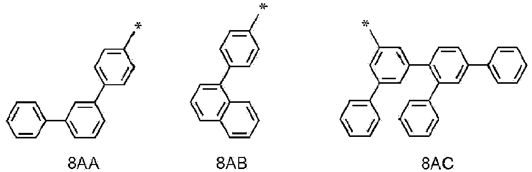 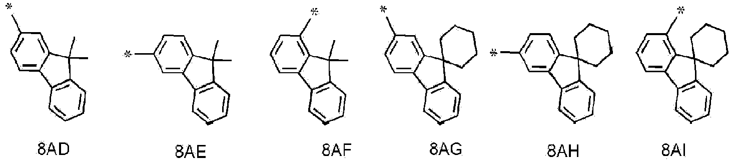 wobei in den Formeln 8A bis 8AI, * eine Bindungsstelle ist.

20. Organische lichtemittierende Vorrichtung nach Anspruch 1, wobei die erste Verbindung, dargestellt durch die Formel 2A oder 2B, ausgewählt ist aus den Verbindungen HTa-1 bis HTa-121 bis HTa-129 bis HTa-284:

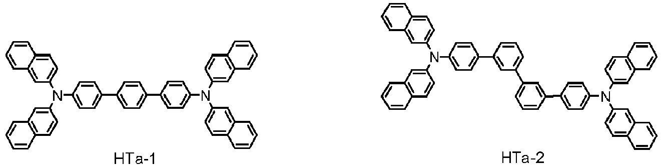

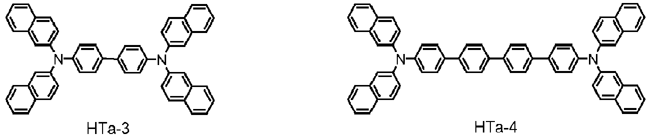

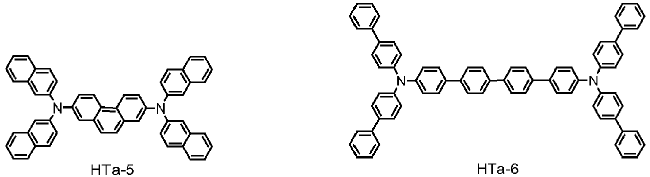

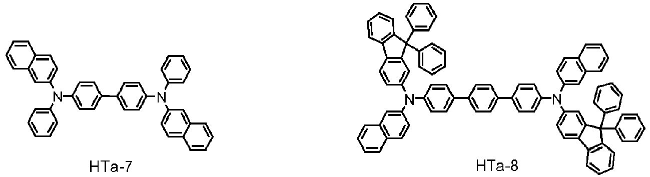

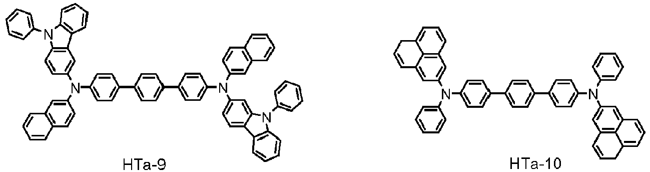

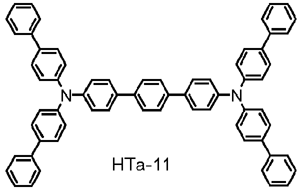

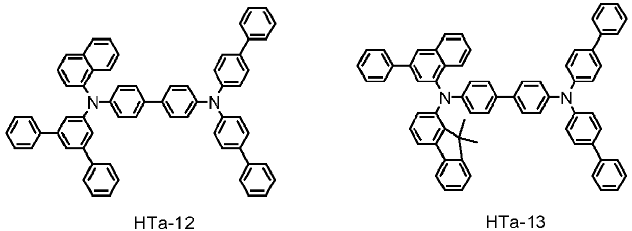

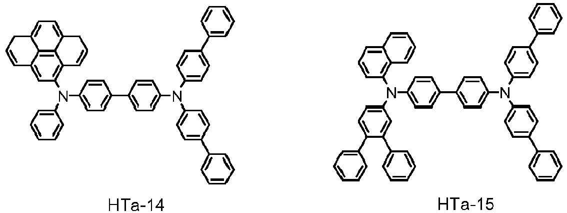

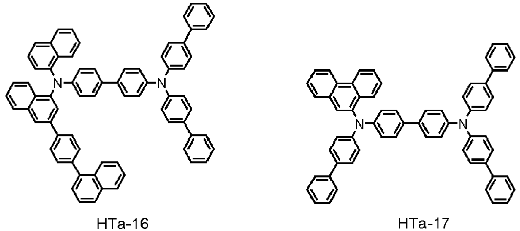

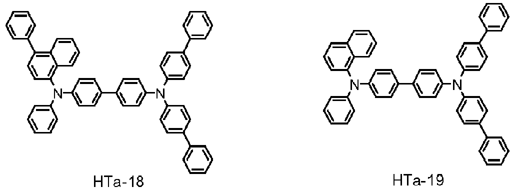

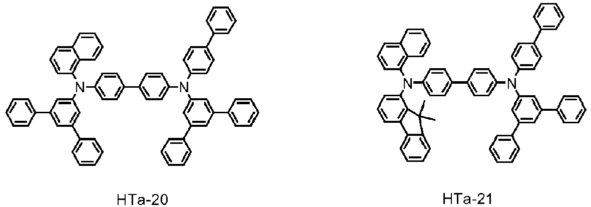

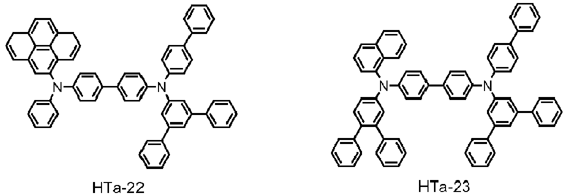

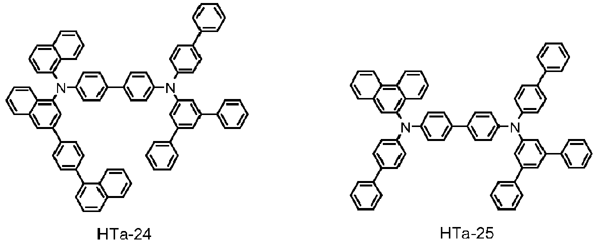

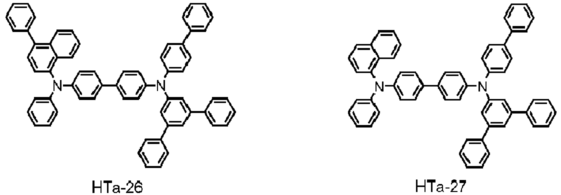

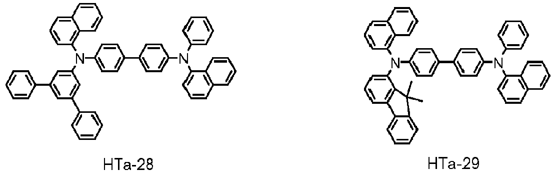

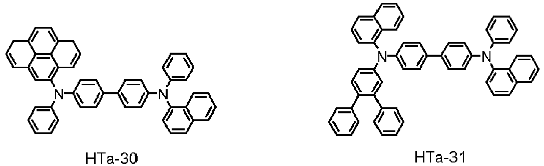

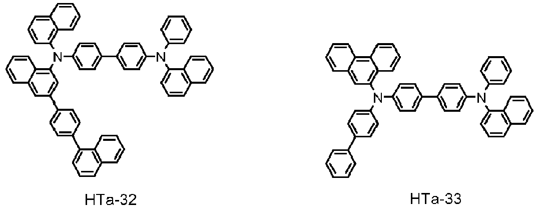

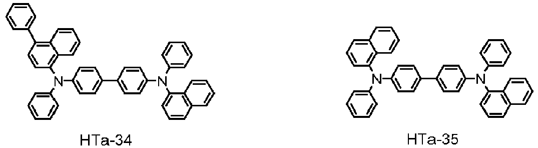

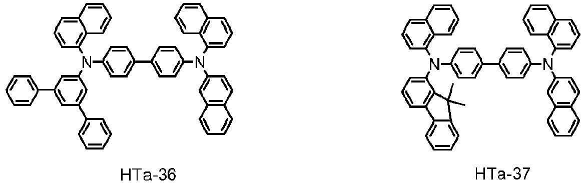

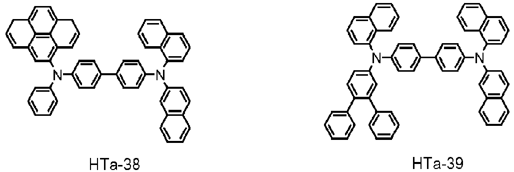

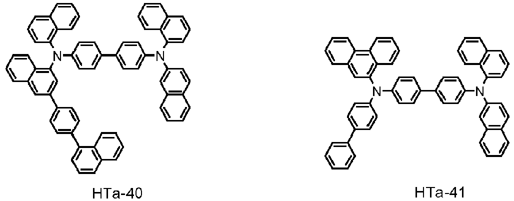

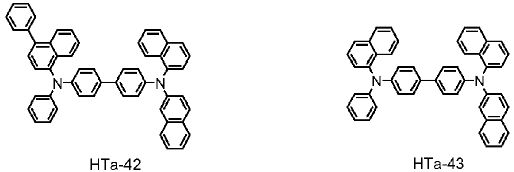

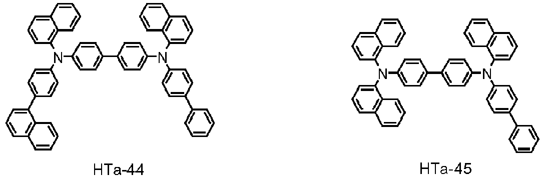

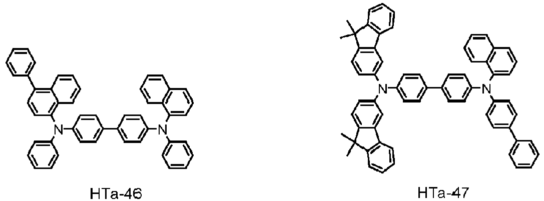

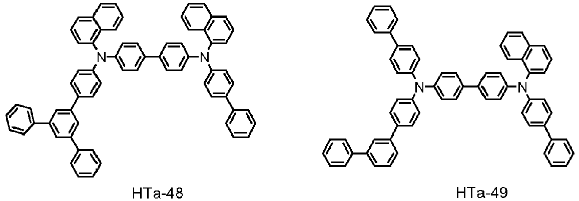

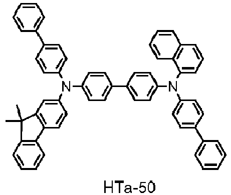

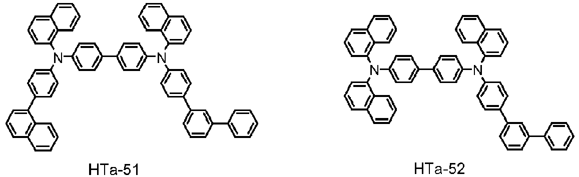

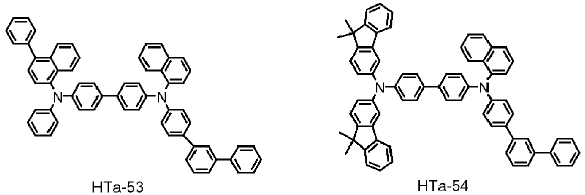

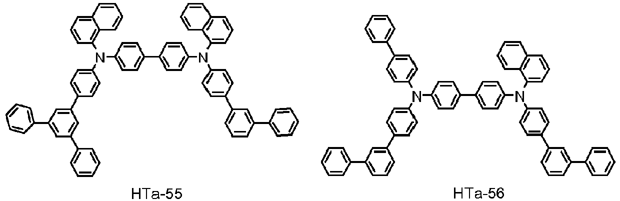

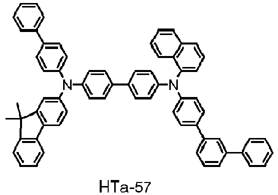

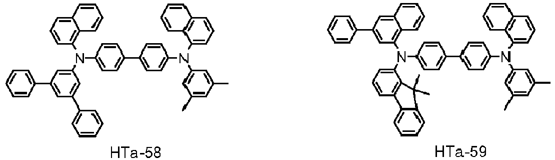

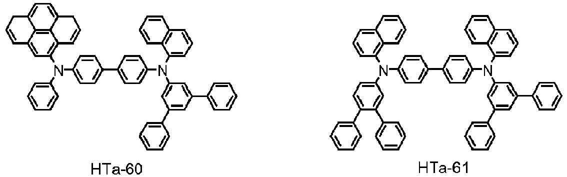

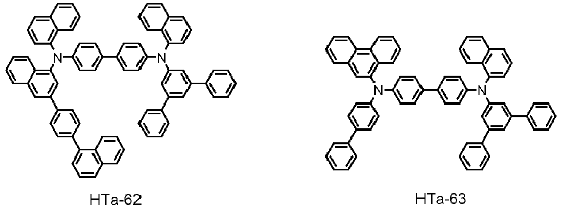

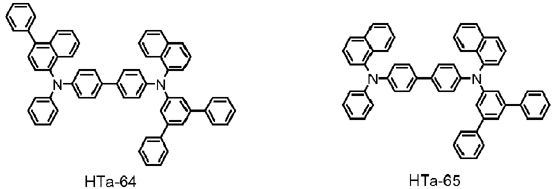

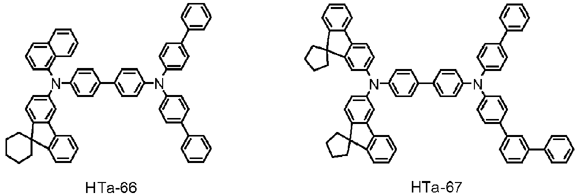

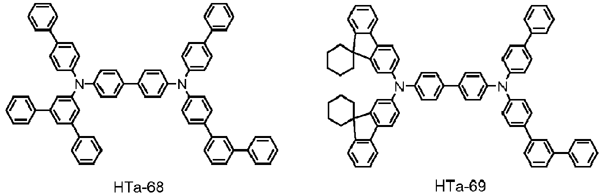

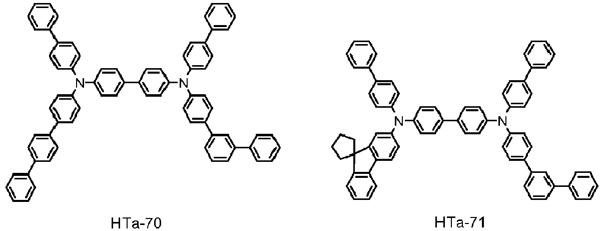

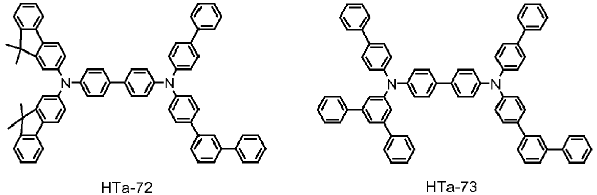

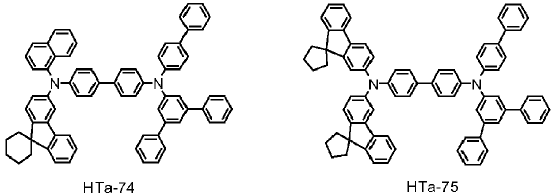

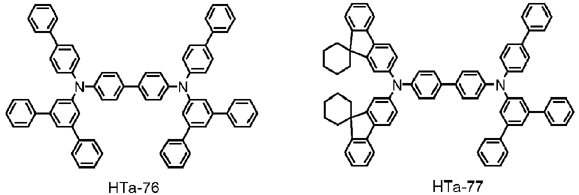

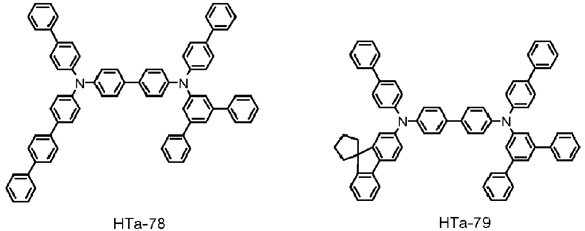

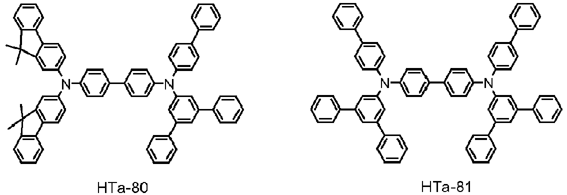

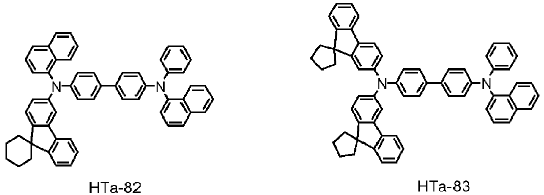

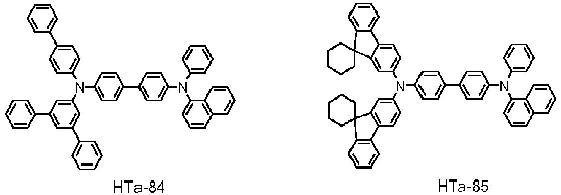

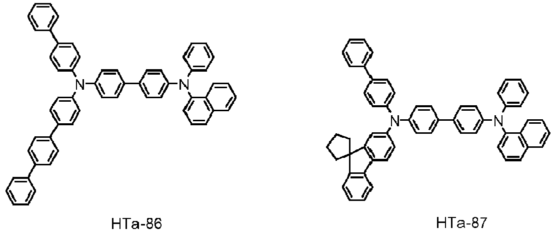

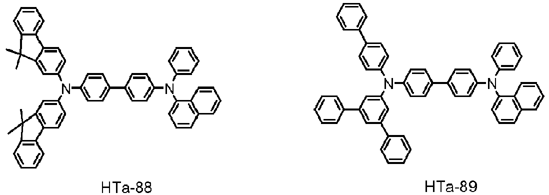

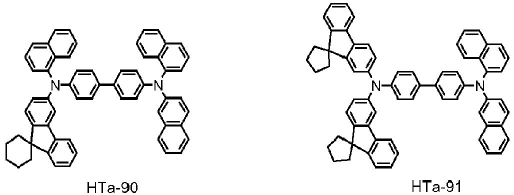

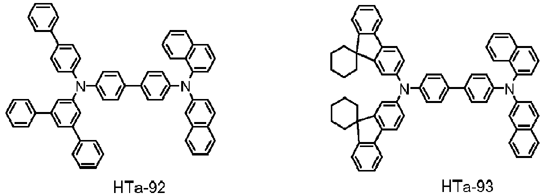

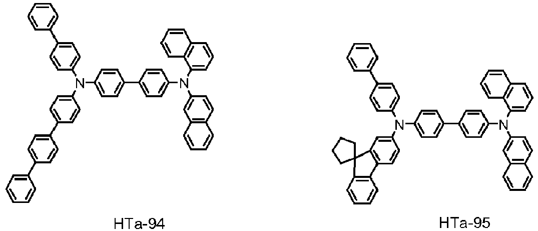

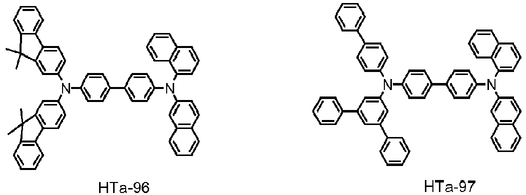

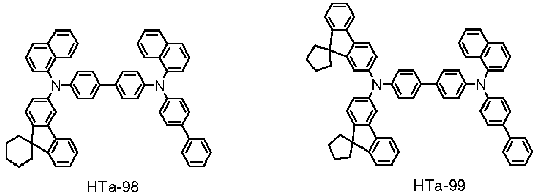

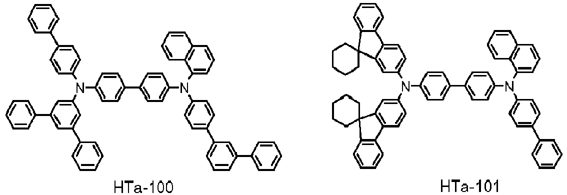

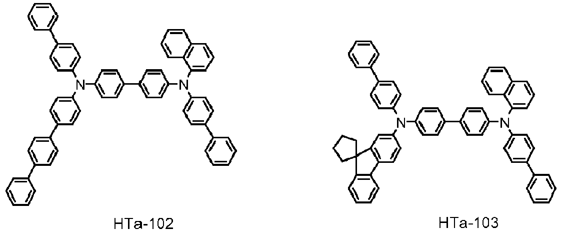

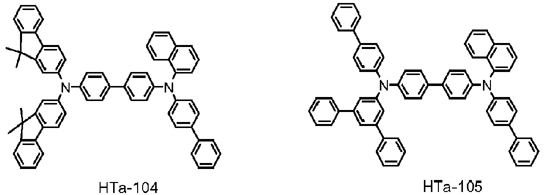

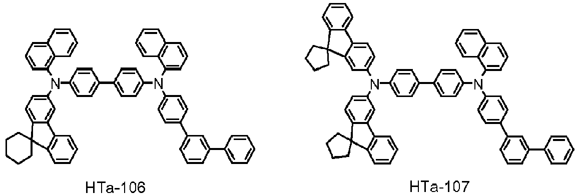

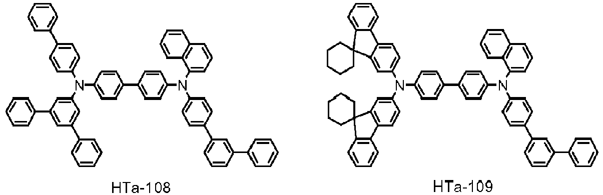

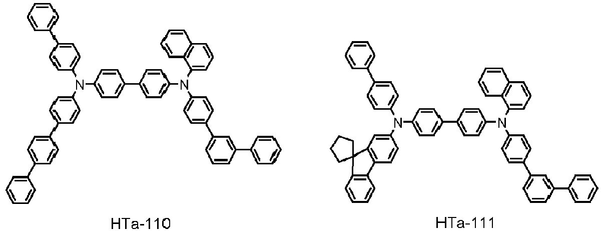

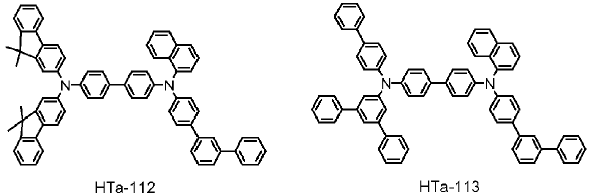

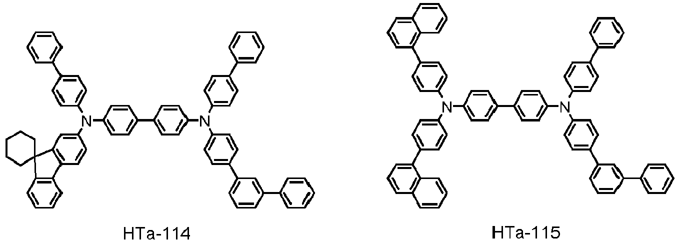

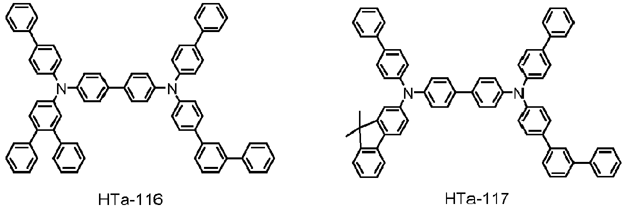

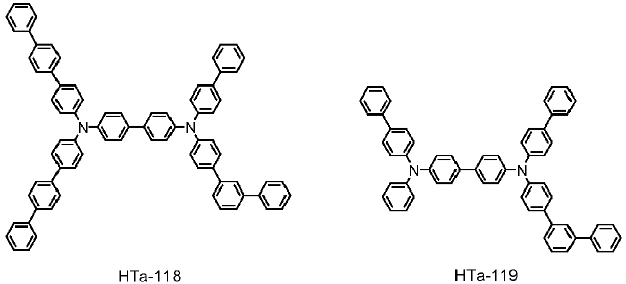

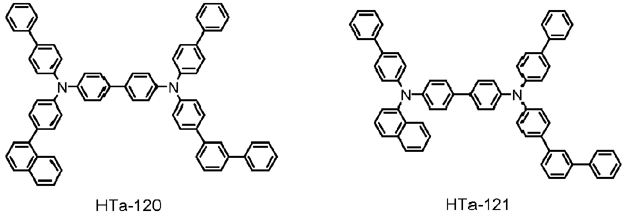

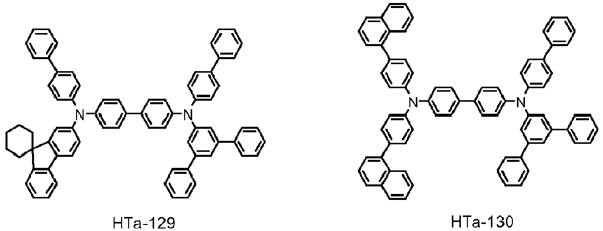

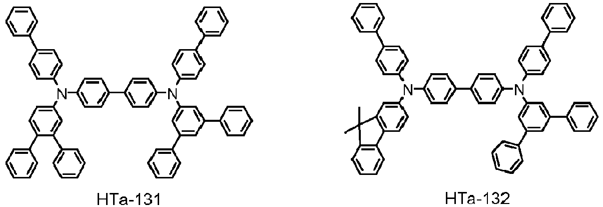

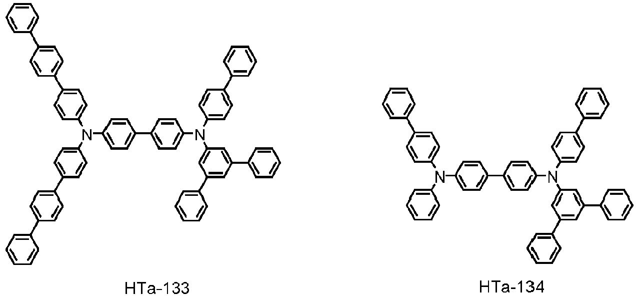

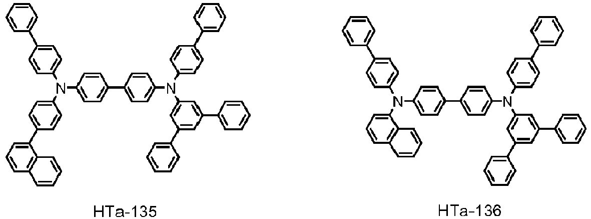

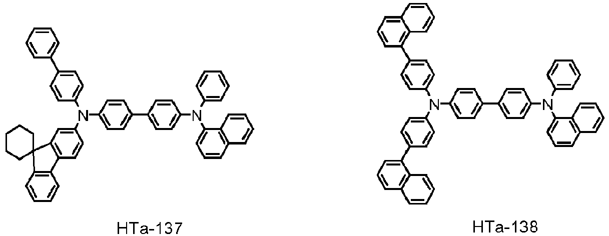

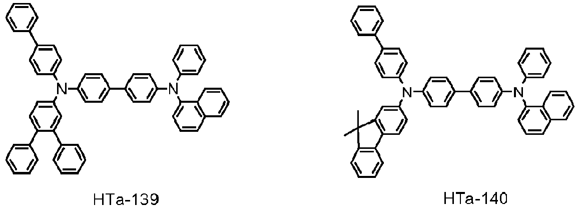

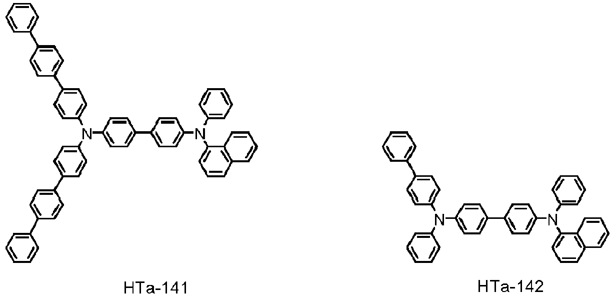

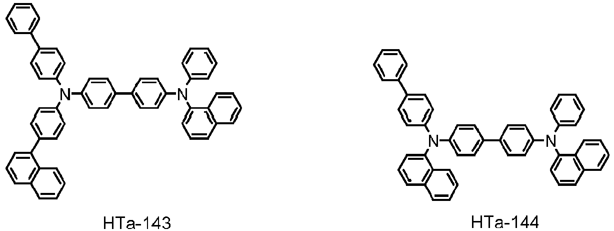

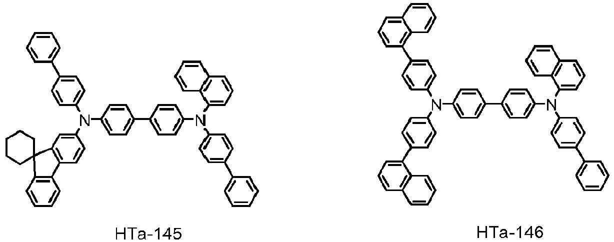

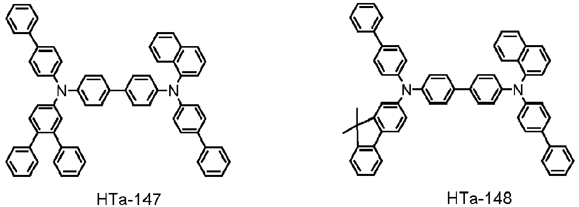

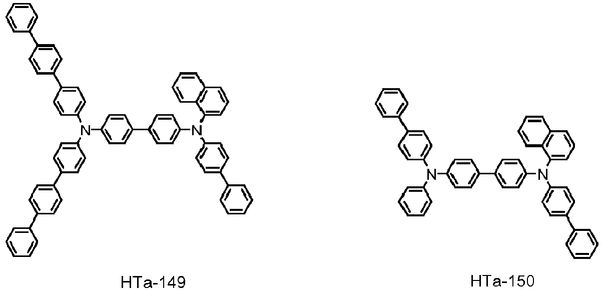

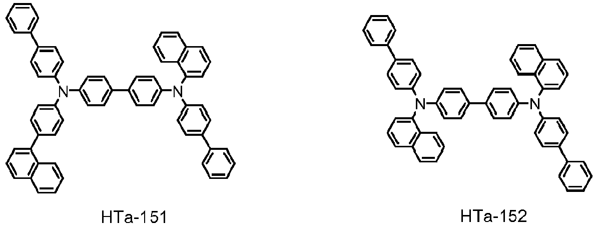

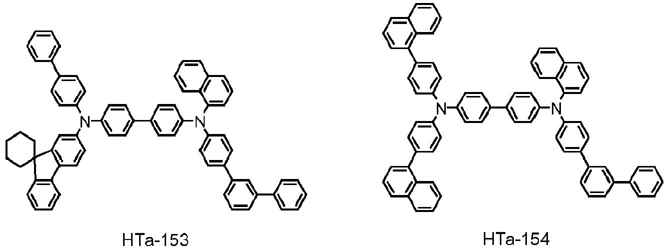

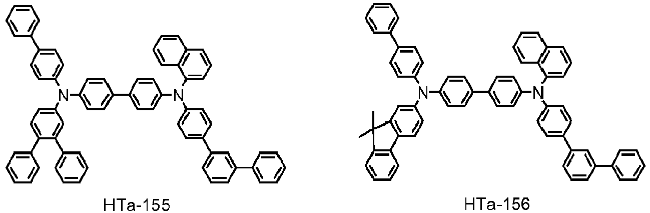

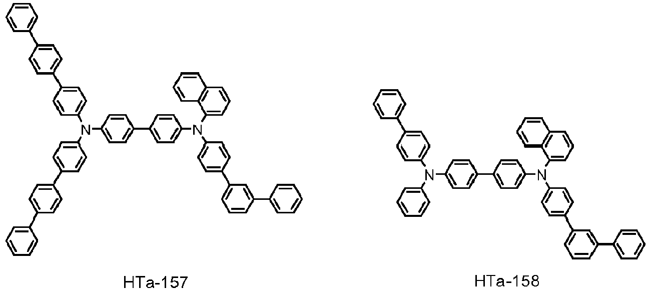

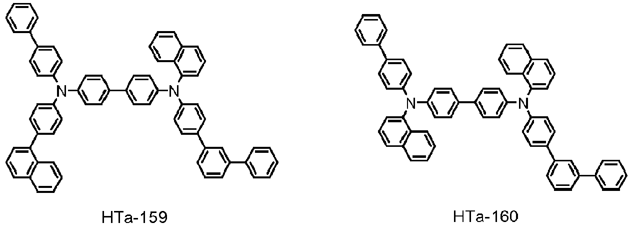

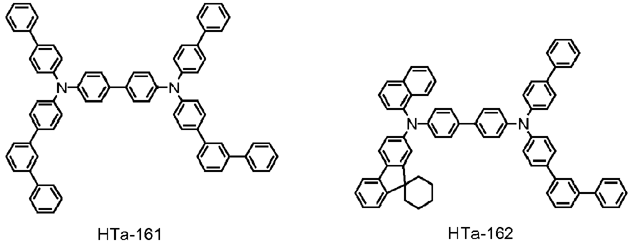

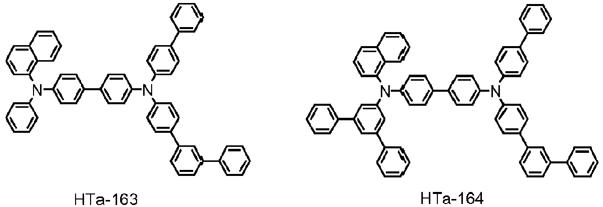

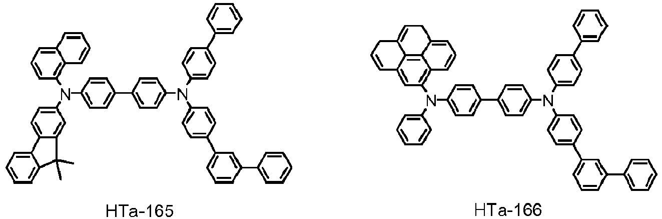

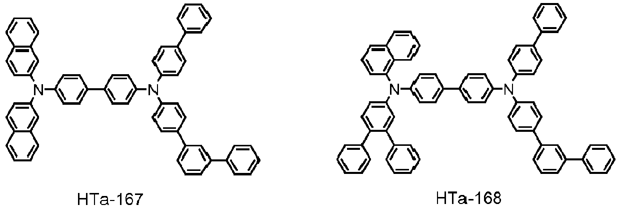

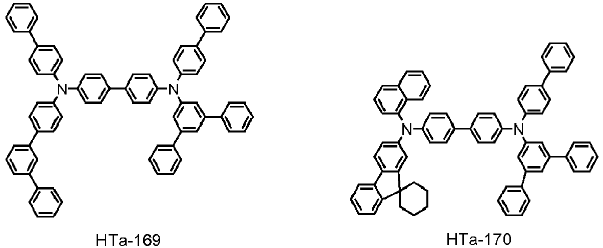

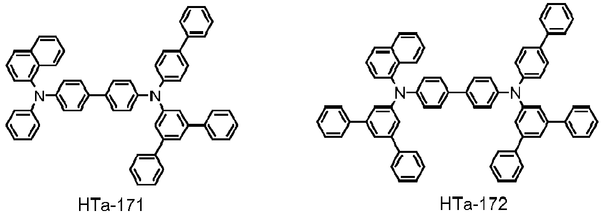

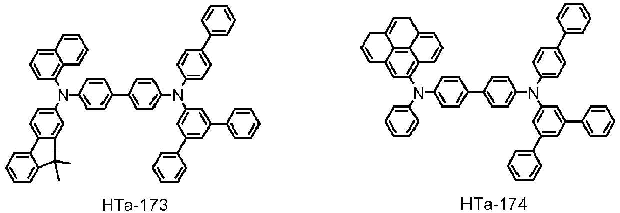

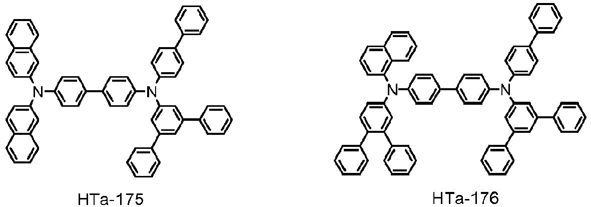

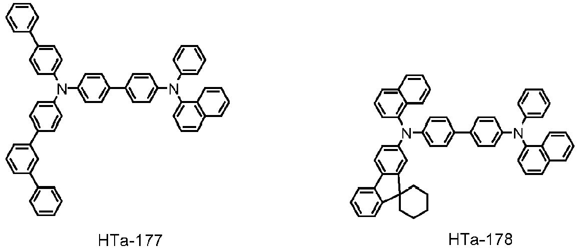

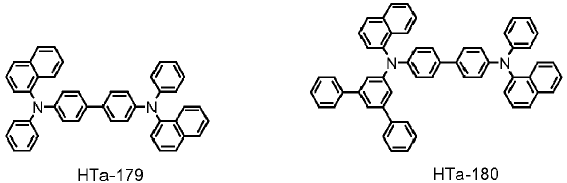

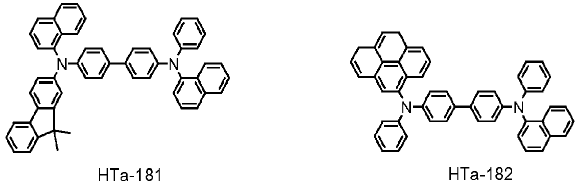

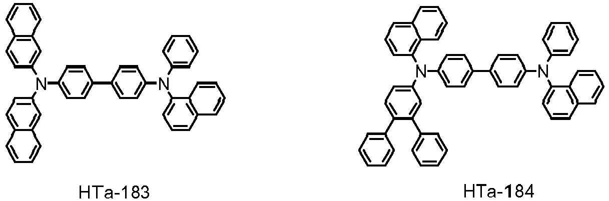

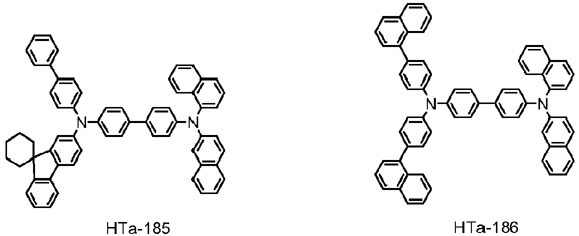

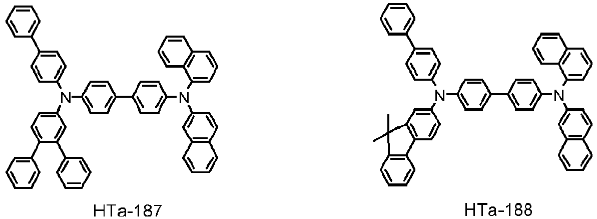

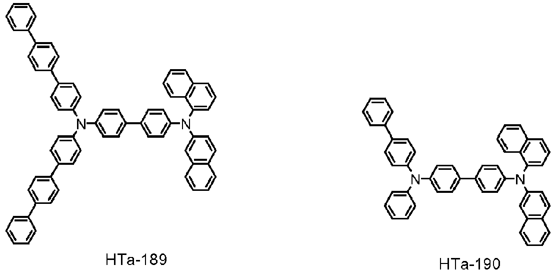

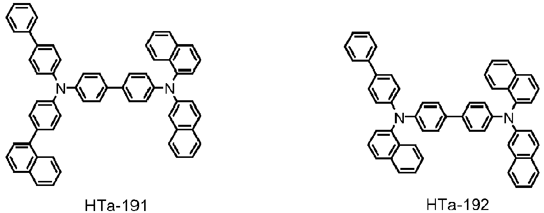

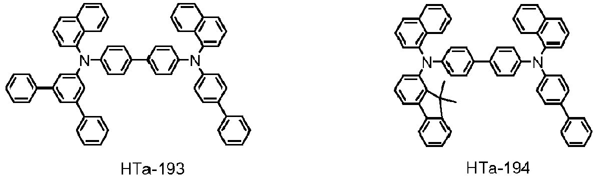

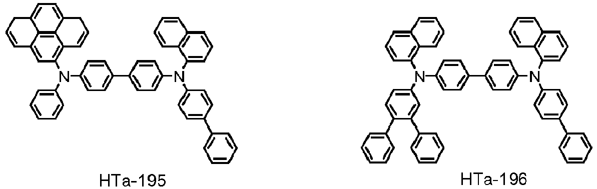

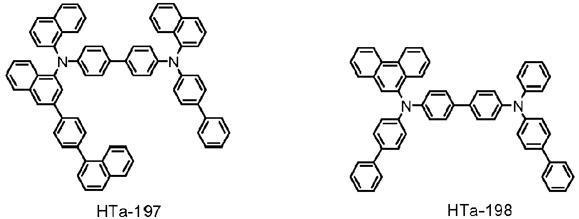

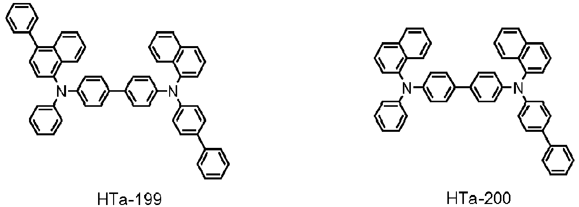

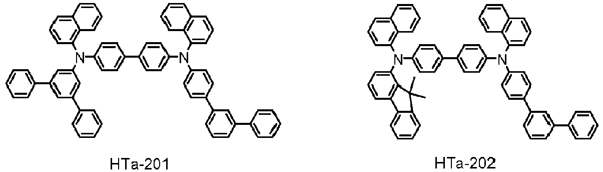

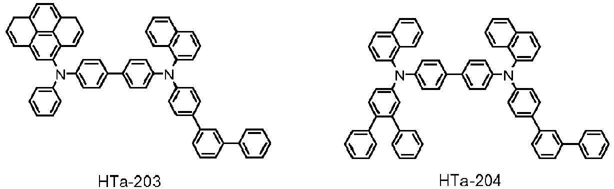

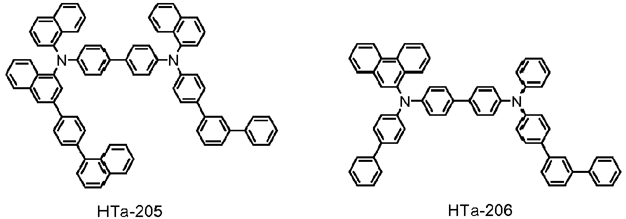

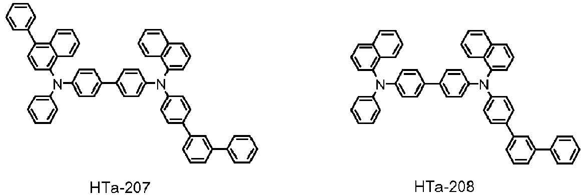

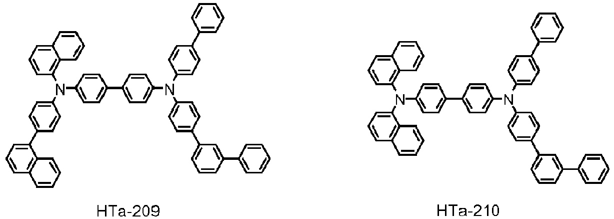

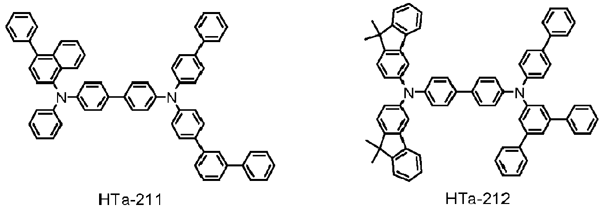

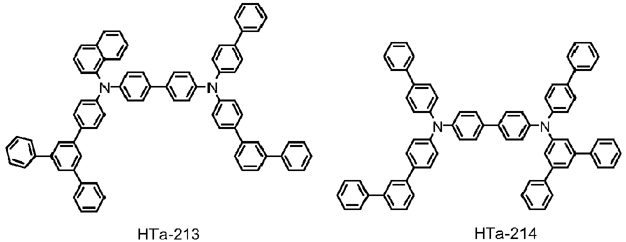

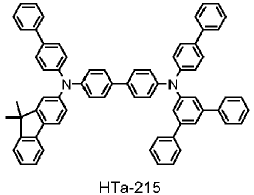

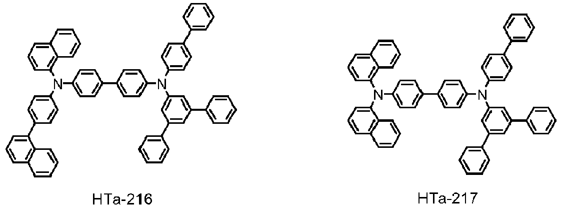

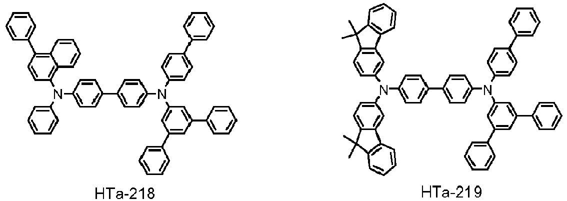

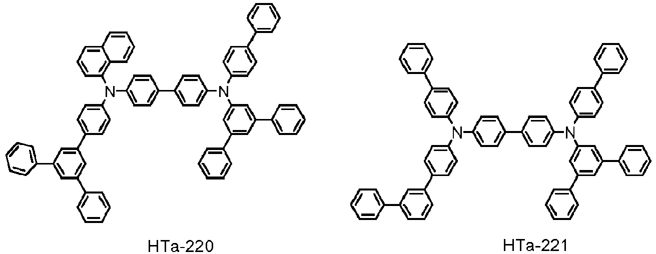

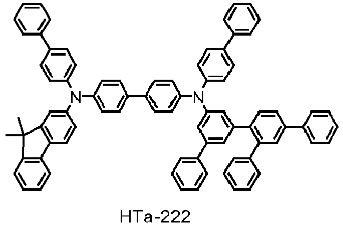

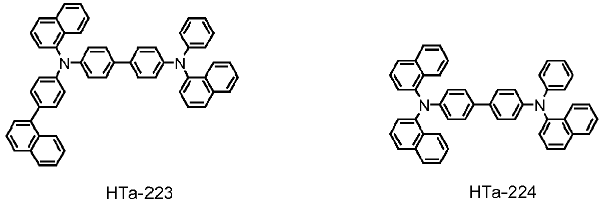

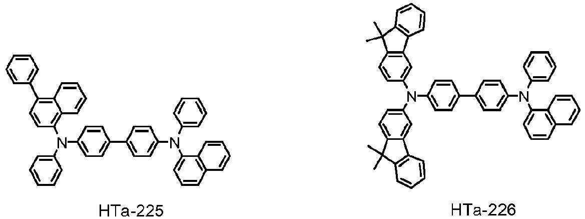

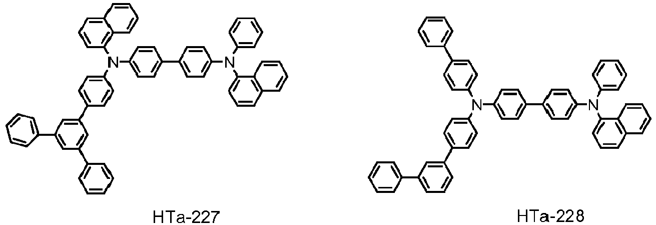

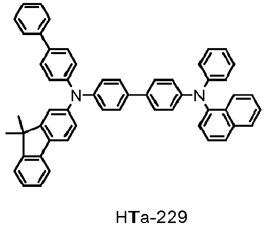

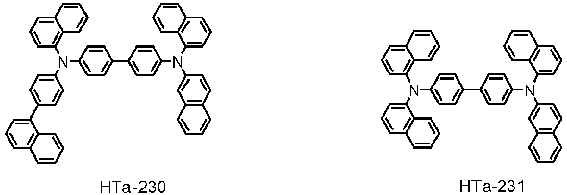

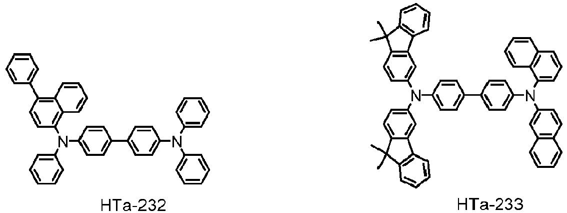

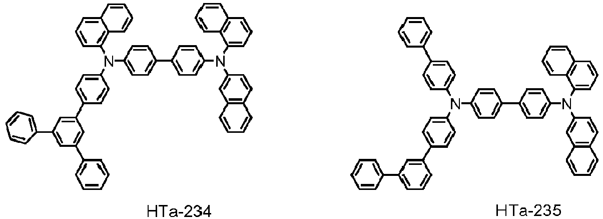

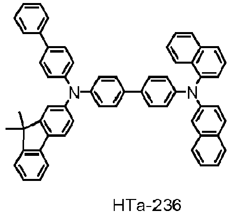

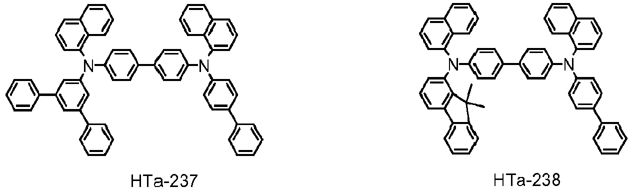

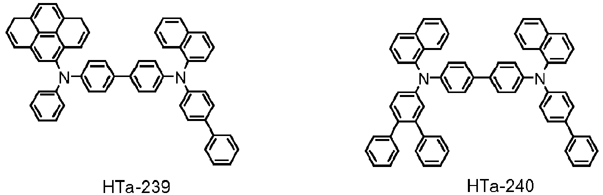

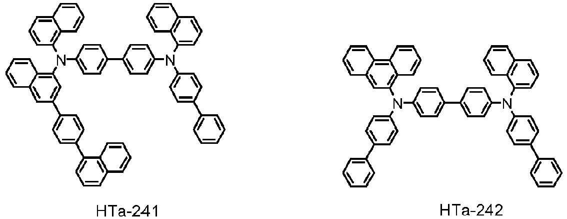

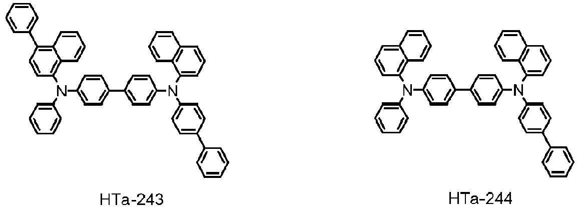

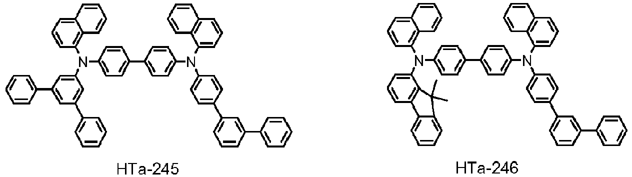

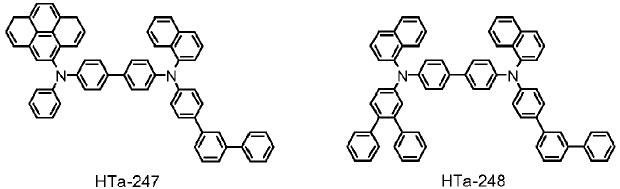

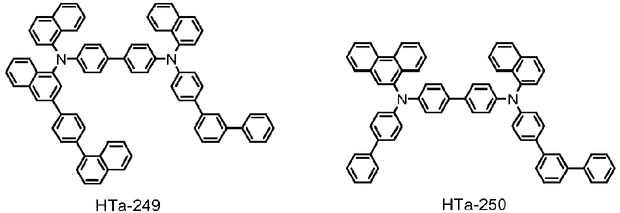

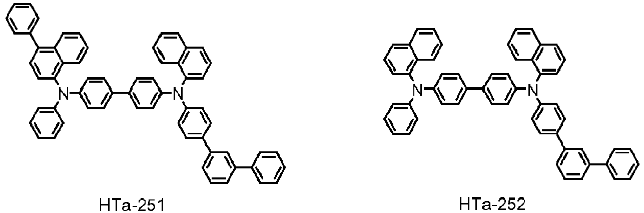

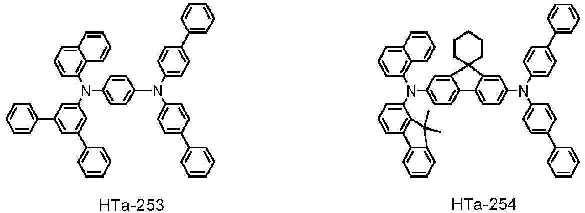

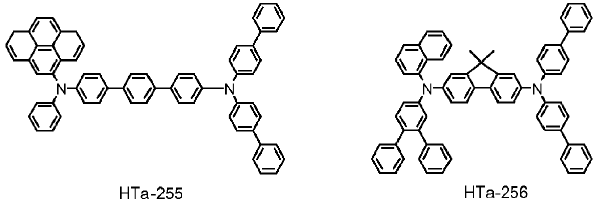

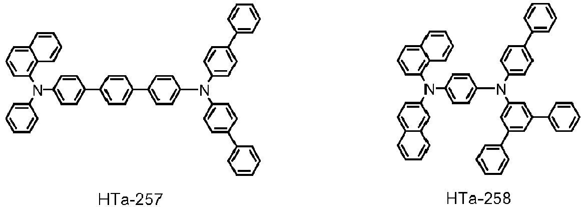

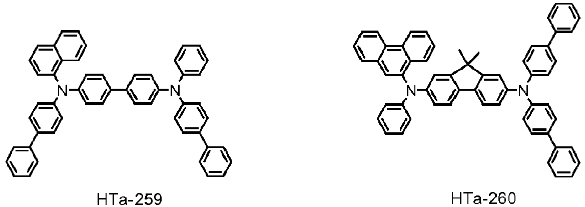

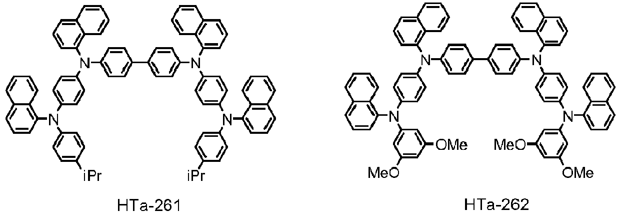

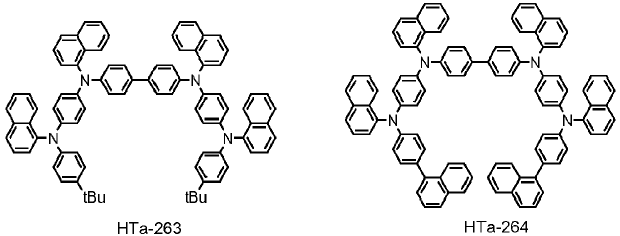

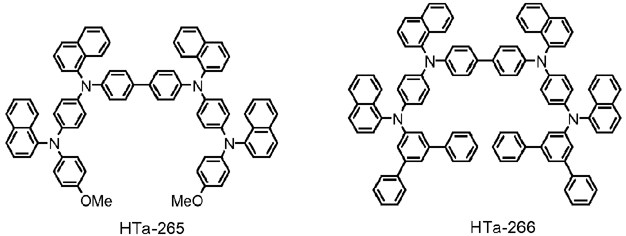

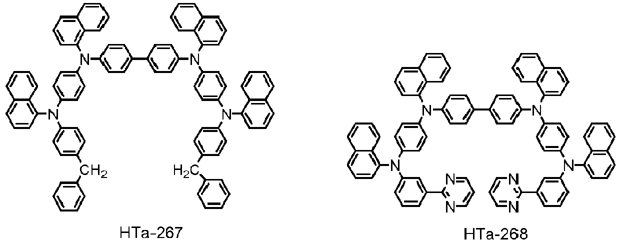

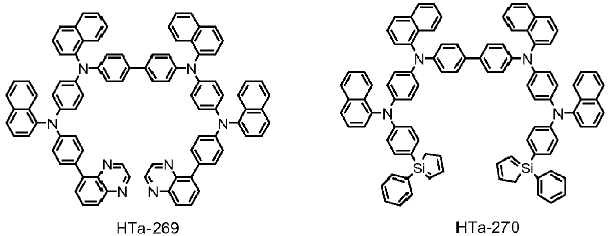

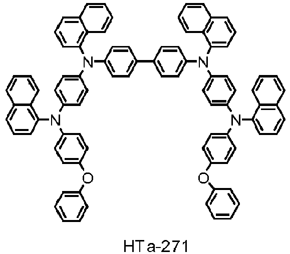

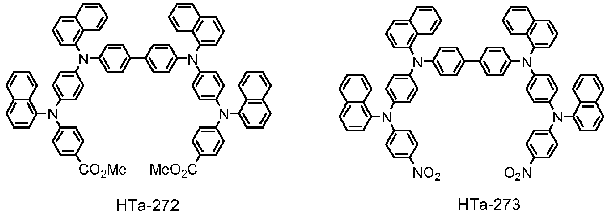

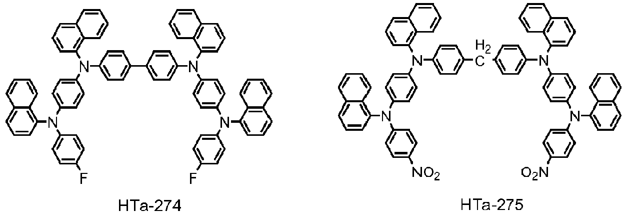

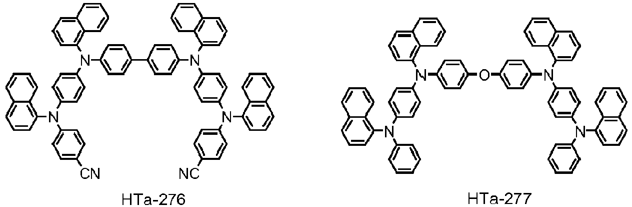

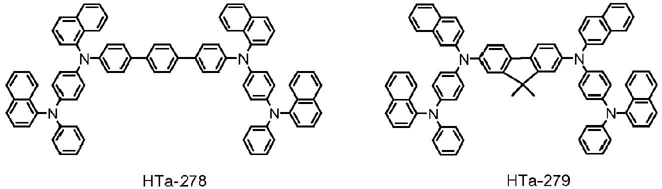

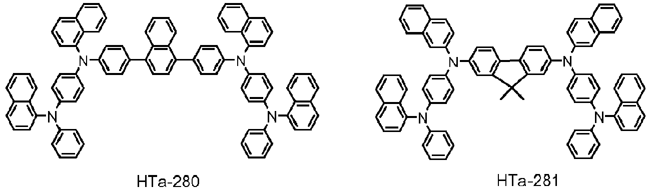

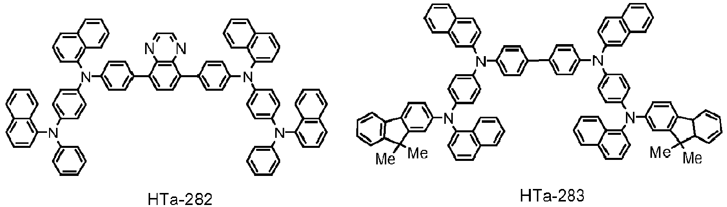

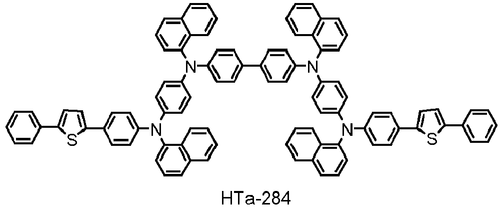

21. Organische lichtemittierende Vorrichtung nach Anspruch 1, wobei der Lochleitungsbereich ferner eine zweite Verbindung umfasst, die durch eine der Formeln 201A-1 und Formel 202A dargestellt ist: 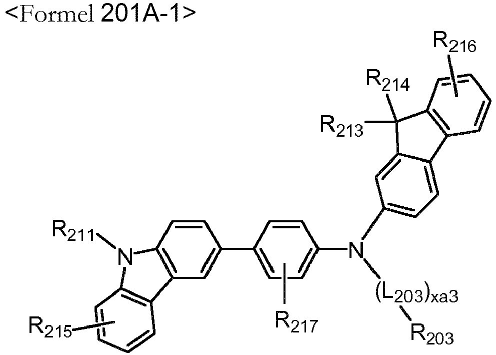 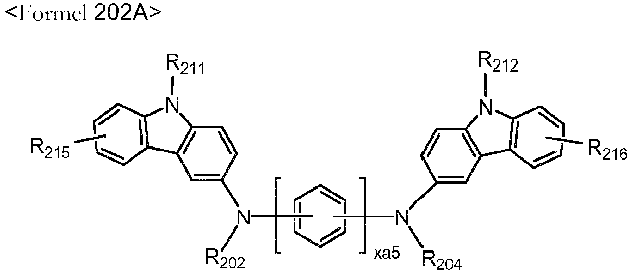 wobei in den Formeln 201A-1 und 202A,
R₂₀₂ bis R₂₀₄ und R₂₁₁ bis R₂₁₂ jeweils unabhängig voneinander ausgewählt sind aus
einer substituierten oder unsubstituierten C₆-C₆₀-Arylgruppe, einer substituierten oder unsubstituierten C₁-C₆₀-Heteroarylgruppe, der substituierten einwertigen nicht-aromatischen kondensierten polyzyklischen Gruppe, und der substituierten einwertigen nicht-aromatischen kondensierten heteropolyzyklischen Gruppe;
L₂₀₃ eine substituierte oder unsubstituierte C₆-C₆₀-Arylengruppe ist;
xa3 and xa5 jeweils unabhängig voneinander eine ganze Zahl sind, ausgewählt aus 0 bis 3;
R₂₁₃ und R₂₁₄ jeweils unabhängig voneinander ausgewählt sind aus
einer C₁-C₁₀-Alkylgruppe, einer C₁-C₁₀-Alkoxygruppe und einer C₁-C₂₀-Arylgruppe;
einer C₁-C₁₀-Alkylgruppe und einer C₁-C₁₀-Alkoxygruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon und einer Phosphorsäuregruppe oder einem Salz davon; und
einer C₁-C₂₀-Alkylgruppe, substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon und einer Phosphorsäuregruppe oder einem Salz davon, einer C₁-C₁₀-Alkylgruppe, einer C₁-C₁₀-Alkoxygruppe und einer C₁-C₂₀-Arylgruppe;
optional R₂₁₃ und R₂₁₄ jeweils aneinandergebunden sind, um einen kondensierten polyzyklischen Ring zu bilden,
R₂₁₅ bis R₂₁₇ jeweils unabhängig voneinander ausgewählt sind aus
einem Wasserstoffatom, einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polyzyklischen Gruppe, einer substituierten oder unsubstituierten einwertigen nicht-aromatischen kondensierten heteropolyzyklischen Gruppe, -N(Q₁) (Q₂), -Si(Q₃) (Q₄) (Q₅) und -B(Q₆) (Q₇) ;
mindestens ein Substituent der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten C₆-C₆₀-Arylengruppe, der substituierten einwertigen nicht-aromatischen kondensierten polyzyklischen Gruppe und der substituierten einwertigen nicht-aromatischen kondensierten heteropolyzyklischen Gruppe ausgewählt ist aus
einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe,
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einem C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe, einer einwertigen nicht-aromatischen kondensierten heteropolyzyklischen Gruppe, -N(Q₁₁)(Q₁₂), -Si(Q₁₃) (Q₁₄) (Q₁₅), and -B(Q₁₆) (Q₁₇),
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀ Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe,
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe, die jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe, einer einwertigen nicht-aromatischen kondensierten heteropolyzyklischen Gruppe, -N(Q₂₁) (Q₂₂) , -Si(Q₂₃) (Q₂₄) (Q₂₅) und -B (Q₂₆) (Q₂₇), und, -N(Q₃₁) (Q₃₂), -Si(Q₃₃) (Q₃₄) (Q₃₅) und -B(Q₃₆) (Q₃₇),
wobei Q₁ bis Q₇, Q₁₁ bis Q₁₇, Q₂₁ bis Q₂₇ und Q₃₁ bis Q₃₇ jeweils unabhängig voneinander ausgewählt sind aus einem Wasserstoffatom, einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polyzyklischen Gruppe und einer einwertigen nicht-aromatischen kondensierten heteropolyzyklischen Gruppe.

22. Organische lichtemittierende Vorrichtung nach Anspruch 21, wobei in den Formeln 201A-1 und 202A, R₂₀₂ bis R₂₀₄ und R₂₁₁ bis R₂₁₂ jeweils unabhängig ausgewählt sind aus
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, jeweils substituiert mit mindestens einem aus einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe;
L₂₀₃ ausgewählt ist aus
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, Anthrylengruppe, einer Fluoranthenylengruppe, einer Triphenylenylengruppe, einer Pyrenylengruppe, einer Chrysenylengruppe, einer Naphthacenylengruppe, einer Picenylengruppe und einer Perylenylengruppe, und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, Anthrylengruppe, einer Fluoranthenylengruppe, einer Triphenylenylengruppe, einer Pyrenylengruppe, einer Chrysenylengruppe, einer Naphthacenylengruppe, einer Picenylengruppe und einer Perylenylengruppe, jeweils substituiert mit mindestens einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe und einer Perylenylgruppe;
R₂₁₃ und R₂₁₄ jeweils unabhängig voneinander ausgewählt sind aus
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, und einer Perylenylgruppe,
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe und einer Pentoxygruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe und einer Perylenylgruppe, jeweils substituiert mit mindestens einem aus einem Deuteriumatom, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, und einer Perylenylgruppe;
R₂₁₅ bis R₂₁₇ jeweils unabhängig voneinander ausgewählt ist aus
einem Wasserstoffatom, einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe und einer Imidazopyrimidinylgruppe, jeweils substituiert mit mindestens einem aus einem Deuteriumatom, -F, -Cl, - Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Methoxygruppe, einer Ethoxygruppe, einer Propoxygruppe, einer Butoxygruppe, einer Pentoxygruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthrylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolylgruppe, einer Isochinolylgruppe, einer Benzochinolylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzofluorenylgruppe, einer Benzimidazolylgruppe, einer Benzofuranylgruppe, einer Benzothiophenylgruppe, einer Benzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofluorenylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridylgruppe, und einer Imidazopyrimidinylgruppe.

23. Organische lichtemittierende Vorrichtung nach Anspruch 21, wobei in den Formeln 201A-1 und 202A, R₂₀₂ bis R₂₀₄ und R₂₁₁ bis R₂₁₂ jeweils unabhängig eine Phenylgruppe, eine Biphenylgruppe, eine Naphthylgruppe, eine Fluorenylgruppe und eine Pyridylgruppe und eine Phenylgruppe und eine Fluorenylgruppe sind, jeweils substituiert mit mindestens einem aus -F, -Cl, -Br, -I, einer Methylgruppe und einer Cyanogruppe;
L₂₀₃ eine Phenylengruppe ist;
R₂₁₃ und R₂₁₄ jeweils unabhängig voneinander eine Methylgruppe oder eine Phenylgruppe sind, und optional R₂₁₃ und R₂₁₄ jeweils aneinandergebunden sind, um einen Fluorenring zu bilden; und
R₂₁₅ bis R₂₁₇ ein Wasserstoffatom sind.

24. Organische lichtemittierende Vorrichtung nach Anspruch 21, wobei die zweite Verbindung ausgewählt ist aus den Verbindungen HTb-1 bis HTb-20:

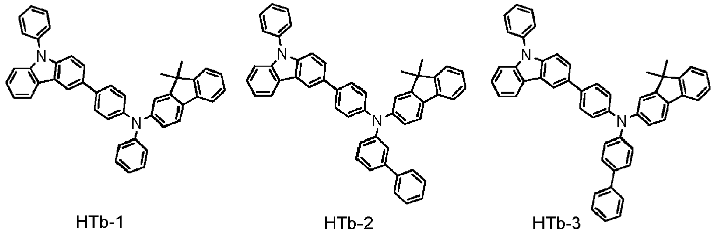

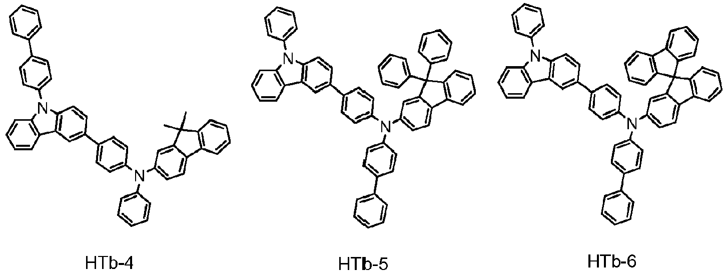

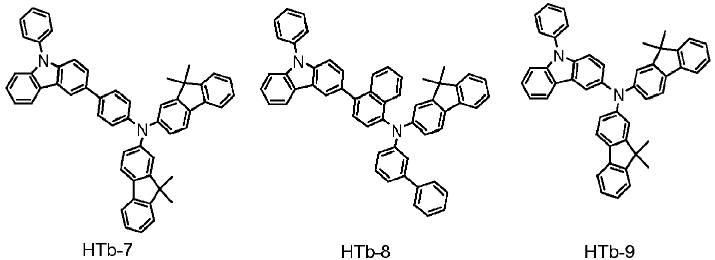

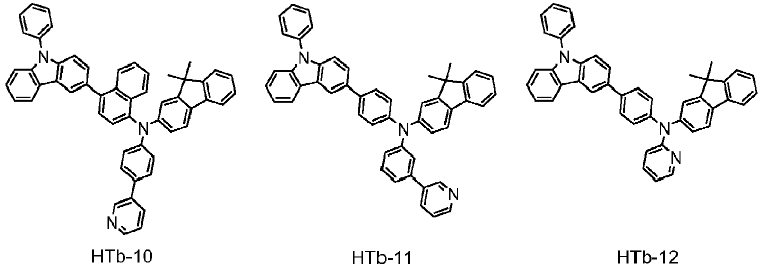

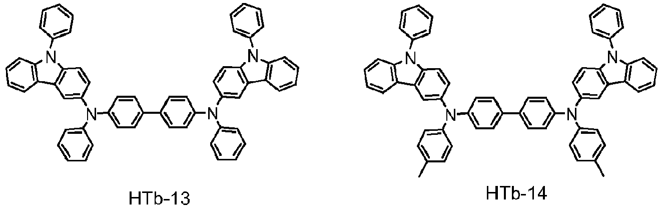

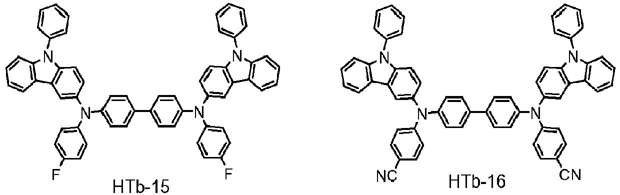

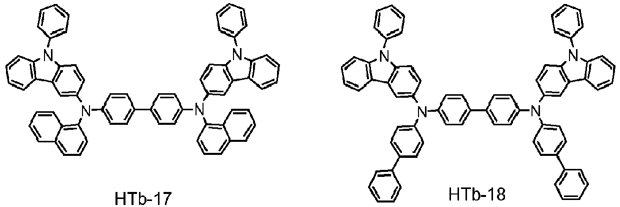

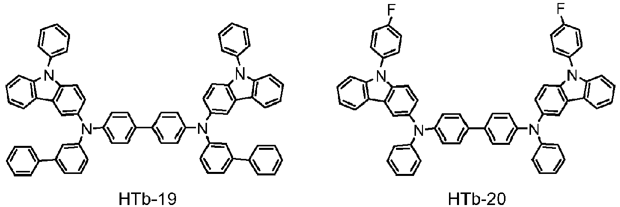

25. Organische lichtemittierende Vorrichtung nach Anspruch 21, wobei die zusätzliche Emissionsschicht ferner die zweite Verbindung umfasst.

26. Organische lichtemittierende Vorrichtung nach Anspruch 21, wobei die Lochleitungsschicht die zweite Verbindung umfasst.

## Revendications

1. Dispositif électroluminescent organique comprenant :
une première électrode ;
une deuxième électrode disposée à l'opposé de la première électrode ;
une couche d'émission entre la première électrode et la deuxième électrode ; et
une région de transport de trous entre la première électrode et la couche d'émission, où la région de transport de trous comprend une couche d'émission auxiliaire adjacente à la couche d'émission, une couche de transport de trous et une couche d'injection de trous ;
dans lequel la couche d'injection de trous est sur la première électrode,
dans lequel la couche de transport de trous est sur la couche d'injection de trous, et
dans lequel la couche d'émission comprend un composé organométallique représenté par la formule 1, et la couche d'émission auxiliaire comprend un premier composé représenté par la formule 2A ou la formule 2B :
<Formule 1> M(L1)ₙ₁(L2)ₙ₂
où, dans la formule 1,
M est choisi parmi l'iridium (Ir), le platine (Pt), l'osmium (Os), le titane (Ti), le zirconium (Zr), le hafnium (Hf), l'europium (Eu), le terbium (Tb), le thulium (TM) et le rhodium (Rd) ;
L1 est un ligand représenté par la formule 1A ;
L2 est un ligand représenté par la formule 1B, où L1 et L2 sont différents l'un de l'autre ;
chacun de n1 et n2 vaut indépendamment 1 ou 2, où n1 + n2 = 2 ou n1 + n2 = 3, les deux L1 quand n1 vaut 2 sont identiques ou différents, et les deux L2 quand n2 vaut 2 sont identiques ou différents ; 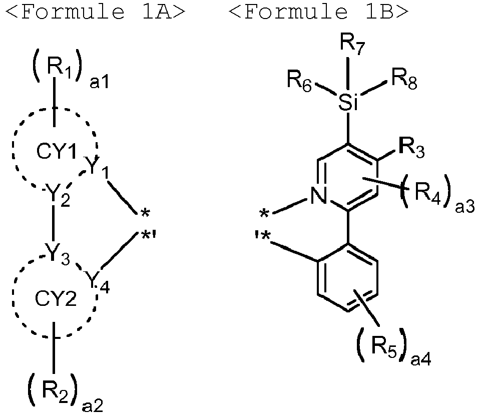 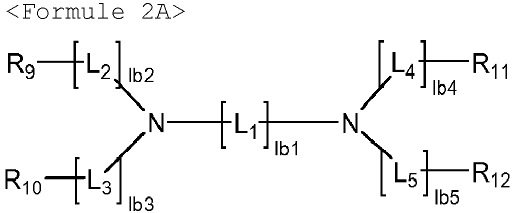 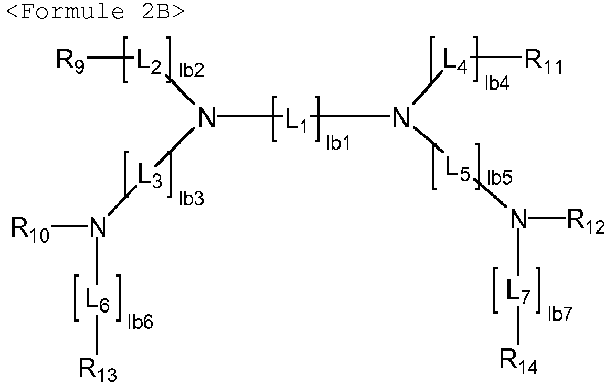
où, dans les formules 1A, 1B, 2A et 2B,
chacun de CY1 et CY2 est indépendamment choisi parmi un groupe cyclique en C₅ à C₆₀ et un groupe hétérocyclique en C₂ à C₆₀, et CY1 et CY2 sont liés l'un à l'autre via une liaison simple ;
chacun de Y1 à Y4 est indépendamment le carbone (C) ou l'azote (N), Y₁ et Y₂ sont liés l'un à l'autre via une liaison simple ou une double liaison, et Y₃ et Y₄ sont liés l'un à l'autre via une liaison simple ou une double liaison ;
chacun de L₁ à L₇ est indépendamment choisi parmi un groupe alkylène en C₁ à C₂₀ substitué ou non substitué, -O-, un groupe arylène en C₆ à C₆₀ substitué ou non substitué, un groupe hétéroarylène en C₁ à C₆₀ substitué ou non substitué, un groupe polycyclique condensé non aromatique divalent substitué ou non substitué, et un groupe hétéropolycyclique condensé non aromatique divalent substitué ou non substitué ;
chacun de R₁ à R₅ et de Rg à R₁₄ est indépendamment choisi parmi un atome d'hydrogène, un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), et -B(Q₆)(Q₇), sous réserve que R₃ ne soit pas un hydrogène ;
chacun de R₆ à R₈ est indépendamment choisi parmi
un groupe alkyle en C₁ à C₁₀, et
un groupe alkyle en C₁ à C₁₀ substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, et un groupe acide phosphorique ou un de ses sels ;
au moins un substituant du groupe alkyle en C₁ à C₆₀ substitué, du groupe alcényle en C₂ à C₆₀ substitué, du groupe alcynyle en C₂ à C₆₀ substitué, du groupe alkoxy en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe arylène en C₆ à C₆₀ substitué, du groupe hétéroarylène en C₁ à C₆₀ substitué, du groupe polycyclique condensé non aromatique monovalent substitué, et du groupe hétéropolycyclique condensé non aromatique monovalent substitué, est choisi parmi
un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, et un groupe alkoxy en C₁ à C₆₀,
un groupe alkyle en C₁ à C₆₀, un groupe alcényle en C₂ à C₆₀, un groupe alcynyle en C₂ à C₆₀, et un groupe alkoxy en C₁ à C₆₀, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), et -B(Q₁₆)(Q₁₇),
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₂₁)(Q₂₂), -Si (Q₂₃)(Q₂₄)(Q₂₅), et -B (Q₂₆)(Q₂₇), et
-N(Q₃₁)(Q₃₂), -Si(Q₃₃)(Q₃₄)(Q₃₅), et -B (Q₃₆) (Q₃₇),
où chacun de Q₁ à Q₇, de Q₁₁ à Q₁₇, de Q₂₁ à Q₂₇, et de Q₃₁ à Q₃₇ est indépendamment choisi parmi un hydrogène, un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent ;
chacun de a₁ et a₂ est indépendamment un entier de 0 à 5 ;
a₃ est un entier de 0 à 2 ;
a₄ est un entier de 0 à 4, où éventuellement plusieurs R₅ quand a₄ vaut 2 ou plus sont condensés à un cycle benzène auquel les R₅ sont liés, pour former ainsi un cycle condensé ;
Ib₁ est un entier de 1 à 5 ;
chacun de Ib₂ à Ib₇ est indépendamment un entier de 0 à 4 ; et
* et *' sont des sites de liaison à M dans la formule 1.

2. Dispositif électroluminescent organique selon la revendication 1, dans lequel M dans la formule 1 est l'osmium (Os), l'iridium (Ir) ou le platine (Pt).

3. Dispositif électroluminescent organique selon la revendication 1, dans lequel M dans la formule 1 est l'iridium (Ir).

4. Dispositif électroluminescent organique selon la revendication 1, dans lequel chacun de n1 et n2 dans la formule 1 vaut indépendamment 1 ou 2, et n1 + n2 = 3.

5. Dispositif électroluminescent organique selon la revendication 1, dans lequel Y₁ dans la formule 1A est un azote (N) et Y₂ à Y₄ sont des carbones (C).

6. Dispositif électroluminescent organique selon la revendication 1, dans lequel chacun de CY1 et CY2 dans la formule 1A est indépendamment choisi parmi un benzène, un naphtalène, un fluorène, un spiro-fluorène, un indole, un indène, un furane, un thiophène, un carbazole, un benzofurane, un benzothiophène, un dibenzofurane, un dibenzothiophène, un pyrrole, un imidazole, un pyrazole, un thiazole, un isothiazole, un oxazole, un isoxazole, un triazole, une pyridine, une pyrimidine, une pyrazine, une pyridazine, une quinoline, une triazine, une isoquinoline, une benzoquinoline, une quinoxaline, une quinazoline, une naphtyridine, un benzimidazole, un benzoxazole, un isobenzoxazole, et un oxadiazole.

7. Dispositif électroluminescent organique selon la revendication 1, dans lequel CY1 dans la formule 1A est choisi parmi un pyrrole, un imidazole, un triazole, un oxadiazole, une pyridine, une pyrimidine, une pyrazine, une quinoline, une isoquinoline, et une triazine.

8. Dispositif électroluminescent organique selon la revendication 1, dans lequel CY2 dans la formule 1A est choisi parmi un benzène, un naphtalène, un furane, un thiophène, une pyridine, une pyrimidine, une pyrazine, une triazine, un fluorène, un carbazole, un phényl-carbazole, un indole, un oxadiazole, un benzofurane, un benzothiophène, un dibenzofurane, et un dibenzothiophène.

9. Dispositif électroluminescent organique selon la revendication 1, dans lequel, dans la formule 1A,
CY1 est choisi parmi une pyridine, une pyrimidine, une triazine, une quinoline, une isoquinoline, un oxadiazole, un triazole, et un imidazole ; et
CY2 est choisi parmi un benzène, une pyridine, une pyrimidine, un dibenzofurane, un dibenzothiophène, un thiophène, un benzothiophène, un furane, un benzofurane, un indole, un carbazole, et un phényl-carbazole.

10. Dispositif électroluminescent organique selon la revendication 1, dans lequel chacun de R₁ à R₅ dans la formule 1A et la formule 1B est indépendamment choisi parmi
un atome d'hydrogène, sous réserve que R₃ ne soit pas un hydrogène, un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, et un groupe phénoxy,
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, et un groupe pentoxy, chacun substitué par au moins l'un parmi un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, et un groupe phénoxy, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle ; et
R₆ à R₈ sont choisis parmi un groupe méthyle, un groupe éthyle, un groupe n-propyle, un groupe isopropyle, un groupe n-butyle, un groupe isobutyle, un groupe sec-butyle, et un groupe tert-butyle, et R₆ à R₈ sont identiques.

11. Dispositif électroluminescent organique selon la revendication 1, dans lequel le composé organométallique représenté par la formule 1 est choisi parmi les composés PD-1 à PD-79 et PD-81 à PD-193 :

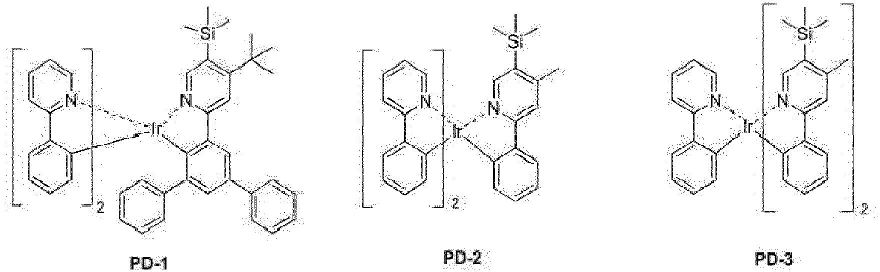

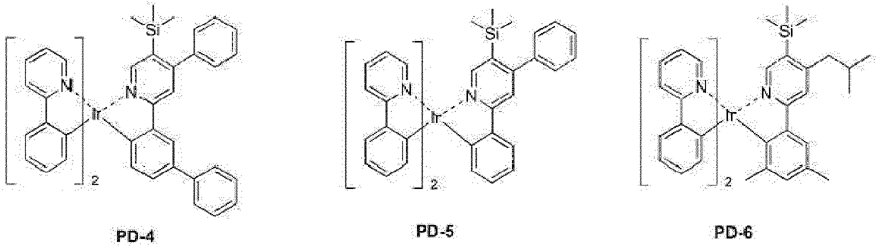

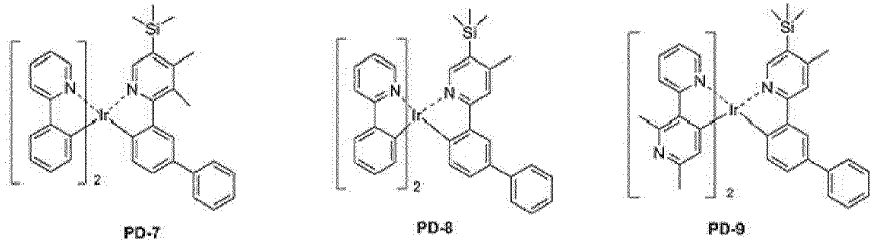

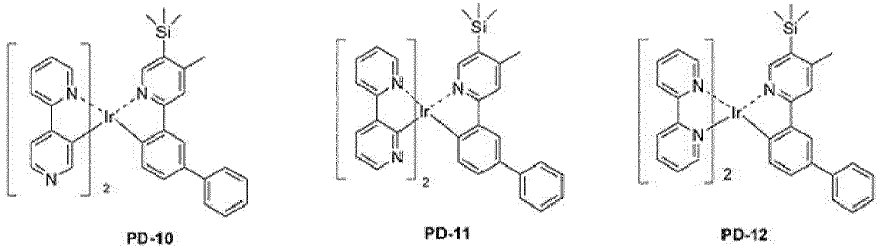

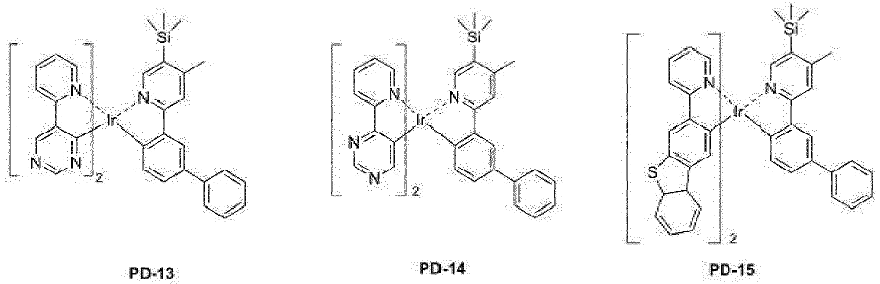

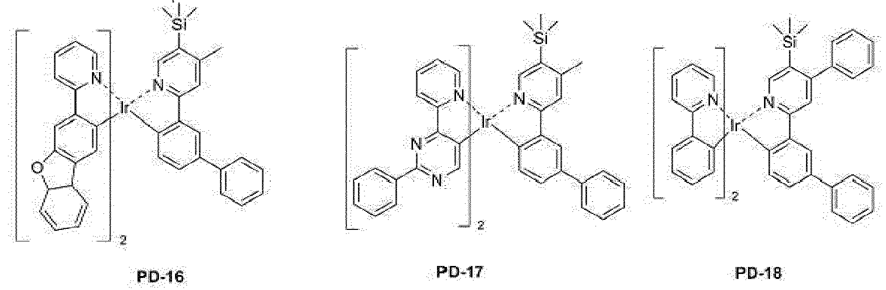

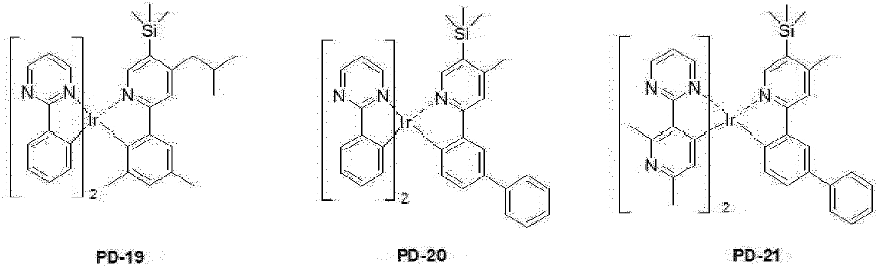

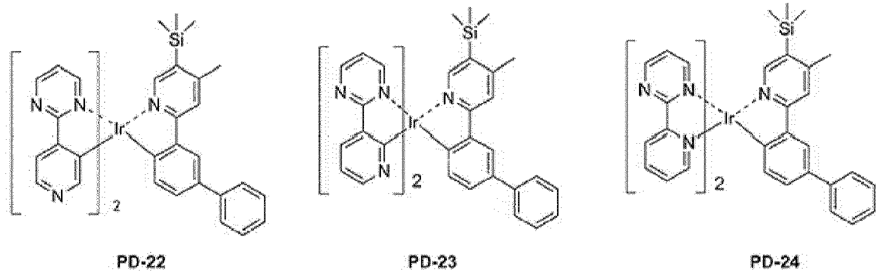

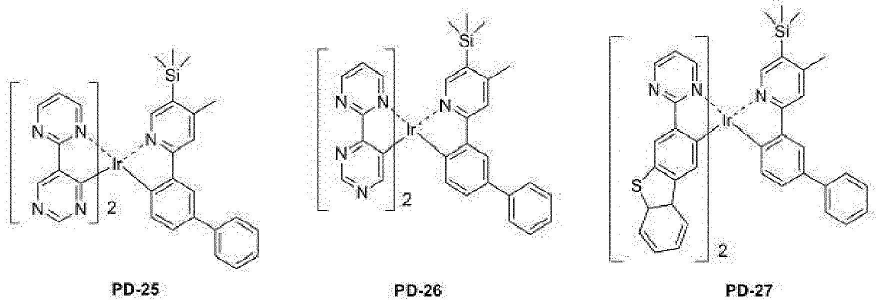

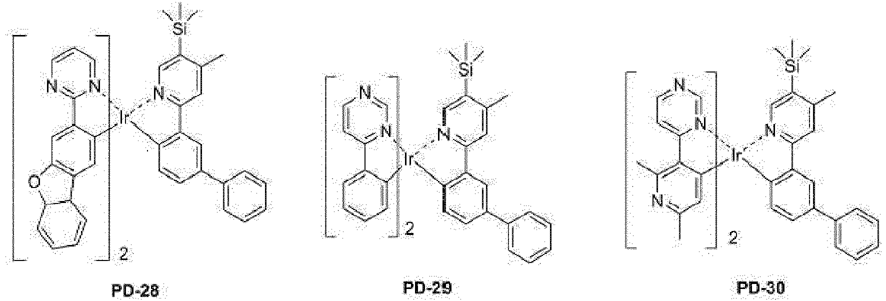

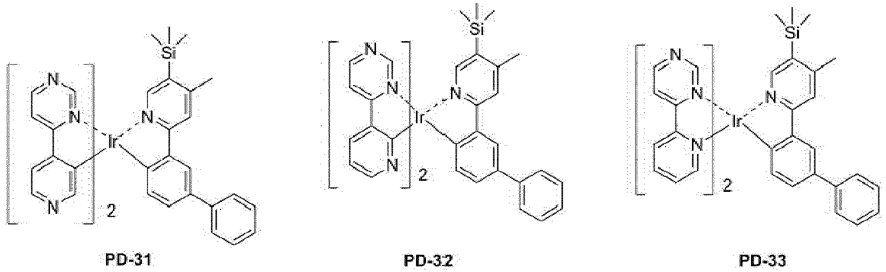

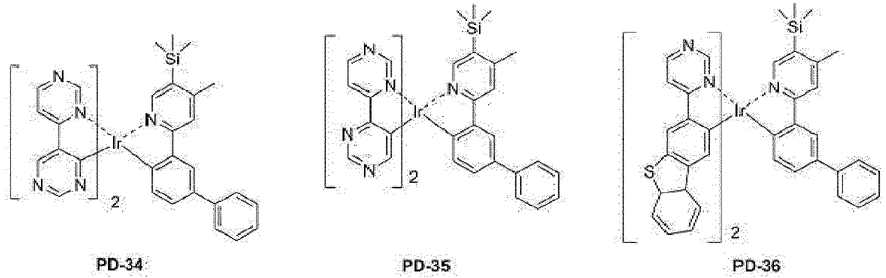

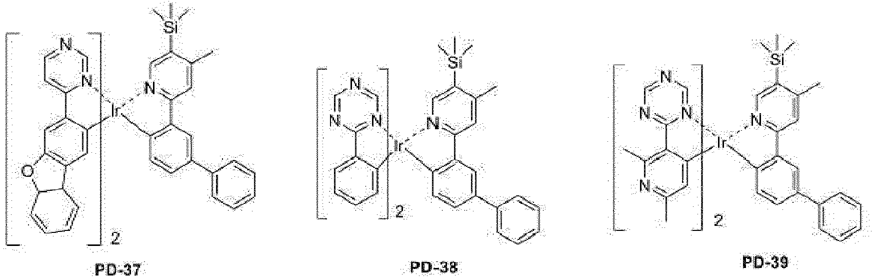

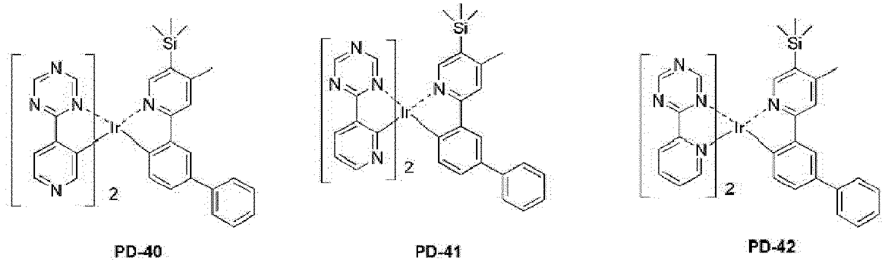

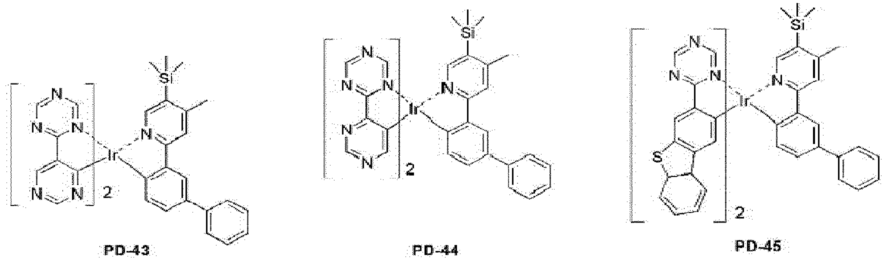

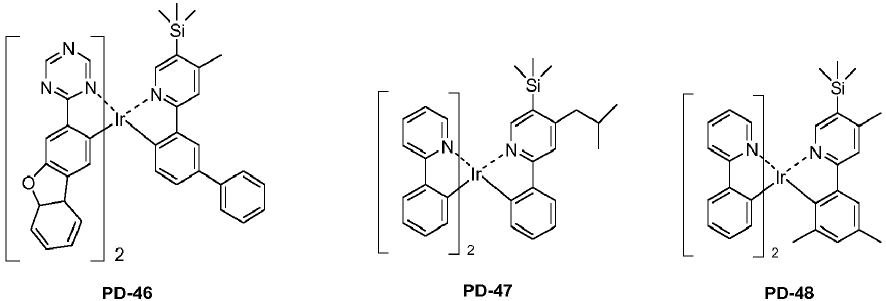

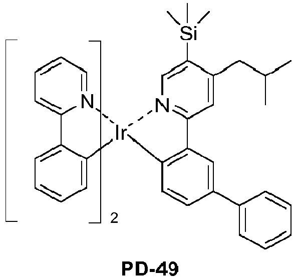

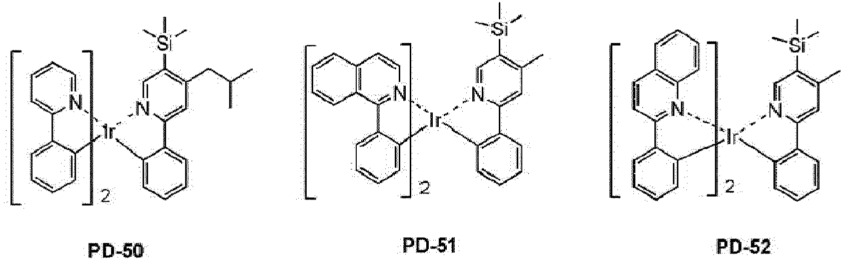

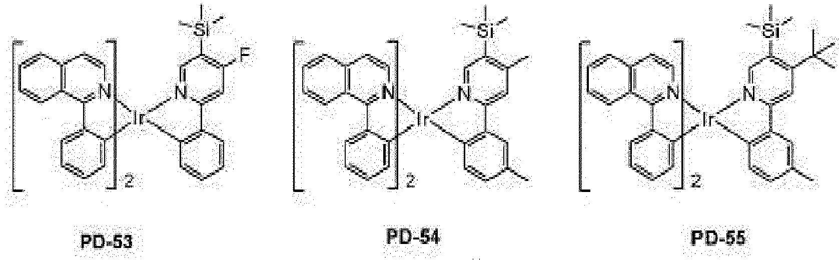

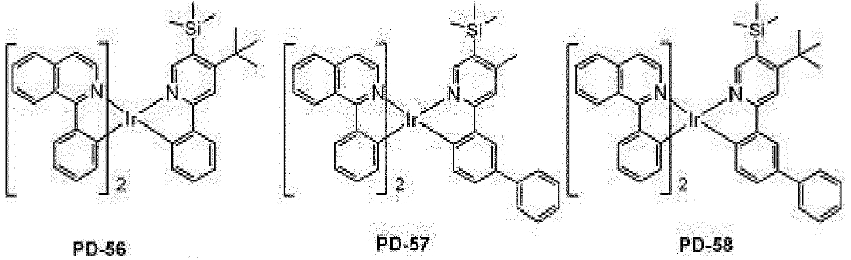

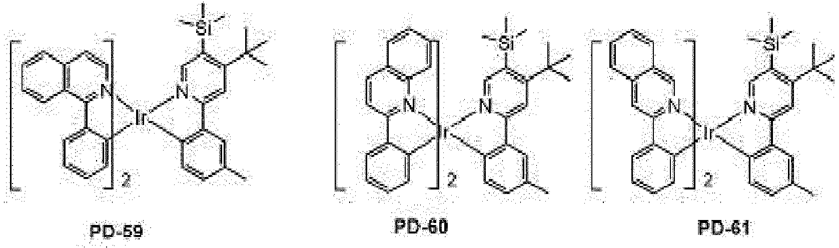

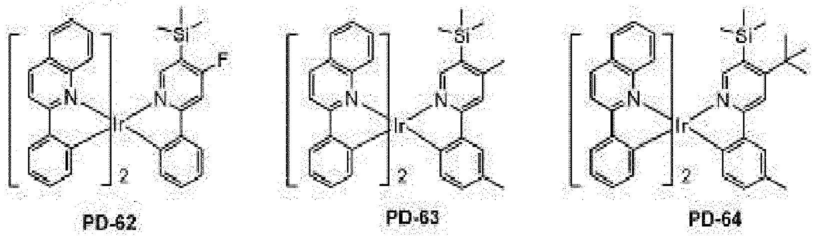

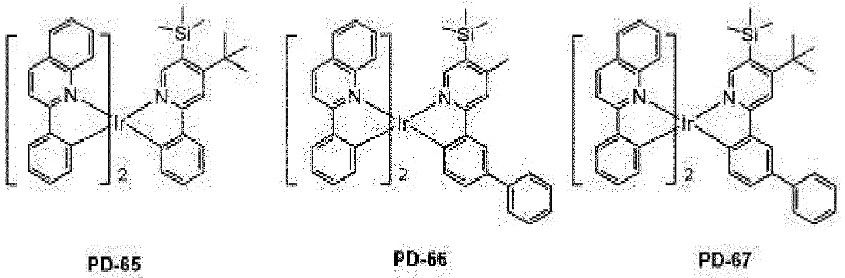

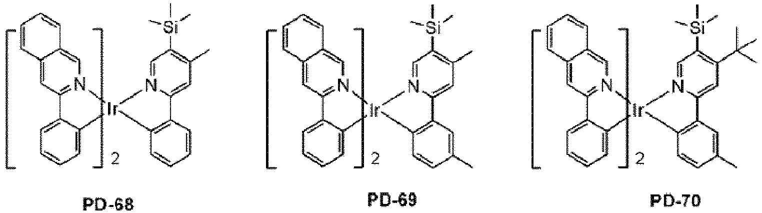

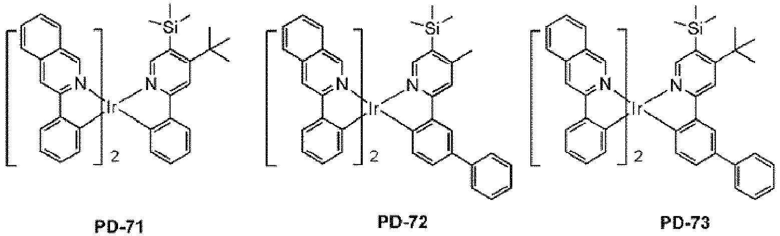

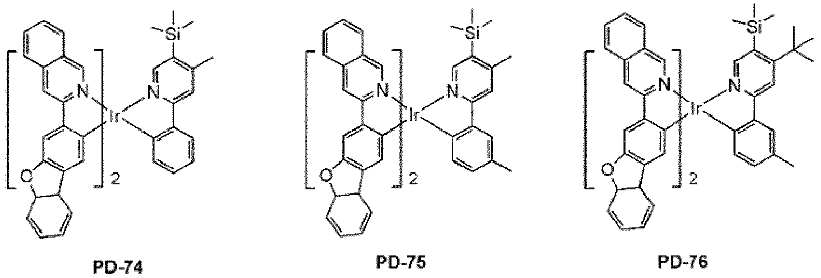

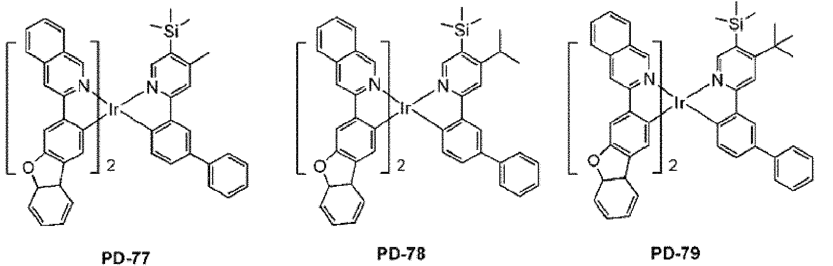

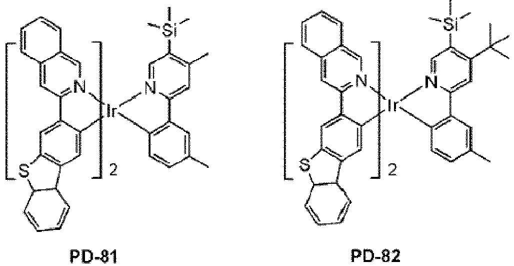

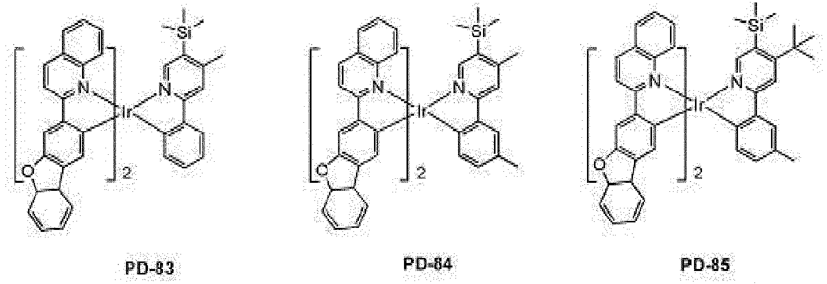

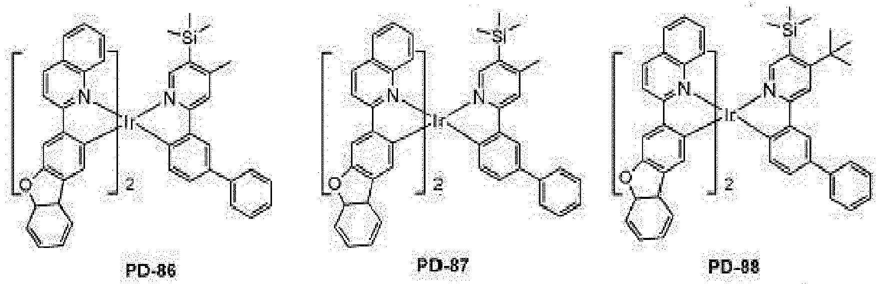

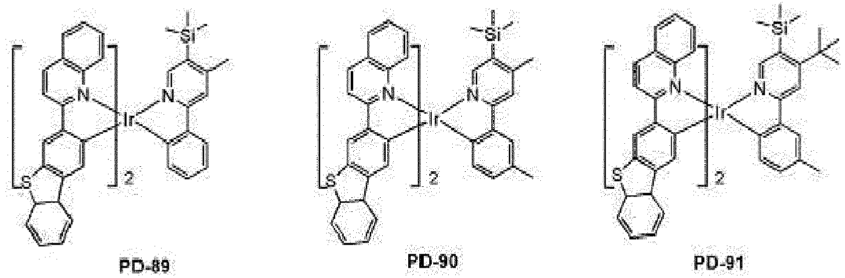

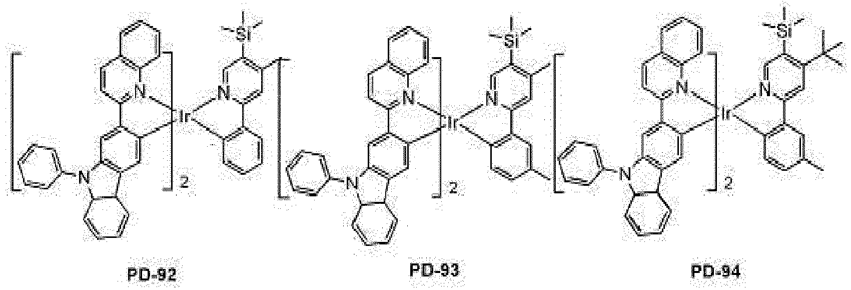

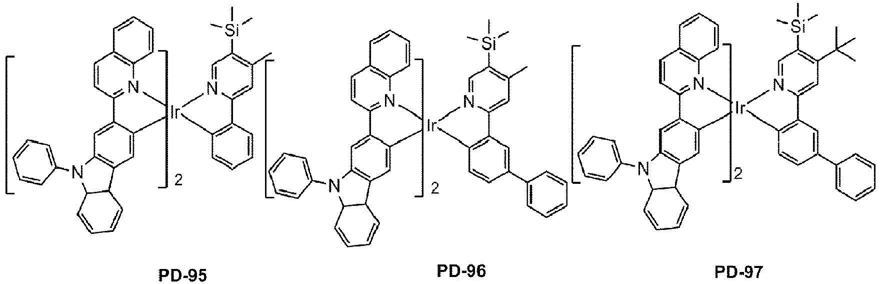

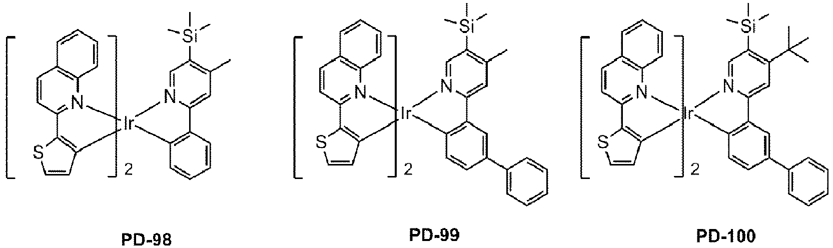

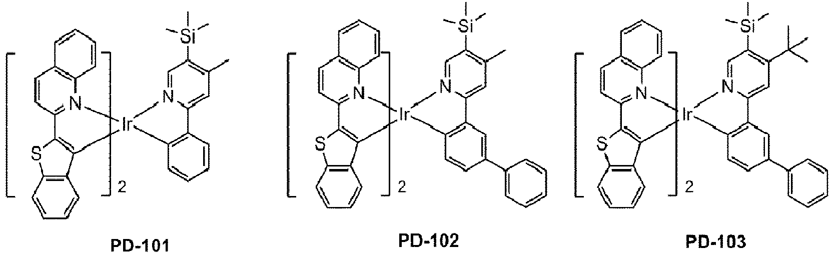

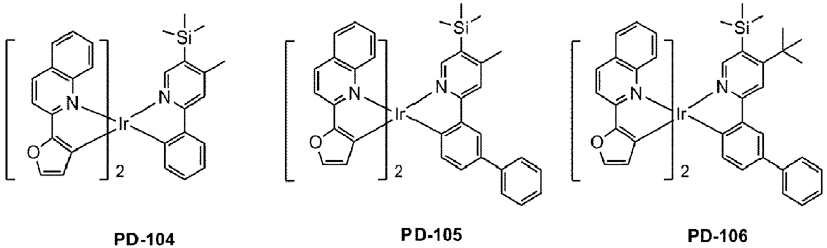

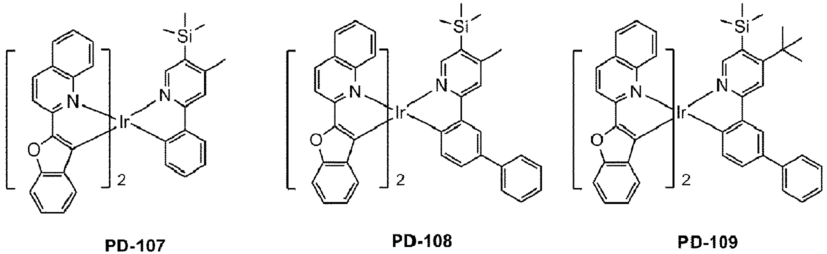

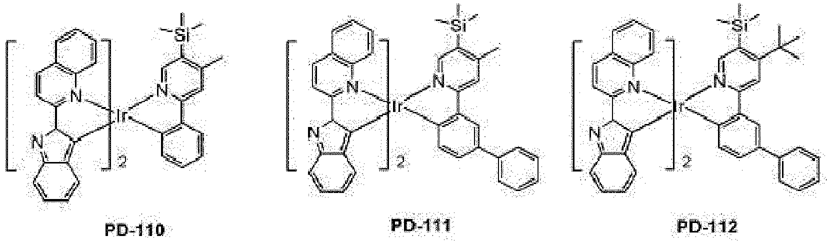

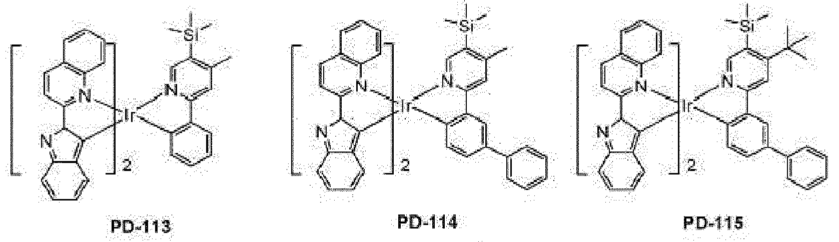

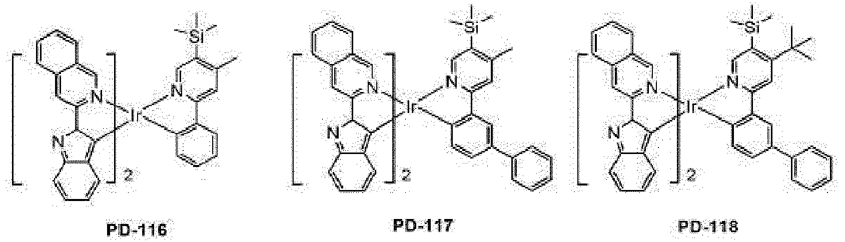

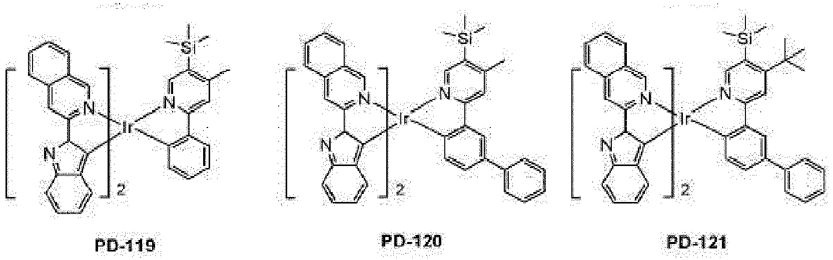

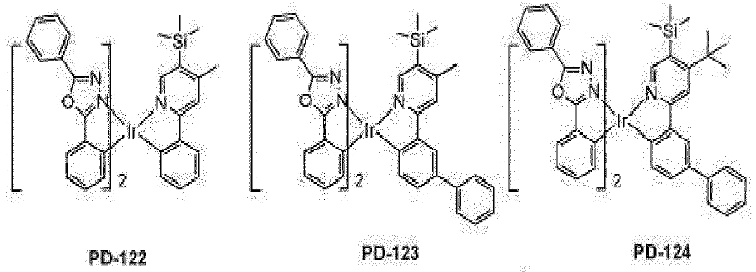

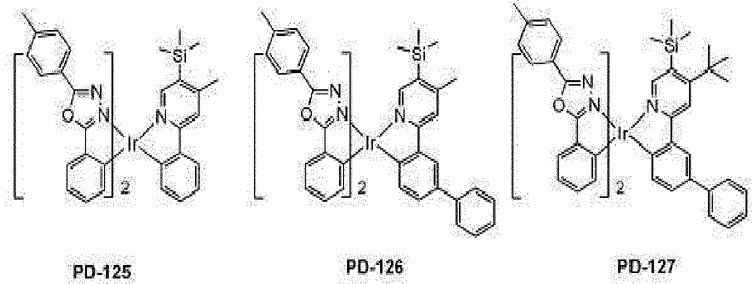

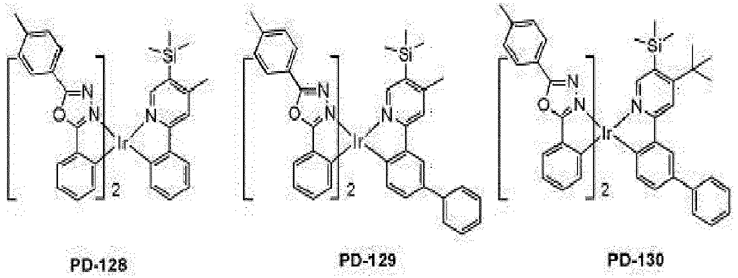

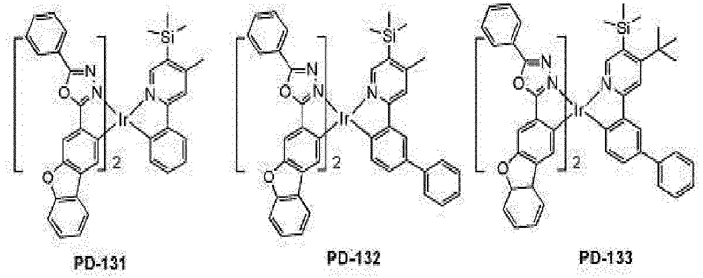

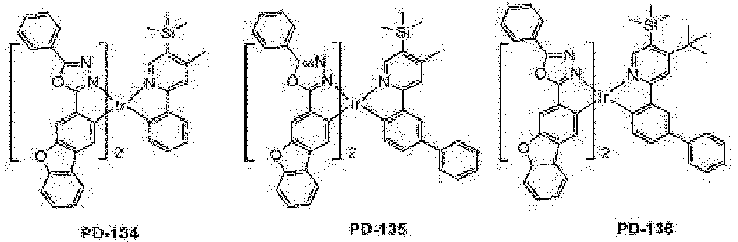

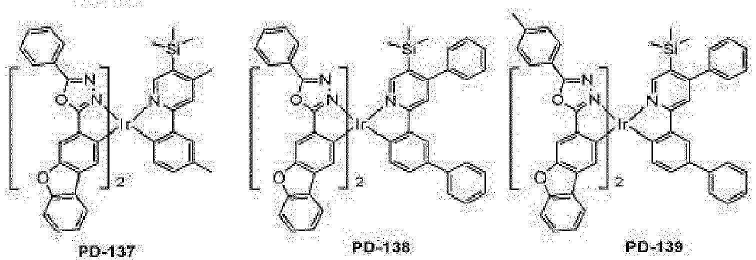

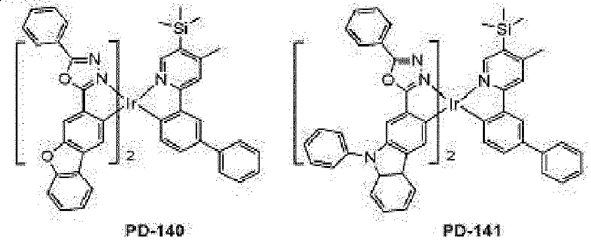

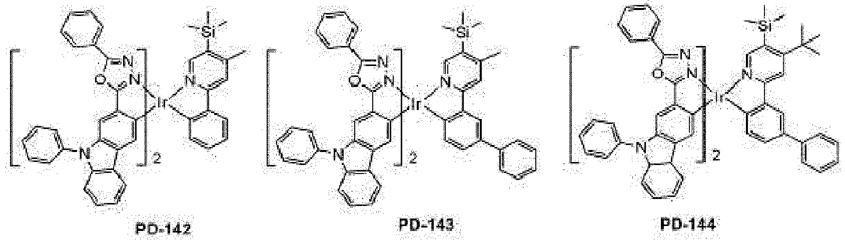

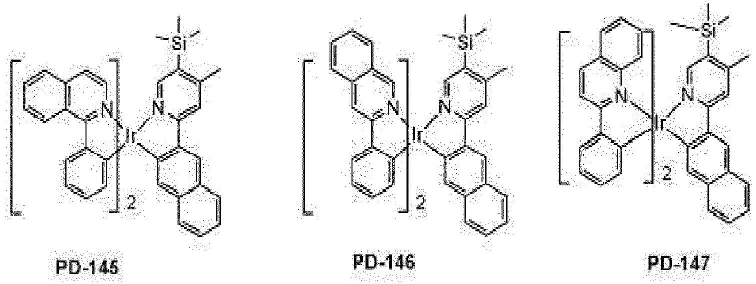

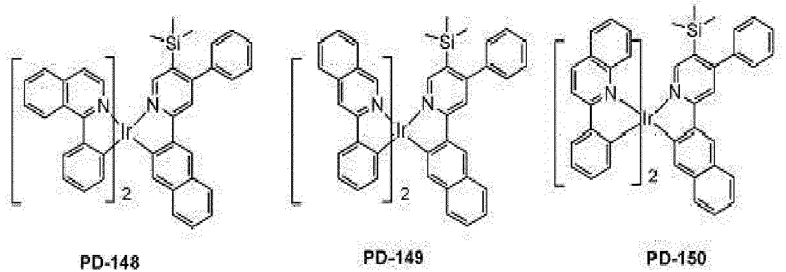

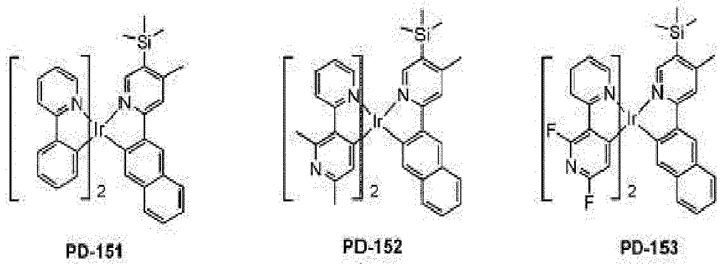

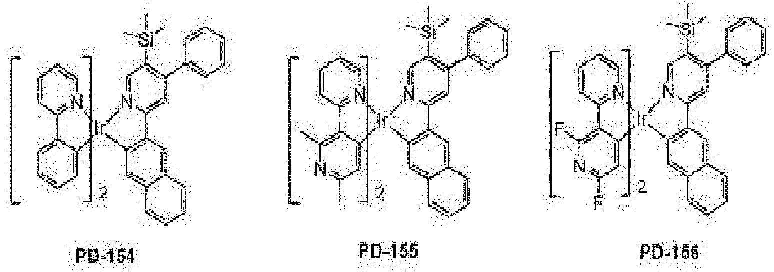

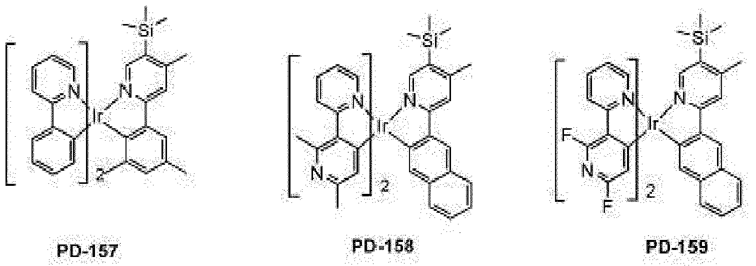

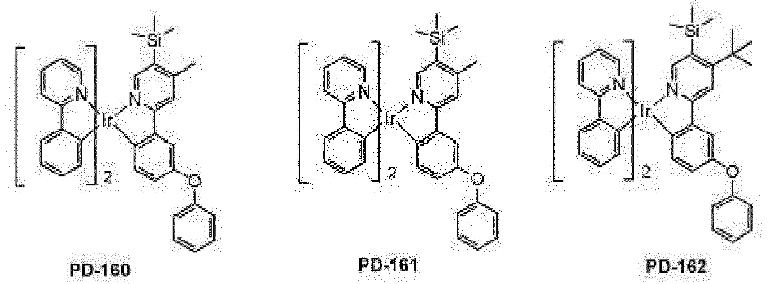

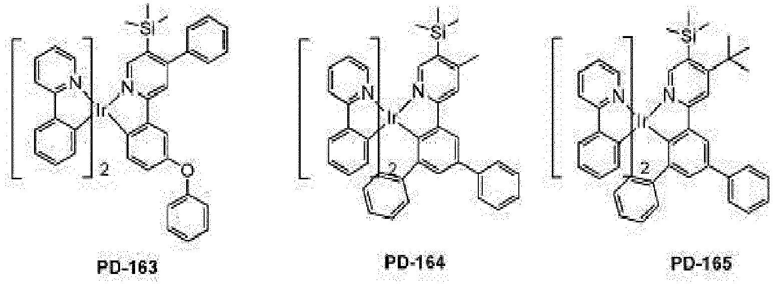

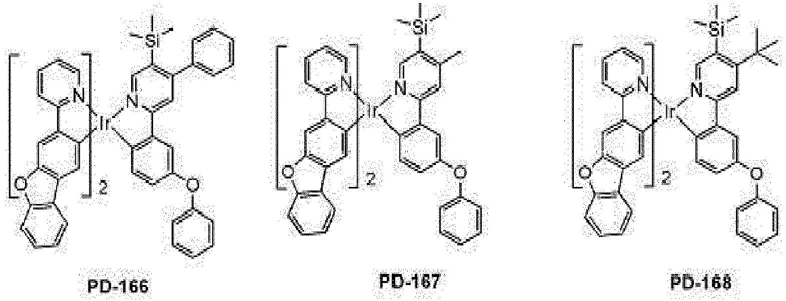

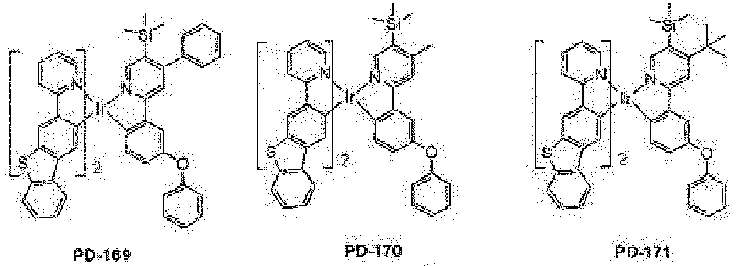

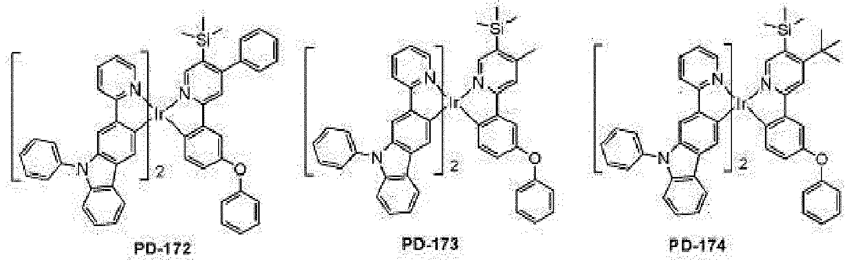

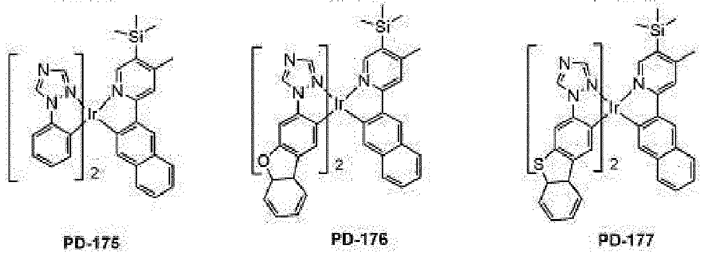

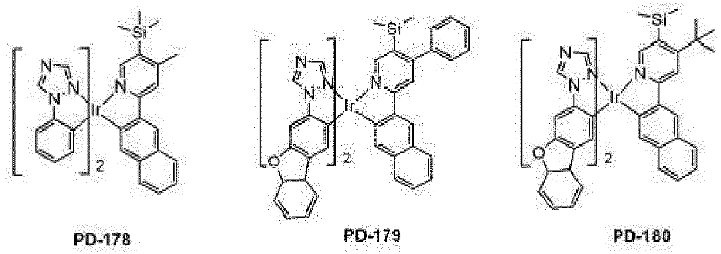

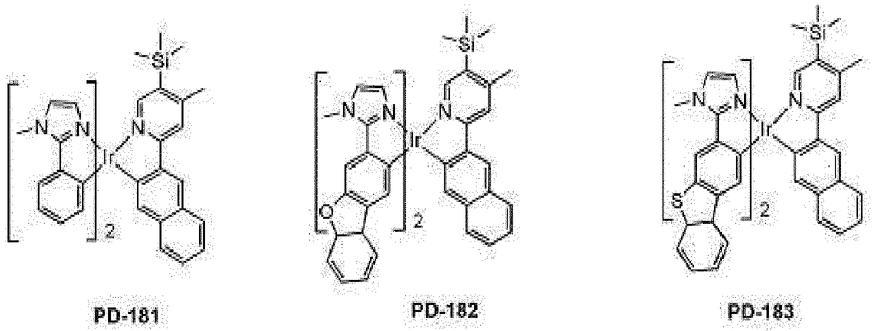

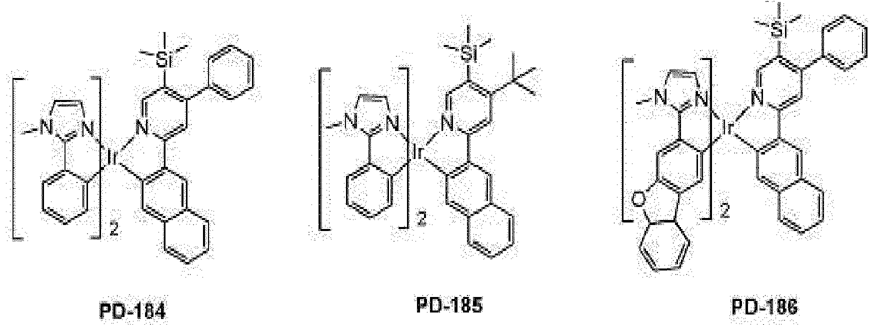

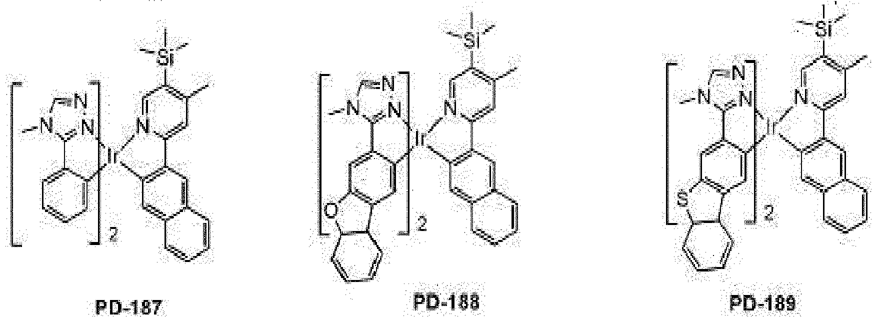

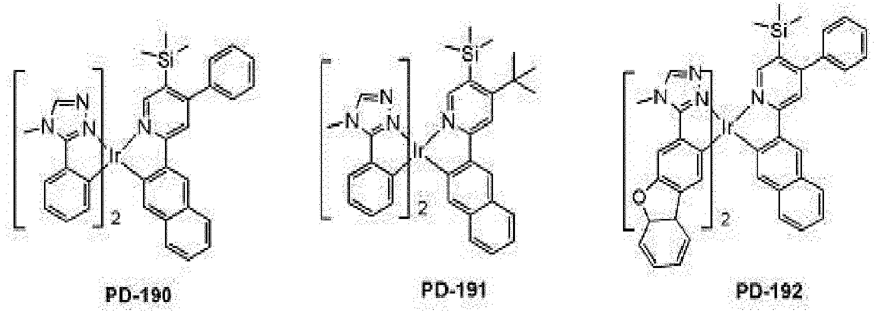

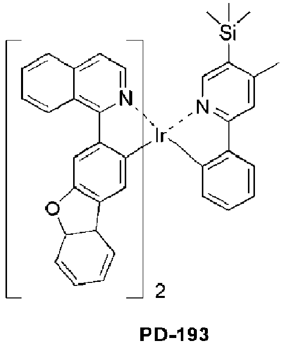

12. Dispositif électroluminescent organique selon la revendication 1, dans lequel chacun de L₁ à L₇ dans les formules 2A et 2B est indépendamment choisi parmi
-O-, un groupe méthylène, un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthrylène, un groupe fluoranthénylène, un groupe triphénylénylène, un groupe pyrénylène, un groupe chrysénylène, un groupe naphtacénylène, un groupe picénylène, un groupe pérylénylène, un groupe pyrrolylène, un groupe thiénylène, un groupe furylène, un groupe imidazolylène, un groupe pyrazolylène, un groupe thiazolylène, un groupe isothiazolylène, un groupe oxazolylène, un groupe isoxazolylène, un groupe pyridylène, un groupe pyrazinylène, un groupe pyrimidinylène, un groupe pyridazinylène, un groupe isoindolylène, un groupe indolylène, un groupe indazolylène, un groupe purinylène, un groupe quinolylène, un groupe isoquinolylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, un groupe dibenzocarbazolylène, un groupe thiadiazolylène, un groupe imidazopyridinylène, un groupe imidazopyrimidinylène, et un groupe cyclohexyle, et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthrylène, un groupe fluoranthénylène, un groupe triphénylénylène, un groupe pyrénylène, un groupe chrysénylène, un groupe naphtacénylène, un groupe picénylène, un groupe pérylénylène, un groupe pyrrolylène, un groupe thiénylène, un groupe furylène, un groupe imidazolylène, un groupe pyrazolylène, un groupe thiazolylène, un groupe isothiazolylène, un groupe oxazolylène, un groupe isoxazolylène, un groupe pyridylène, un groupe pyrazinylène, un groupe pyrimidinylène, un groupe pyridazinylène, un groupe isoindolylène, un groupe indolylène, un groupe indazolylène, un groupe purinylène, un groupe quinolylène, un groupe isoquinolylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, un groupe dibenzocarbazolylène, un groupe thiadiazolylène, un groupe imidazopyridinylène, un groupe imidazopyrimidinylène, et un groupe cyclohexyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle.

13. Dispositif électroluminescent organique selon la revendication 1, dans lequel chacun de L₁ à L₇ dans les formules 2A et 2B est indépendamment choisi parmi -O-, un groupe méthylène, et un groupe représenté par l'une des formules 3A à 3E : 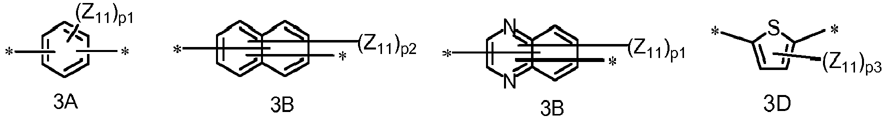 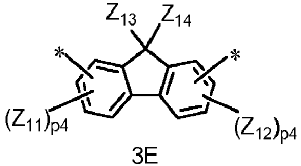 où, dans les formules 3A à 3E,
chacun de Z₁₁ à Z₁₄ est indépendamment choisi parmi
un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, un groupe imidazopyrimidinyle, -N(Q₃₁)(Q₃₂), et -Si(Q₃₃) (Q₃₄) (Q₃₅), et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phénoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, un groupe imidazopyrimidinyle, -N(Q₂₁)(Q₂₂) et -Si(Q₂₃)(Q₂₄)(Q₂₅),
où chacun de Q₃₁ à Q₃₅ et de Q₂₁ à Q₂₅ est indépendamment choisi parmi un atome d'hydrogène, un groupe alkyle en C₁ à C₂₀, un groupe alkoxy en C₁ à C₂₀, un groupe phényle, un groupe biphényle, un groupe naphtyle, un groupe anthryle, un groupe pyrényle, un groupe phénanthrényle, un groupe triphénylényle, et un groupe fluorényle, et
un groupe phényle, un groupe biphényle, un groupe naphtyle, un groupe anthryle, un groupe pyrényle, un groupe phénanthrényle, un groupe triphénylényle, et un groupe fluorényle, chacun substitué par au moins l'un parmi un groupe alkyle en C₁ à C₂₀, un groupe alkoxy en C₁ à C₂₀, un groupe phényle, un groupe biphényle, un groupe naphtyle, un groupe anthryle, un groupe pyrényle, un groupe phénanthrényle, un groupe triphénylényle, et un groupe fluorényle ;
éventuellement au moins deux parmi Q₂₃ à Q₂₅ sont liés ensemble pour former un cycle ;
éventuellement Z₁₃ et Z₁₄ dans la formule 3E sont liés l'un à l'autre pour former un cycle ;
p1 est un entier de 0 à 4 ;
p2 est un entier de 0 à 6 ;
p3 est un entier de 0 à 2 ;
p4 est un entier de 0 à 3 ; et
* est un site de liaison.

14. Dispositif électroluminescent organique selon la revendication 1, dans lequel chacun de L₁ à L₇ dans les formules 2A et 2B est indépendamment choisi parmi -O-, un groupe méthylène, et les groupes représentés par les formules 4A à 4J : 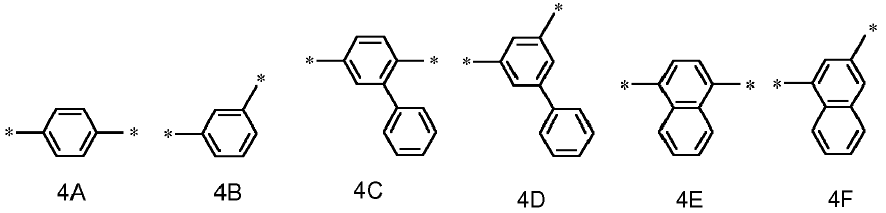 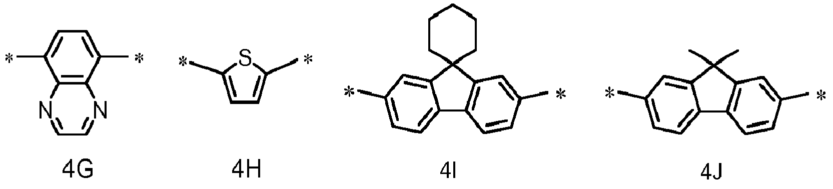 où, dans les formules 4A à 4J, * est un site de liaison.

15. Dispositif électroluminescent organique selon la revendication 1, dans lequel [L₁]_{Ib1} dans les formules 2A et 2B est un groupe représenté par l'une des formules 5A à 5L : 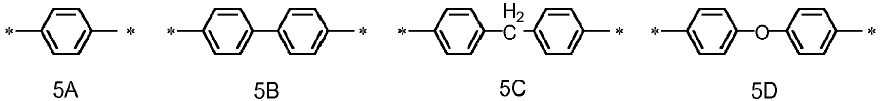 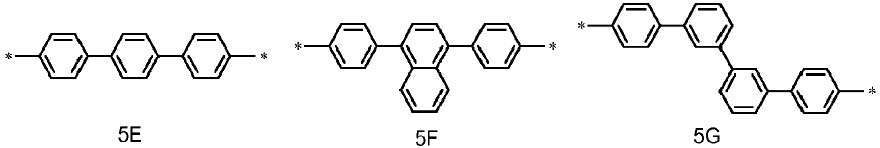 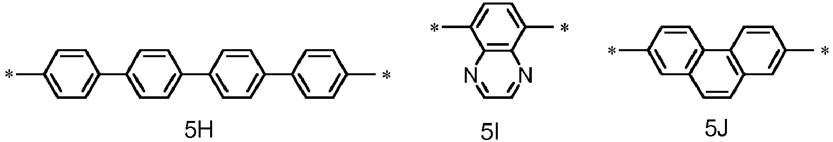 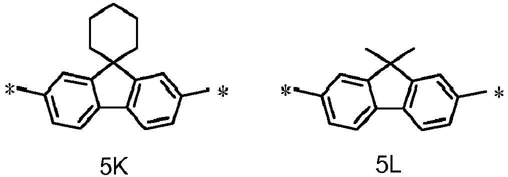 où, dans les formules 5A à 5L, * est un site de liaison.

16. Dispositif électroluminescent organique selon la revendication 1, dans lequel chacun de R₉ à R₁₄ dans les formules 2A et 2B est indépendamment choisi parmi
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe phénylméthyle, un groupe triphénylméthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe cyclohexyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, un groupe imidazopyrimidinyle, -N(Q₂₁)(Q₂₂) et -Si(Q₂₃)(Q₂₄)(Q₂₅),
où chacun de Q₂₁ à Q₂₅ est indépendamment choisi parmi
un atome d'hydrogène, un groupe alkyle en C₁ à C₂₀, un groupe alkoxy en C₁ à C₂₀, un groupe phényle, un groupe biphényle, un groupe naphtyle, un groupe anthryle, un groupe pyrényle, un groupe phénanthrényle, un groupe triphénylényle, et un groupe fluorényle, et
un groupe phényle, un groupe biphényle, un groupe naphtyle, un groupe anthryle, un groupe pyrényle, un groupe phénanthrényle, un groupe triphénylényle, et un groupe fluorényle, chacun substitué par au moins l'un parmi un groupe alkyle en C₁ à C₂₀, un groupe alkoxy en C₁ à C₂₀, un groupe biphényle, un groupe phényle, un groupe naphtyle, un groupe anthryle, un groupe pyrényle, un groupe phénanthrényle, un groupe triphénylényle, et un groupe fluorényle.

17. Dispositif électroluminescent organique selon la revendication 1, dans lequel chacun de Rg à R₁₄ dans les formules 2A et 2B est indépendamment un groupe représenté par l'une des formules 6A à 6G : 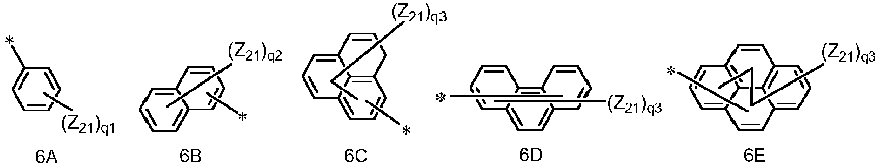 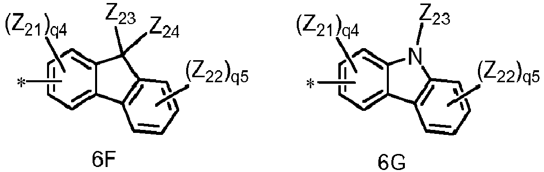 où, dans les formules 6A à 6G,
chacun de Z₂₁ à Z₂₄ est indépendamment choisi parmi
un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, un groupe imidazopyrimidinyle, -N(Q₃₁)(Q₃₂), et -Si(Q₃₃) (Q₃₄) (Q₃₅), et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phénoxy, un groupe phénylméthyle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, un groupe imidazopyrimidinyle, -N(Q₂₁)(Q₂₂) et -Si(Q₂₃)(Q₂₄)(Q₂₅),
où chacun de Q₃₁ à Q₃₅ et de Q₂₁ à Q₂₅ est indépendamment choisi parmi
un atome d'hydrogène, un groupe alkyle en C₁ à C₂₀, un groupe alkoxy en C₁ à C₂₀, un groupe phényle, un groupe biphényle, un groupe naphtyle, un groupe anthryle, un groupe pyrényle, un groupe phénanthrényle, un groupe triphénylényle, et un groupe fluorényle, et
un groupe phényle, un groupe biphényle, un groupe naphtyle, un groupe anthryle, un groupe pyrényle, un groupe phénanthrényle, un groupe triphénylényle, et un groupe fluorényle, chacun substitué par au moins l'un parmi un groupe alkyle en C₁ à C₂₀, un groupe alkoxy en C₁ à C₂₀, un groupe phényle, un groupe biphényle, un groupe naphtyle, un groupe anthryle, un groupe pyrényle, un groupe phénanthrényle, un groupe triphénylényle, et un groupe fluorényle ;
où éventuellement au moins deux parmi Q₂₃ à Q₂₅ sont liés ensemble pour former un cycle ;
éventuellement Z₂₃ et Z₂₄ dans la formule 6F sont liés l'un à l'autre pour former un cycle ;
q1 est un entier de 0 à 5 ;
q2 est un entier de 0 à 7 ;
q3 est un entier de 0 à 9 ;
q4 est un entier de 0 à 3 ;
q5 est un entier de 0 à 4 ; et
* est un site de liaison.

18. Dispositif électroluminescent organique selon la revendication 1, dans lequel chacun de Rg à R₁₄ dans les formules 2A et 2B est indépendamment un groupe représenté par l'une des formules 7A à 7AB : 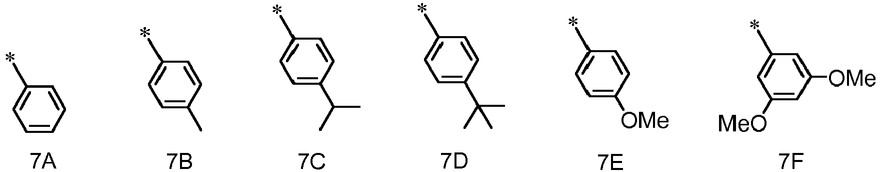 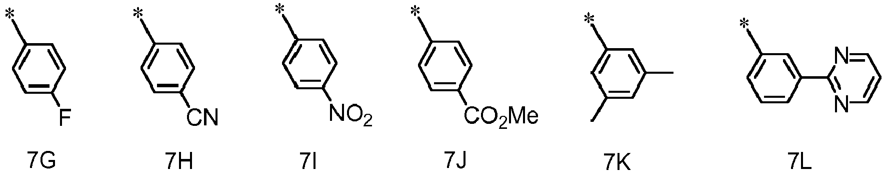 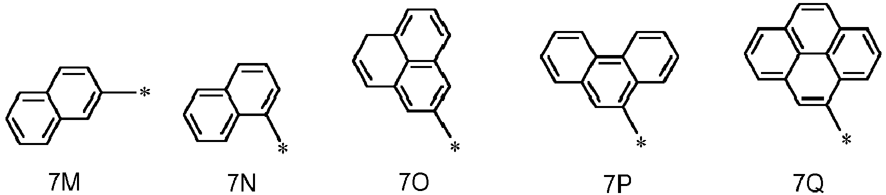 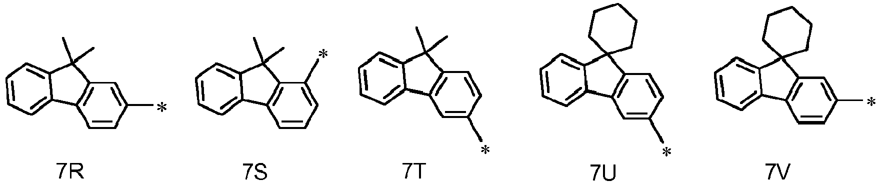 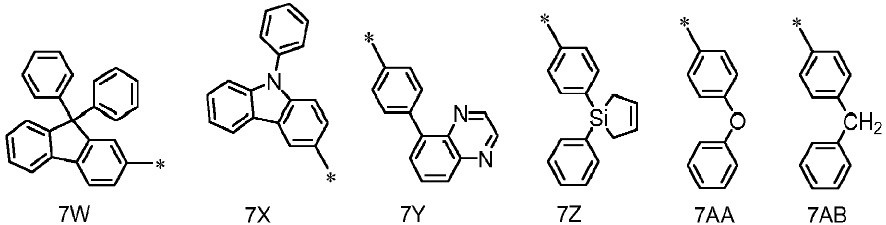 où, dans les formules 7A à 7AB, * est un site de liaison.

19. Dispositif électroluminescent organique selon la revendication 1, dans lequel chacun de -[L₂]_{Ib2}-R₉, -[L₃]_{Ib3}-R₁₀, -[L₄]_{Ib4}-R₁₁, -[L₅]_{Ib5}-R₁₂, -[L₆]_{Ib6}-R₁₃, et -[L₇]_{Ib7}-R₁₄ dans les formules 2A et 2B est indépendamment un groupe représenté par l'une des formules 8A à 8AI : 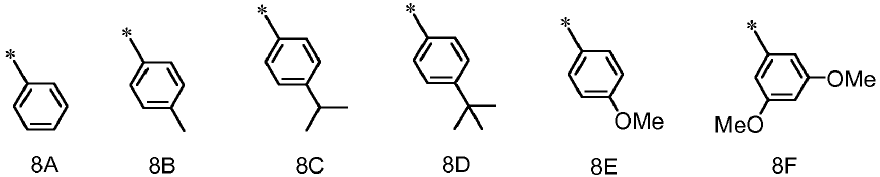 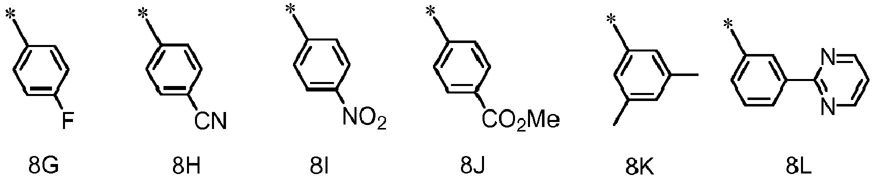 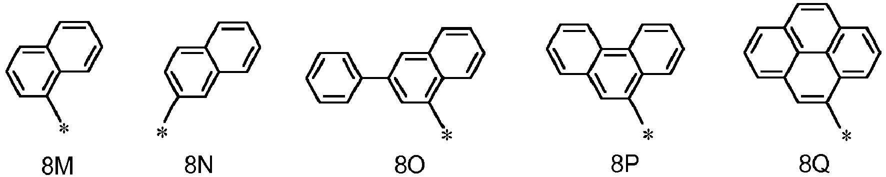 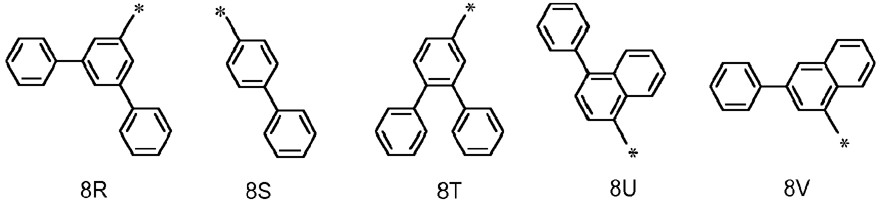 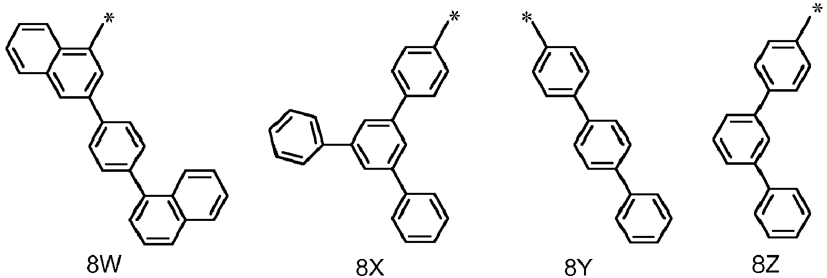 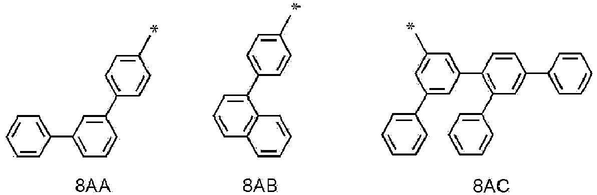 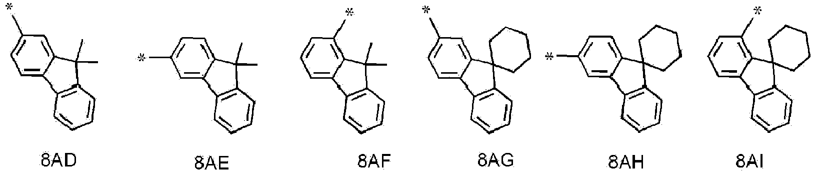 où, dans les formules 8A à 8AI, * est un site de liaison.

20. Dispositif électroluminescent organique selon la revendication 1, dans lequel le premier composé représenté par la formule 2A ou 2B est choisi parmi les composés HTa-1 à HTa-121 et HTa-129 à HTa-284 :

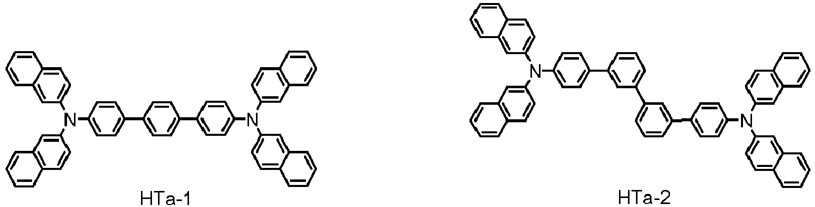

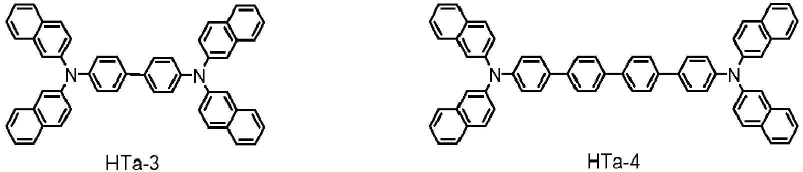

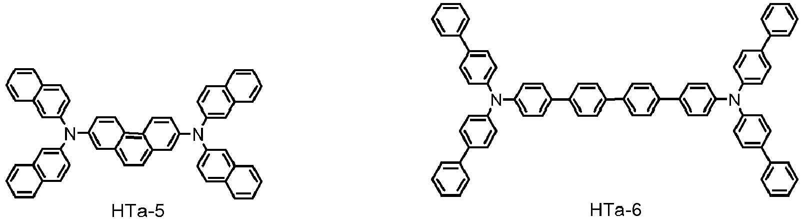

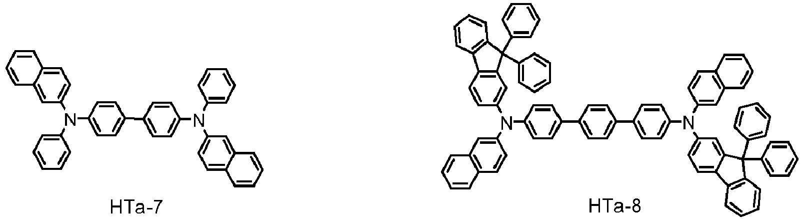

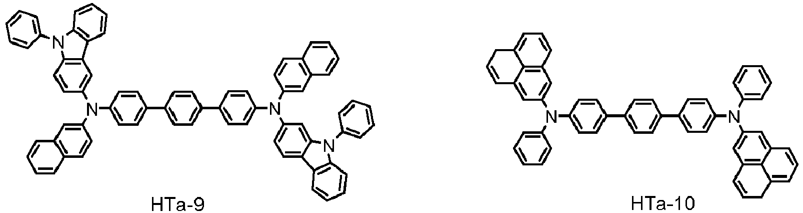

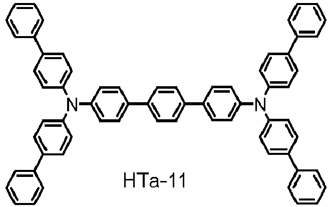

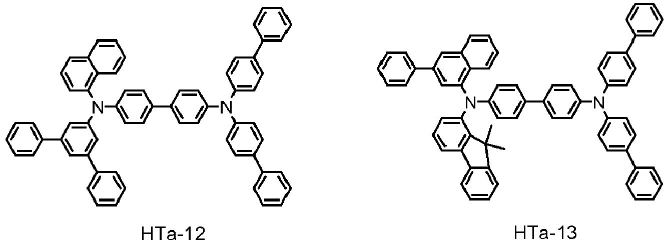

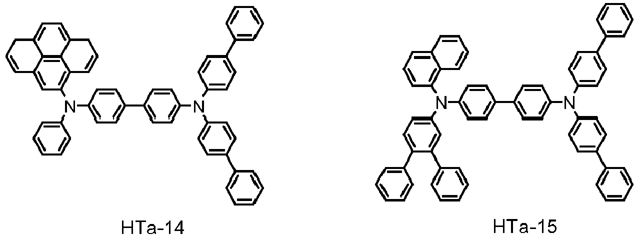

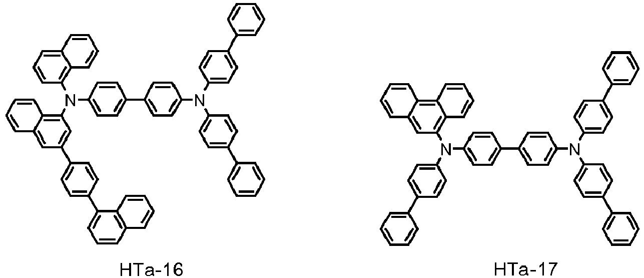

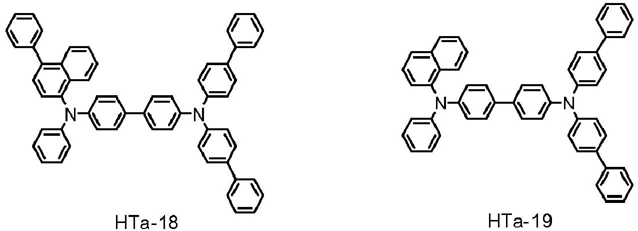

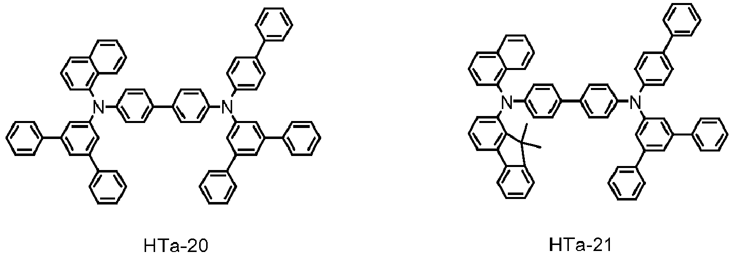

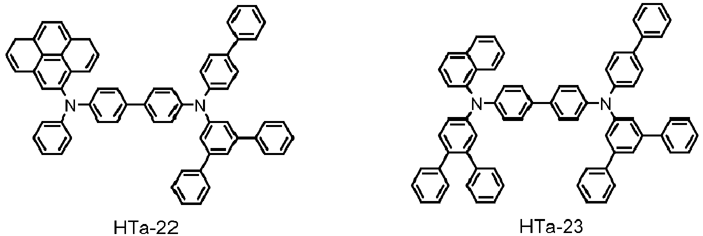

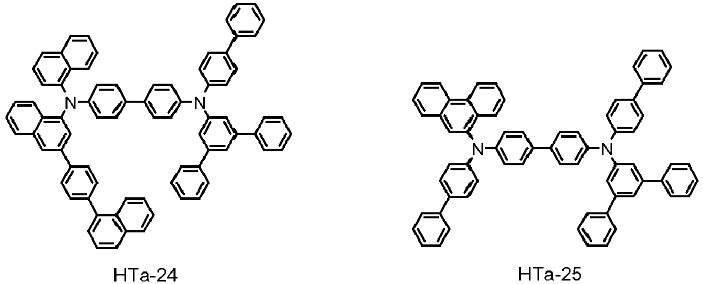

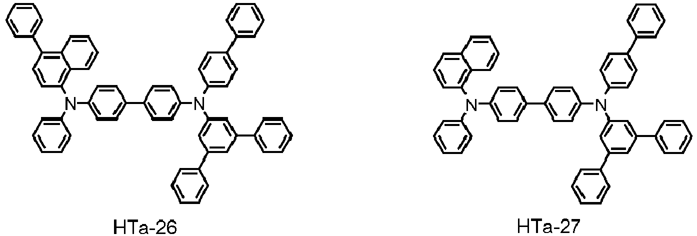

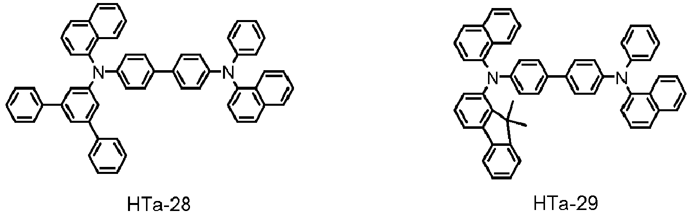

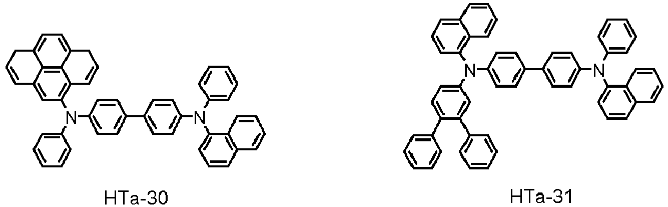

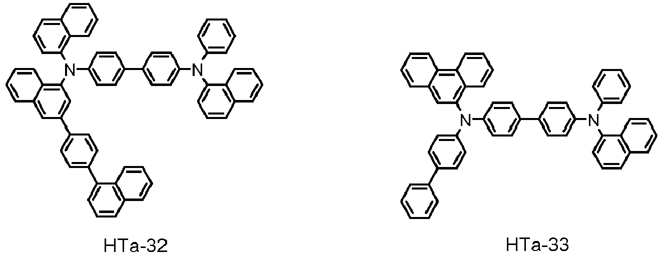

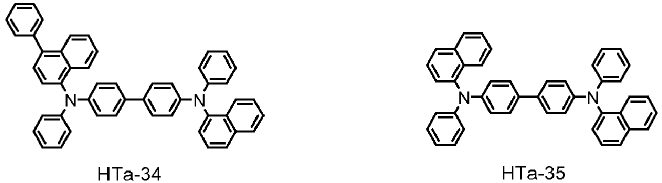

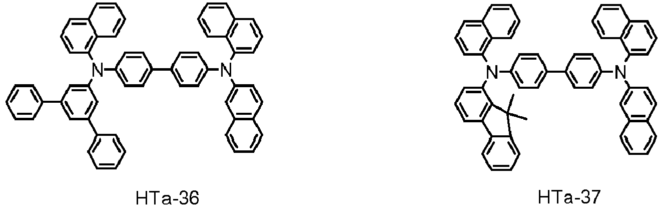

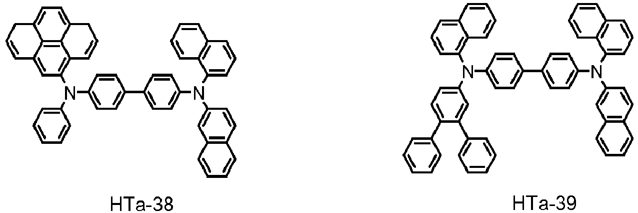

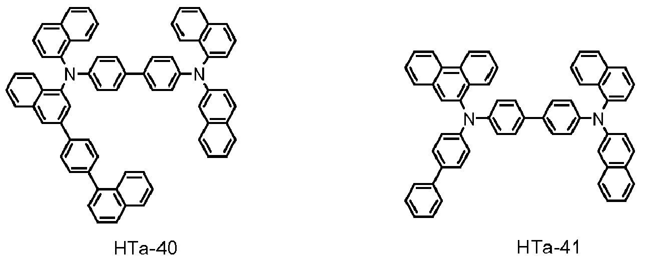

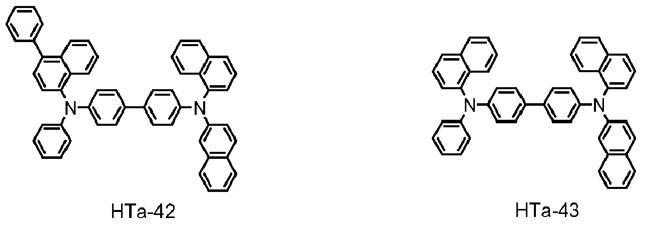

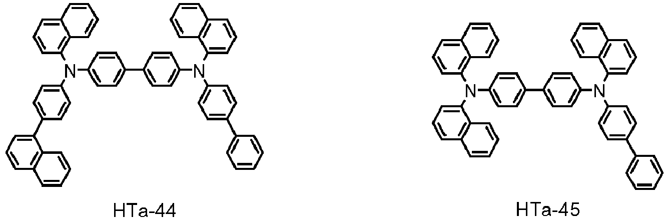

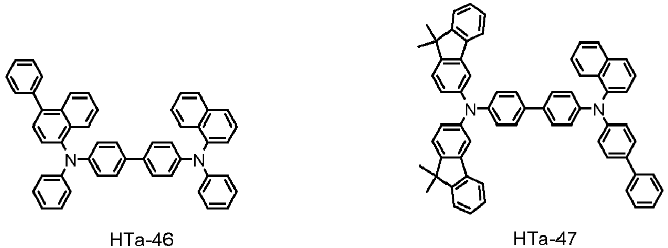

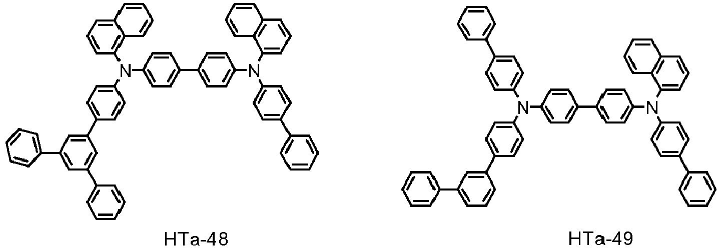

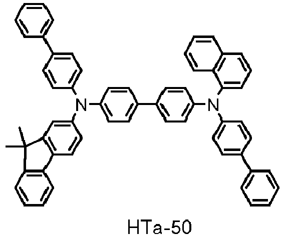

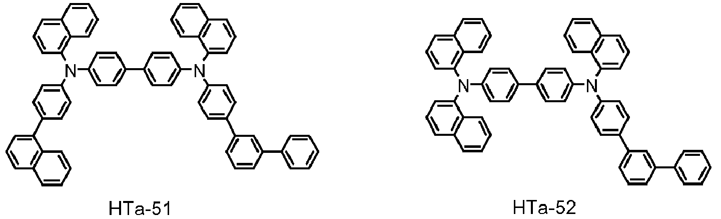

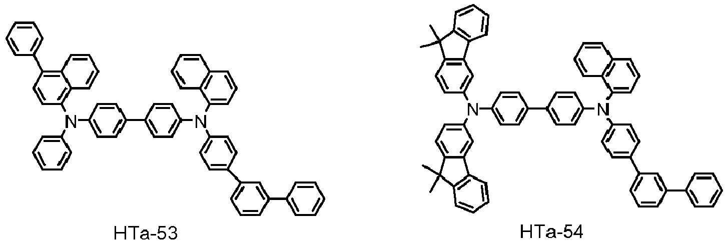

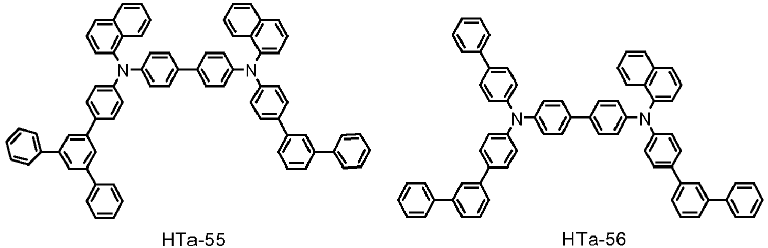

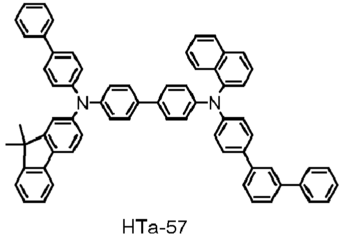

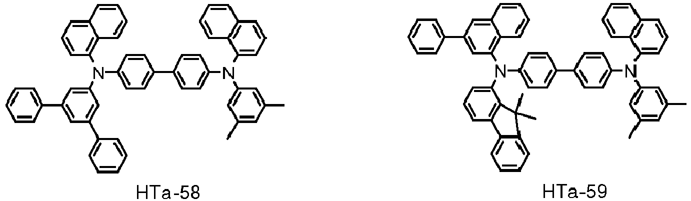

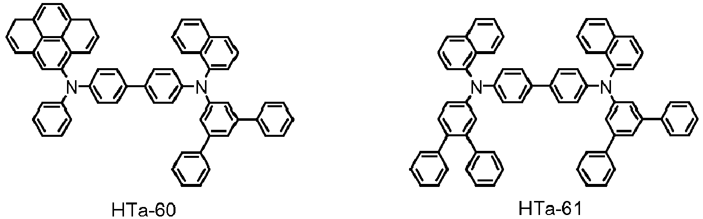

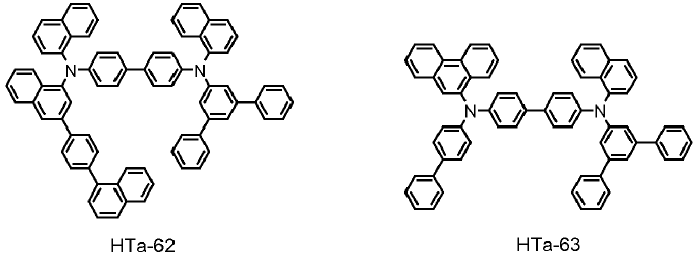

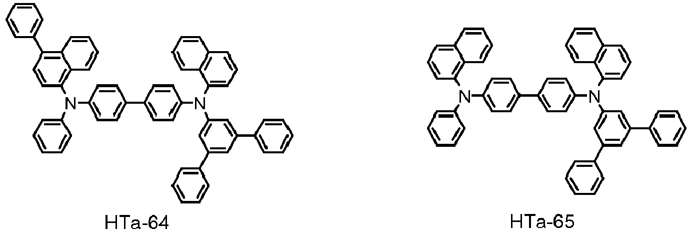

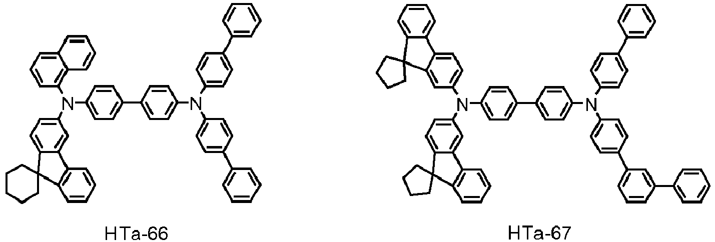

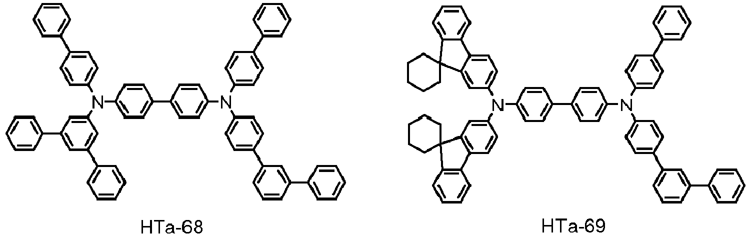

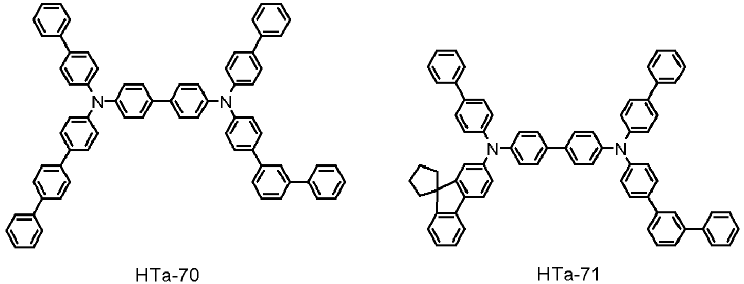

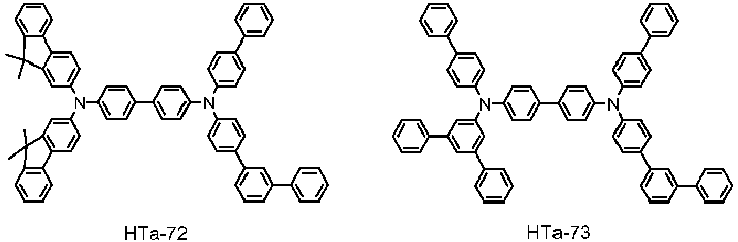

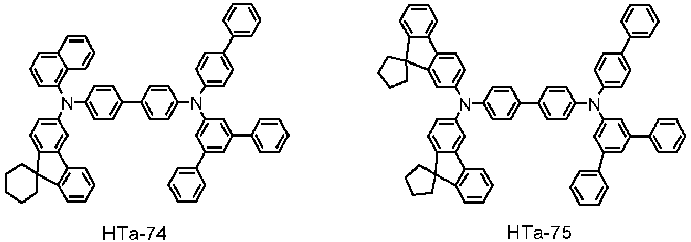

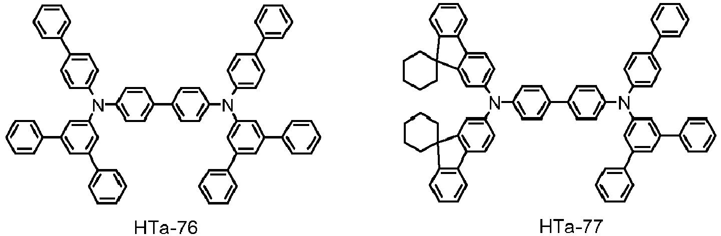

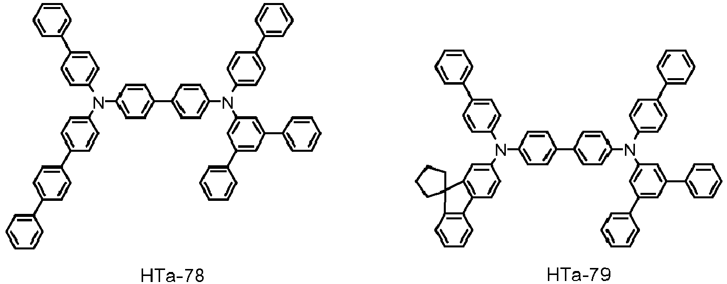

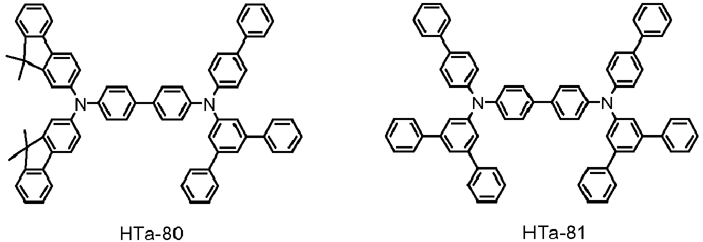

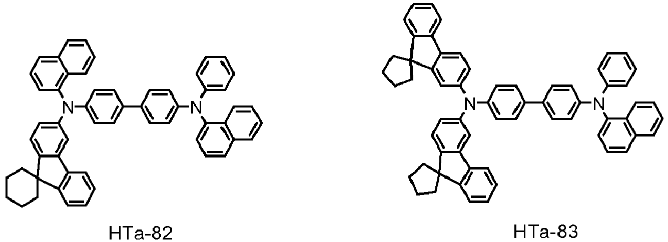

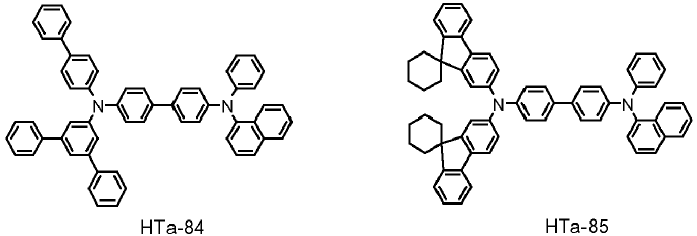

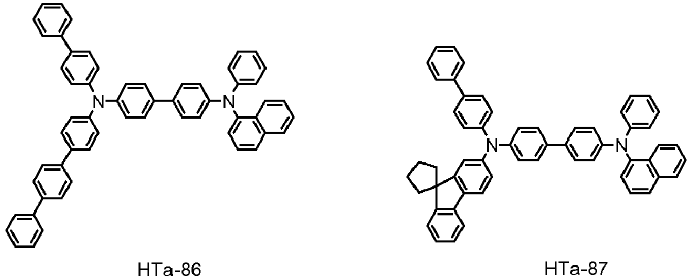

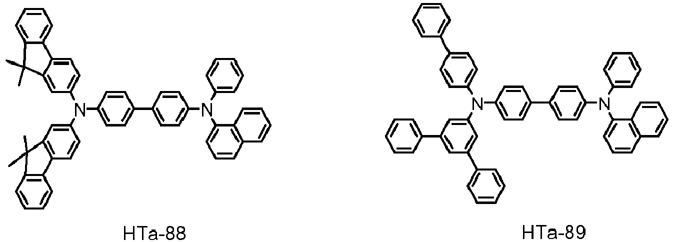

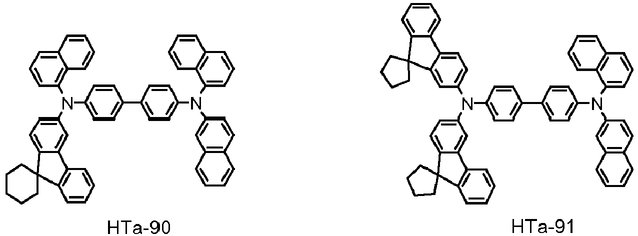

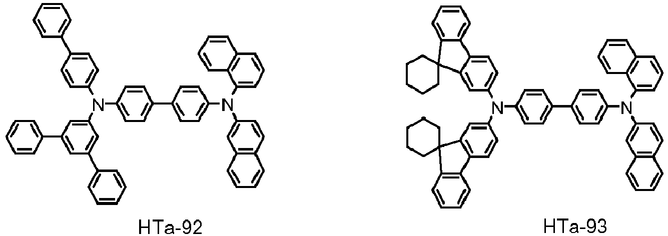

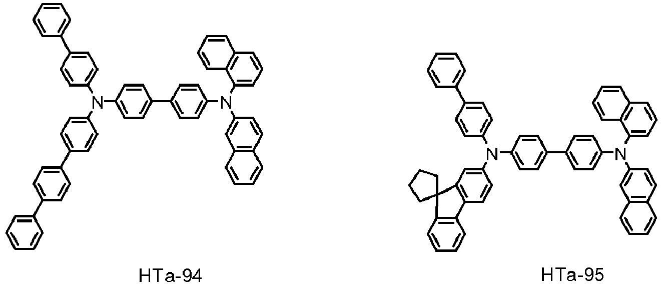

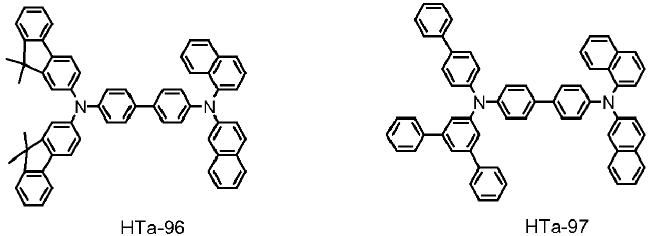

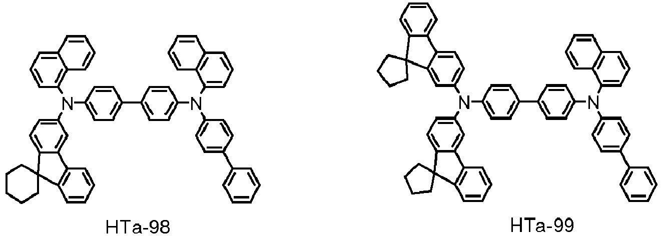

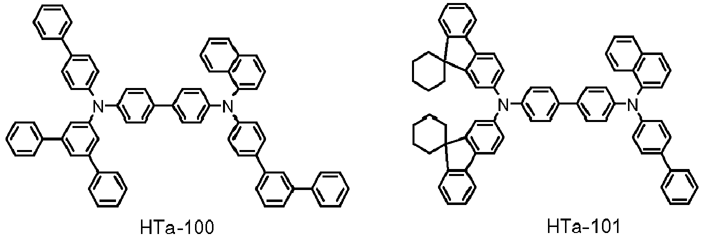

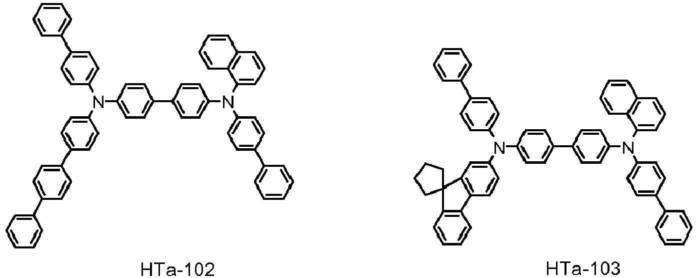

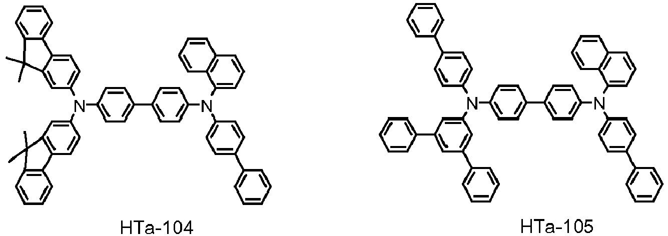

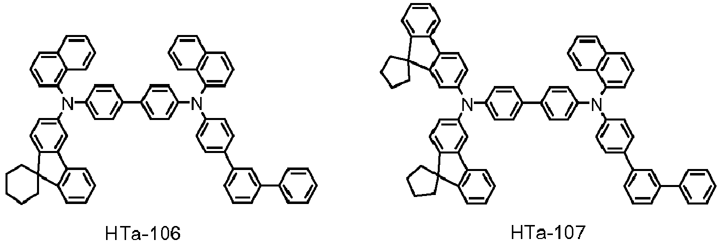

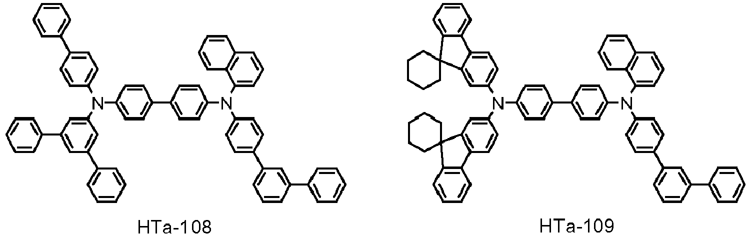

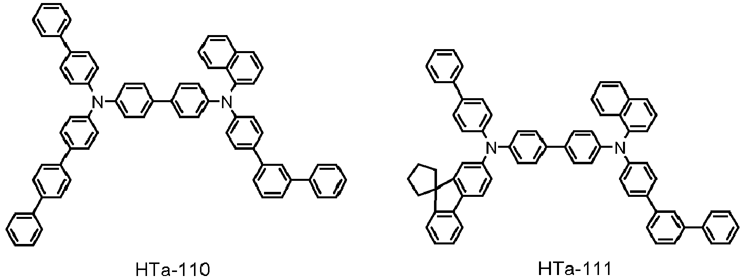

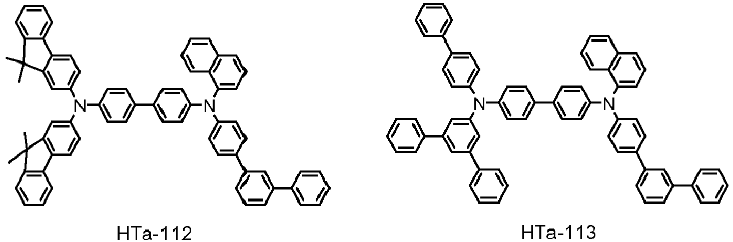

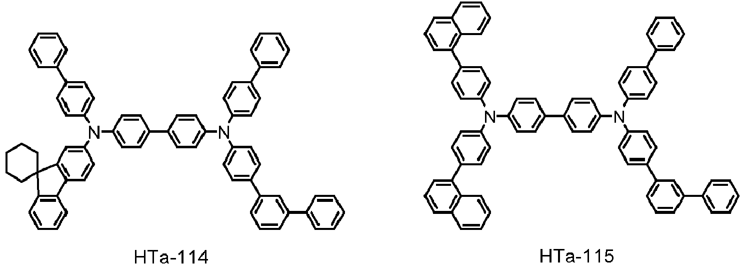

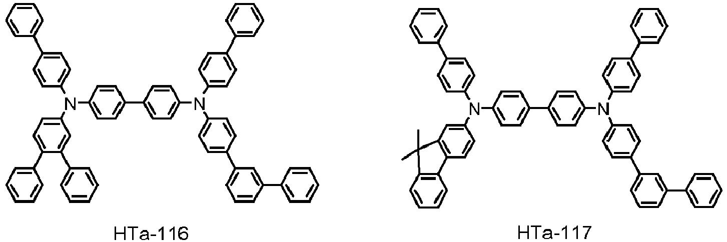

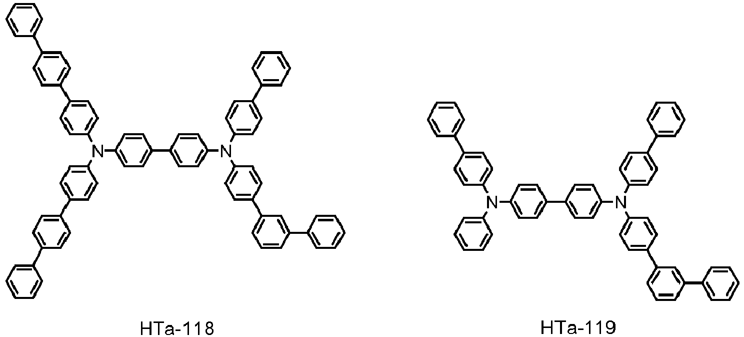

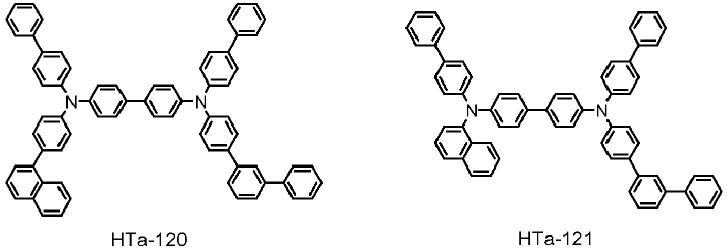

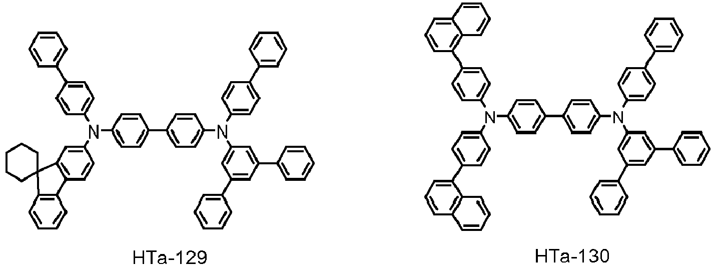

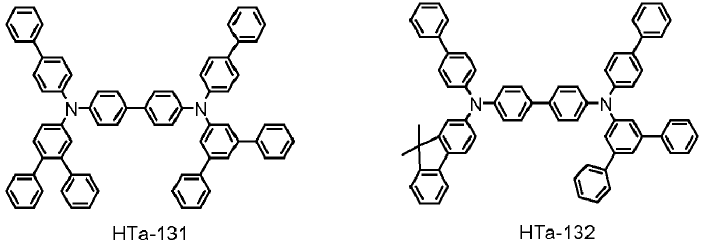

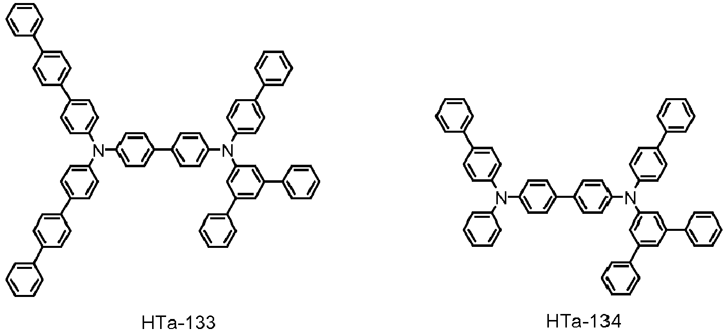

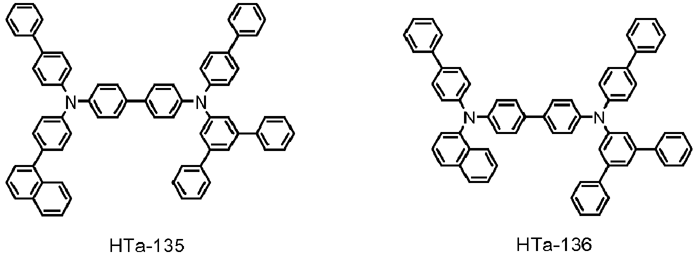

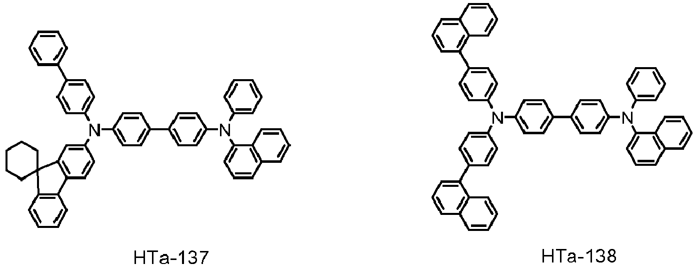

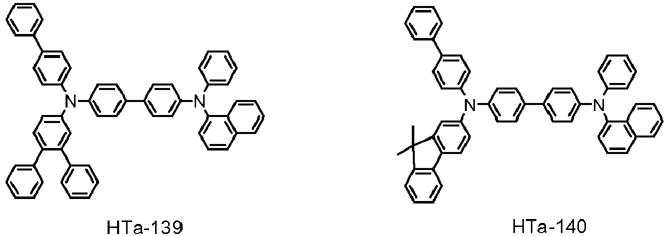

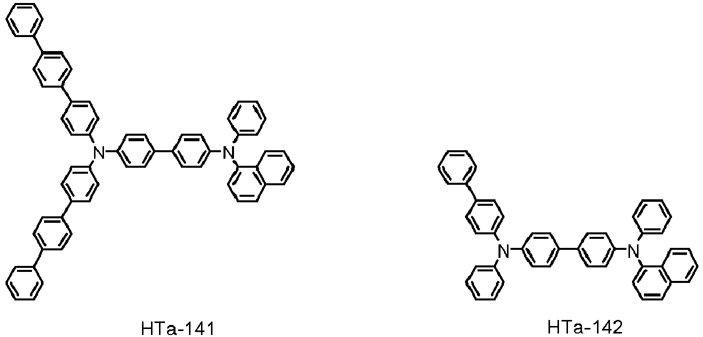

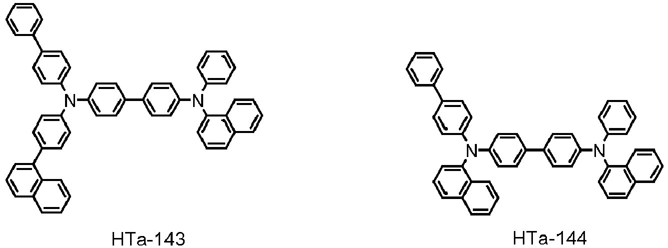

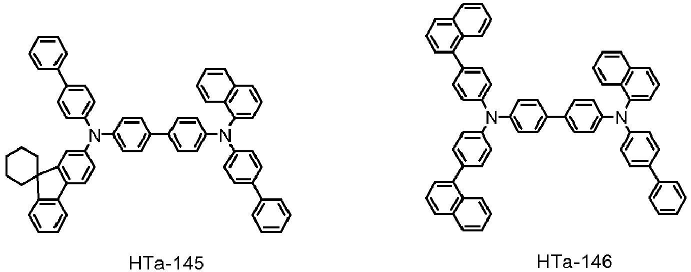

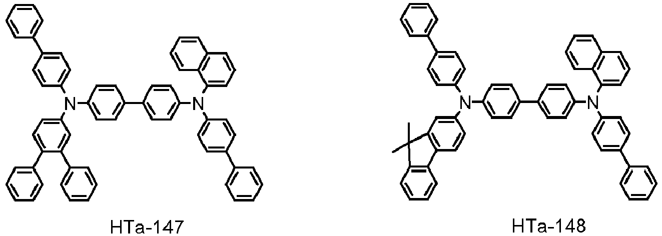

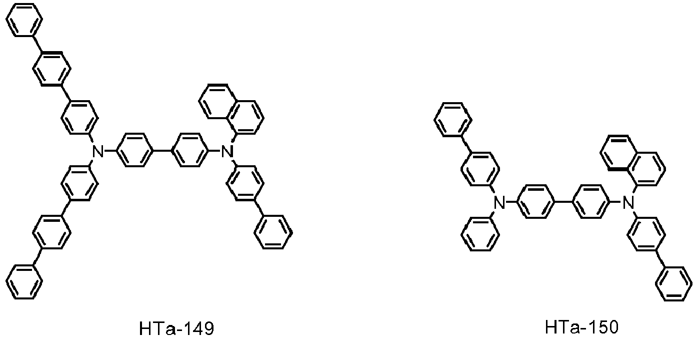

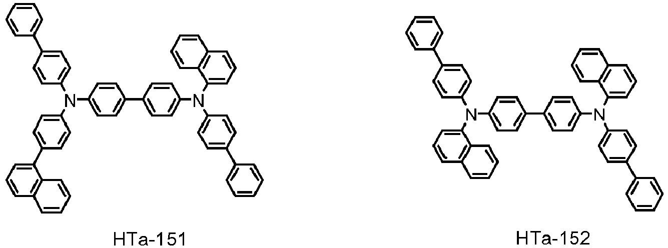

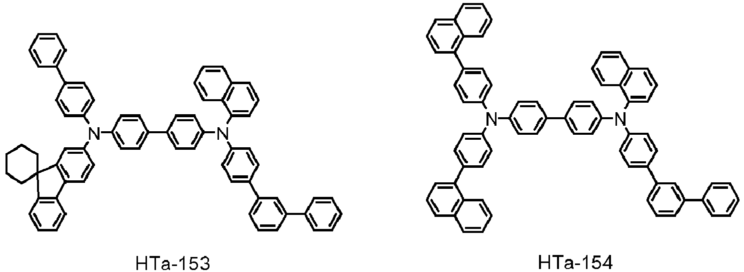

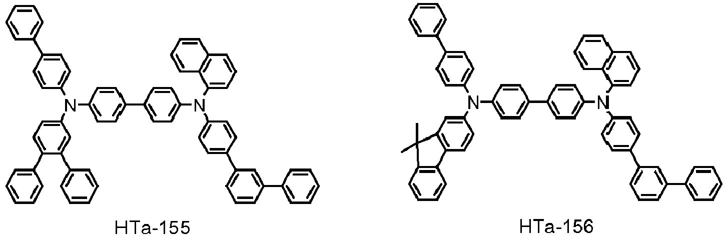

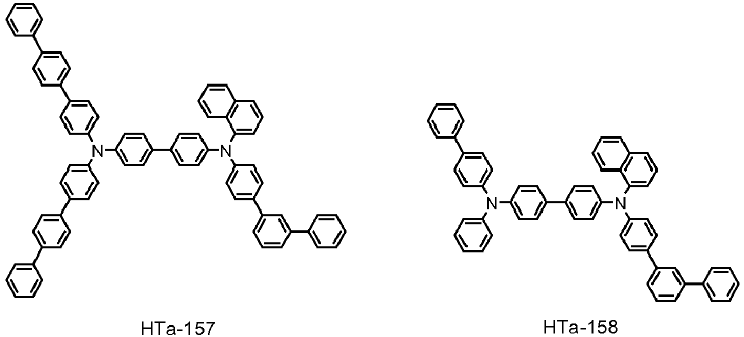

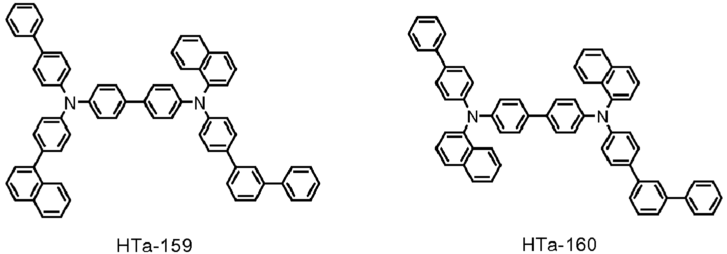

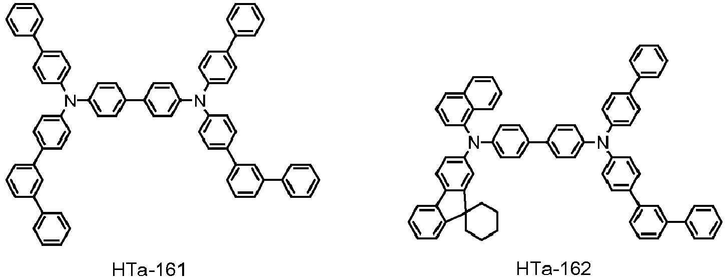

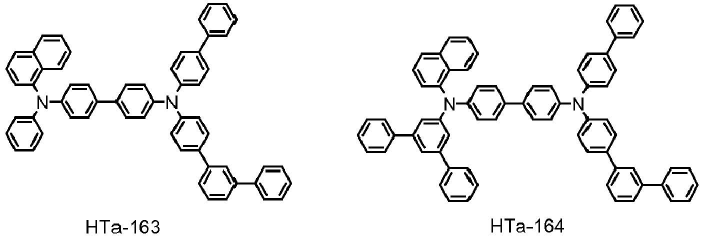

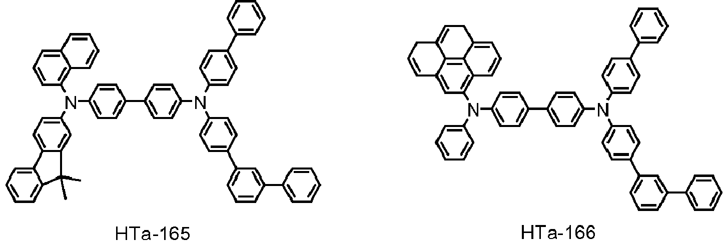

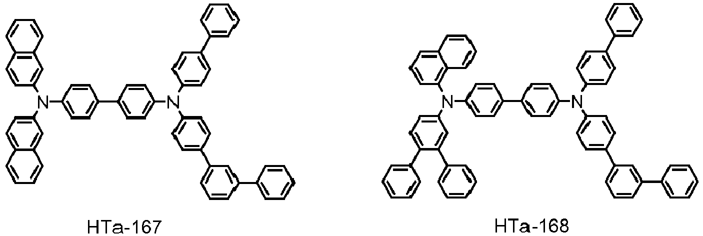

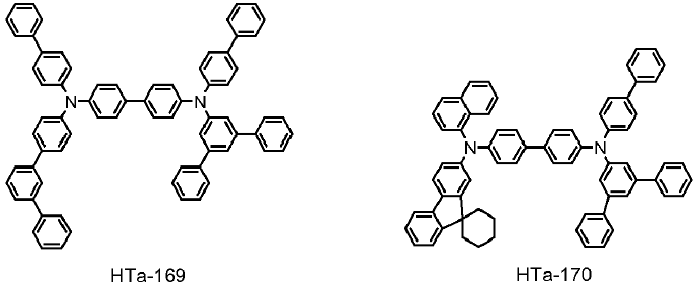

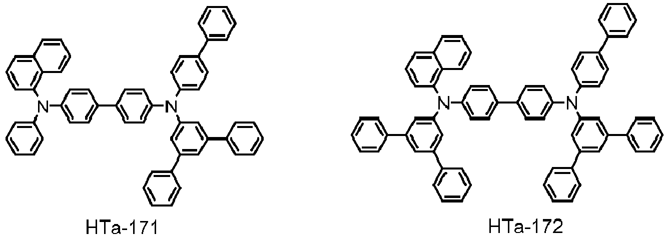

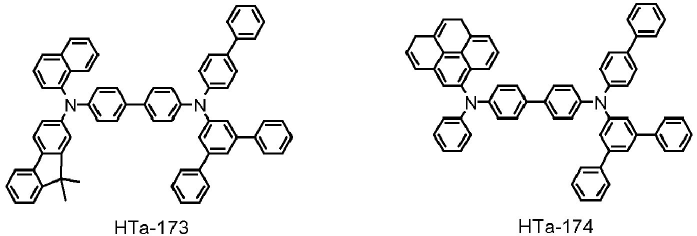

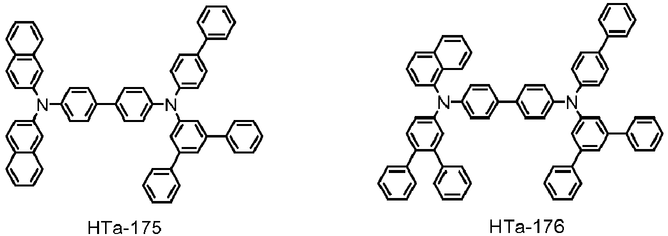

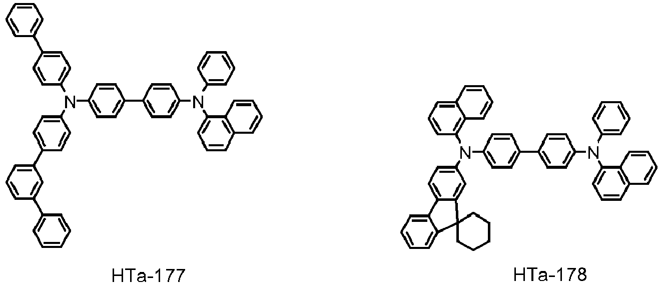

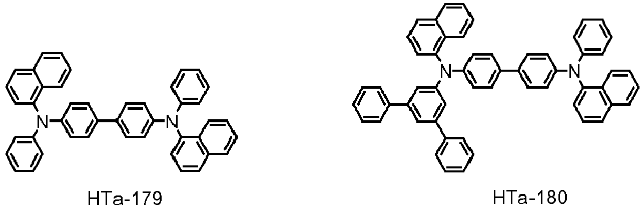

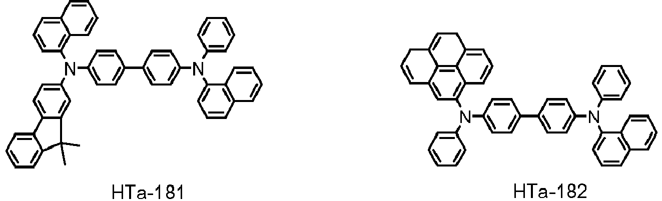

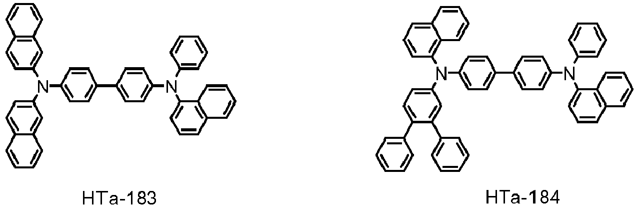

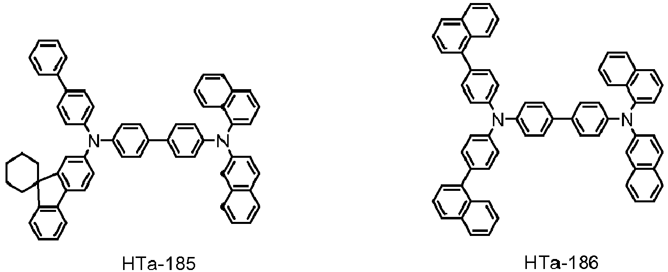

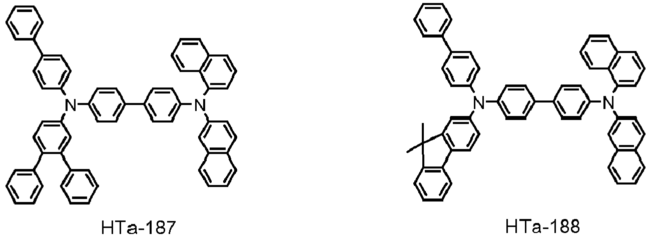

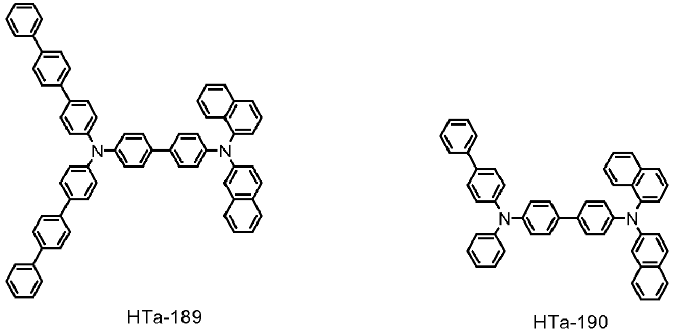

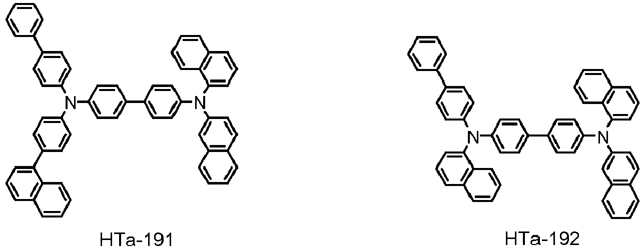

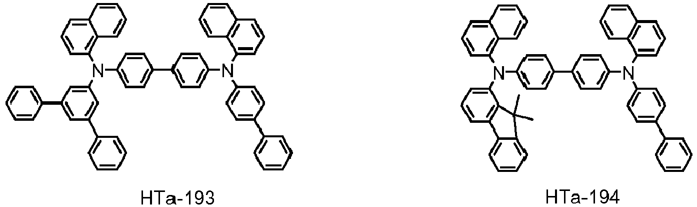

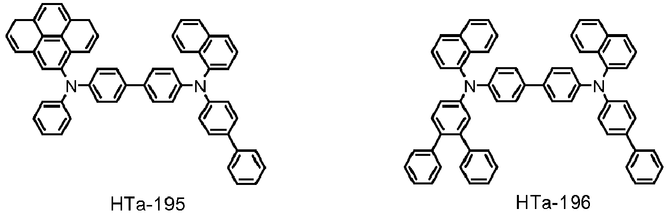

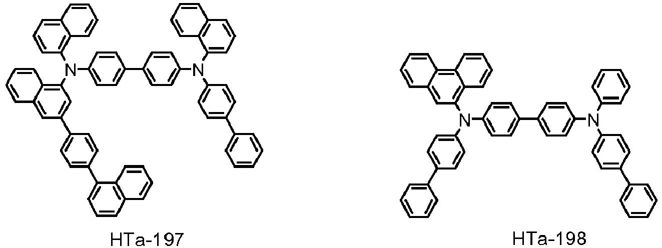

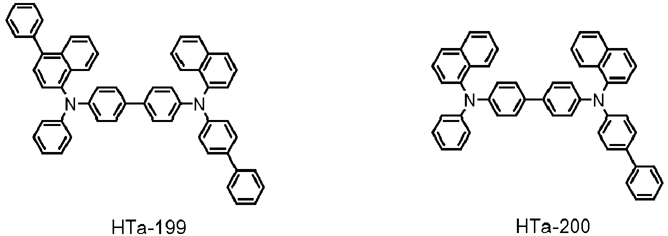

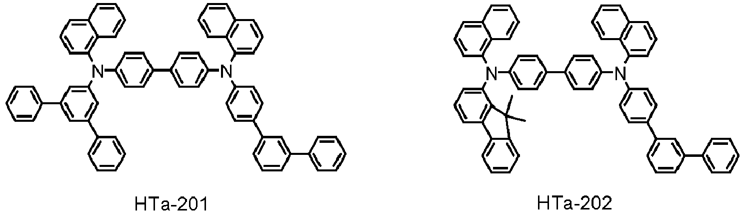

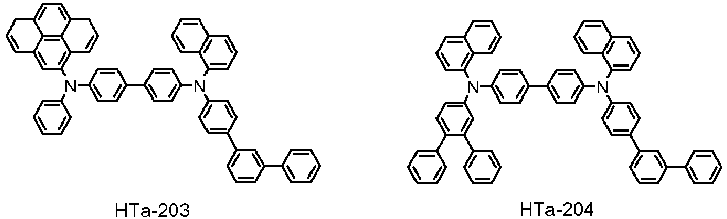

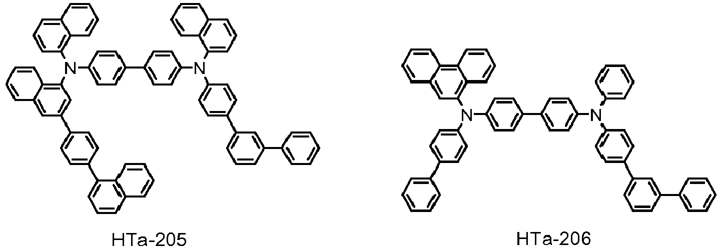

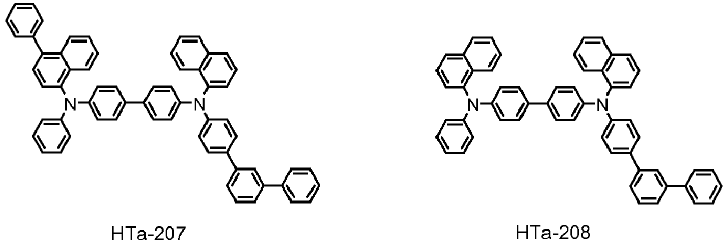

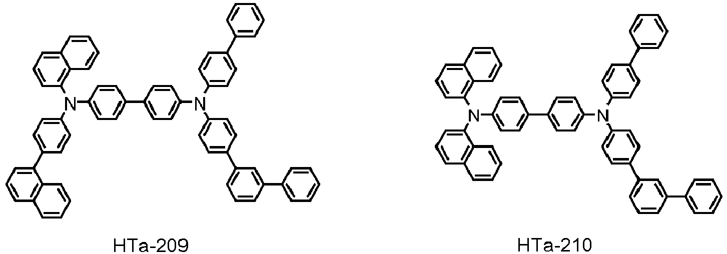

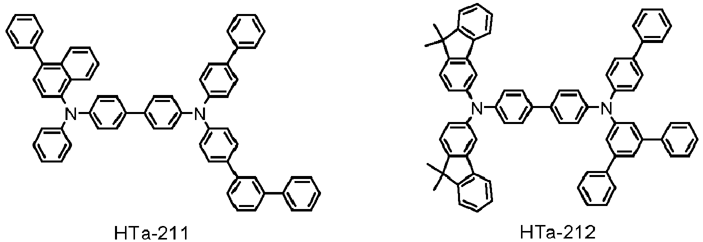

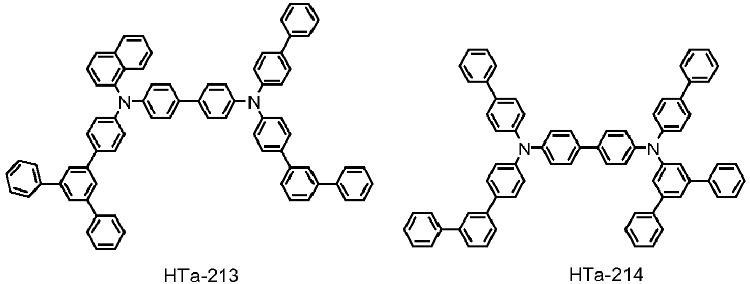

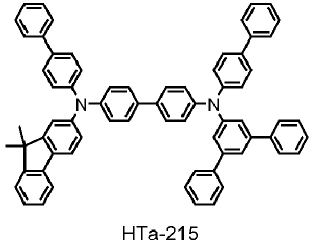

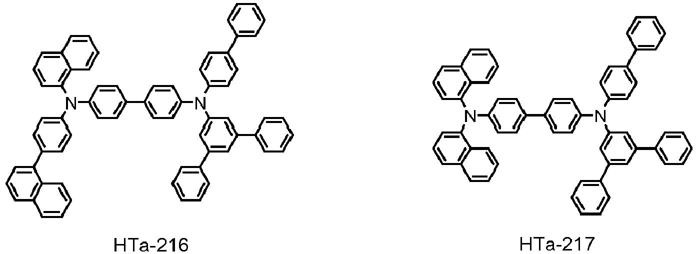

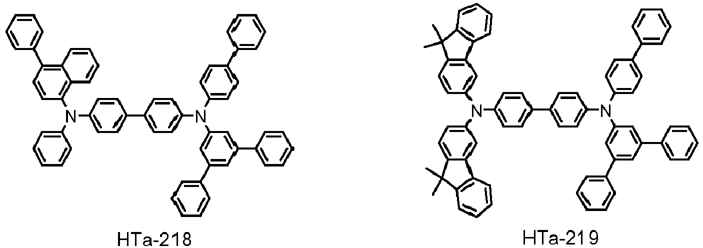

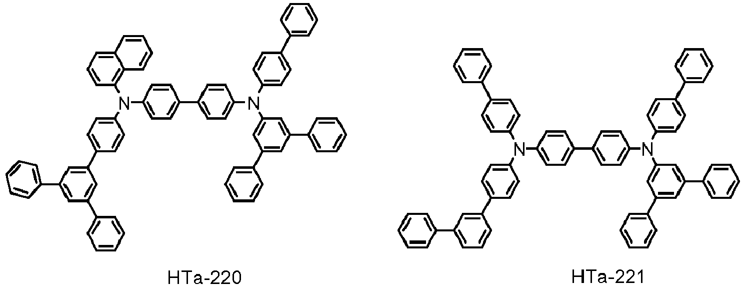

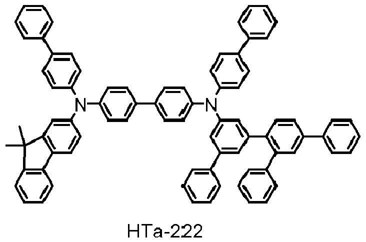

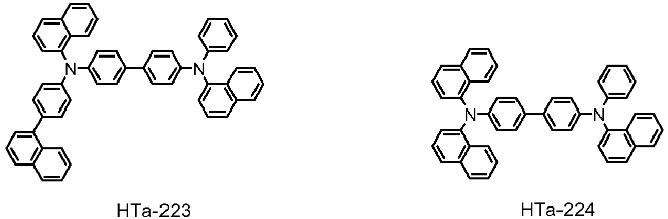

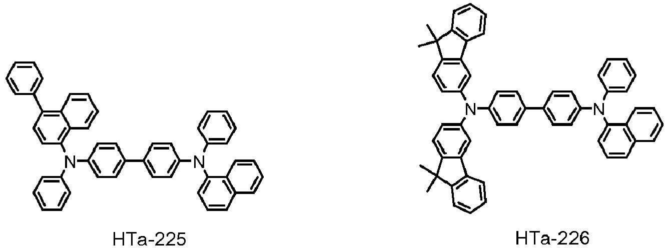

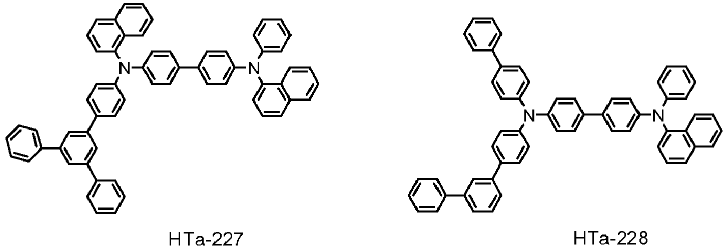

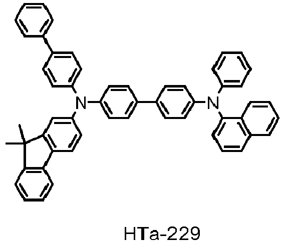

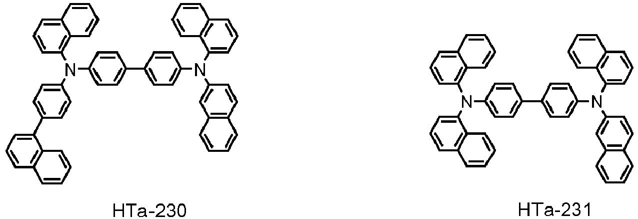

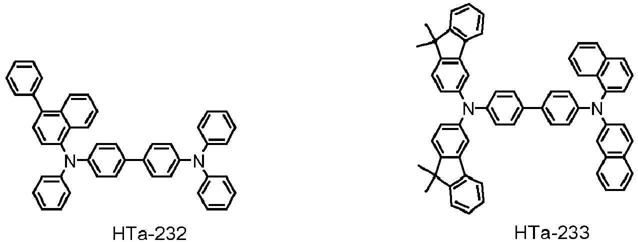

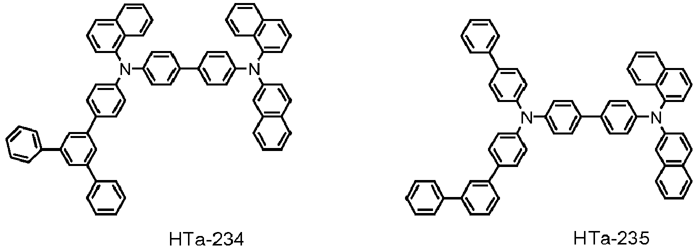

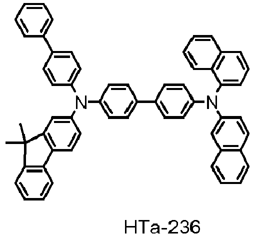

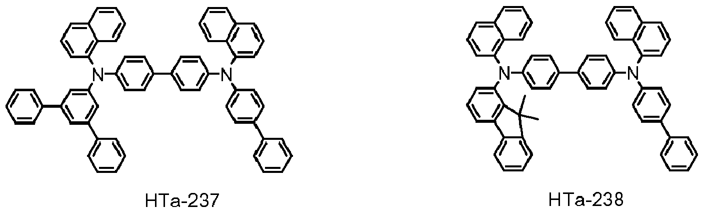

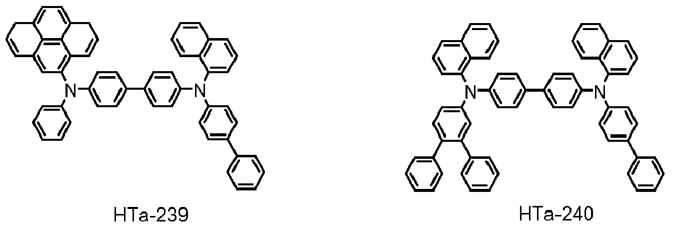

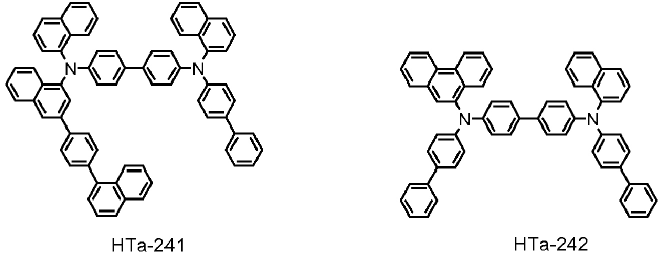

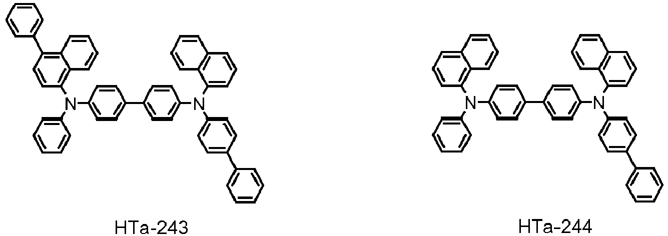

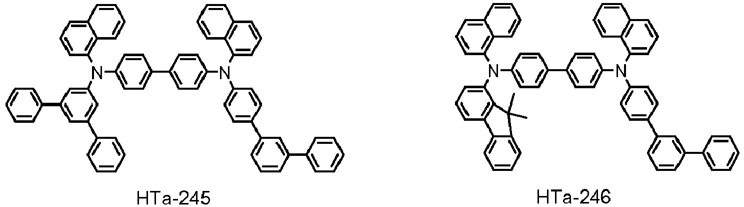

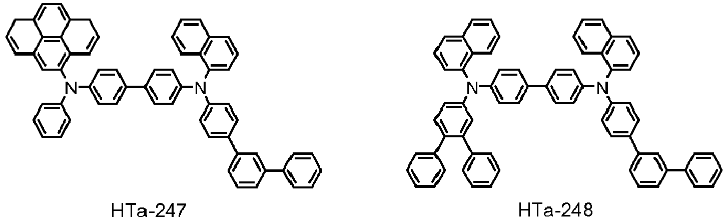

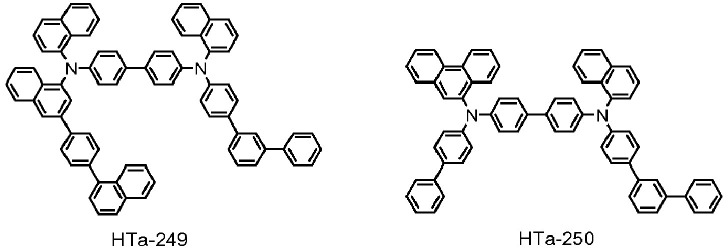

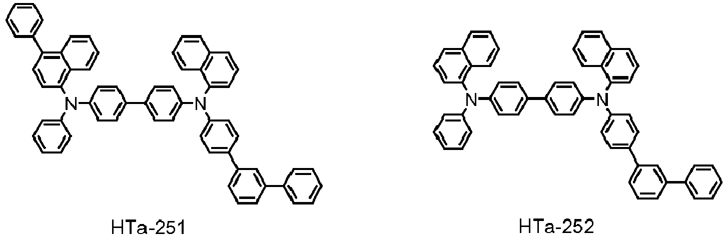

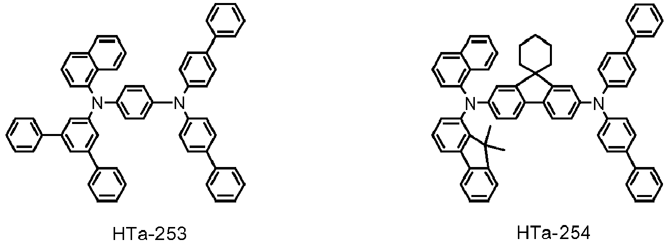

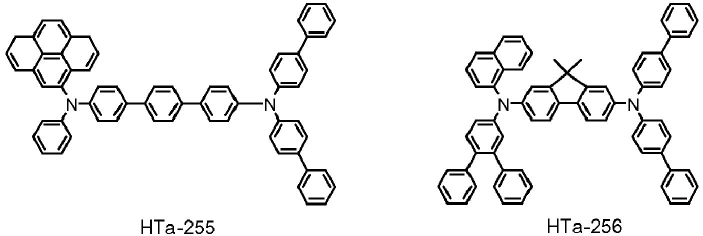

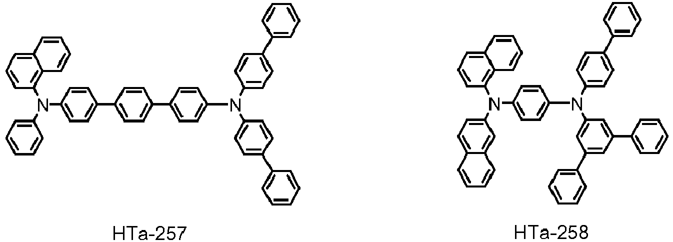

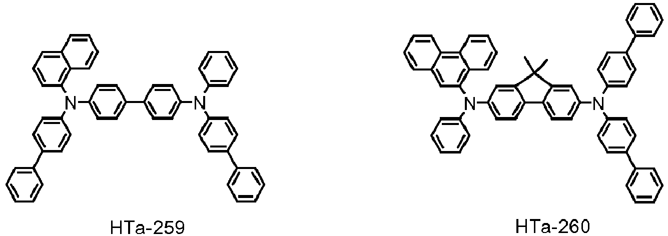

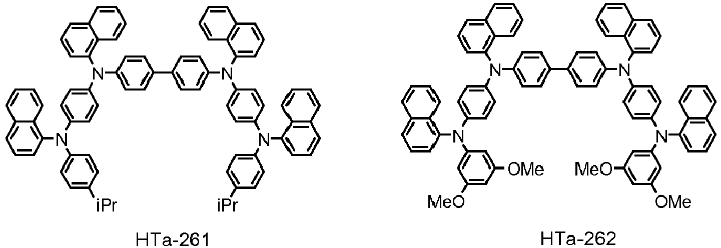

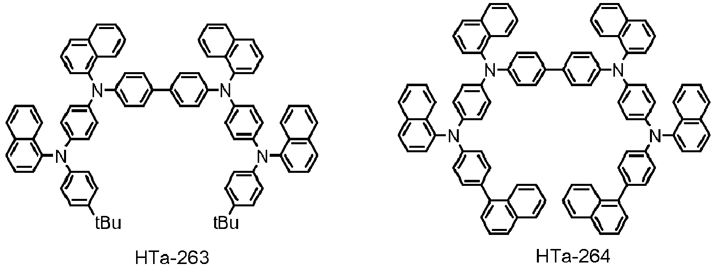

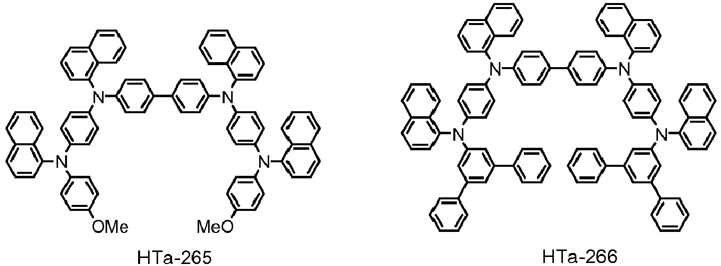

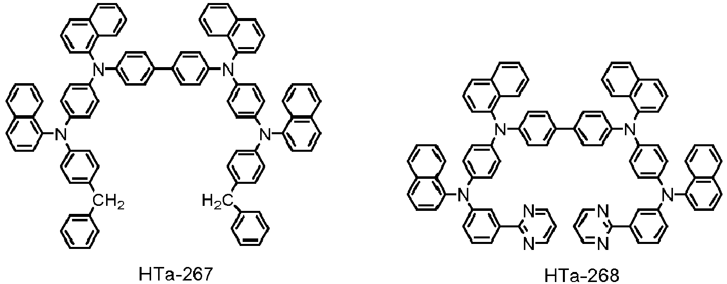

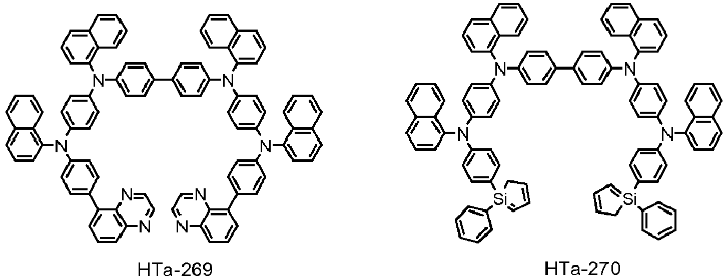

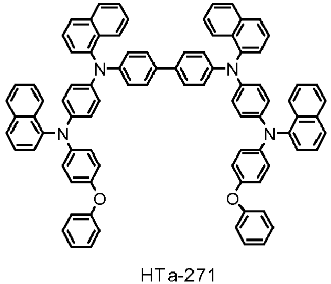

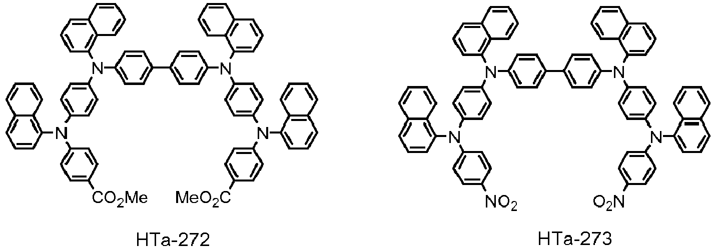

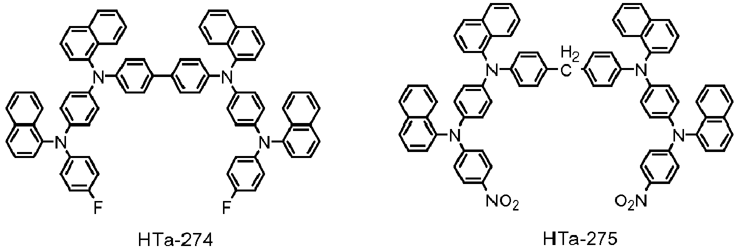

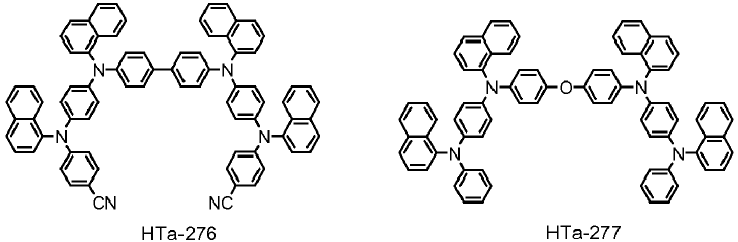

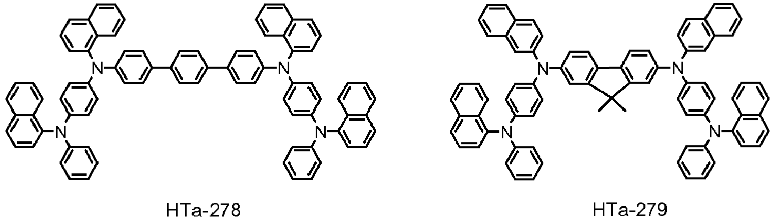

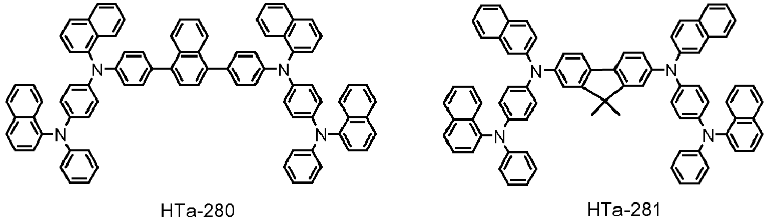

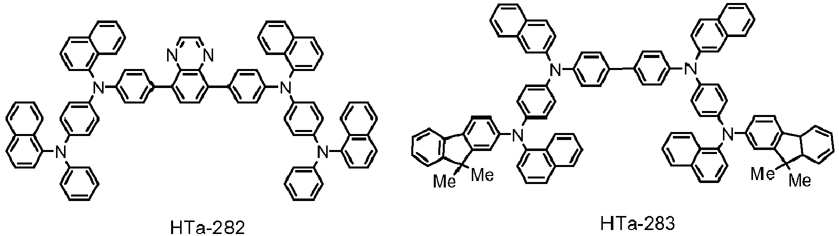

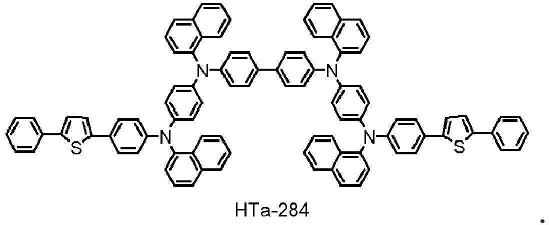

21. Dispositif électroluminescent organique selon la revendication 1, dans lequel la région de transport de trous comprend en outre un deuxième composé représenté par l'une des formules 201A-1 et 202A : 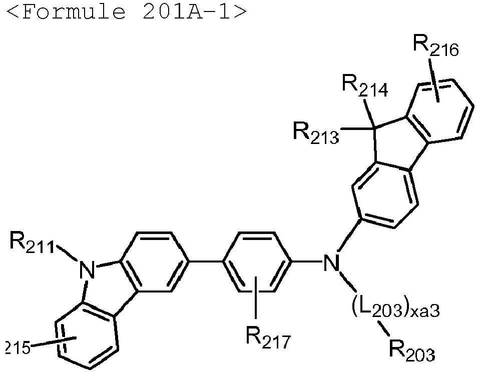 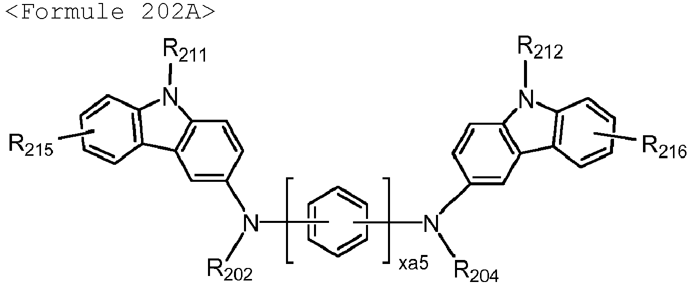 où, dans les formules 201A-1 et 202A,
chacun de R₂₀₂ à R₂₀₄, R₂₁₁ et R₂₁₂ est indépendamment choisi parmi
un groupe aryle en C₆ à C₆₀ substitué ou non substitué, un groupe hétéroaryle en C₁ à C₆₀ substitué ou non substitué, un groupe polycyclique condensé non aromatique monovalent substitué, et un groupe hétéropolycyclique condensé non aromatique monovalent substitué ;
L₂₀₃ est un groupe arylène en C₆ à C₆₀ substitué ou non substitué ;
chacun de xa3 et xa5 est indépendamment un entier de 0 à 3 ;
chacun de R₂₁₃ et R₂₁₄ est indépendamment choisi parmi
un groupe alkyle en C₁ à C₁₀, un groupe alkoxy en C₁ à C₁₀, et un groupe aryle en C₁ à C₂₀ ;
un groupe alkyle en C₁ à C₁₀ et un groupe alkoxy en C₁ à C₁₀, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, et un groupe acide phosphorique ou un de ses sels ; et
un groupe aryle en C₁ à C₂₀ substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₁₀, un groupe alkoxy en C₁ à C₁₀, et un groupe aryle en C₁ à C₂₀ ;
éventuellement R₂₁₃ et R₂₁₄ sont liés l'un à l'autre pour former un cycle polycyclique condensé,
chacun de R₂₁₅ à R₂₁₇ est indépendamment choisi parmi
un atome d'hydrogène, un atome de deutérium, -F, -Cl, -Br, -I, un groupe hydroxyle, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), et -B(Q₆)(Q₇) ;
au moins un substituant du groupe alkyle en C₁ à C₆₀ substitué, du groupe alcényle en C₂ à C₆₀ substitué, du groupe alcynyle en C₂ à C₆₀ substitué, du groupe alkoxy en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe arylène en C₆ à C₆₀ substitué, du groupe polycyclique condensé non aromatique monovalent substitué, et du groupe hétéropolycyclique condensé non aromatique monovalent substitué, est choisi parmi
un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, et un groupe alkoxy en C₁ à C₆₀,
un groupe alkyle en C₁ à C₆₀, un groupe alcényle en C₂ à C₆₀, un groupe alcynyle en C₂ à C₆₀, et un groupe alkoxy en C₁ à C₆₀, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), et -B(Q₁₆)(Q₁₇),
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -N(Q₂₁)(Q₂₂), -Si (Q₂₃) (Q₂₄)(Q₂₅), et -B (Q₂₆) (Q₂₇), et
-N(Q₃₁)(Q₃₂), -Si(Q₃₃)(Q₃₄)(Q₃₅), et -B(Q₃₆)(Q₃₇),
où chacun de Q₁ à Q₇, de Q₁₁ à Q₁₇, de Q₂₁ à Q₂₇, et de Q₃₁ à Q₃₇ est indépendamment choisi parmi un hydrogène, un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, et un groupe hétéropolycyclique condensé non aromatique monovalent.

22. Dispositif électroluminescent organique selon la revendication 21, dans lequel, dans les formules 201A-1 et 202A, chacun de R₂₀₂ à R₂₀₄, et R₂₁₁ et R₂₁₂ est indépendamment choisi parmi
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle ; et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle ;
L₂₀₃ est choisi parmi
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthrylène, un groupe fluoranthénylène, un groupe triphénylénylène, un groupe pyrénylène, un groupe chrysénylène, un groupe naphtacénylène, un groupe picénylène, et un groupe pérylénylène, et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-fluorénylène, un groupe benzofluorénylène, un groupe dibenzofluorénylène, un groupe phénalénylène, un groupe phénanthrénylène, un groupe anthrylène, un groupe fluoranthénylène, un groupe triphénylénylène, un groupe pyrénylène, un groupe chrysénylène, un groupe naphtacénylène, un groupe picénylène, et un groupe pérylénylène, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle ;
chacun de R₂₁₃ et R₂₁₄ est indépendamment choisi parmi
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle,
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, et un groupe pentoxy, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle ;
chacun de R₂₁₅ à R₂₁₇ est indépendamment choisi parmi
un atome d'hydrogène, un atome de deutérium, -F, -Cl, -Br, -I, un groupe hydroxyle, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, et un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle, chacun substitué par au moins l'un parmi un atome de deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un de ses sels, un groupe acide sulfonique ou un de ses sels, un groupe acide phosphorique ou un de ses sels, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe méthoxy, un groupe éthoxy, un groupe propoxy, un groupe butoxy, un groupe pentoxy, un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthryle, un groupe fluoranthényle, un groupe triphénylényle, un groupe pyrényle, un groupe chrysényle, un groupe naphtacényle, un groupe picényle, un groupe pérylényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridyle, un groupe pyrazinyle, un groupe pyrimidinyle, un groupe pyridazinyle, un groupe isoindolyle, un groupe indolyle, un groupe indazolyle, un groupe purinyle, un groupe quinolyle, un groupe isoquinolyle, un groupe benzoquinolyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzofluorényle, un groupe benzimidazolyle, un groupe benzofuranyle, un groupe benzothiophényle, un groupe benzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofluorényle, un groupe dibenzofuranyle, un groupe dibenzothiophényle, un groupe benzocarbazolyle, un groupe dibenzocarbazolyle, un groupe thiadiazolyle, un groupe imidazopyridyle, et un groupe imidazopyrimidinyle.

23. Dispositif électroluminescent organique selon la revendication 21, dans lequel, dans les formules 201A-1 et 202A,
chacun de R₂₀₂ à R₂₀₄, et R₂₁₁ et R₂₁₂ est indépendamment un groupe phényle, un groupe biphényle, un groupe naphtyle, un groupe fluorényle, et un groupe pyridyle ; et un groupe phényle, et un groupe fluorényle, chacun substitué par au moins l'un parmi -F, -Cl, -Br, -I, un groupe méthyle, et un groupe cyano ;
L₂₀₃ est un groupe phénylène ;
chacun de R₂₁₃ et R₂₁₄ est indépendamment un groupe méthyle ou un groupe phényle, et éventuellement R₂₁₃ et R₂₁₄ sont liés l'un à l'autre pour former un cycle fluorène ; et
R₂₁₅ à R₂₁₇ sont des atomes d'hydrogène.

24. Dispositif électroluminescent organique selon la revendication 21, dans lequel le deuxième composé est choisi parmi les composés HTb-1 à HTb-20 :

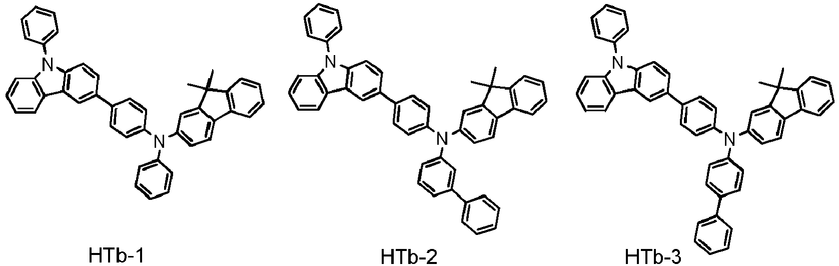

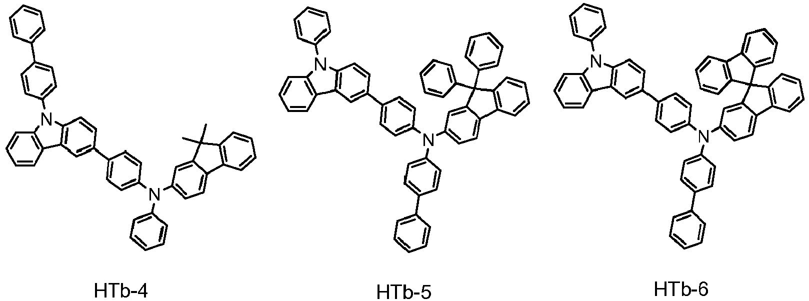

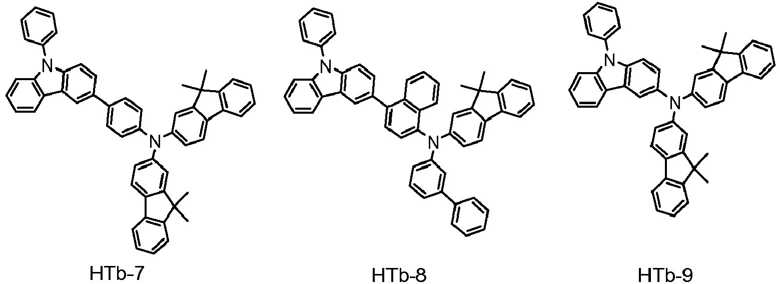

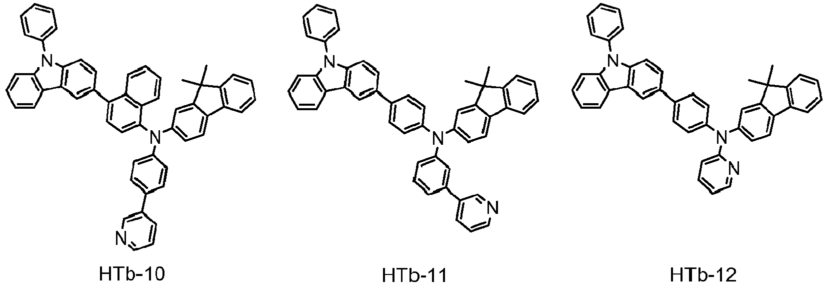

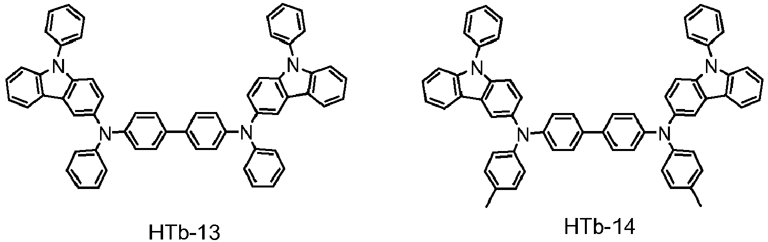

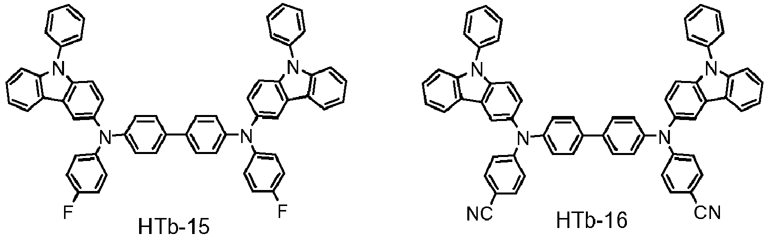

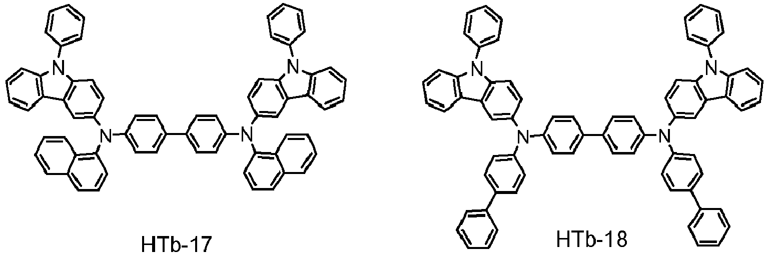

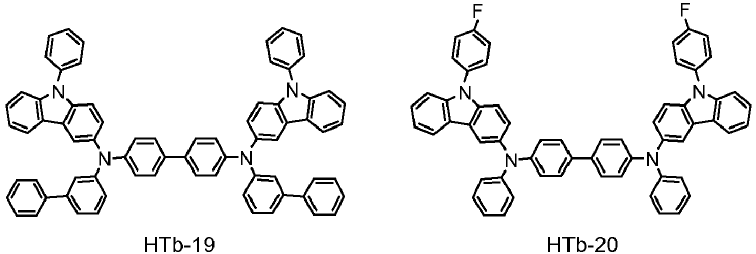

25. Dispositif électroluminescent organique selon la revendication 21, dans lequel la couche d'émission auxiliaire comprend en outre le deuxième composé.

26. Dispositif électroluminescent organique selon la revendication 21, dans lequel la couche de transport de trous comprend le deuxième composé.
